# EUROPEAN PATENT APPLICATION

(11) **EP 4 424 782 A1**
(43) Date of publication of application: **04.09.2024**
(21) Application number: 23872977.6
(22) Date of filing: 22.09.2023
(51) Int. Cl.: C09D 11/03, C09D 11/033, C09D 11/30, C09K 11/06, H10K 50/14, H10K 50/11, H10K 50/17, H10K 85/60

(54) **INK COMPOSITION, ORGANIC LIGHT-EMITTING DEVICE USING SAME, AND MANUFACTURING METHOD THEREFOR**

(30) Priority: 30.09.2022 KR 20220125404
(71) Applicant: LG Chem, Ltd., Yeongdeungpo-gu Seoul 07336 (KR)
(72) Inventor: JEONG, Su Hun, Daejeon 34122 (KR); KANG, Eunhye, Daejeon 34122 (KR); KIM, Byungjae, Daejeon 34122 (KR); SHIN, Jiyeon, Daejeon 34122 (KR); YOO, Seung Jun, Daejeon 34122 (KR); LEE, Jumin, Daejeon 34122 (KR)
(74) Representative: Hoffmann Eitle
(86) International application number: PCT/KR2023/014531
(87) International publication number: WO 2024/071860

(57) **Abstract**

The present specification relates to an ink composition including a compound represented by Chemical Formula 1, a first solvent represented by Chemical Formula 2 and a second solvent represented by Chemical Formula 3.

## Description

### [Technical Field]

This application claims priority to and the benefit of Korean Patent Application No. 10-2022-0125404 filed in the Korean Intellectual Property Office on September 30, 2022, the entire contents of which are incorporated herein by reference.

The present invention relates to an ink composition, an organic light emitting device using the same, and a method for manufacturing the same.

### [Background Art]

Although a deposition process has been mainly used to manufacture an organic light emitting device in the related art, when an organic light emitting device is manufactured by the deposition process, there are problems in that a lot of materials are lost and it difficult to manufacture a device having a large area.

In order to solve these problems, a device manufactured using a solution process is being developed, and there is a need for developing an ink having excellent flatness of a film formed through the solution process.

### [Detailed Description of the Invention]

### [Technical Problem]

An object of the present invention is to provide an ink composition capable of forming a flat organic material layer thin film after drying, an organic light emitting device manufactured using the same, and a method for manufacturing the same.

### [Technical Solution]

The present invention provides an ink composition including: a compound represented by the following Chemical Formula 1; a first solvent represented by the following Chemical Formula 2; and a second solvent represented by the following Chemical Formula 3.

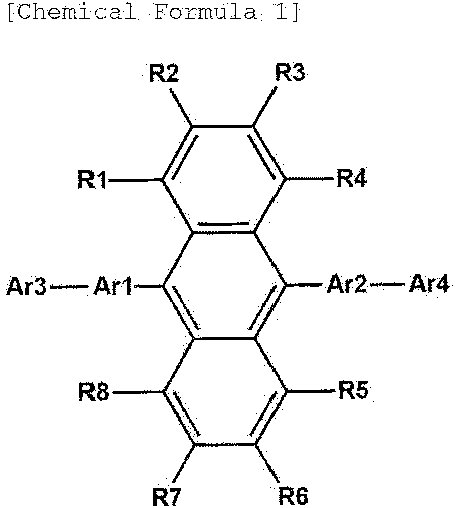

In Chemical Formula 1,
R1 to R8 are the same as or different from each other, and are each independently hydrogen; deuterium; a substituted or unsubstituted alkyl group; a substituted or unsubstituted alkoxy group; a substituted or unsubstituted aryl group; a substituted or unsubstituted aryloxy group; a substituted or unsubstituted diarylamino group; a substituted or unsubstituted siloxane group; or a substituted or unsubstituted silyl group,
Ar1 and Ar2 are the same as or different from each other, and are each independently a direct bond; or a substituted or unsubstituted arylene group,
Ar3 and Ar4 are the same as or different from each other, and are each independently a substituted or unsubstituted aryl group; or a substituted or unsubstituted heteroaryl group, 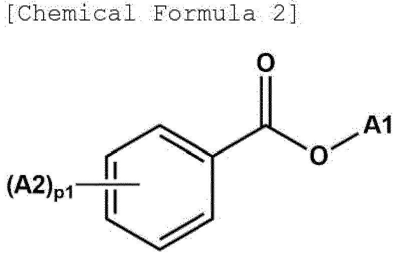 in Chemical Formula 2,
   A1 and A2 are the same as or different from each other, and each independently a substituted or unsubstituted alkyl group; a substituted or unsubstituted alkoxy group; a substituted or unsubstituted cycloalkyl group; or a substituted or unsubstituted aryl group,
   p1 is an integer from 0 to 5, and when p1 is 2 or higher, two or more A2's are the same as or different from each other, 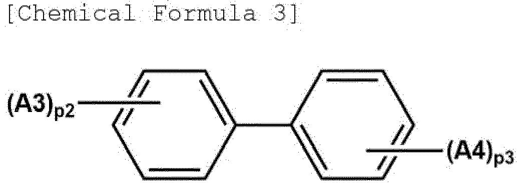 in Chemical Formula 3,
      A3 and A4 are the same as or different from each other, and each independently a substituted or unsubstituted alkyl group; a substituted or unsubstituted alkoxy group; a substituted or unsubstituted cycloalkyl group; or a substituted or unsubstituted aryl group, and
      p2 and p3 are each an integer from 0 to 5, and when p2 and p3 are 2 or higher, two or more substituents in the parenthesis are the same as or different from each other.

Further, the present specification provides an organic light emitting device including: a first electrode; a second electrode; and an organic material layer having one or more layers provided between the first electrode and the second electrode, in which one or more layers of the organic material layer having one or more layers include the above-described ink composition or a cured product thereof.

Finally, the present invention provides a method for manufacturing an organic light emitting device, the method including: preparing a first electrode; forming an organic material layer having one or more layers on the first electrode; and forming a second electrode on the organic material layer having one or more layers, in which the forming of the organic material layer having one or more layers includes forming the organic material layer using the above-described ink composition.

### [Advantageous Effects]

Since the ink composition according to the present invention includes an anthracene-based compound represented by Chemical Formula 1, a benzoate-based first solvent represented by Chemical Formula 2, and a biphenyl-based second solvent represented by Chemical Formula 3, a flat film can be obtained when a thin film is formed. In addition, when the ink composition according to the present invention is applied to a device, there is an advantage in that the efficiency and service life of the device are improved.

### [Brief Description of Drawings]

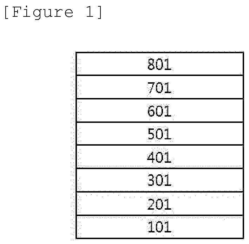

FIG. 1 illustrates an example of an organic light emitting device according to an exemplary embodiment of the present specification.

### [Explanation of Reference Numerals and Symbols]

101: Substrate
201: Positive electrode
301: Hole injection layer
401: Hole transport layer
501: Light emitting layer
601: Electron transport layer
701: Electron injection layer
801: Negative electrode

### [Best Mode]

Hereinafter, the present invention will be described in detail. The following contents are intended to aid in the understanding of the present invention, and does not define or limit the scope of the invention.

When one member (layer) is disposed "on" another member (layer) in the present specification, this includes not only a case where the one member (layer) is brought into contact with another member, but also a case where still another member (layer) is present between the two members (layers).

When one part "includes" one constituent element in the present specification, unless otherwise specifically described, this does not mean that another constituent element is excluded, but means that another constituent element may be further included.

In the present specification, the alkyl group may be straight-chained or branch-chained, and the number of carbon atoms thereof is not particularly limited, but may be 1 to 20. According to another exemplary embodiment, the number of carbon atoms of the alkyl group is 1 to 10. Specific examples of the alkyl group include a methyl group, an ethyl group, an n-propyl group, an isopropyl group, an n-butyl group, an isobutyl group, a t-butyl group, an n-pentyl group, an n-hexyl group, an n-heptyl group, and the like, but are not limited thereto.

In the present specification, a cycloalkyl group is not particularly limited, but may have 3 to 60 carbon atoms, and according to an exemplary embodiment, the number of carbon atoms of the cycloalkyl group is 3 to 30. According to another exemplary embodiment, the number of carbon atoms of the cycloalkyl group is 3 to 20. Specific examples of the cycloalkyl group include a cyclopropyl group, a cyclobutyl group, a cyclopentyl group, a cyclohexyl group, a cycloheptyl group, a cyclooctyl group, and the like, but are not limited thereto.

In the present specification, the alkoxy group may be straight-chained or branch-chained. The number of carbon atoms of the alkoxy group is not particularly limited, but may be 1 to 20. Specific examples of the alkoxy group include a methoxy group, an ethoxy group, an n-propoxy group, an n-butoxy group, a t-butoxy group, an n-pentyloxy group, an n-hexyloxy group, an n-octyloxy group, an n-nonyloxy group, an n-decyloxy group, and the like, but are not limited thereto.

In the present specification, the aryl group is not particularly limited, but may have 6 to 60 carbon atoms, and may be a monocyclic aryl group or a polycyclic aryl group.

According to an exemplary embodiment, the number of carbon atoms of the monocyclic aryl group is 6 to 60. Examples of the monocyclic aryl group include a phenyl group, a biphenyl group, a terphenyl group, and the like, but are not limited thereto.

According to an exemplary embodiment, the number of carbon atoms of the polycyclic aryl group is 10 to 60. Examples of the polycyclic aryl group include a naphthyl group, an anthracenyl group, a fluorenyl group, and the like, but are not limited thereto.

In the present specification, a fluorenyl group may be substituted, and two substituents may be bonded to each other to form a spiro structure.

When the fluorenyl group is substituted or two substituents are bonded to each other to form a spiro structure, the fluorenyl group may be a spirofluorenyl group such as 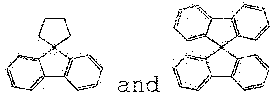 and a substituted fluorenyl group such as 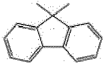 (a 9,9-dimethylfluorenyl group) and 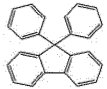 (a 9,9-diphenylfluorenyl group). However, the fluorenyl group is not limited thereto.

The aryl group may be bonded to an alkoxy group to act as an aryloxy group. The alkoxy group may be selected from the above-described examples.

In the present specification, a heteroaryl group includes one or more non-carbon atoms (heteroatoms) such as O, S, P, Si, and N, and the number of carbon atoms of the heteroaryl group is not particularly limited, but may be 2 to 60. According to an exemplary embodiment, the number of carbon atoms of the heteroaryl group is 2 to 30. Examples of the heteroaryl group include a pyridyl group, a thiophenyl group, a furanyl group, and the like, but are not limited thereto.

The ink composition according to the present invention includes: a compound represented by the following Chemical Formula 1; a first solvent represented by the following Chemical Formula 2; and a second solvent represented by the following Chemical Formula 3.

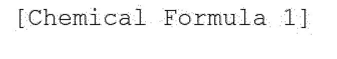

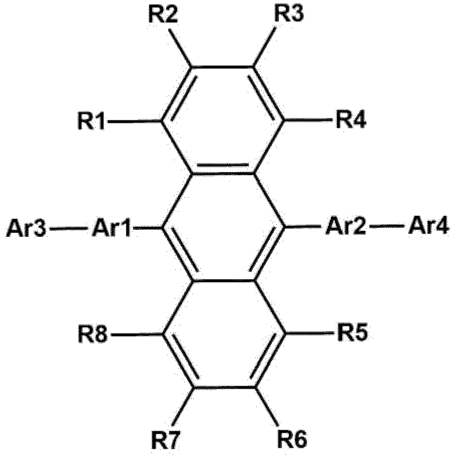

In Chemical Formula 1,
R1 to R8 are the same as or different from each other, and are each independently hydrogen; deuterium; a substituted or unsubstituted alkyl group; a substituted or unsubstituted alkoxy group; a substituted or unsubstituted aryl group; a substituted or unsubstituted aryloxy group; a substituted or unsubstituted diarylamino group; a substituted or unsubstituted siloxane group; or a substituted or unsubstituted silyl group,
Ar1 and Ar2 are the same as or different from each other, and are each independently a direct bond; or a substituted or unsubstituted arylene group,
Ar3 and Ar4 are the same as or different from each other, and are each independently a substituted or unsubstituted aryl group; or a substituted or unsubstituted heteroaryl group, 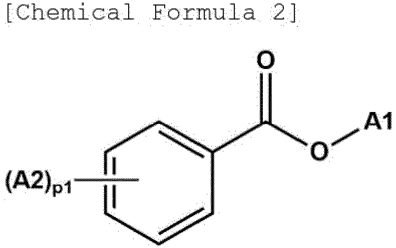 in Chemical Formula 2,
   A1 and A2 are the same as or different from each other, and each independently a substituted or unsubstituted alkyl group; a substituted or unsubstituted alkoxy group; a substituted or unsubstituted cycloalkyl group; or a substituted or unsubstituted aryl group,
   p1 is an integer from 0 to 5, and when p1 is 2 or higher, two or more A2's are the same as or different from each other, 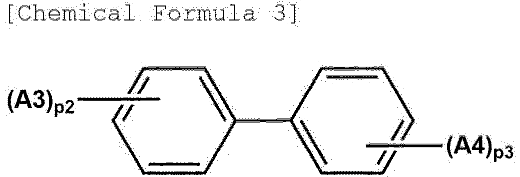 in Chemical Formula 3,
      A3 and A4 are the same as or different from each other, and each independently a substituted or unsubstituted alkyl group; a substituted or unsubstituted alkoxy group; a substituted or unsubstituted cycloalkyl group; or a substituted or unsubstituted aryl group, and
      p2 and p3 are each an integer from 0 to 5, and when p2 and p3 are 2 or higher, two or more substituents in the parenthesis are the same as or different from each other.

The ink composition of the present specification includes the compound represented by Chemical Formula 1.

According to an exemplary embodiment of the present specification, Chemical Formula 1 is substituted with at least one deuterium.

In the present specification, the non-deuterated specific compound of Chemical Formula 1 may be prepared by known coupling and substitution reactions. The deuterated compound of Chemical Formula 1 may be prepared in a similar manner using a deuterated precursor material, or more generally by treating a non-deuterated compound with a deuterated solvent, for example, d6-benzene in the presence of a Lewis acid H/D exchange catalyst such as aluminum trichloride or ethylaluminum chloride.

In the present specification, the level of deuteration may be determined by NMR analysis and a mass spectrophotometer, such as an atmospheric solid analysis probe mass spectrometer (ASAP-MS).

In another exemplary embodiment, Chemical Formula 1 is deuterated by at least 10%. This means that at least 10% of the available hydrogen is replaced by deuterium.

According to another exemplary embodiment, Chemical Formula 1 is deuterated by at least 20%.

According to still another exemplary embodiment, Chemical Formula 1 is deuterated by at least 30%.

According to yet another exemplary embodiment, Chemical Formula 1 is deuterated by at least 40%.

According to still yet another exemplary embodiment, Chemical Formula 1 is deuterated by at least 50%.

According to a further exemplary embodiment, Chemical Formula 1 is deuterated by at least 60%.

According to another further exemplary embodiment, Chemical Formula 1 is deuterated by at least 70%.

According to still another further exemplary embodiment, Chemical Formula 1 is deuterated by at least 80%.

According to an exemplary embodiment of the present specification, R1 to R8 are the same as or different from each other, and are each independently hydrogen or deuterium.

In an exemplary embodiment of the present specification, Ar1 and Ar2 are the same as or different from each other, and are each independently a direct bond; or a substituted or unsubstituted arylene group having 6 to 60 carbon atoms.

According to another exemplary embodiment, Ar1 and Ar2 are the same as or different from each other, and are each independently a direct bond; or an arylene group having 6 to 60 carbon atoms, which is unsubstituted or substituted with deuterium.

According to still another exemplary embodiment, Ar1 and Ar2 are the same as or different from each other, and are each independently a direct bond; a substituted or unsubstituted phenylene group; or a substituted or unsubstituted naphthylene group.

According to yet another exemplary embodiment, Ar1 and Ar2 are the same as or different from each other, and are each independently a direct bond; a phenylene group unsubstituted or substituted with deuterium; or a naphthylene group unsubstituted or substituted with deuterium.

In an exemplary embodiment of the present specification, Ar3 and Ar4 are the same as or different from each other, and are each independently a substituted or unsubstituted aryl group having 6 to 60 carbon atoms; or a substituted or unsubstituted heteroaryl group having 2 to 60 carbon atoms.

In another exemplary embodiment, Ar3 and Ar4 are the same as or different from each other, and are each independently an aryl group having 6 to 60 carbon atoms, which is unsubstituted or substituted with deuterium; or a heteroaryl group having 2 to 60 carbon atoms, which is unsubstituted or substituted with deuterium.

In still another exemplary embodiment, Ar3 and Ar4 are the same as or different from each other, and are each independently a substituted or unsubstituted phenyl group; a substituted or unsubstituted naphthyl group; a substituted or unsubstituted dibenzofuranyl group; or a substituted or unsubstituted naphthobenzofuranyl group.

According to still yet another exemplary embodiment, Ar3 and Ar4 are the same as or different from each other, and are each independently a phenyl group unsubstituted or substituted with deuterium; a naphthyl group unsubstituted or substituted with deuterium; a dibenzofuranyl group unsubstituted or substituted with deuterium; or a naphthobenzofuranyl group unsubstituted or substituted with deuterium.

In an exemplary embodiment of the present specification, the compound represented by Chemical Formula 1 may be any one of the following structures, but is not limited thereto.

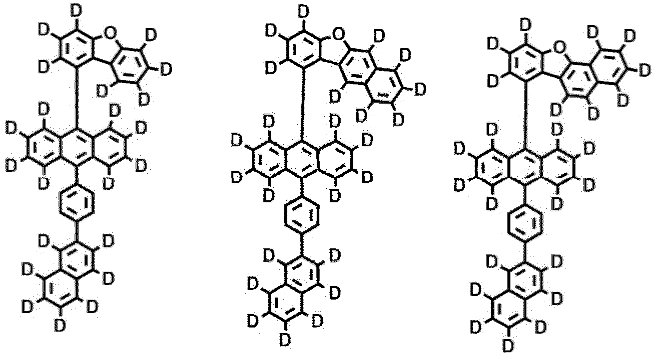

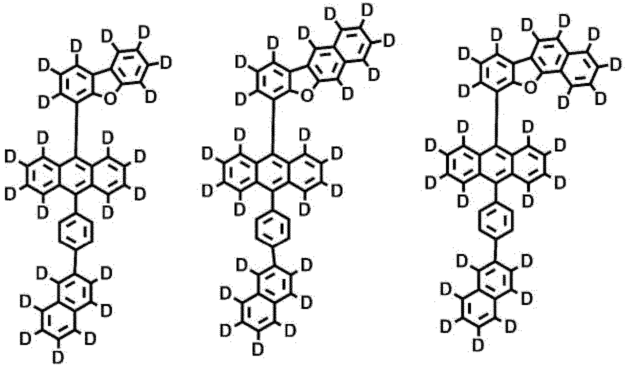

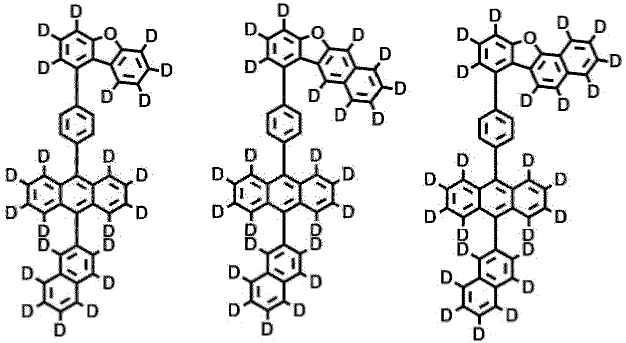

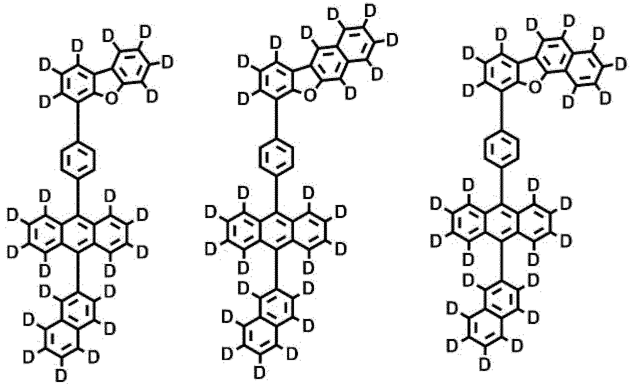

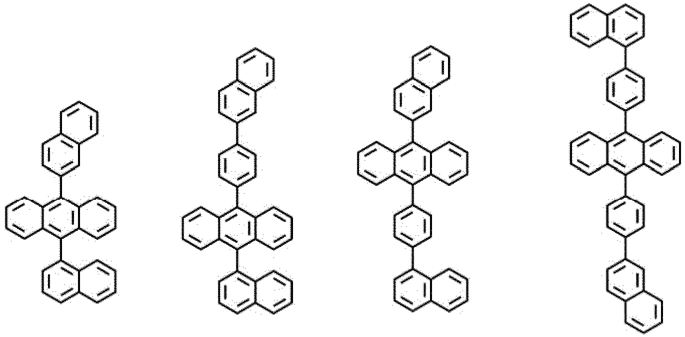

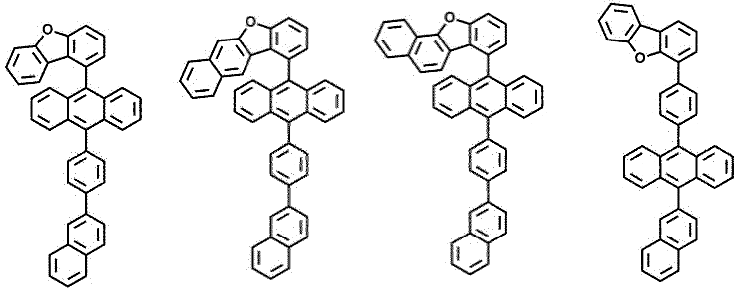

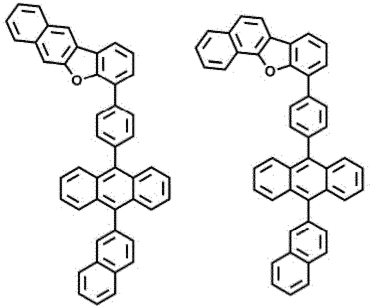

In another exemplary embodiment, the compound represented by Chemical Formula 1 may be any one of the following structures, but is not limited thereto. 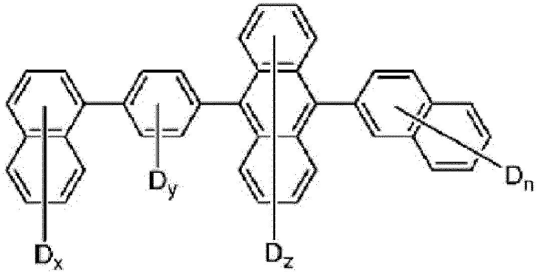 (here, x + y + z + n = 20 to 26) 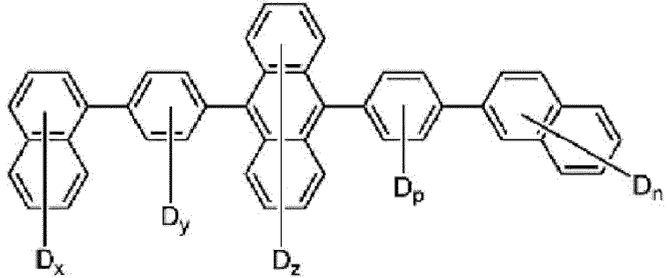 (here, x + y + z + p + n = 24 to 30) 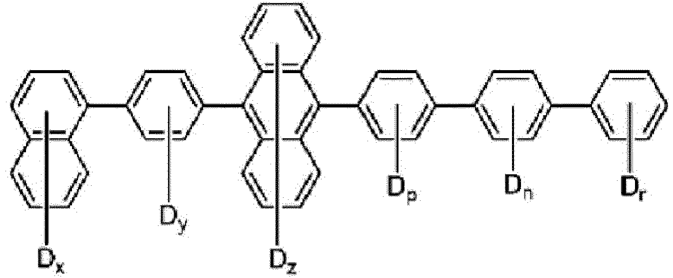 (here, x + y + z + p + n + r = 26 to 32) 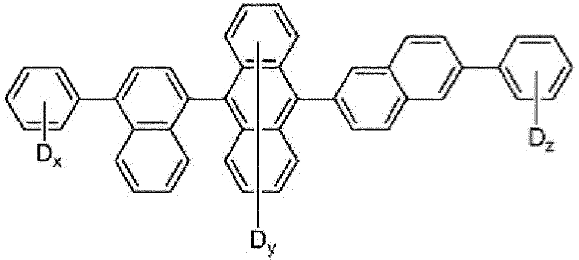 (here, x + y + z = 16 to 18) 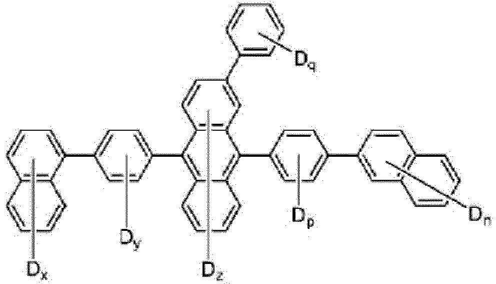 (here, x + y + z + p + n + q = 28 to 34) 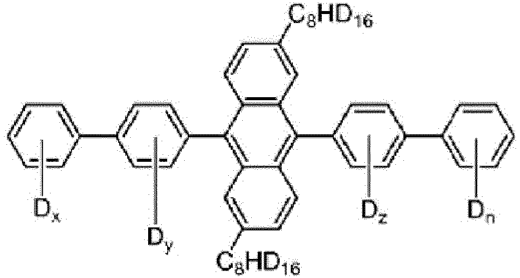 (here, x + y + z + n = 14 to 18) 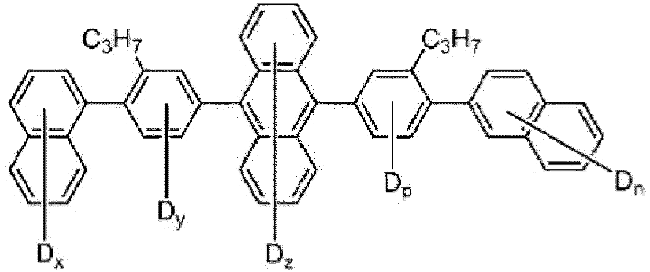 (here, x + y + z + p + n = 22 to 28)

The ink composition of the present invention includes a benzoate-based first solvent represented by the following Chemical Formula 2.

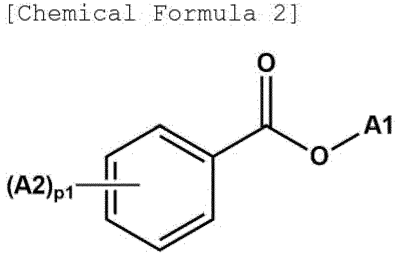

In Chemical Formula 2,
A1 and A2 are the same as or different from each other, and each independently a substituted or unsubstituted alkyl group; a substituted or unsubstituted alkoxy group; a substituted or unsubstituted cycloalkyl group; or a substituted or unsubstituted aryl group, and
p1 is an integer from 0 to 5, and when p1 is 2 or higher, two or more A2's are the same as or different from each other.

According to an exemplary embodiment of the present specification, A1 and A2 are the same as or different from each other, and are each independently a substituted or unsubstituted alkyl group having 1 to 20 carbon atoms; a substituted or unsubstituted alkoxy group having 1 to 20 carbon atoms; a substituted or unsubstituted cycloalkyl group having 3 to 30 carbon atoms; or a substituted or unsubstituted aryl group having 6 to 30 carbon atoms.

In an exemplary embodiment of the present specification, A1 and A2 are the same as or different from each other, and are each independently a substituted or unsubstituted alkyl group having 1 to 20 carbon atoms; or a substituted or unsubstituted alkoxy group having 1 to 20 carbon atoms.

In another exemplary embodiment, A1 is a substituted or unsubstituted methyl group; a substituted or unsubstituted ethyl group; a substituted or unsubstituted propyl group; a substituted or unsubstituted butyl group; a substituted or unsubstituted pentyl group; or a substituted or unsubstituted hexyl group.

According to another exemplary embodiment, A1 is a methyl group; an ethyl group; a propyl group; a butyl group; an isobutyl group; a pentyl group; an isopentyl group; or a hexyl group.

According to still another exemplary embodiment, A2 is a substituted or unsubstituted methyl group; a substituted or unsubstituted methoxy group; or a substituted or unsubstituted ethoxy group.

In still another exemplary embodiment, A2 is a methyl group; a methoxy group; or an ethoxy group.

In an exemplary embodiment of the present specification, p1 is an integer from 0 to 2, and when p1 is 2, two A2's are the same as or different from each other.

In another exemplary embodiment, p1 is 0 or 1.

According to an exemplary embodiment of the present specification, Chemical Formula 2 may be represented by any one of the following structures, but is not limited thereto.

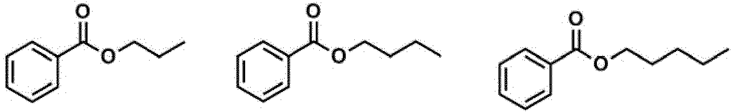

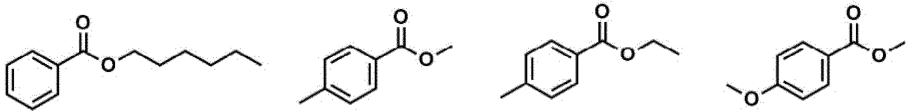

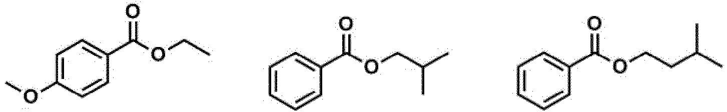

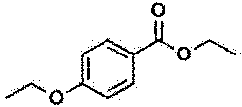

According to an exemplary embodiment of the present specification, Chemical Formula 2 may be represented by any one of the following structures, but is not limited thereto.

The ink composition of the present invention includes a second solvent represented by the following Chemical Formula 3.

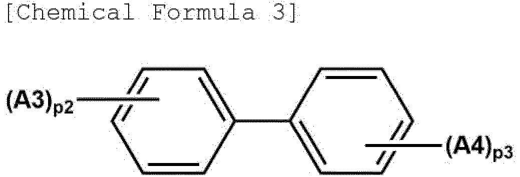

In Chemical Formula 3,
A3 and A4 are the same as or different from each other, and each independently a substituted or unsubstituted alkyl group; a substituted or unsubstituted alkoxy group; a substituted or unsubstituted cycloalkyl group; or a substituted or unsubstituted aryl group, and
p2 and p3 are each an integer from 0 to 5, and when p2 and p3 are 2 or higher, two or more substituents in the parenthesis are the same as or different from each other.

According to an exemplary embodiment of the present specification, A3 and A4 are the same as or different from each other, and are each independently a substituted or unsubstituted alkyl group having 1 to 20 carbon atoms; a substituted or unsubstituted alkoxy group having 1 to 20 carbon atoms; a substituted or unsubstituted cycloalkyl group having 3 to 30 carbon atoms; or a substituted or unsubstituted aryl group having 6 to 30 carbon atoms.

In an exemplary embodiment of the present specification, A3 and A4 are the same as or different from each other, and are each independently a substituted or unsubstituted alkyl group having 1 to 20 carbon atoms; or a substituted or unsubstituted alkoxy group having 1 to 20 carbon atoms.

According to another exemplary embodiment, A3 and A4 are the same as or different from each other, and are each independently an alkyl group having 1 to 20 carbon atoms, which is unsubstituted or substituted with an alkoxy group having 1 to 20 carbon atoms; or a substituted or unsubstituted alkoxy group having 1 to 20 carbon atoms.

According to an exemplary embodiment of the present specification, one or more of p2 and p3 are an integer of 1 or higher.

According to an exemplary embodiment of the present specification, Chemical Formula 3 may be represented by any one of the following structures, but is not limited thereto.

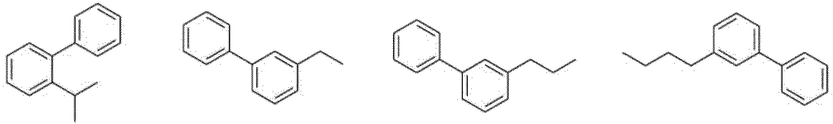

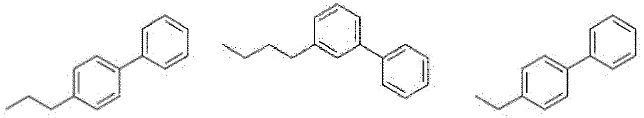

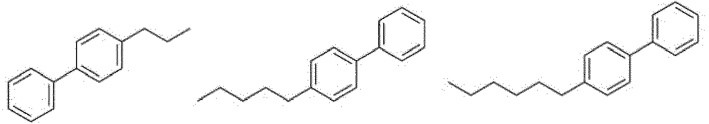

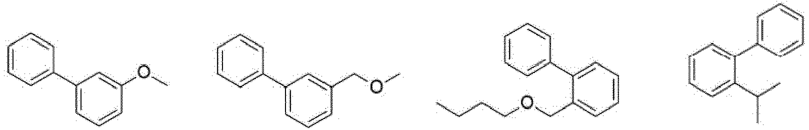

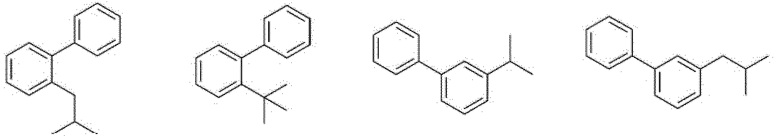

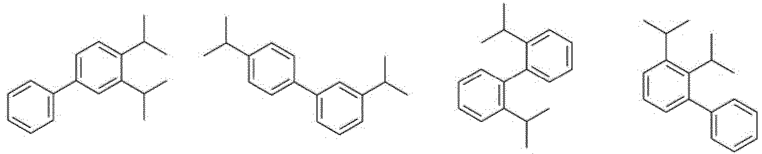

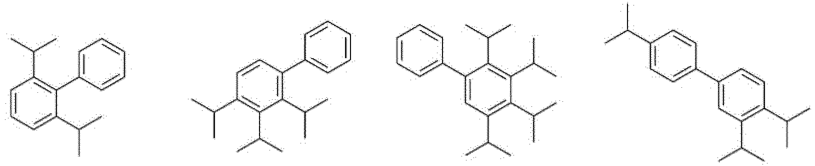

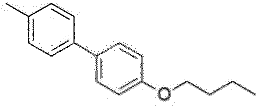

According to an exemplary embodiment of the present specification, one or two or more second solvents may be included in the ink composition.

In another exemplary embodiment, the ink composition includes one or two second solvent(s).

In still another exemplary embodiment, the ink composition includes one second solvent.

In yet another exemplary embodiment, the ink composition includes two second solvents.

In an exemplary embodiment of the present specification, the second solvent is one or more selected from the group consisting of 4-butylbiphenyl, 3-ethylbiphenyl, 3,4,4'-triisopropyl-1,1'-biphenyl, 2-ethyl-2'-isopropyl-1,1'-biphenyl, 3,4'-diisopropylbiphenyl and 4-isopropylbiphenyl.

The first solvent and second solvent of the present specification have different boiling points. The ink composition of the present specification simultaneously includes a first solvent with a low boiling point and a second solvent with a high boiling point. Since the first solvent and the second solvent have different boiling points, there is a difference in drying speed. Specifically, a flat film may be formed while the first solvent with a low boiling point is first dried (evaporated) and the remaining second solvent is dried. According to an exemplary embodiment of the present specification, the first solvent has a boiling point of 180°C to 270°C.

According to an exemplary embodiment of the present specification, the second solvent has a boiling point of 240°C to 350°C.

In an exemplary embodiment of the present specification, the first solvent and the second solvent are included at a weight ratio of 95 . 5 to 50 . 50 (the weight of the first solvent : the weight of the second solvent).

According to another exemplary embodiment, when one of the first solvent and two of the second solvent are included, the mixing weight ratio of the first second solvent and the second second solvent may be 95 . 5 to 50 : 50.

According to an exemplary embodiment of the present specification, the ink composition further includes an additional compound. When a thin film is formed using the ink composition of the present specification, the compound represented by Chemical Formula 1 and the additional compound may act as a host and a dopant, respectively.

According to an exemplary embodiment of the present specification, the compound represented by Chemical Formula 1 is included in the ink composition in an amount of 0.1 parts by weight to 10 parts by weight based on 100 (based on a solid content).

In an exemplary embodiment of the present specification, the compound represented by Chemical Formula 1 and the additional compound are included in an amount of 0.1 parts by weight to 10 parts by weight based on 100 parts by weight of the ink composition (based on the solid content).

In an exemplary embodiment of the present specification, the ink composition may further include an additional compound which is a dopant, and the dopant (additional compound) is represented by the following Chemical Formula A or B.

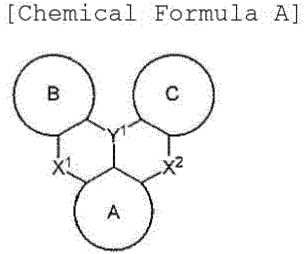

In Chemical Formula A,
Ring A, Ring B and Ring C are each independently a substituted or unsubstituted hydrocarbon ring or a substituted or unsubstituted hetero ring,
Y¹ is B, P, P=O, P=S, Al, Ga, As, Si-R or Ge-R,
X¹ and X² are each independently O, N-R, C-R₂, S or Se,
R is hydrogen; a substituted or unsubstituted alkyl group; a substituted or unsubstituted cycloalkyl group; or a substituted or unsubstituted aryl group, and
the substituent of Chemical Formula A may be bonded to an adjacent substituent or adjacent Ring A, Ring B or Ring C to form a ring.

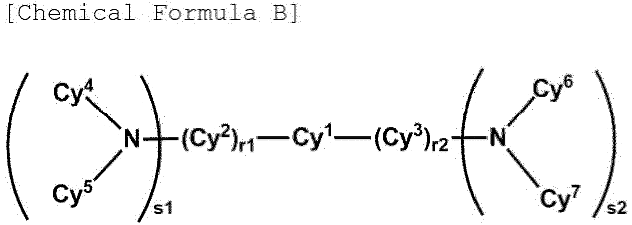

In Chemical Formula B,
Cy¹ is a substituted or unsubstituted divalent hexacyclic or more fused aromatic ring group; or a substituted or unsubstituted divalent hexacyclic or more fused aromatic heterocyclic group;
Cy² and Cy³ are the same as or different from each other, and are each independently a substituted or unsubstituted arylene group; or a substituted or unsubstituted heteroarylene group,
Cy⁴ to Cy⁷ are the same as or different from each other, and are each independently a substituted or unsubstituted aryl group; or a substituted or unsubstituted heteroaryl group, or are bonded to an adjacent substituent to form a substituted or unsubstituted ring,
r1 and r2 are each 0 or 1,
s1 and s2 are each 0 or 1, and
r1+r2+s1+s2 is 1 or higher.

According to an exemplary embodiment of the present specification, Chemical Formula A is represented by the following Chemical Formula A-1.

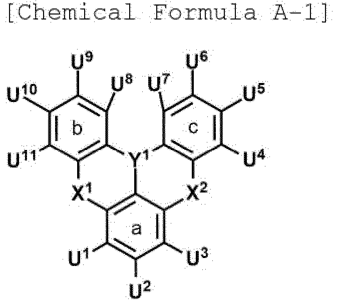

In Chemical Formula A-1,
the definitions of Y¹, X¹ and X² are the same as the definitions in Chemical Formula A,
in Ring a, Ring b and Ring c, any -C(-R)= (here, R is U¹ to U¹¹ in Chemical Formula A-1) may be substituted with -N=, any -C(-R)=C(-R)- (here, R is U¹ to U¹¹ in Chemical Formula A-1) may be substituted with -N(-R)-, -O- or -S-, and R of -N(-R)- is a substituted or unsubstituted alkyl group; a substituted or unsubstituted aryl group; or a substituted or unsubstituted cycloalkyl group, and
U¹ to U¹¹ are each independently hydrogen; a substituted or unsubstituted aryl group; a substituted or unsubstituted heteroaryl group; a substituted or unsubstituted amino group; a substituted or unsubstituted boryl group; a substituted or unsubstituted alkyl group; a substituted or unsubstituted cycloalkyl group; a substituted or unsubstituted alkoxy group; a substituted or unsubstituted aryloxy group; or a substituted or unsubstituted silyl group, and adjacent groups in U¹ to U¹¹ may be bonded to each other to form a substituted or unsubstituted aromatic hydrocarbon ring or a substituted or unsubstituted aromatic hetero ring with Ring a, Ring b or Ring c.

According to an exemplary embodiment of the present specification, Chemical Formula A may be any one of the following structures, but is not limited thereto. In the following structures, Me represents a methyl group, D represents deuterium, Et represents an ethyl group, iPr represents an isopropyl group, tBu represents a tert-butyl group, tAm represents a tert-amyl group, Ph represents a phenyl group, F represents fluorine, CN represents a cyano group, TMS represents a trimethylsilyl group and TPhS represents a triphenylsilyl group, and in Formula (1-1001) to Formula (1-1265), the notation of the methyl group (Me) in the structural formulae is omitted.

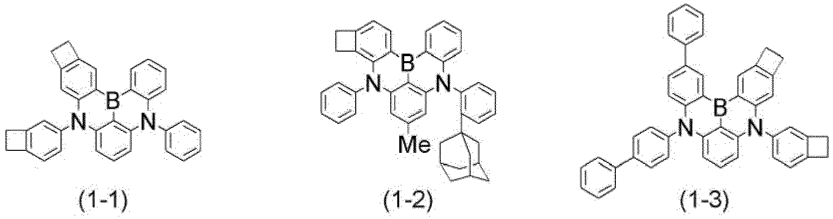

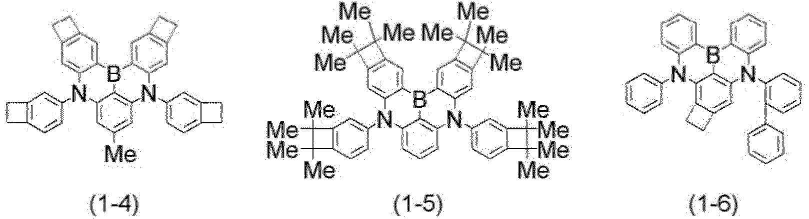

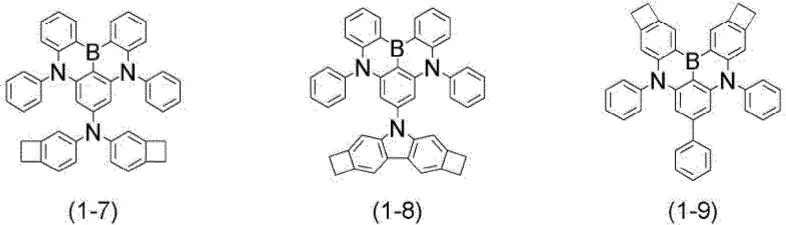

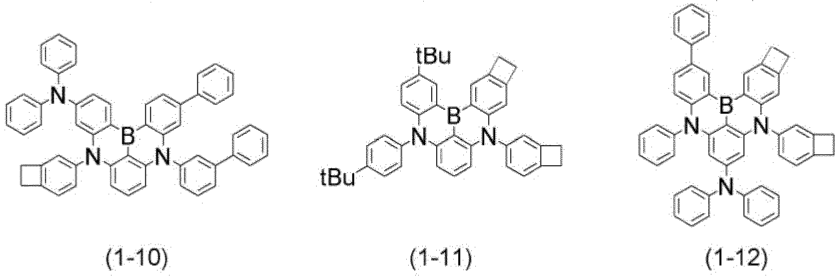

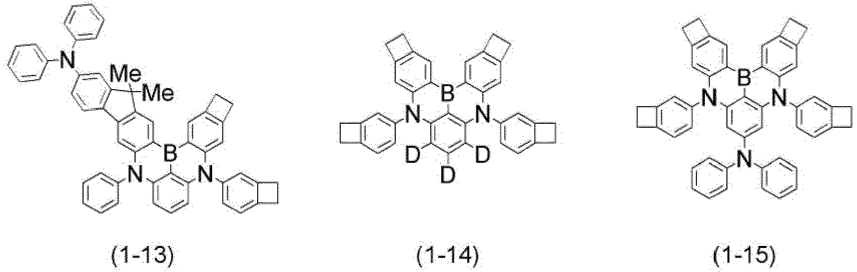

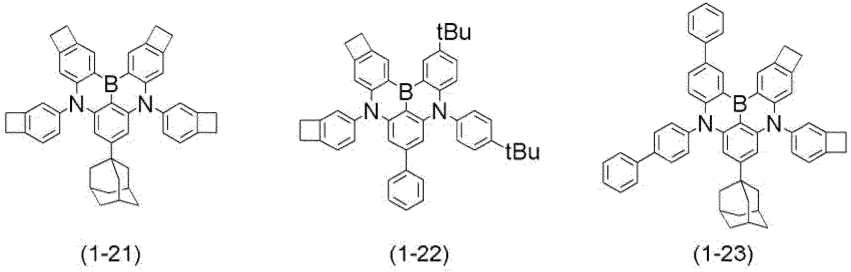

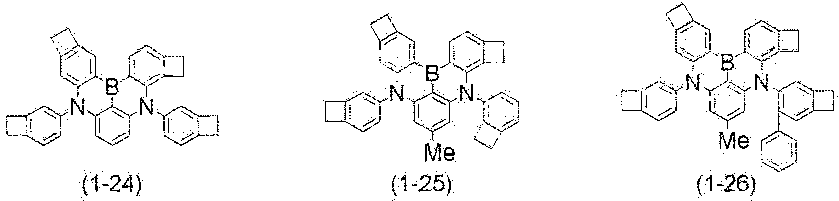

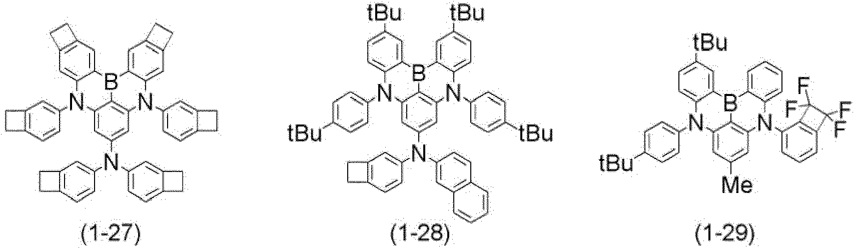

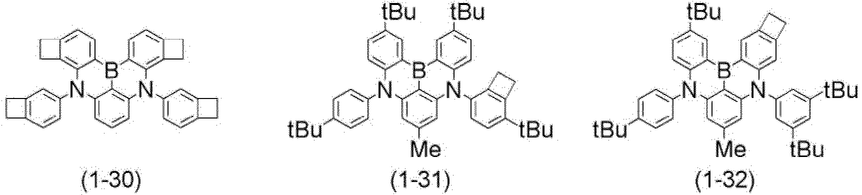

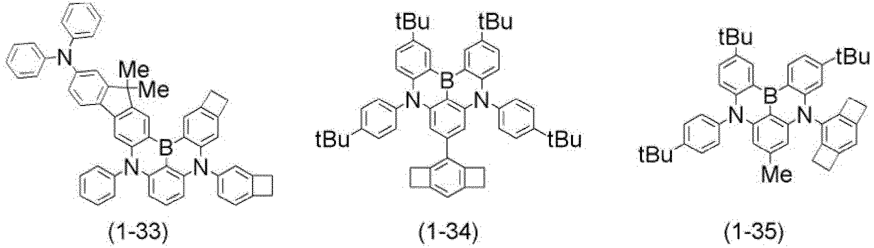

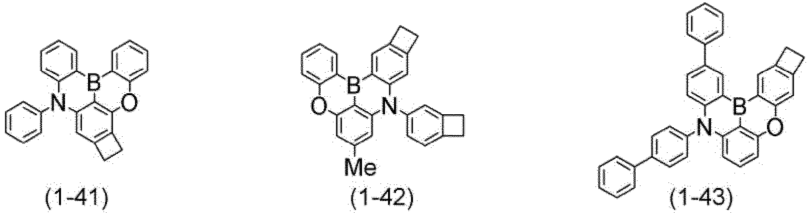

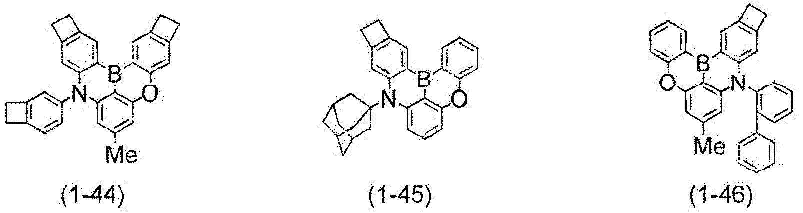

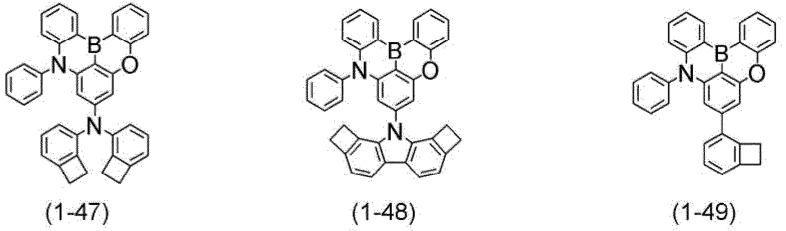

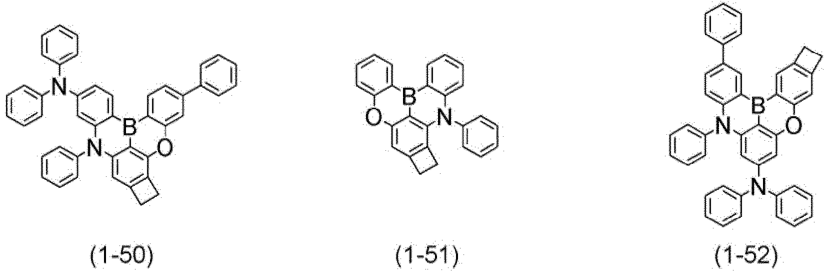

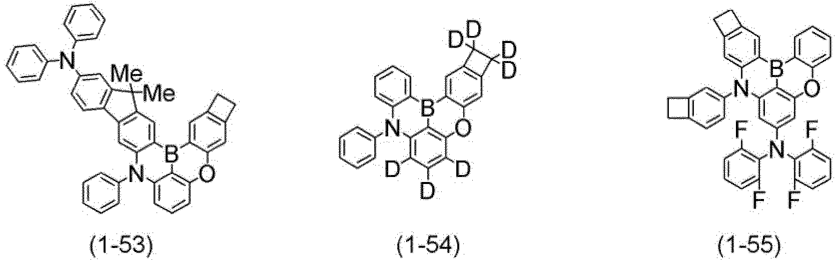

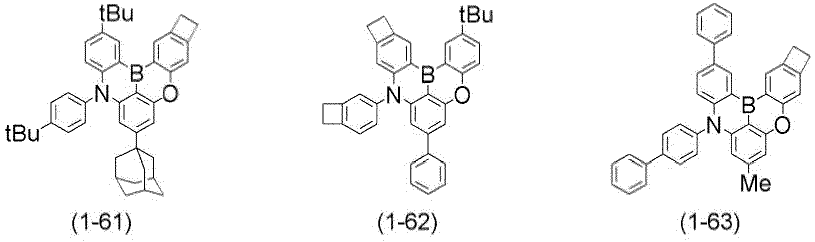

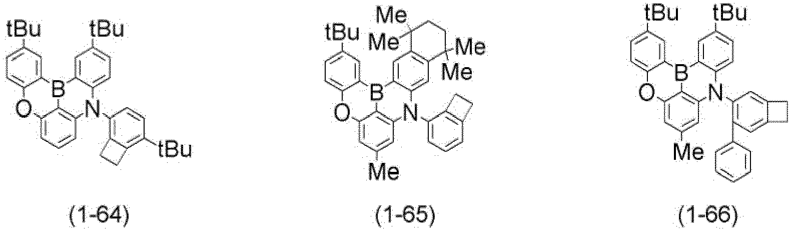

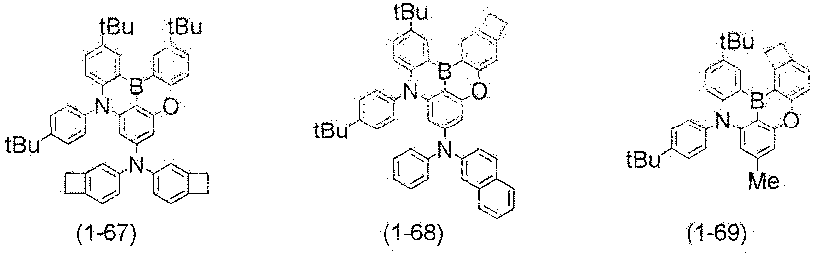

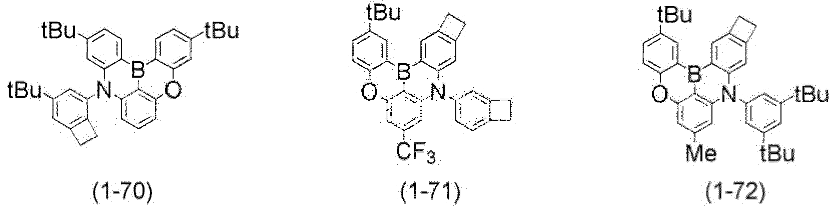

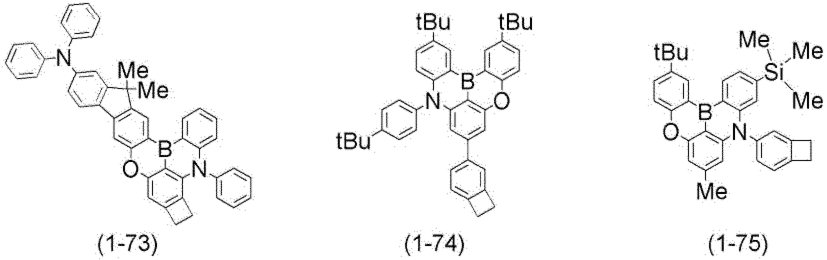

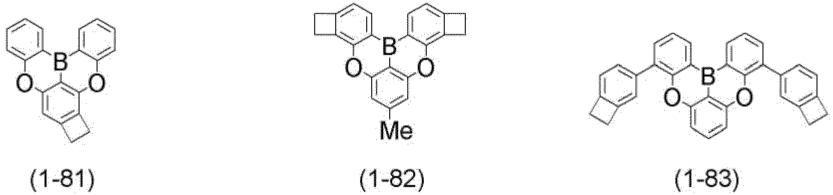

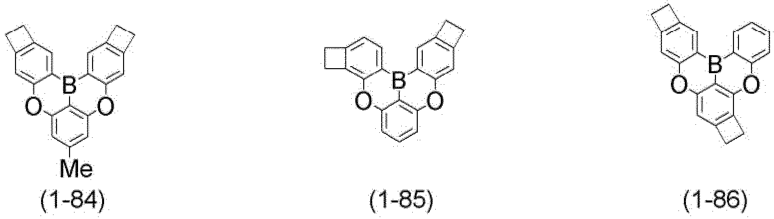

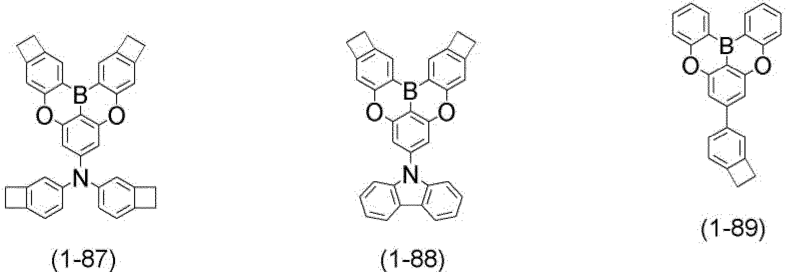

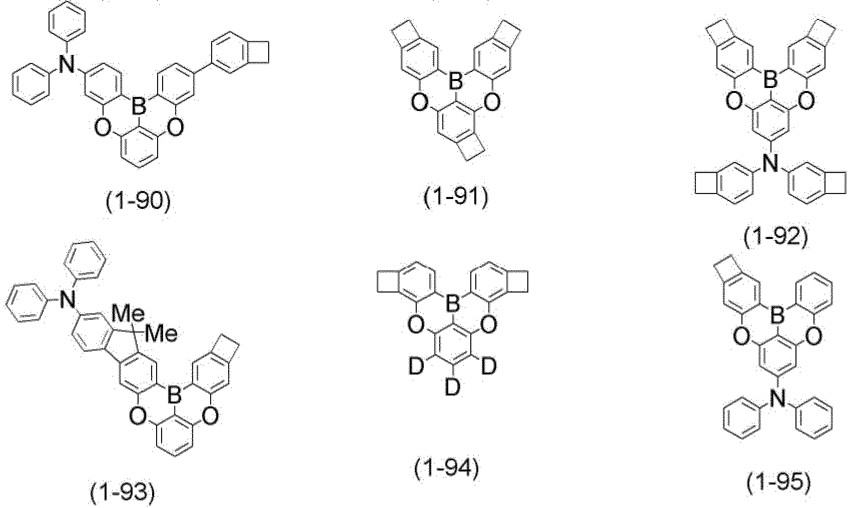

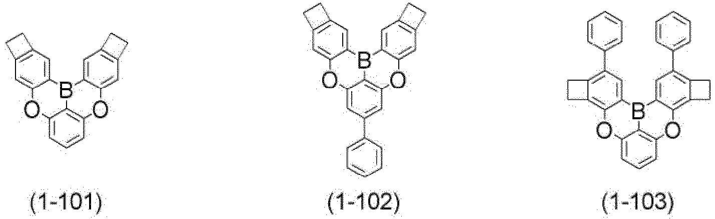

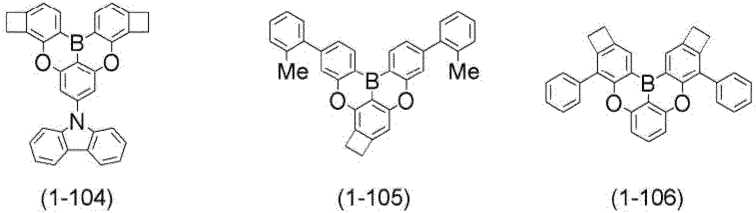

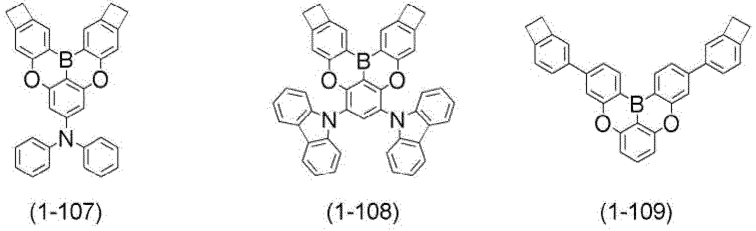

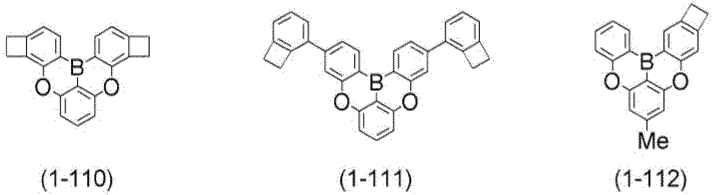

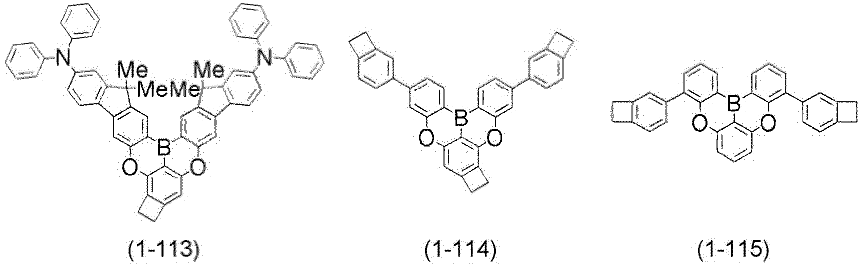

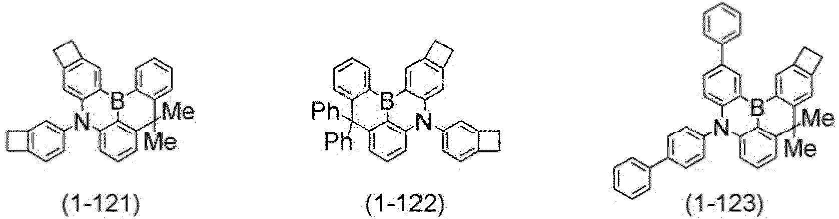

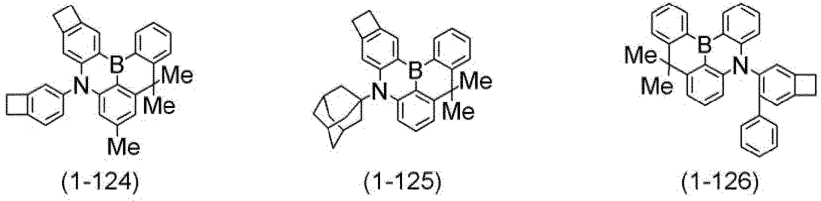

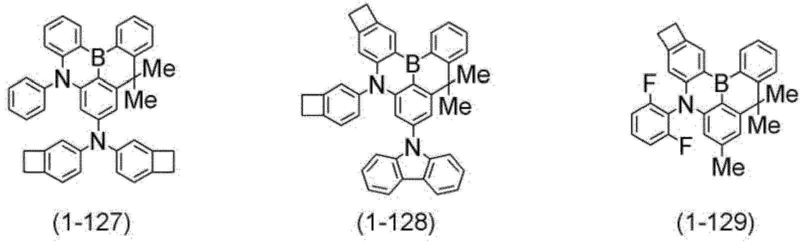

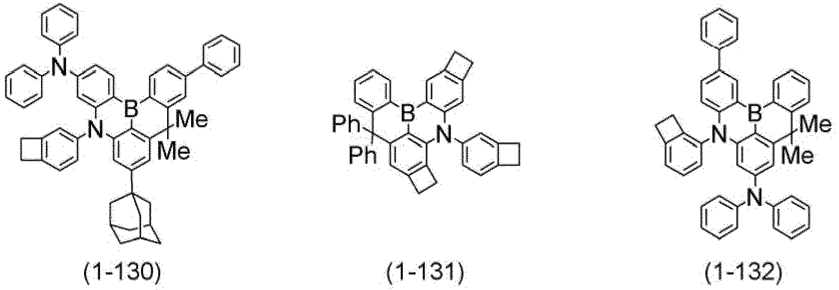

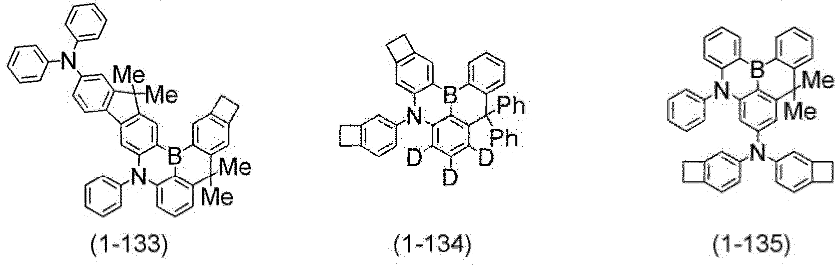

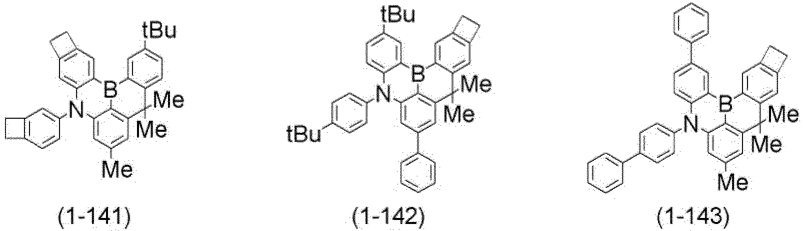

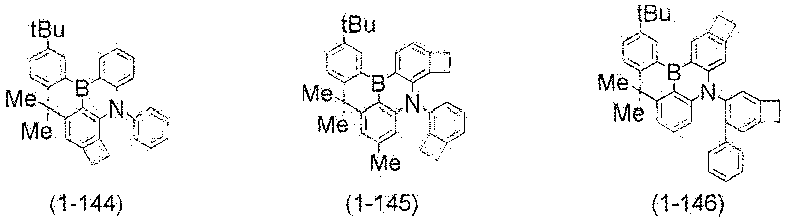

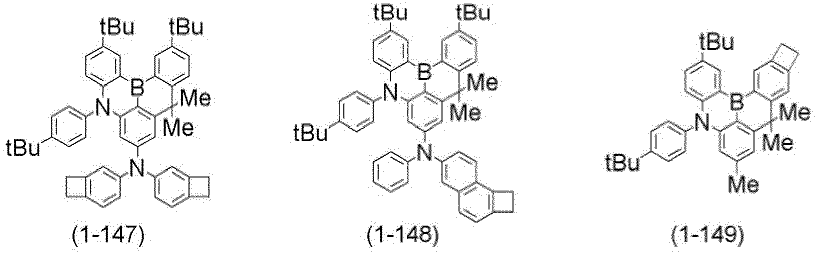

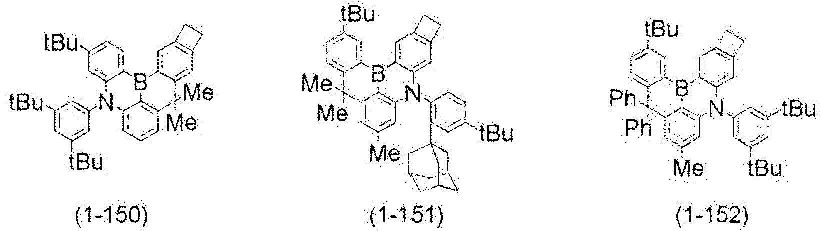

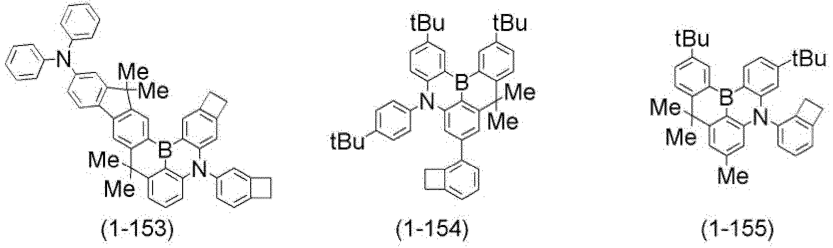

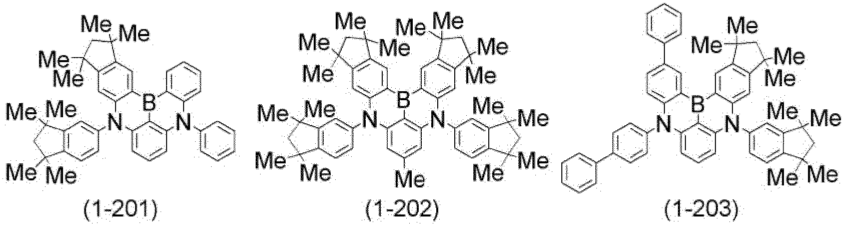

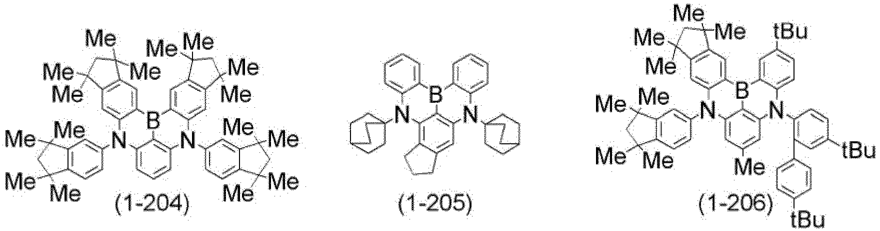

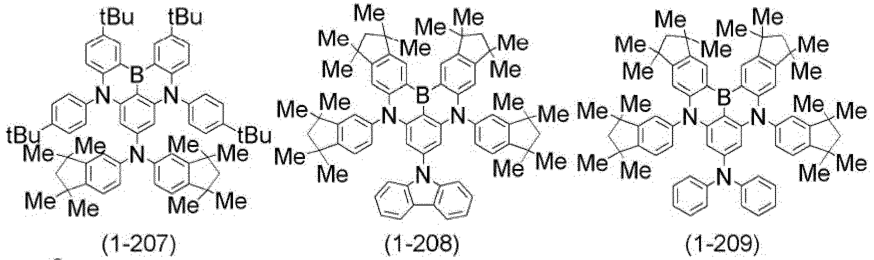

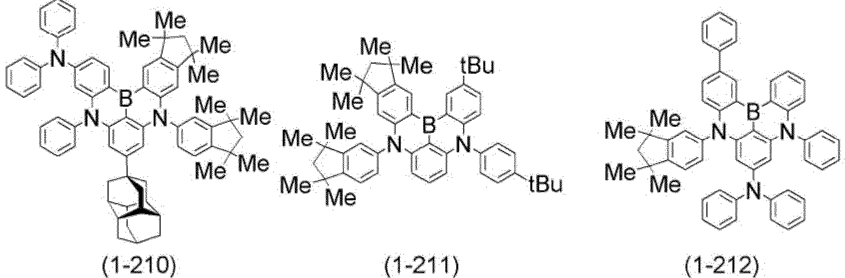

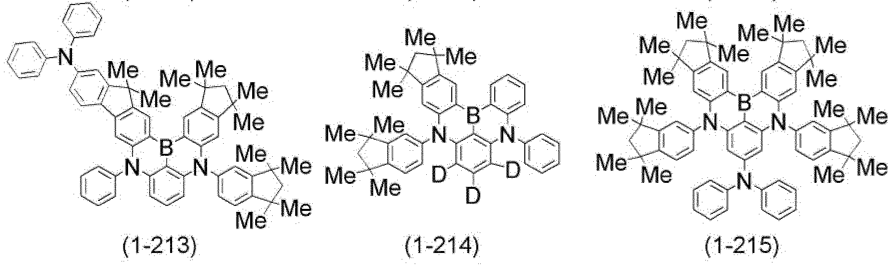

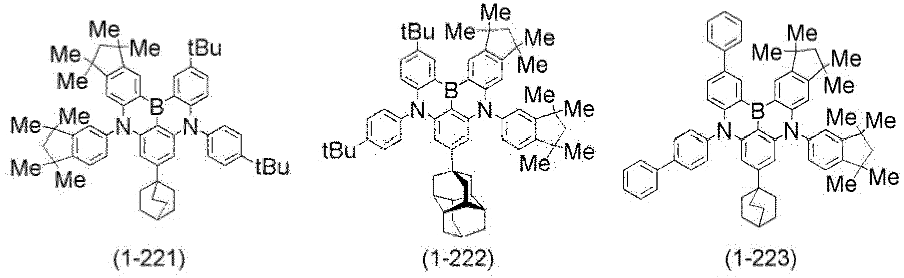

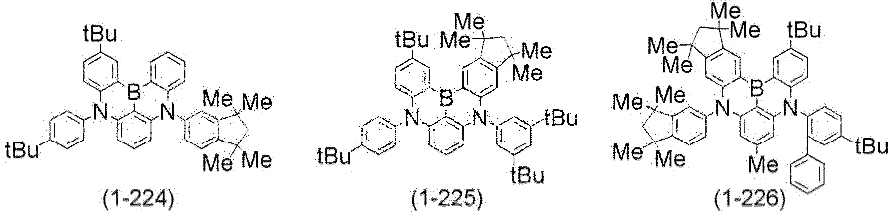

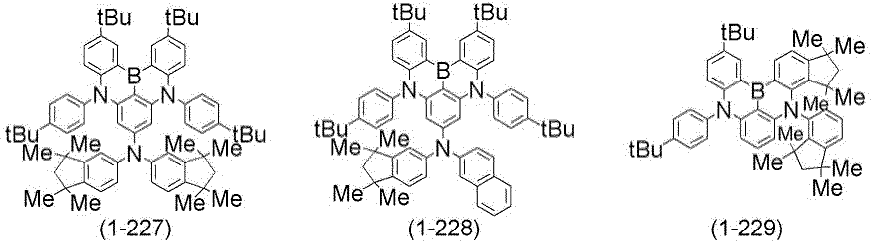

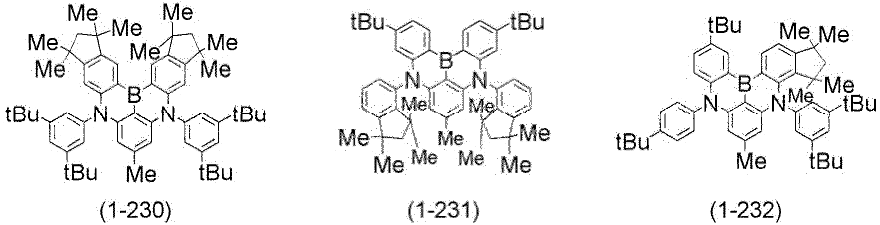

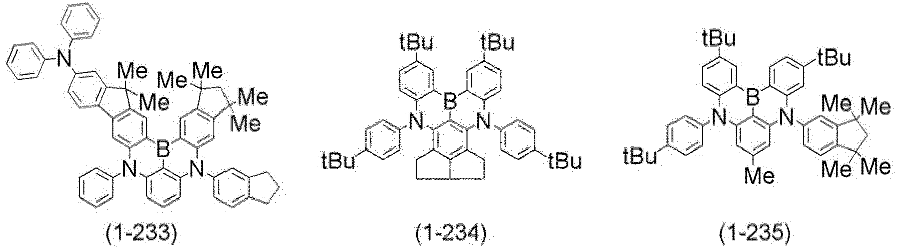

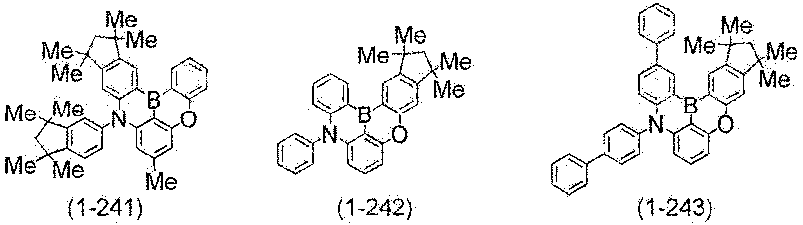

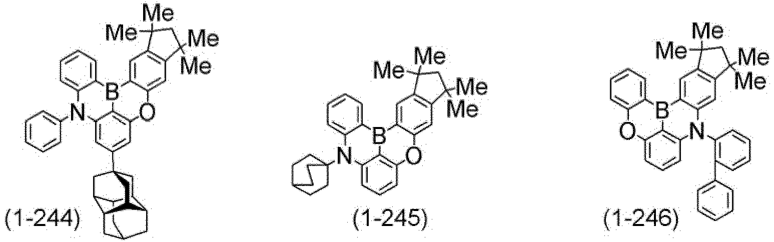

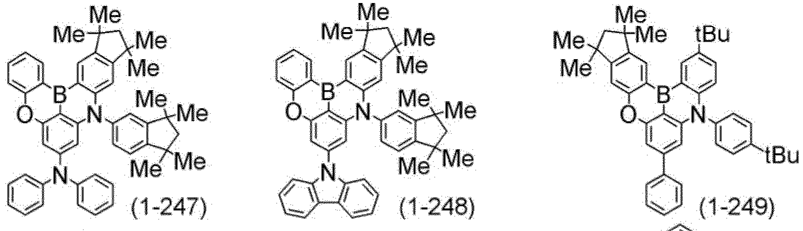

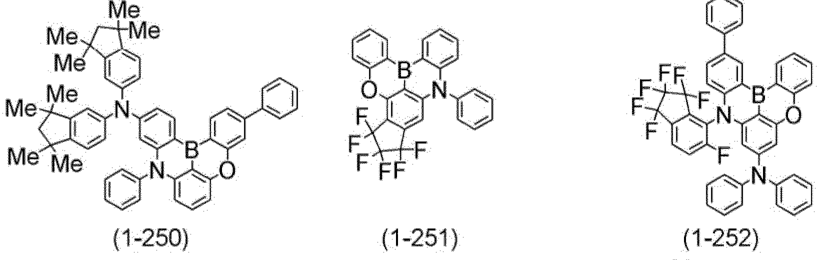

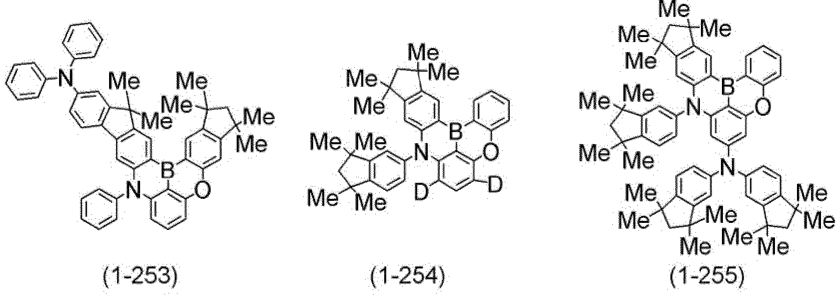

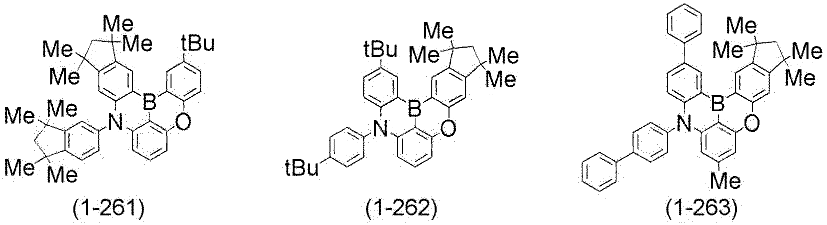

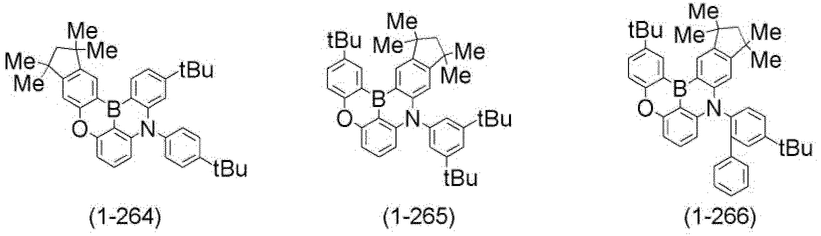

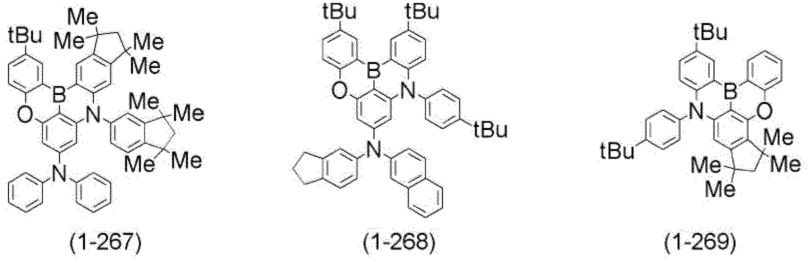

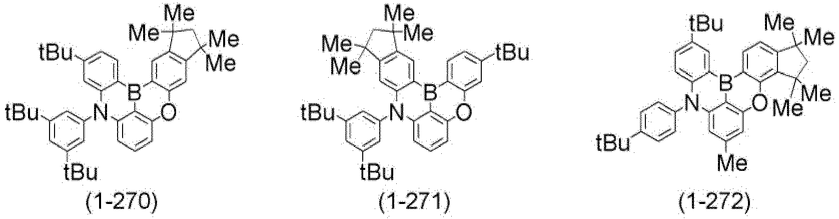

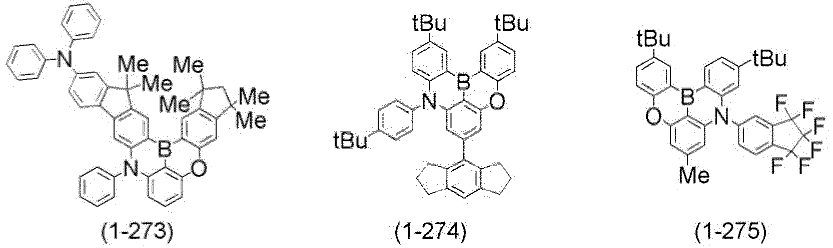

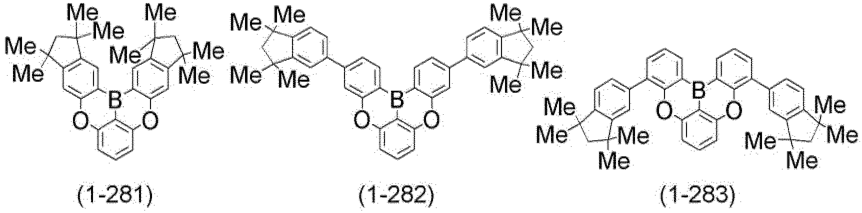

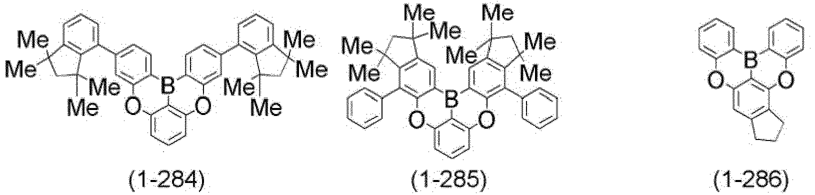

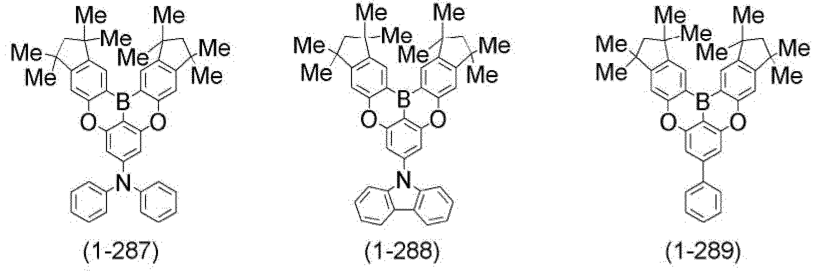

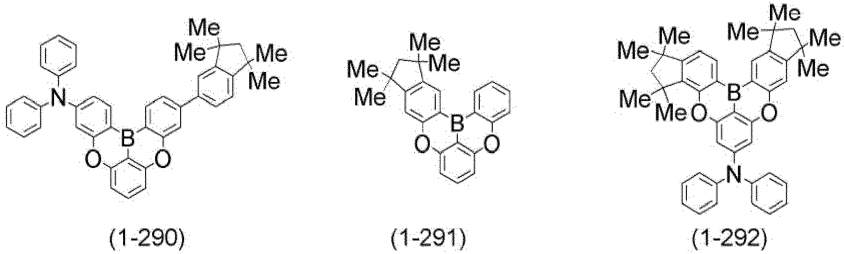

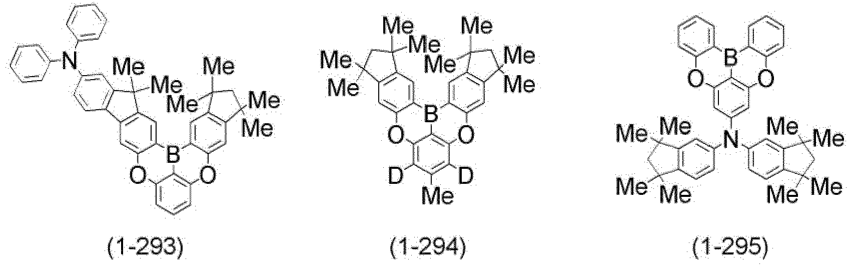

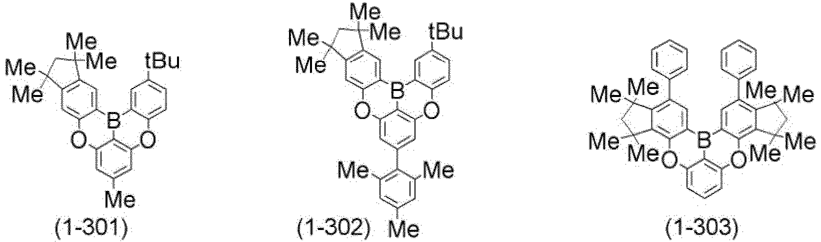

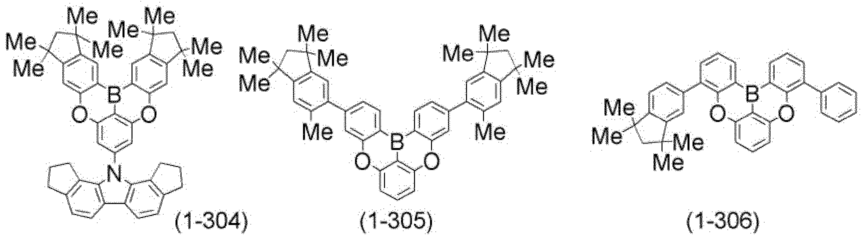

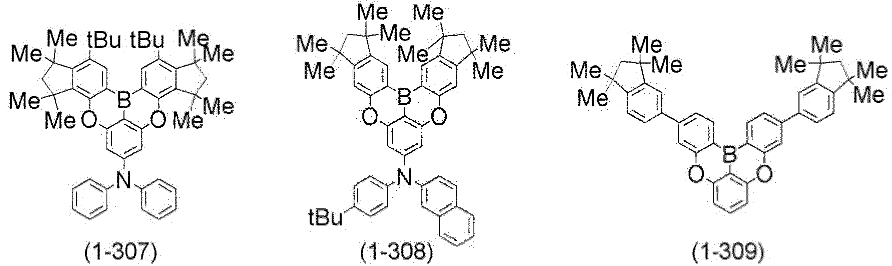

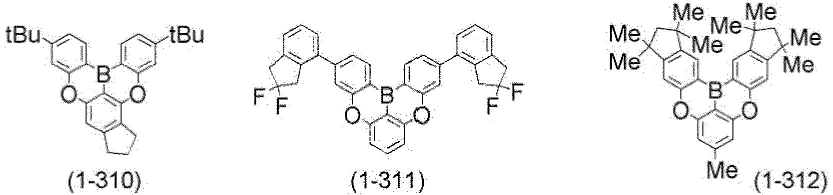

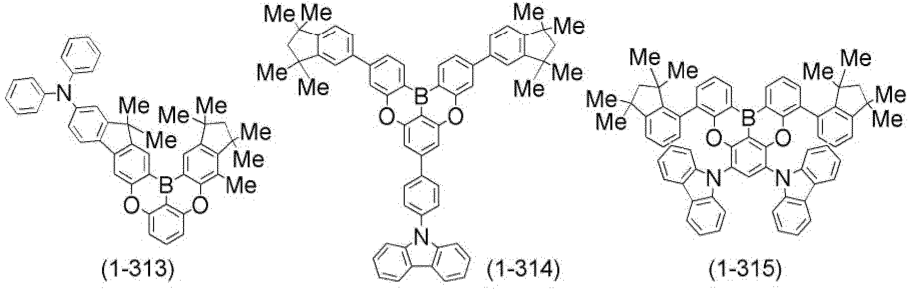

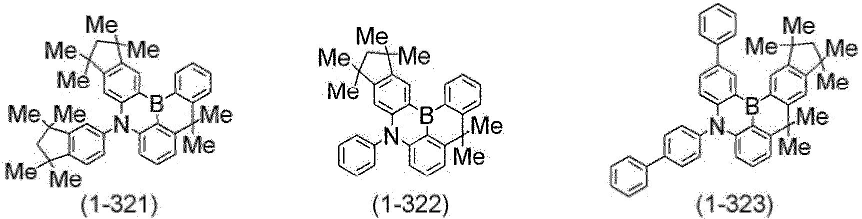

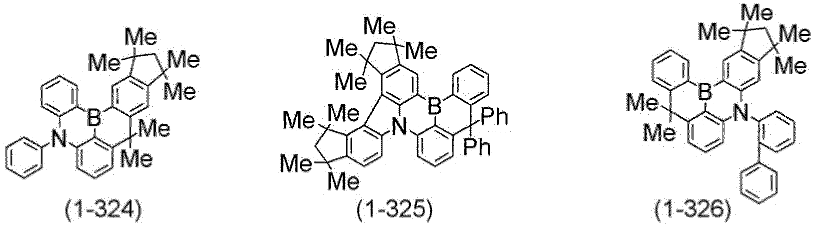

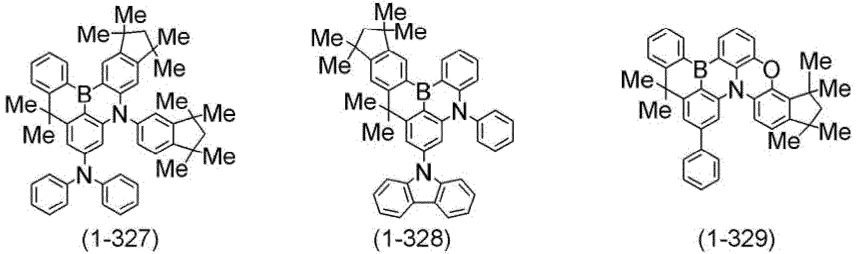

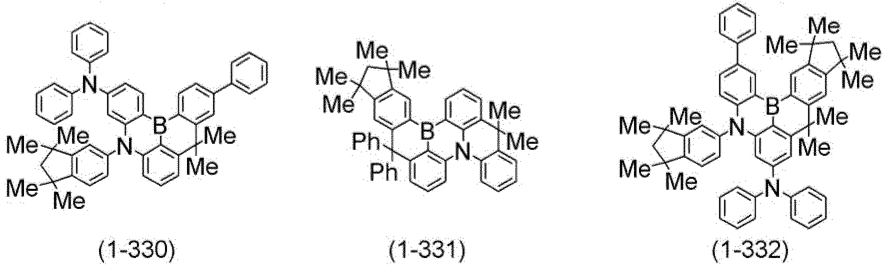

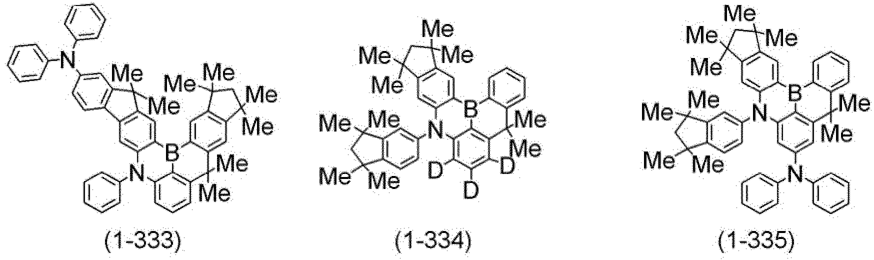

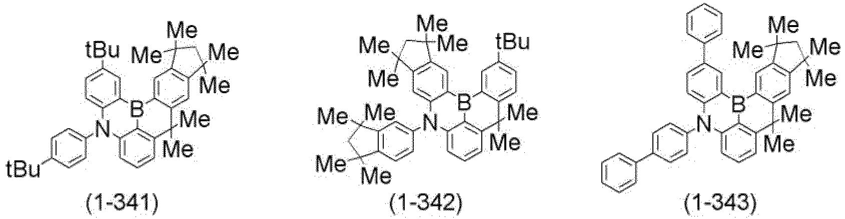

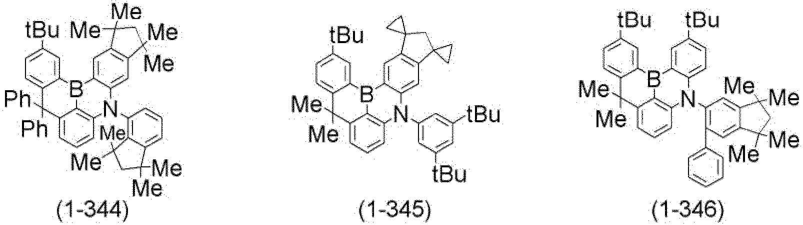

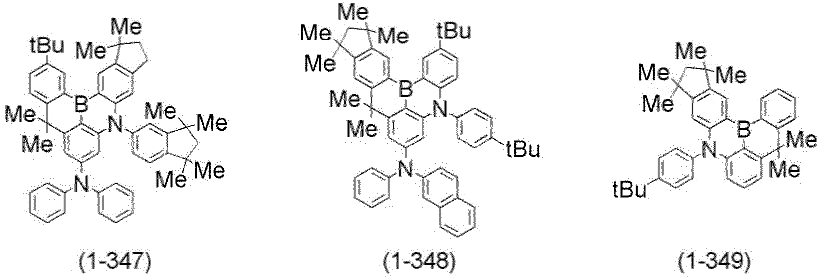

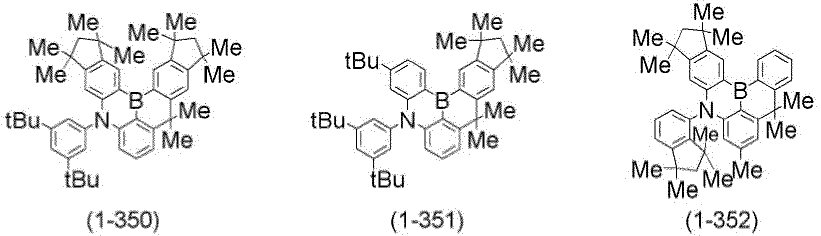

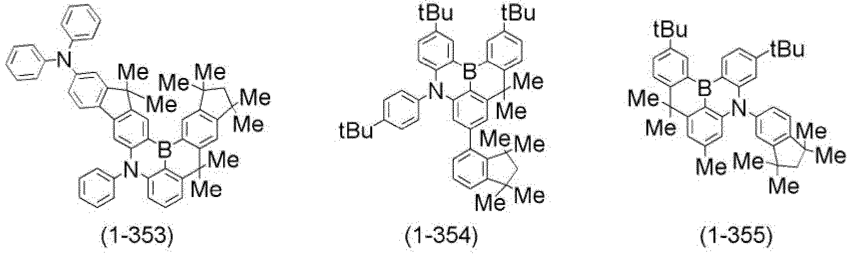

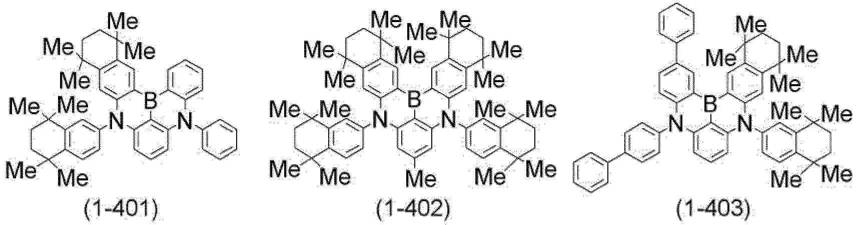

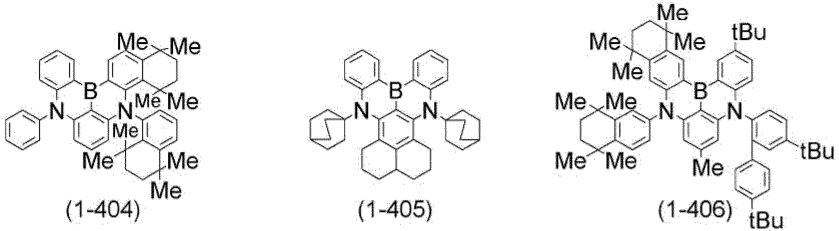

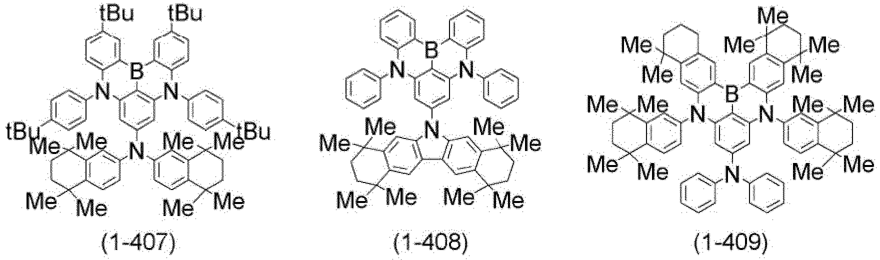

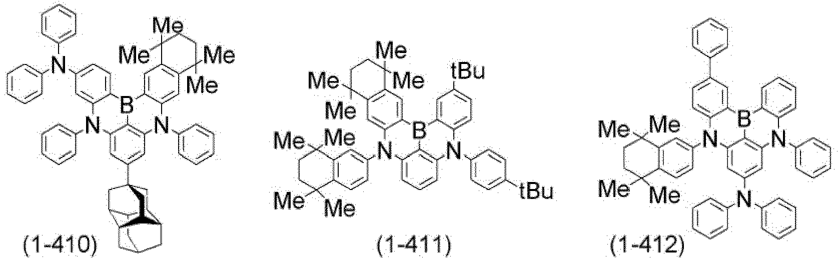

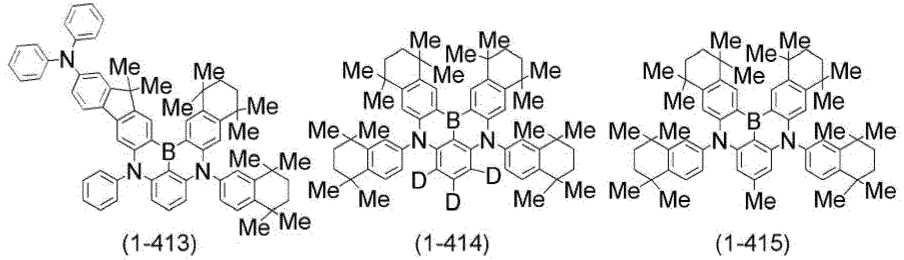

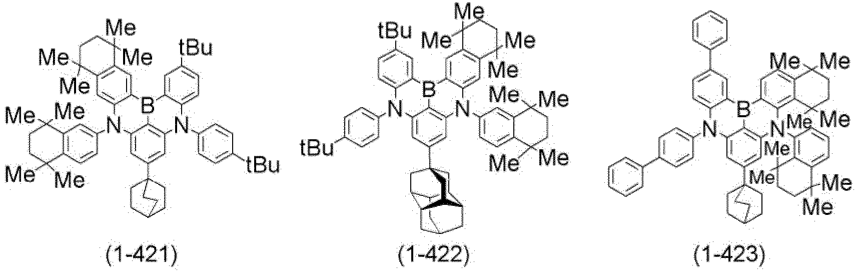

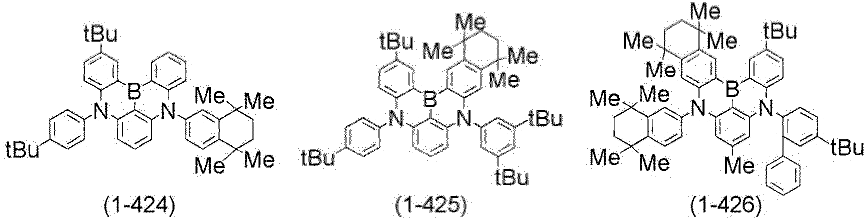

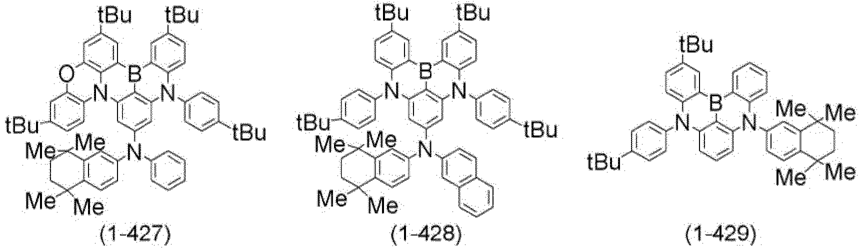

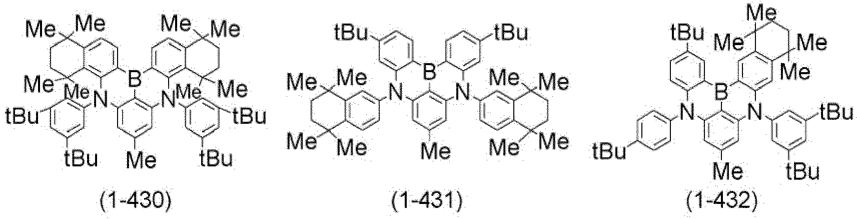

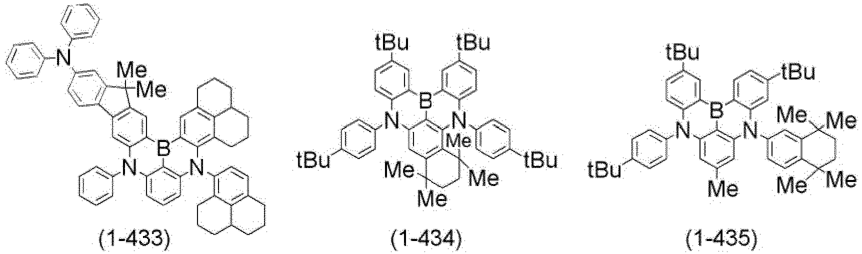

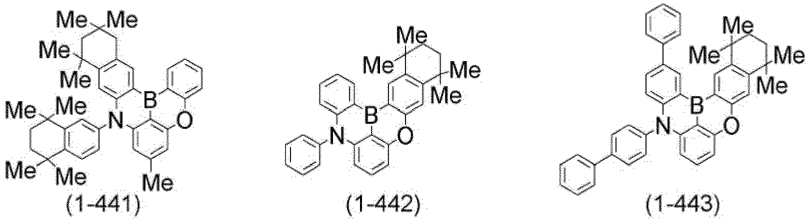

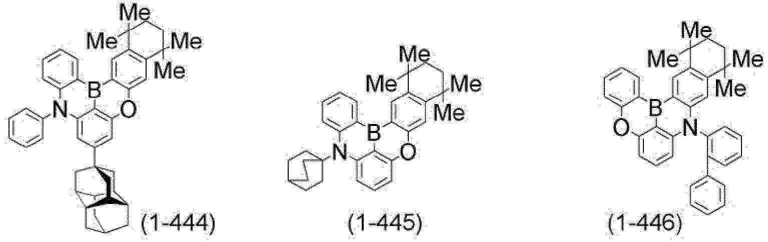

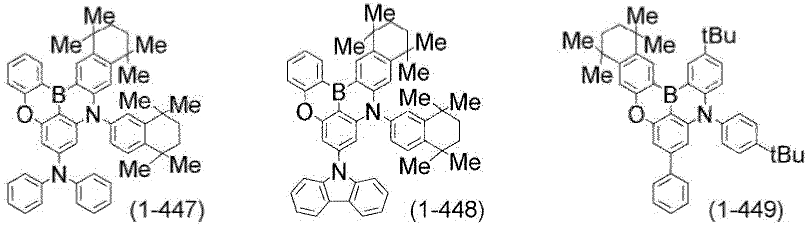

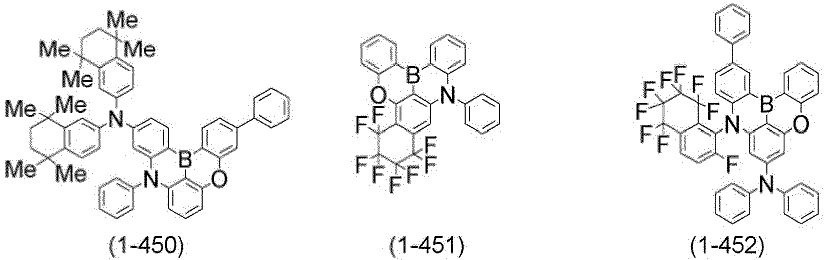

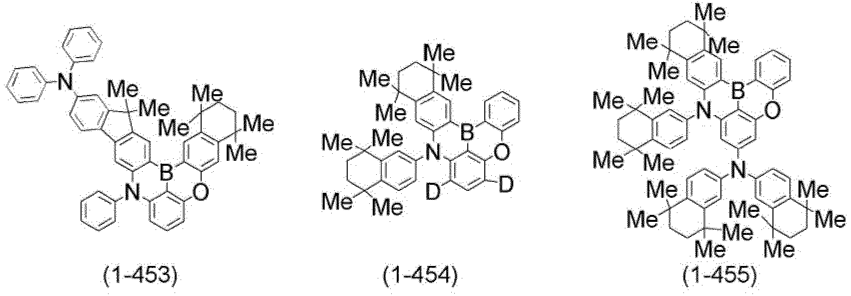

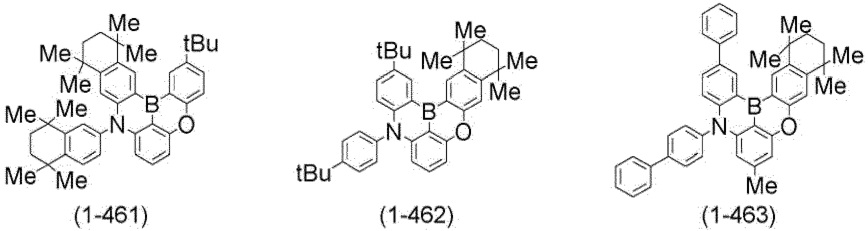

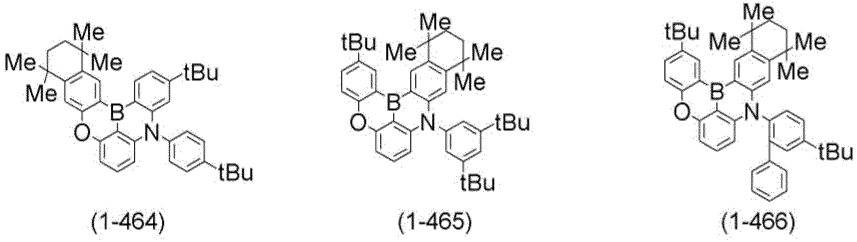

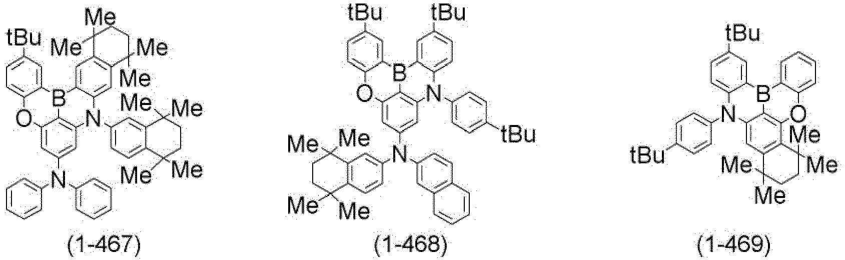

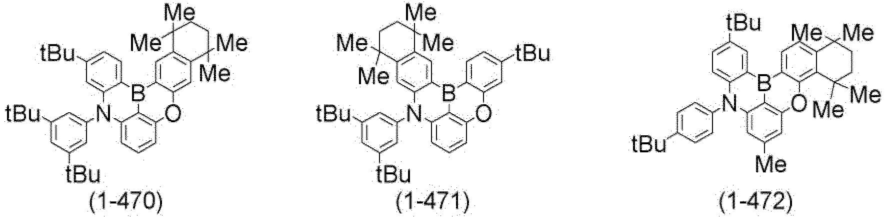

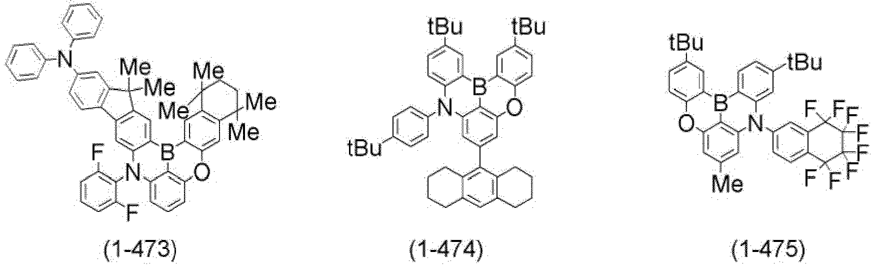

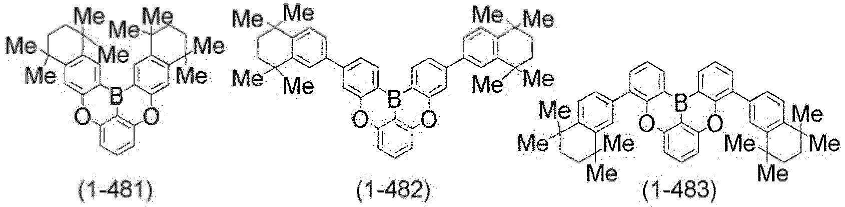

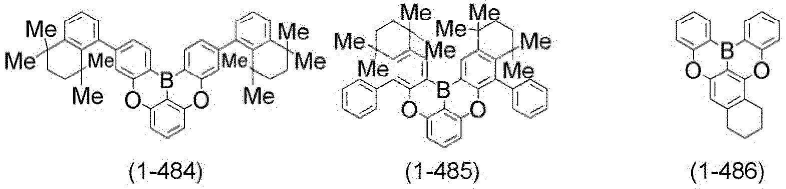

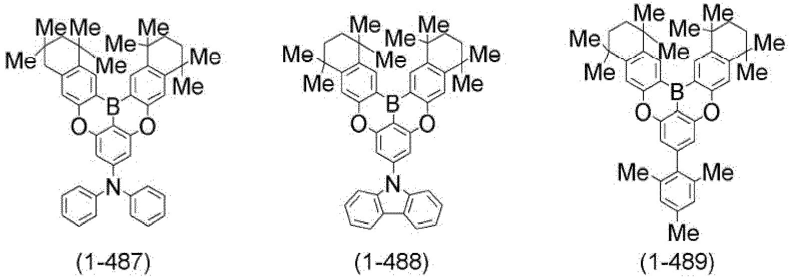

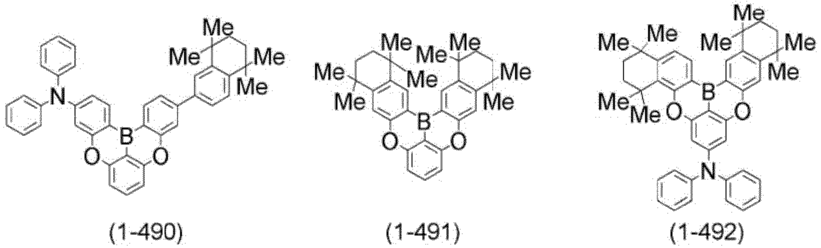

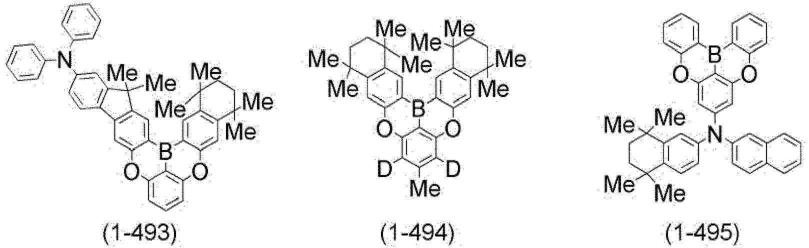

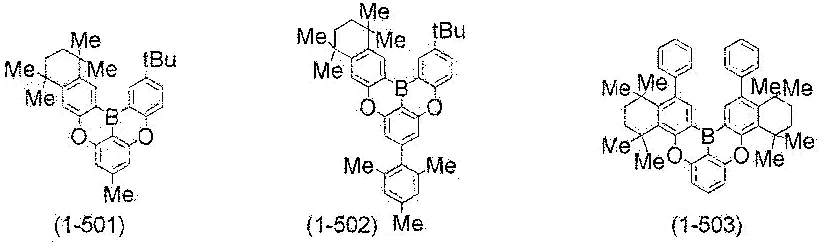

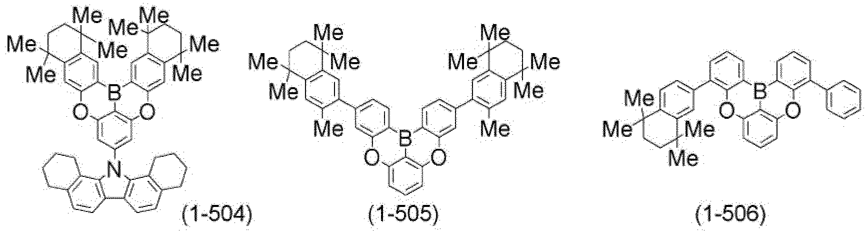

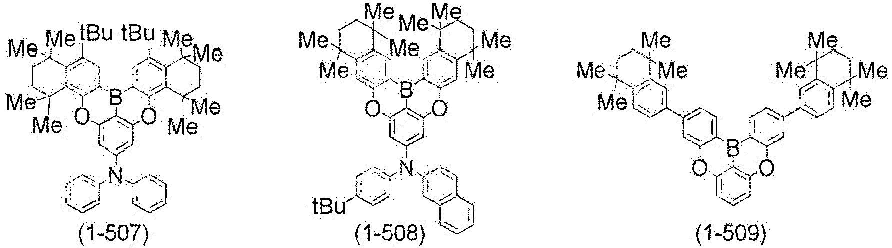

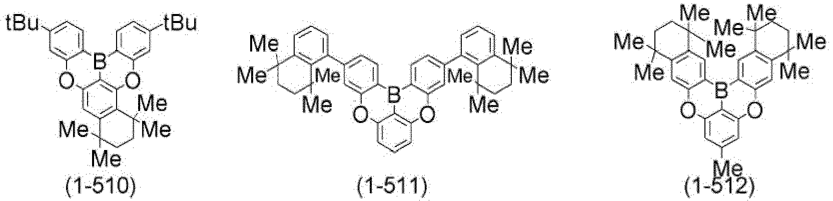

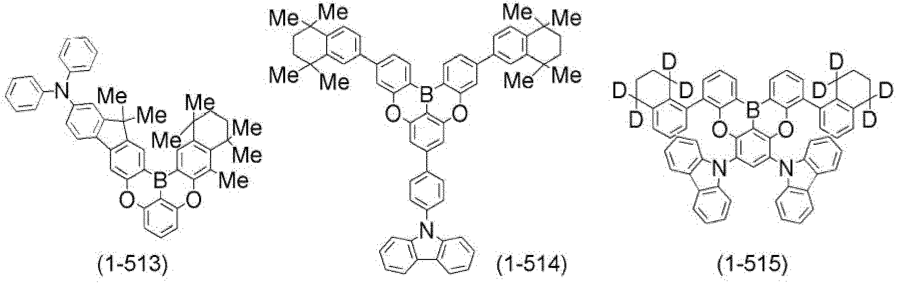

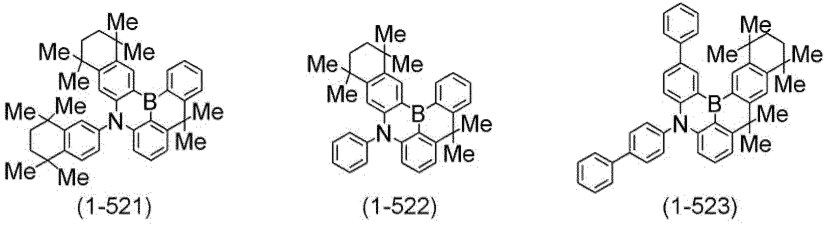

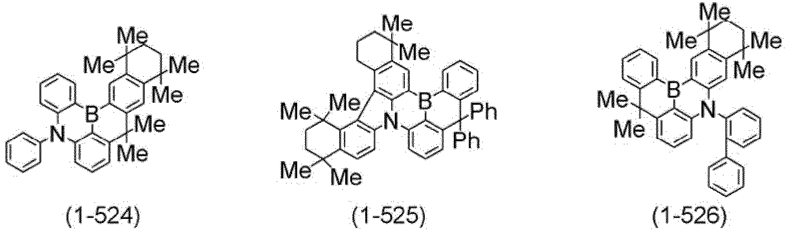

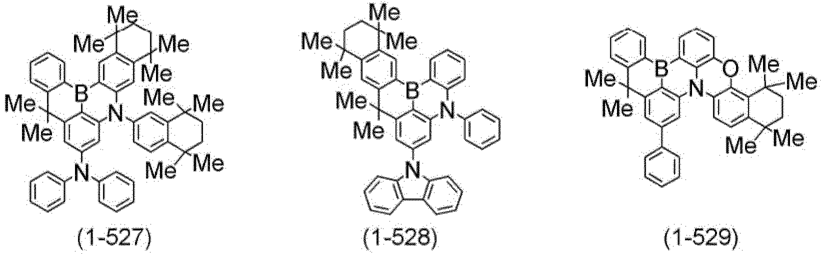

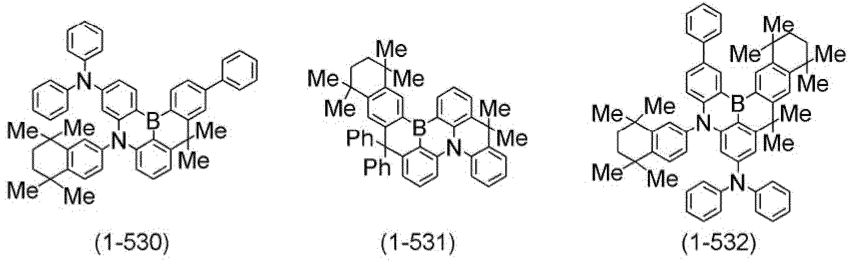

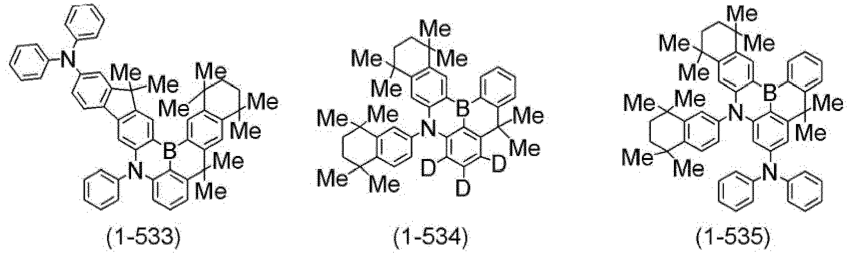

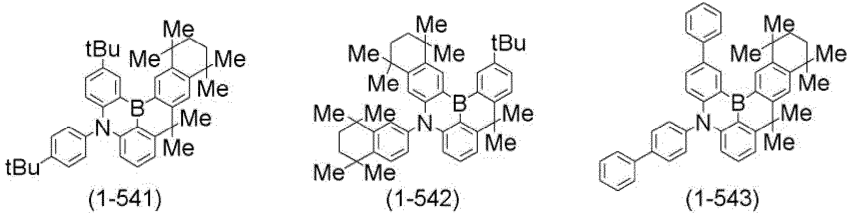

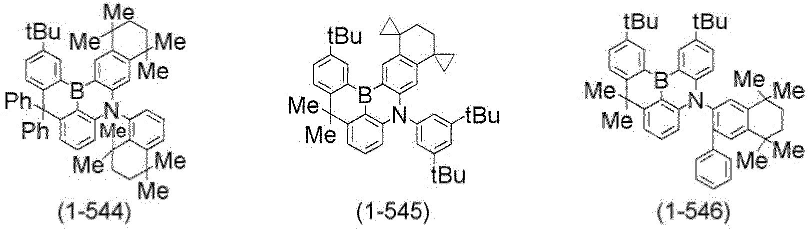

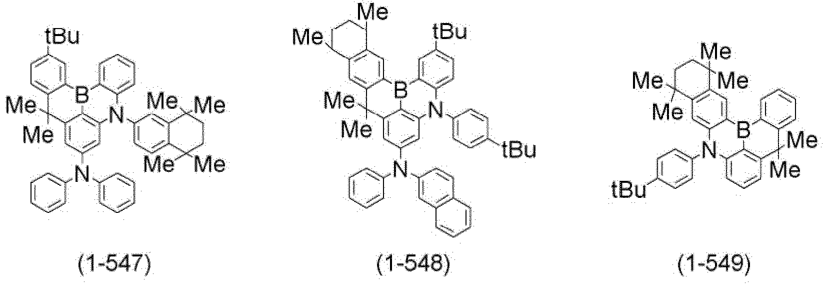

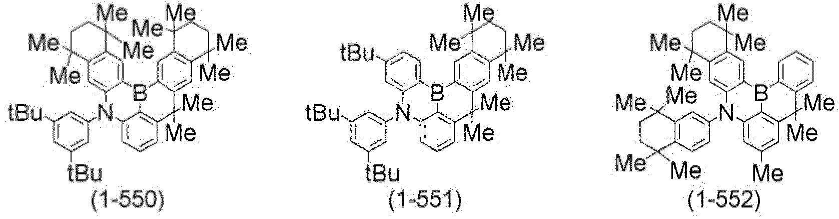

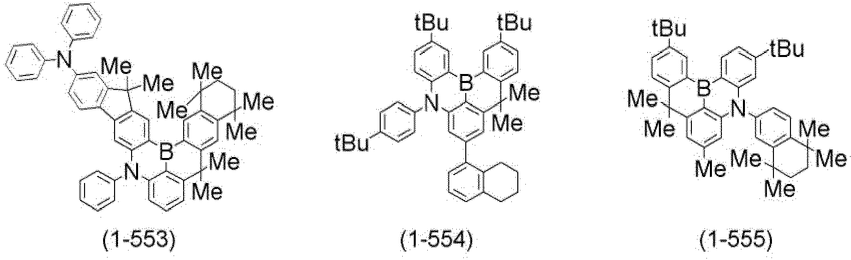

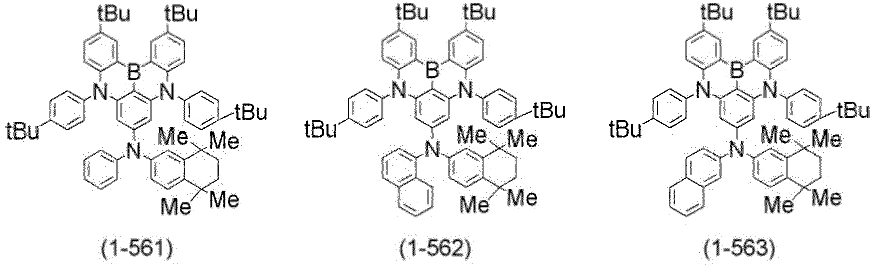

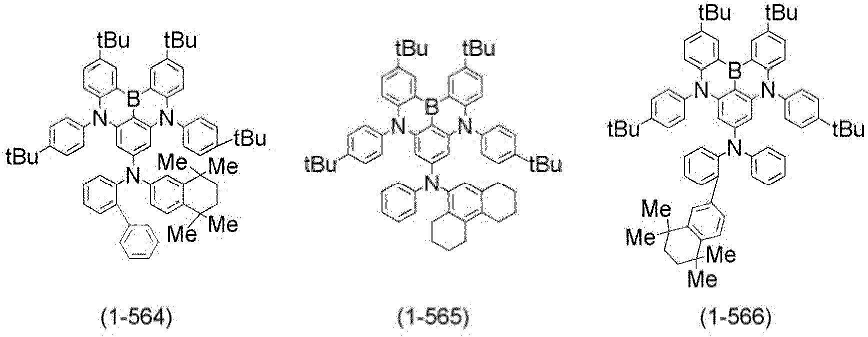

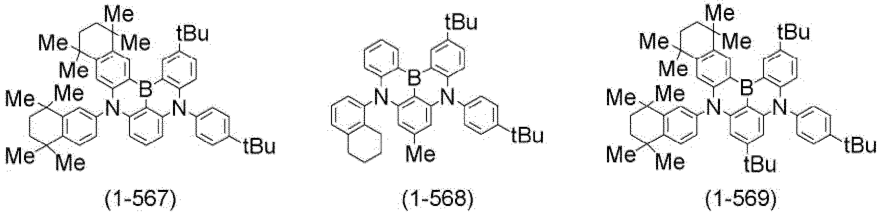

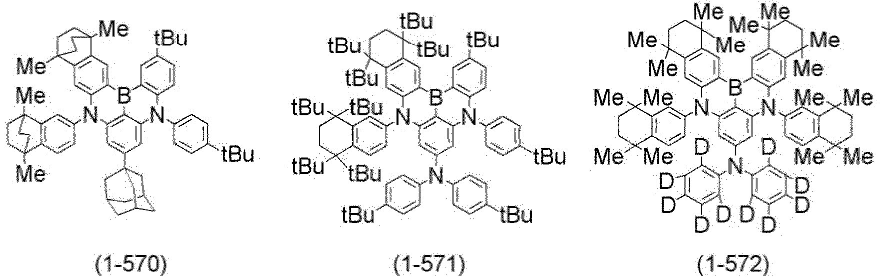

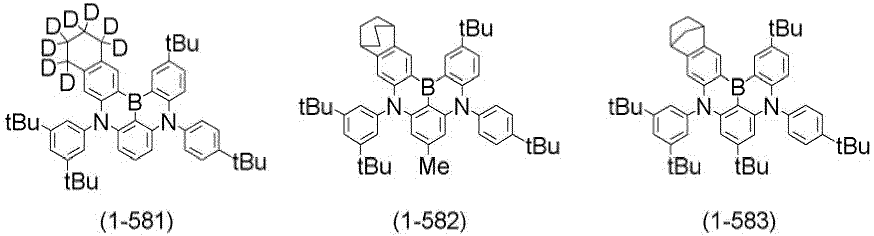

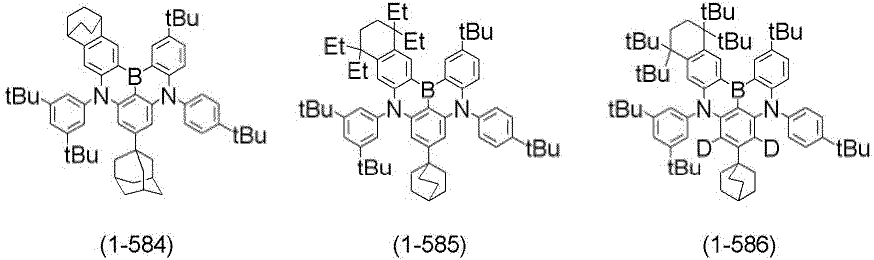

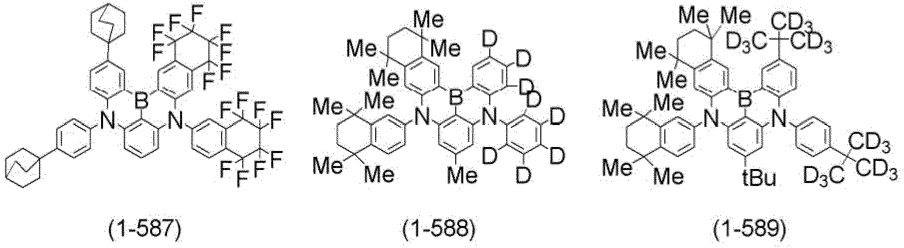

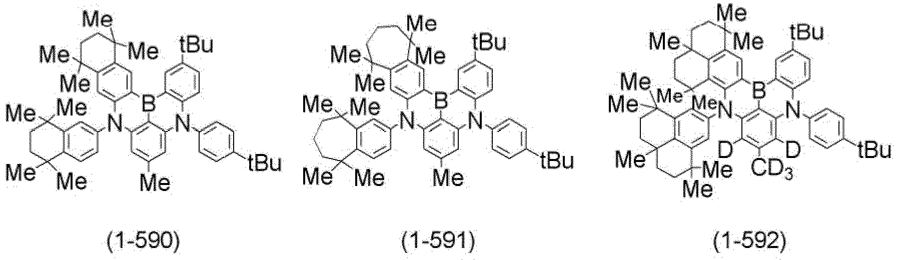

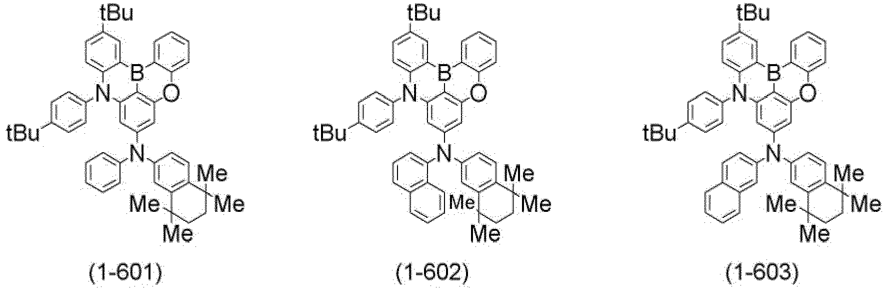

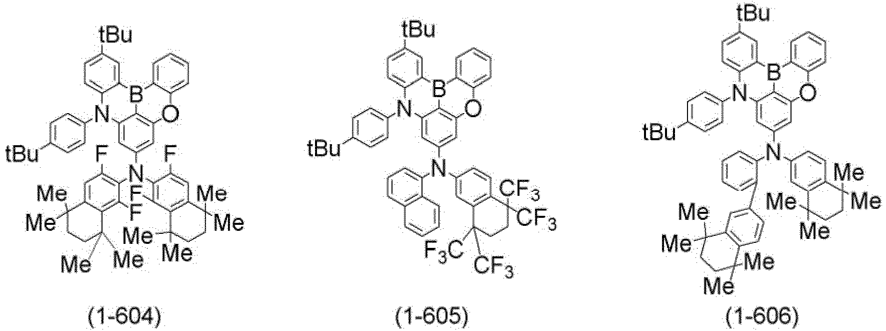

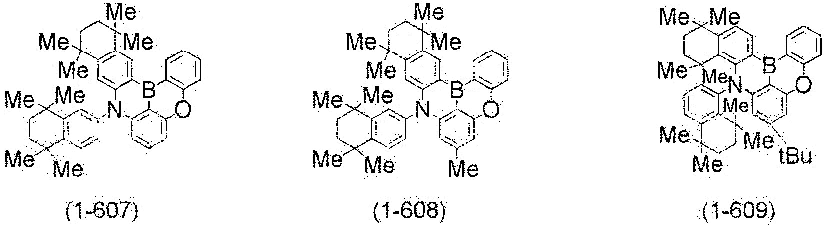

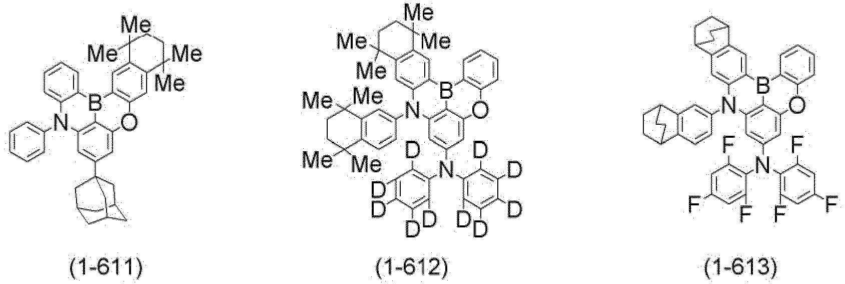

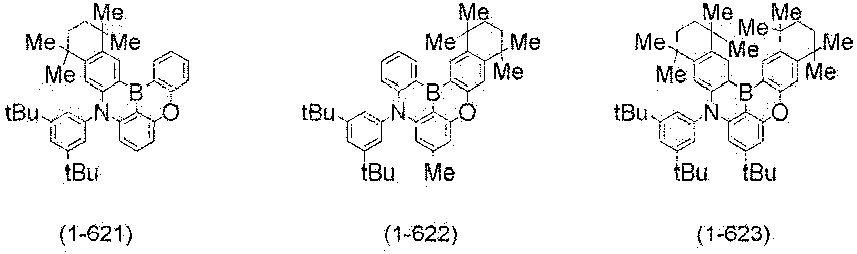

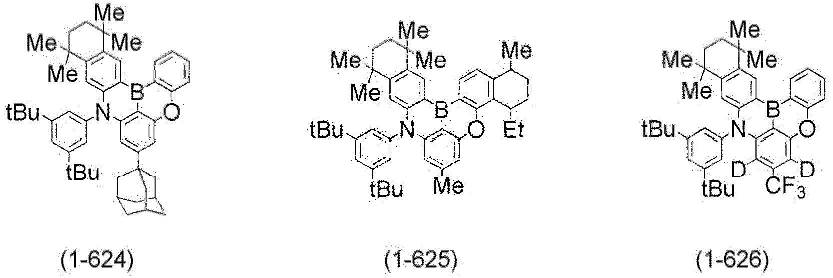

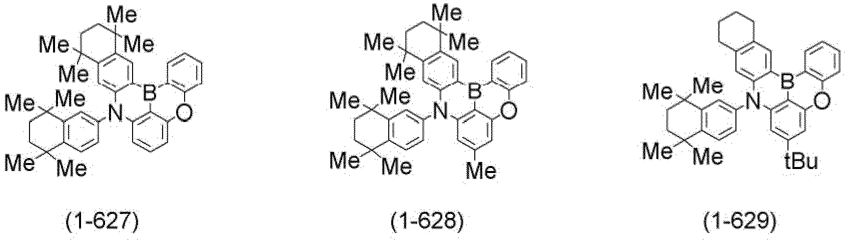

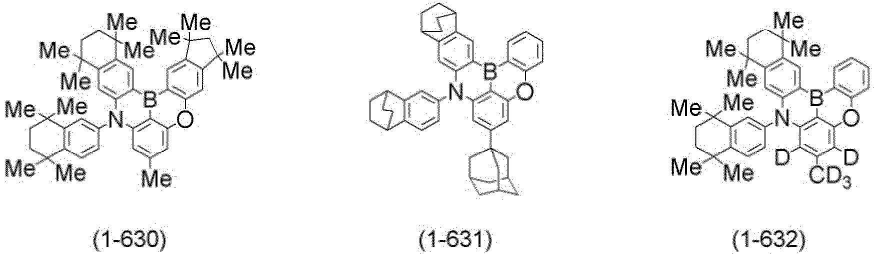

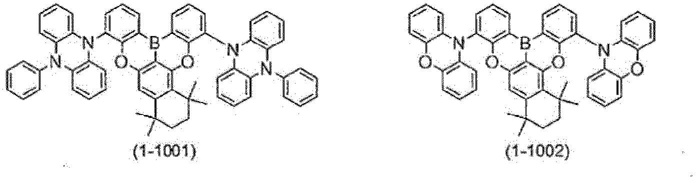

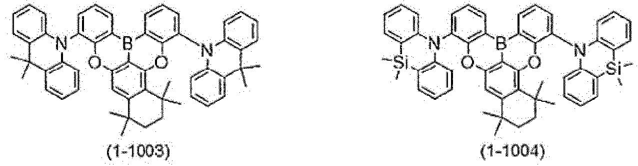

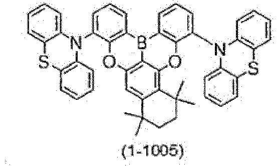

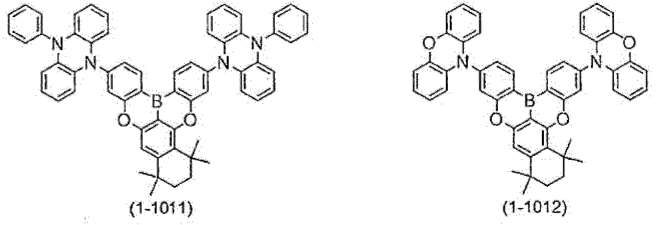

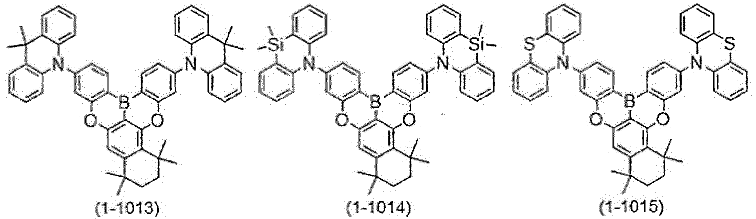

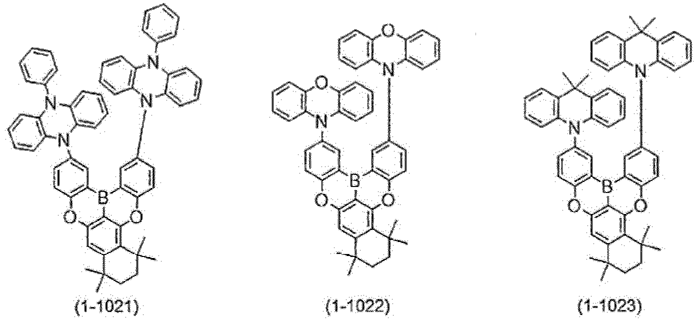

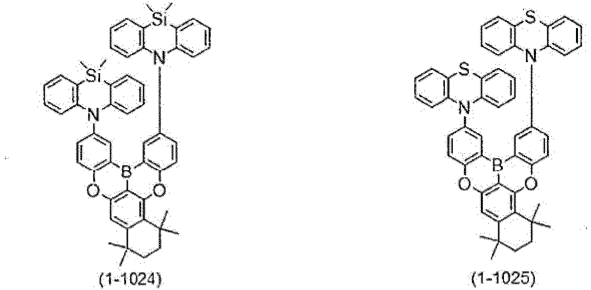

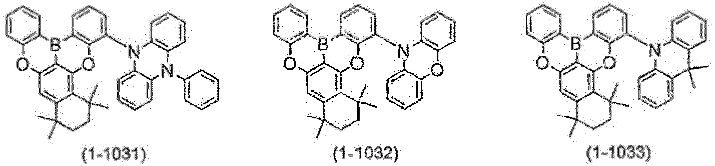

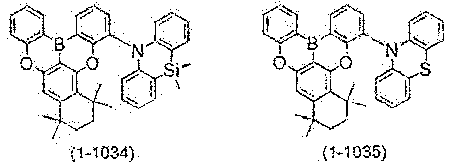

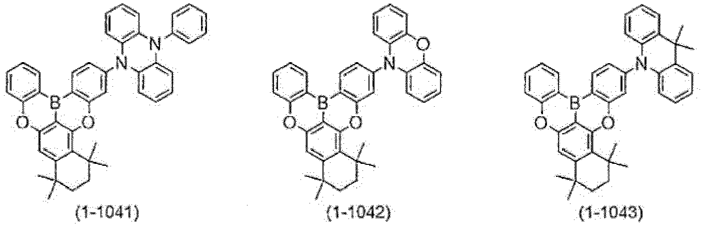

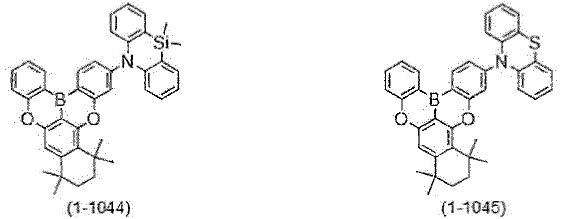

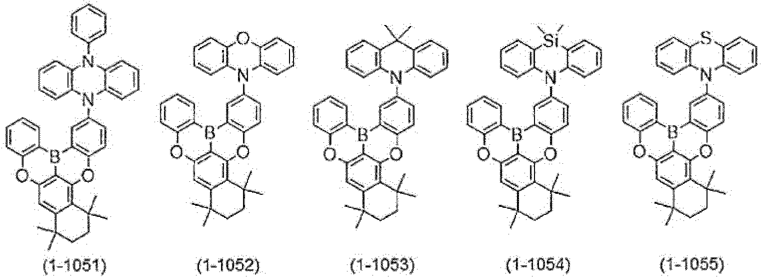

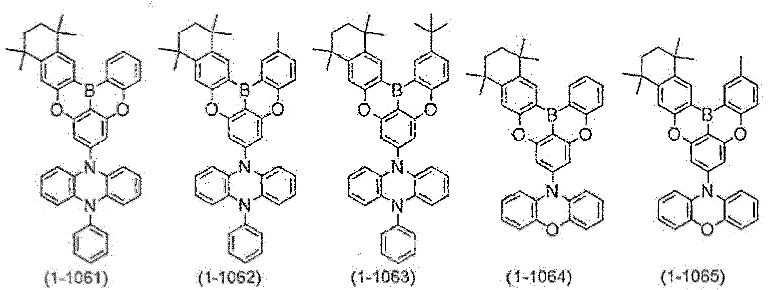

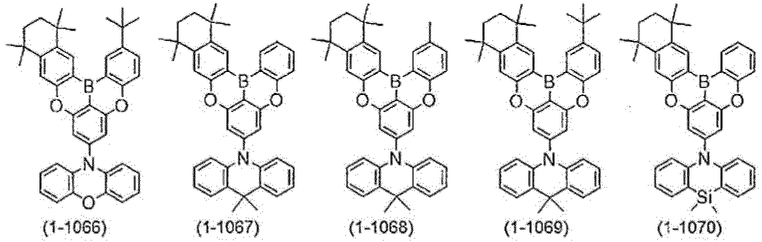

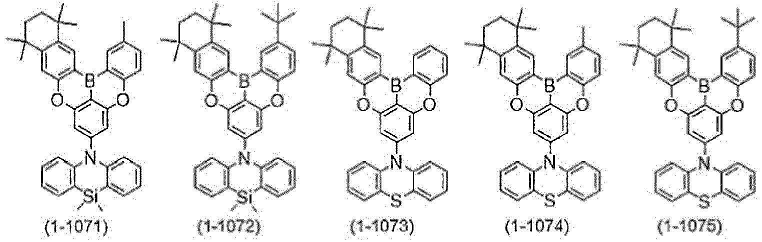

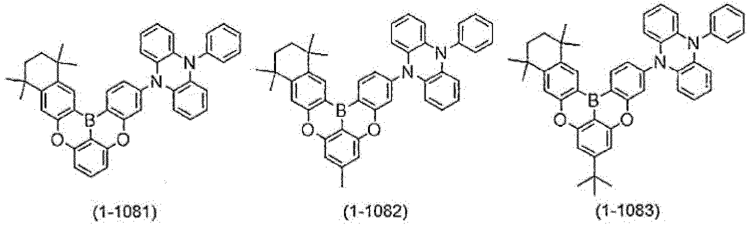

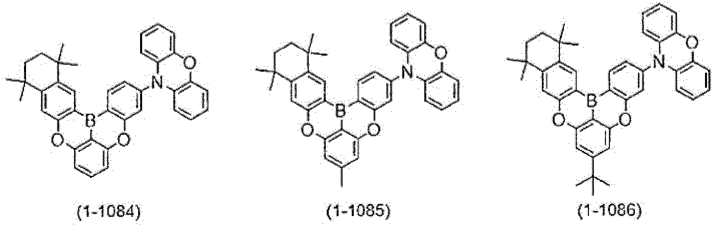

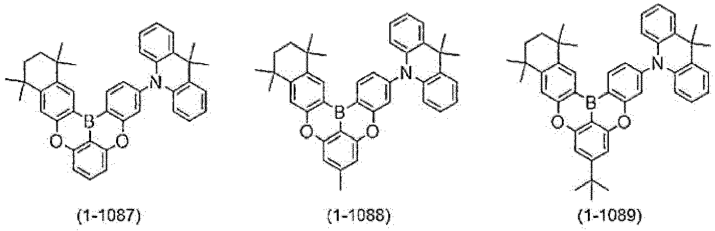

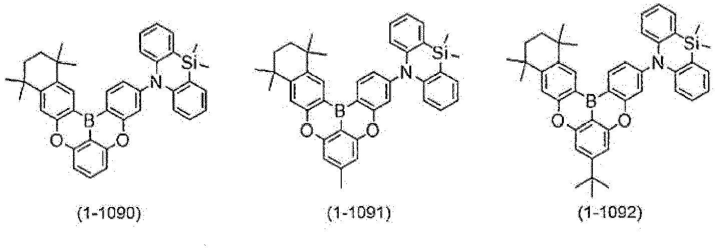

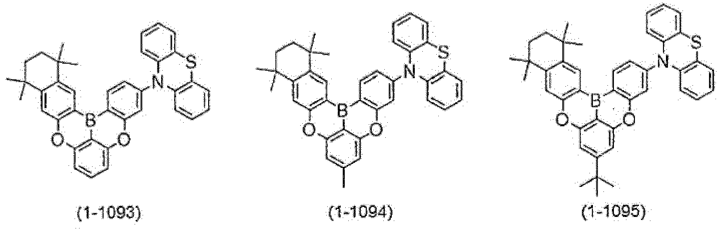

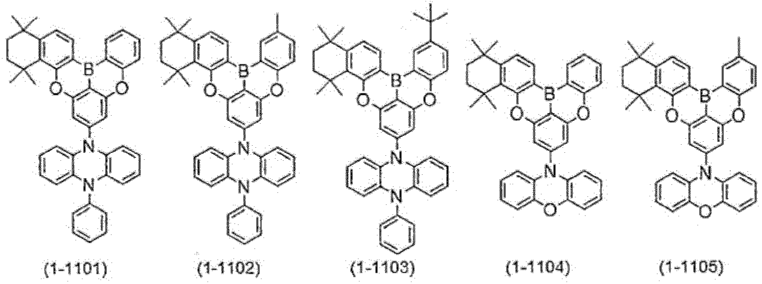

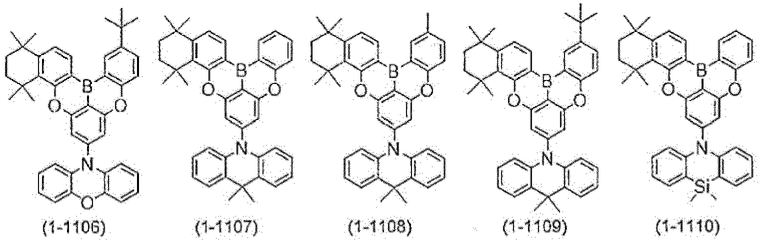

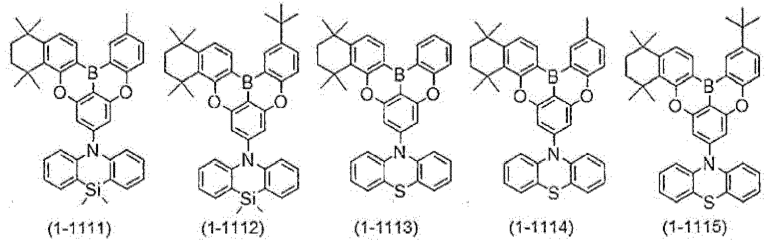

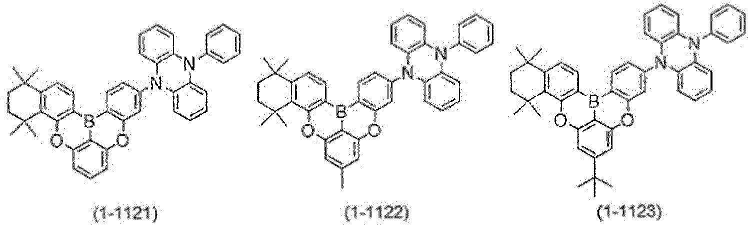

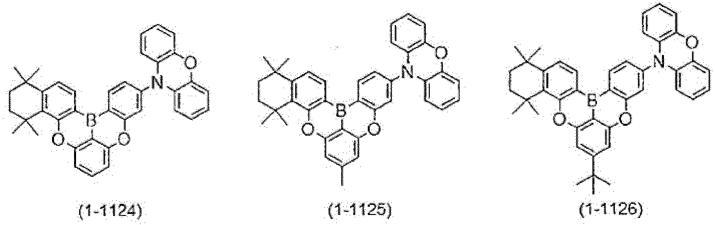

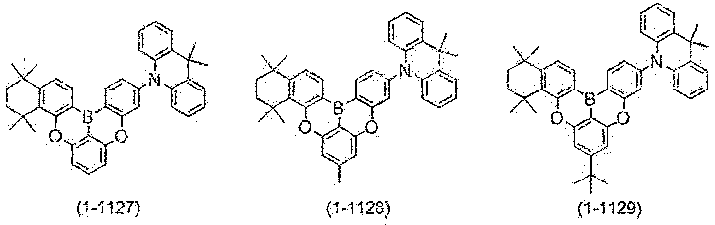

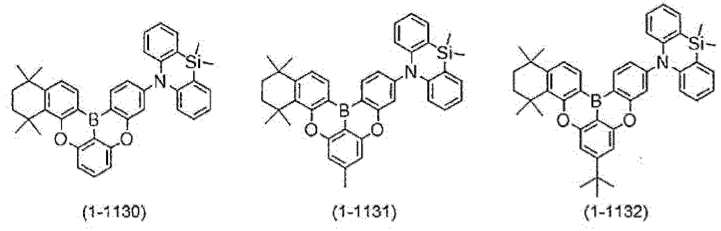

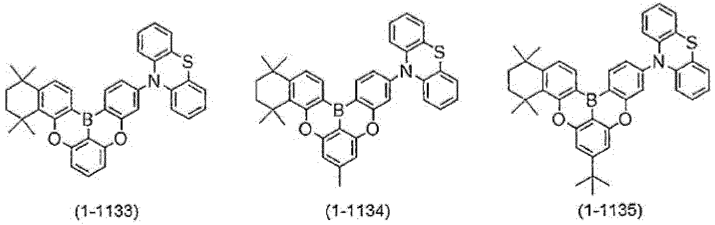

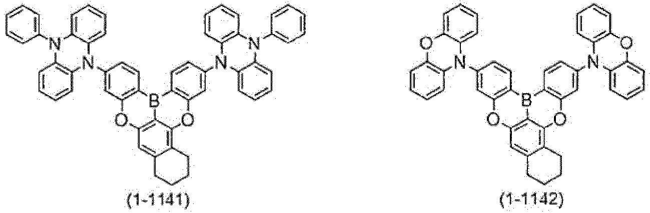

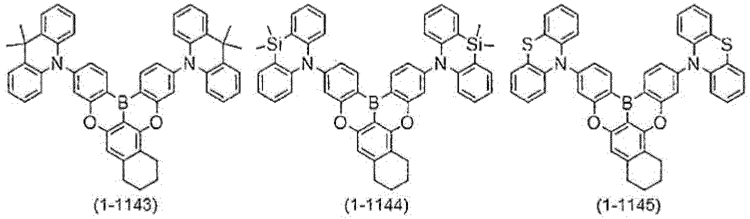

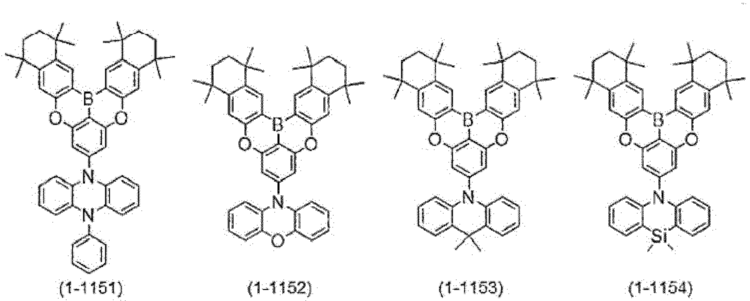

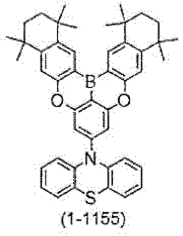

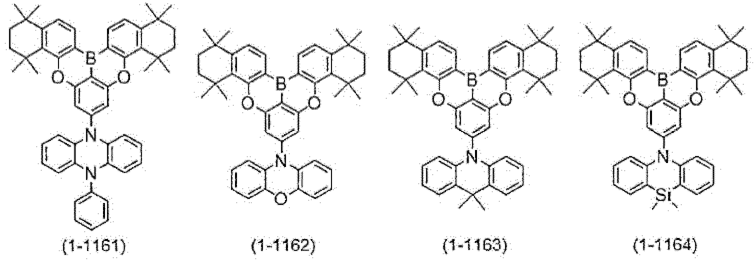

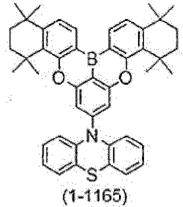

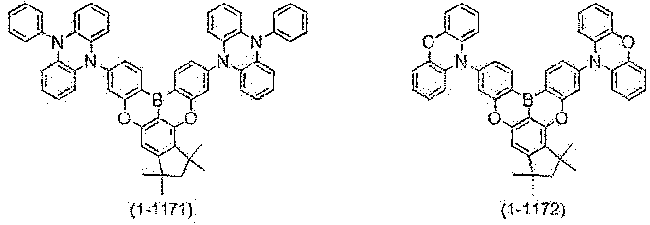

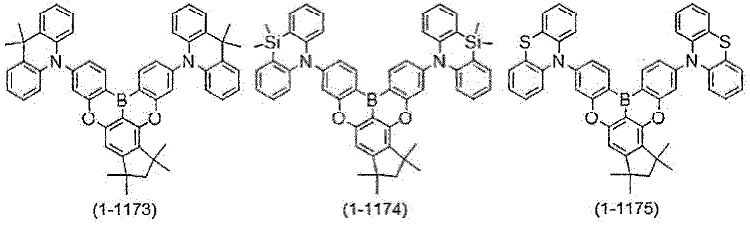

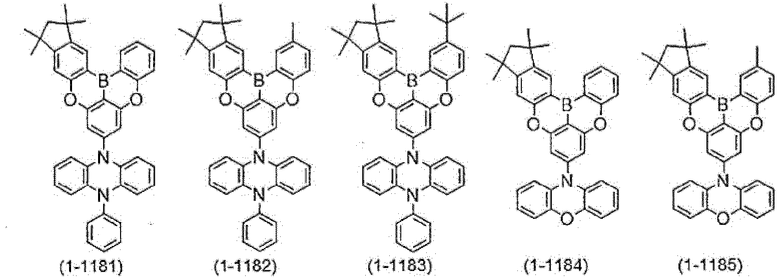

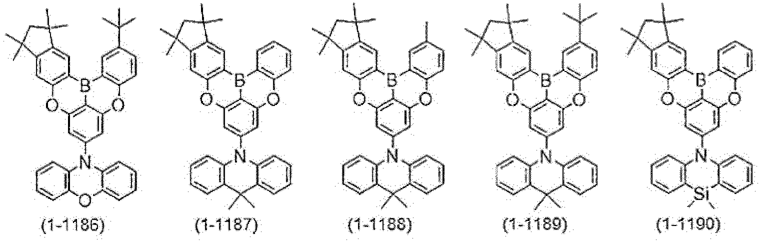

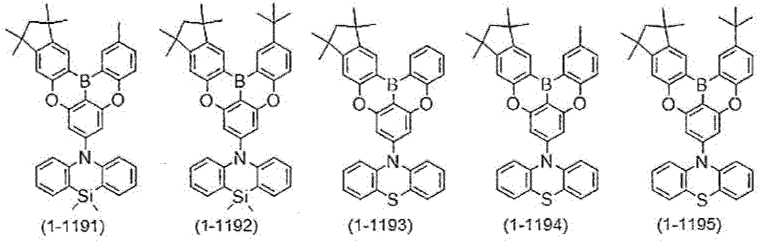

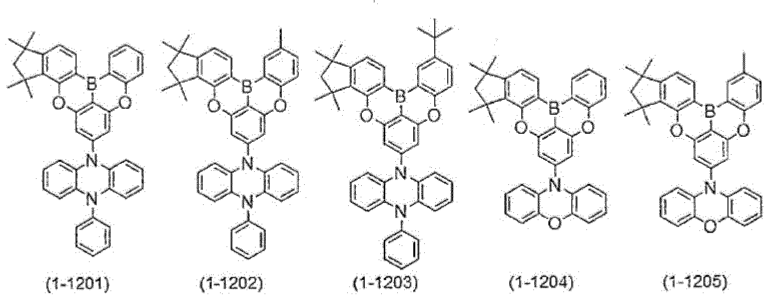

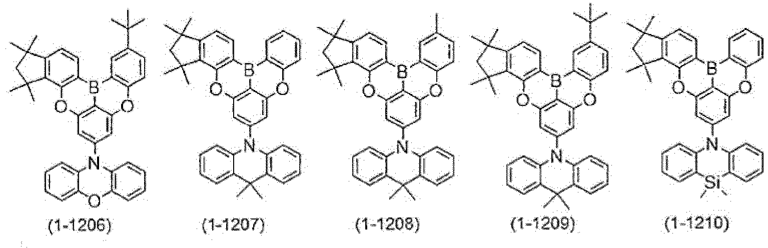

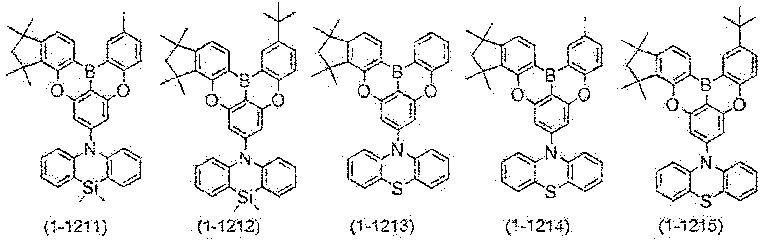

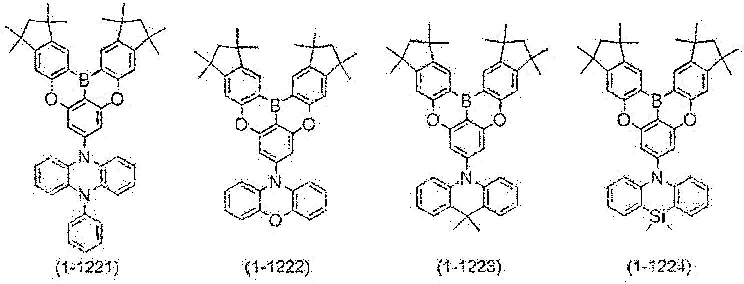

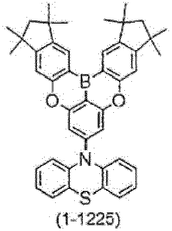

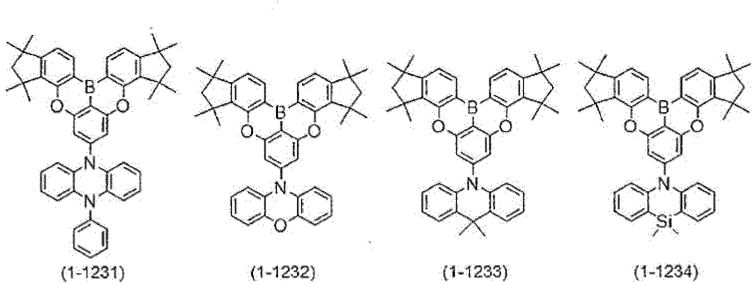

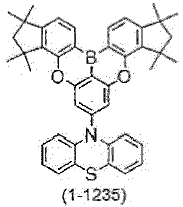

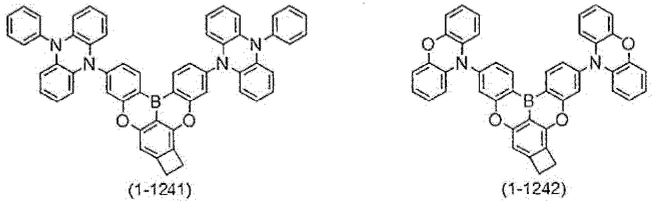

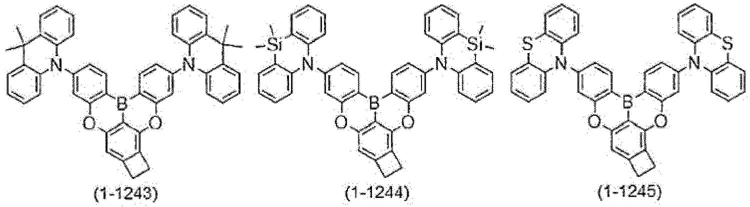

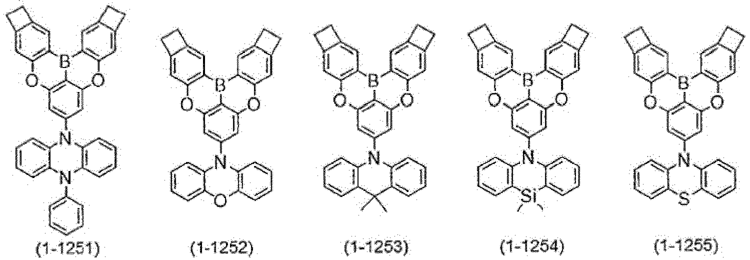

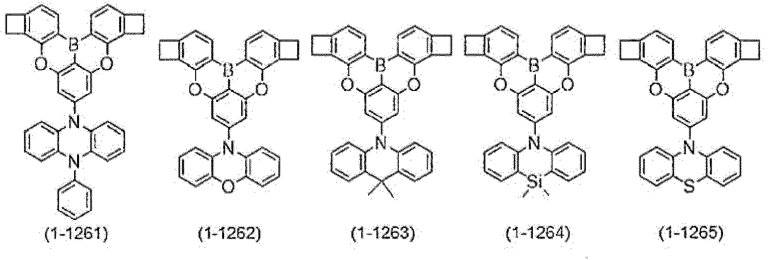

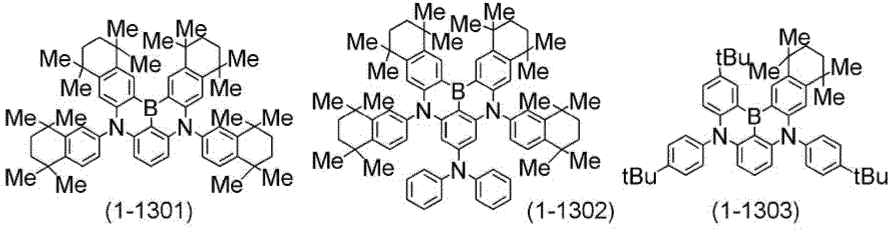

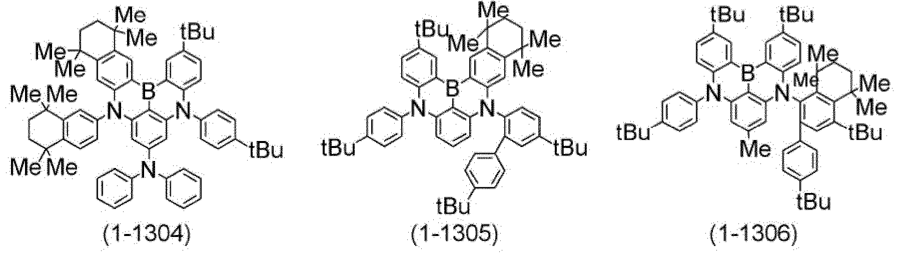

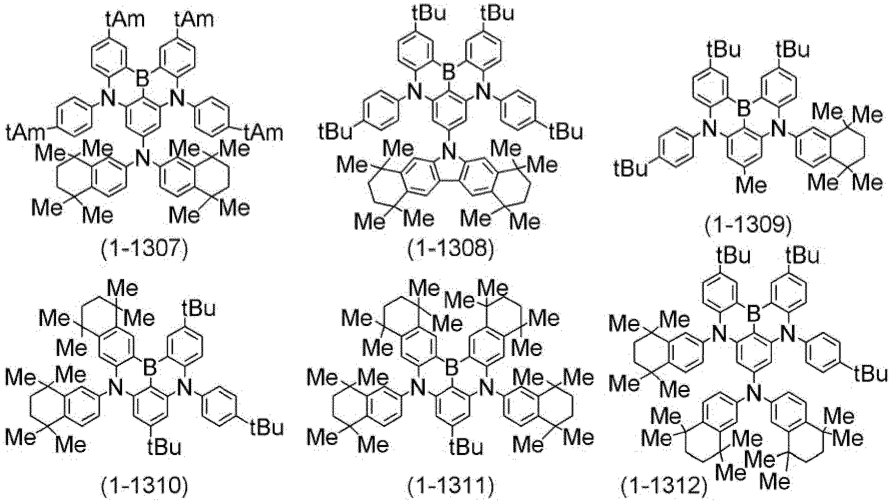

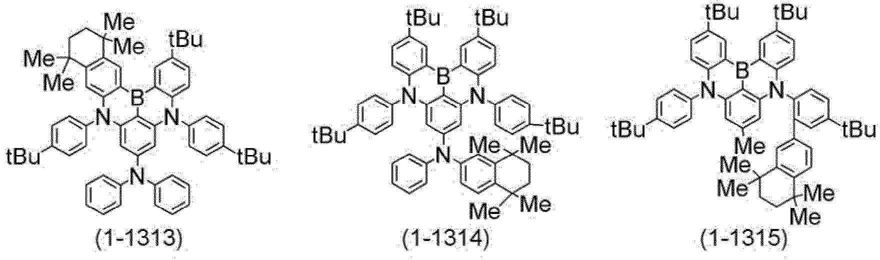

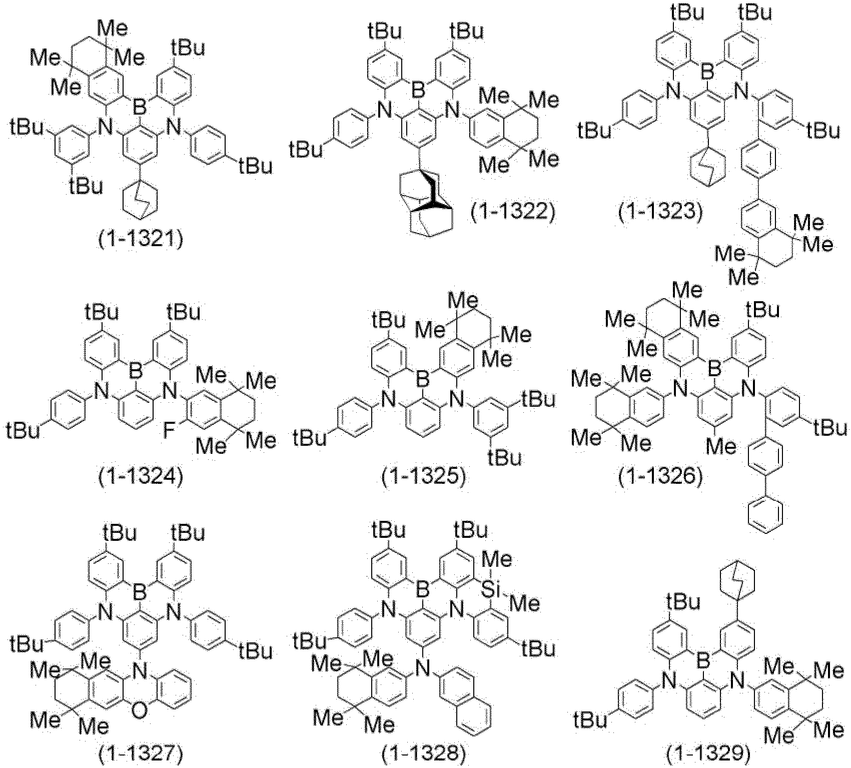

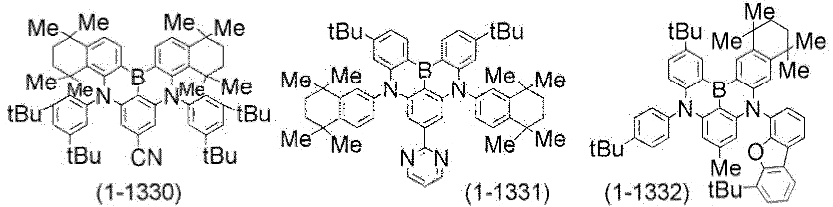

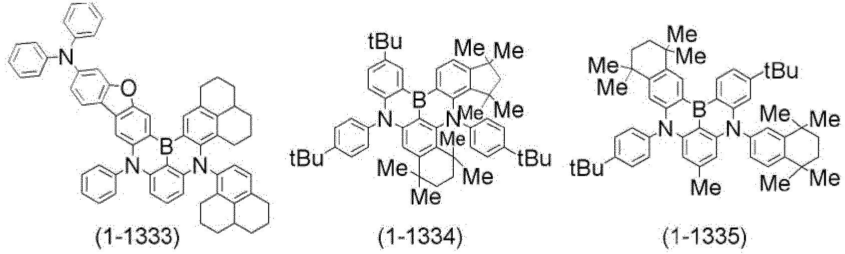

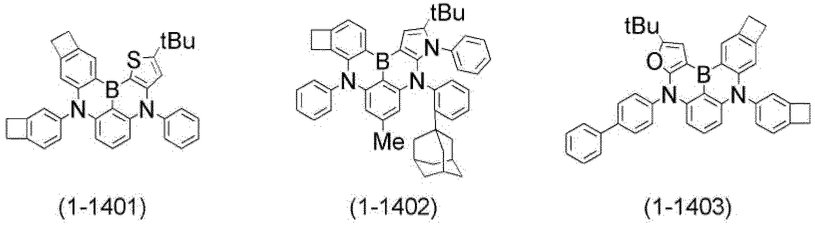

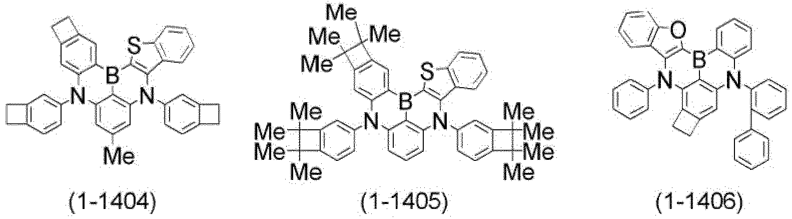

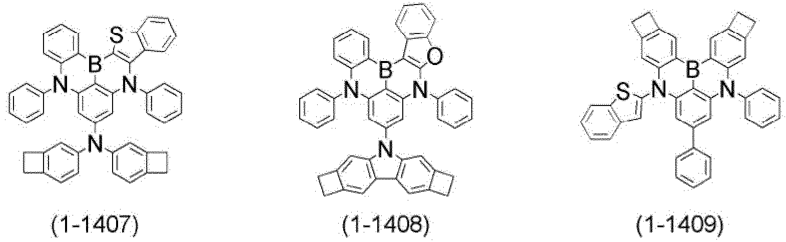

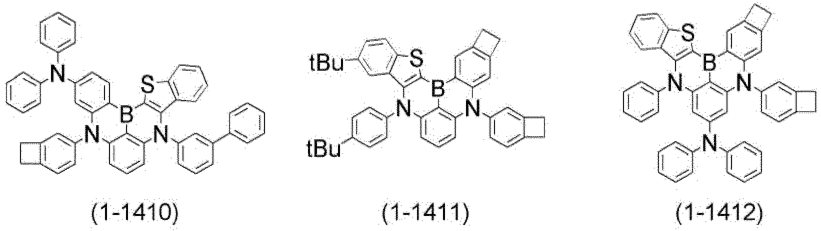

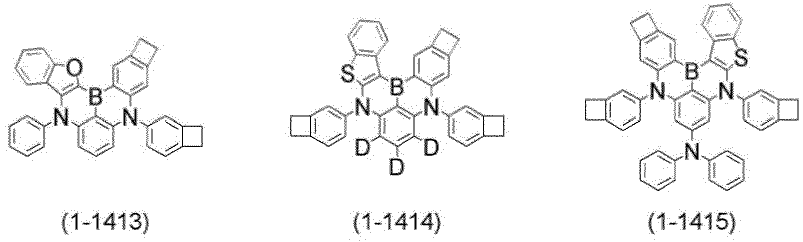

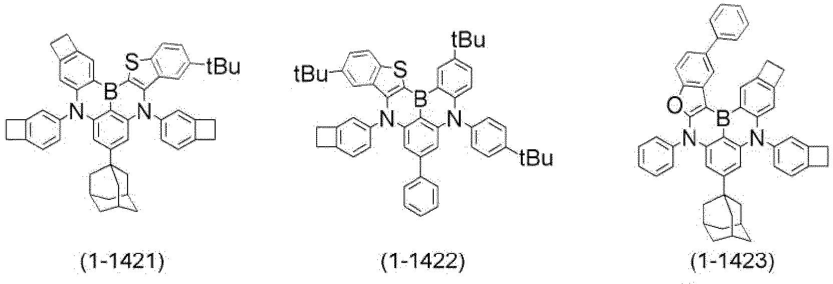

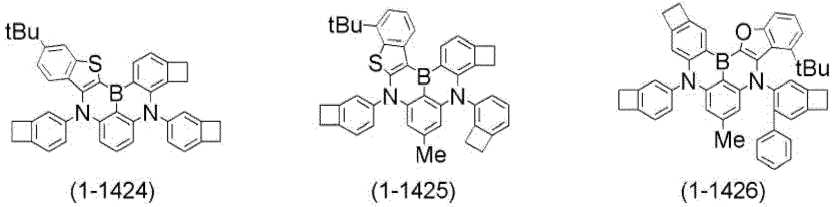

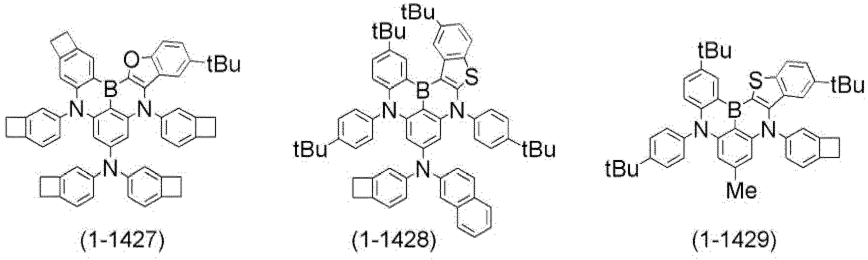

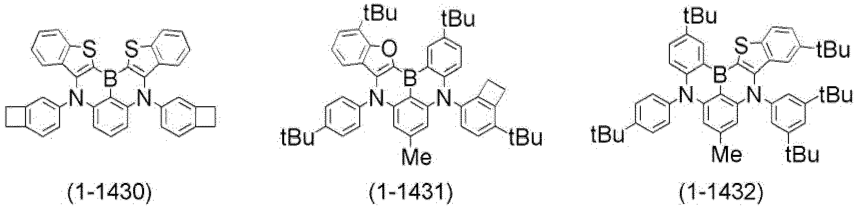

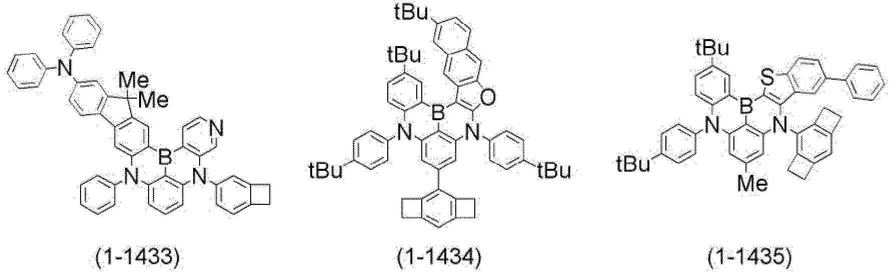

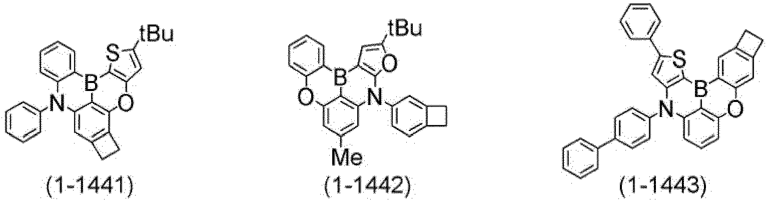

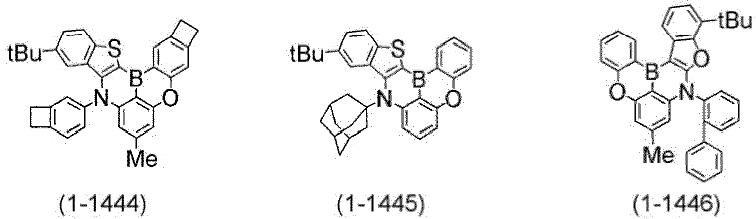

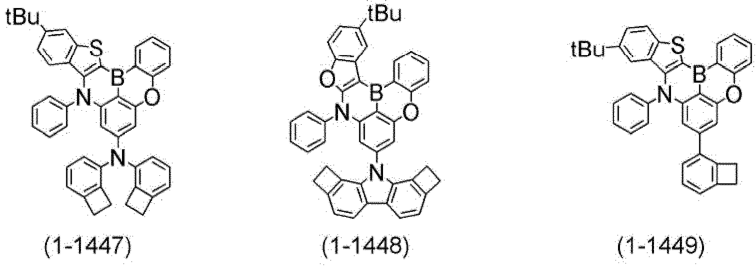

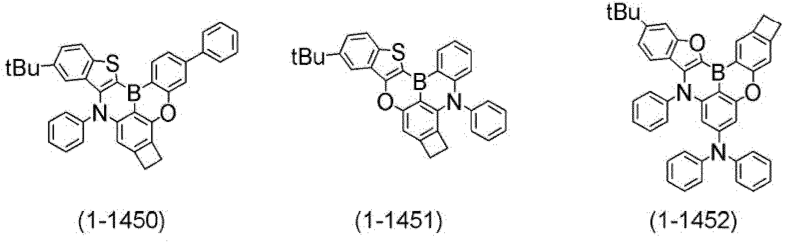

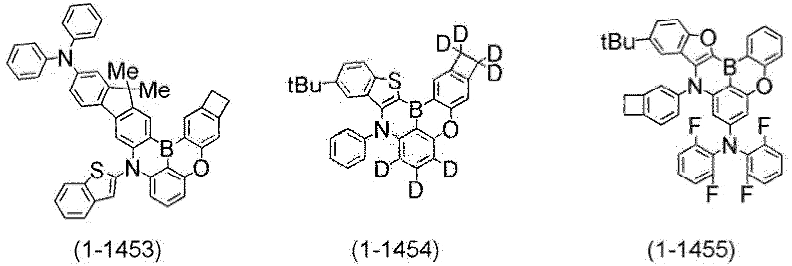

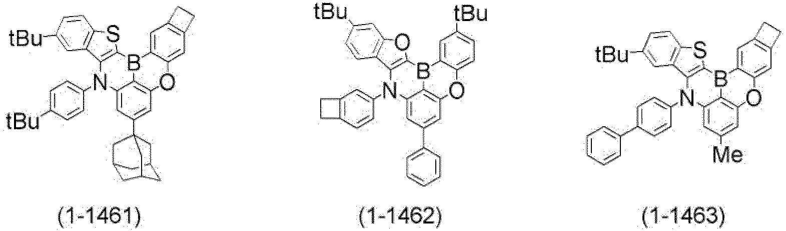

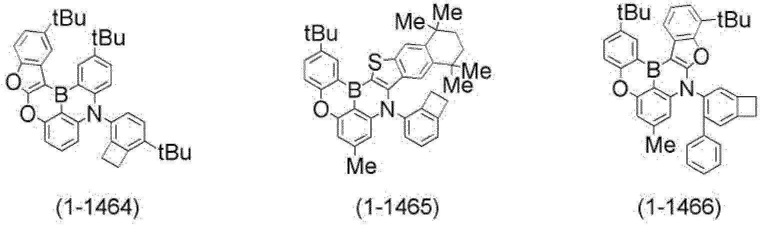

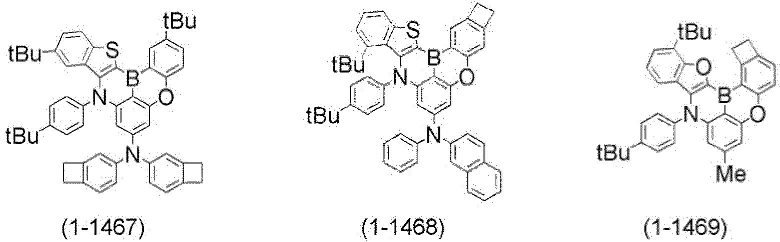

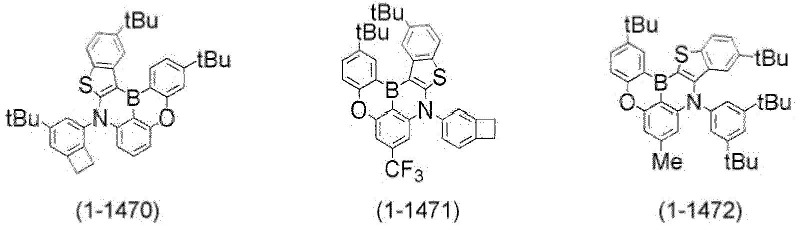

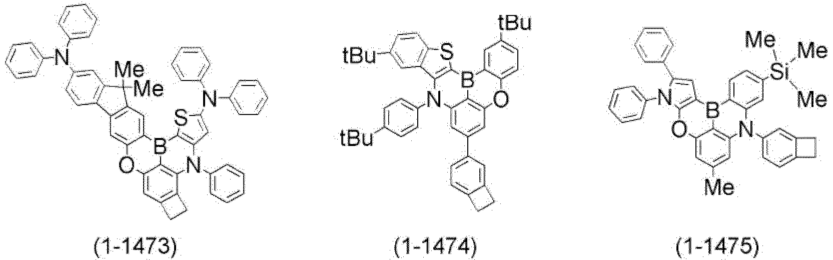

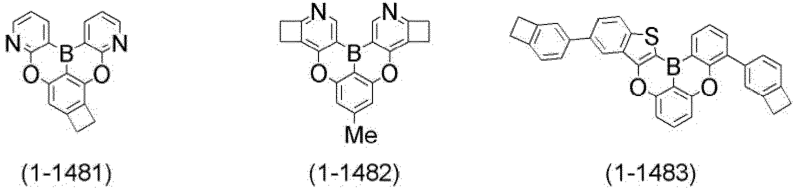

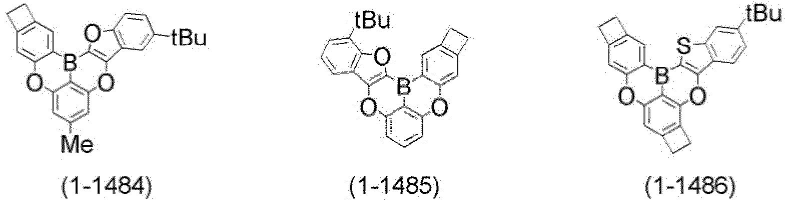

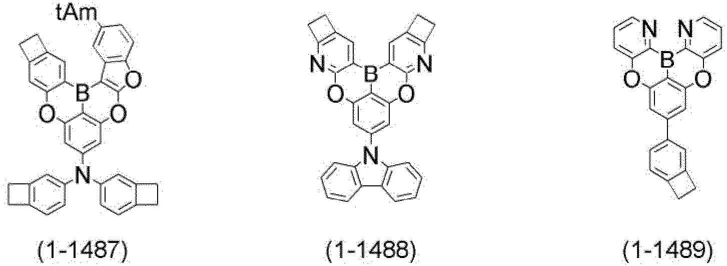

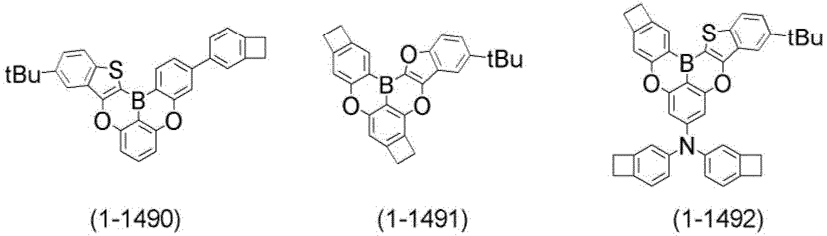

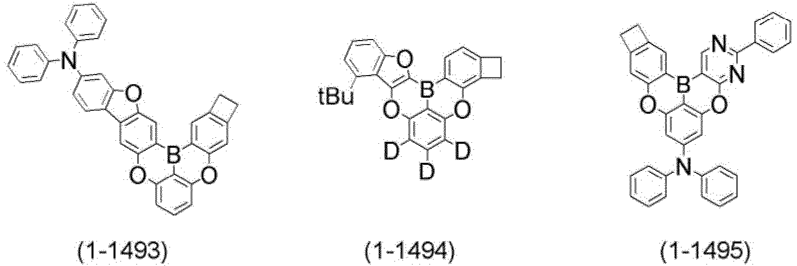

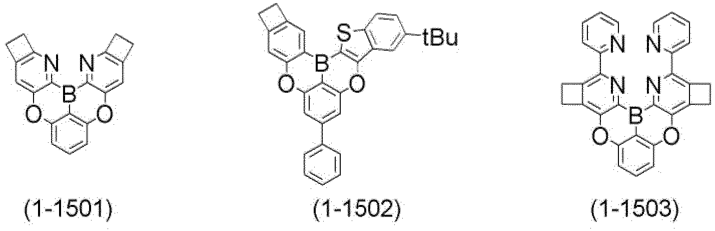

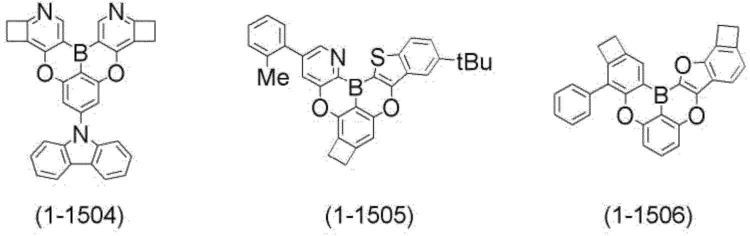

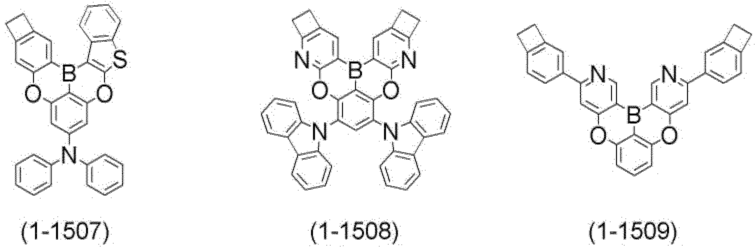

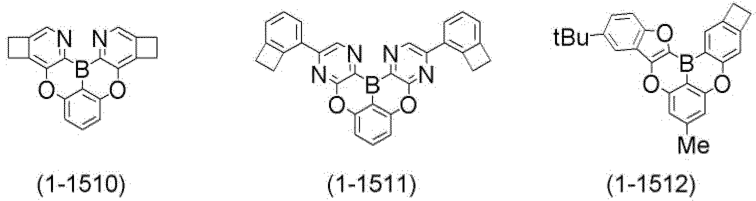

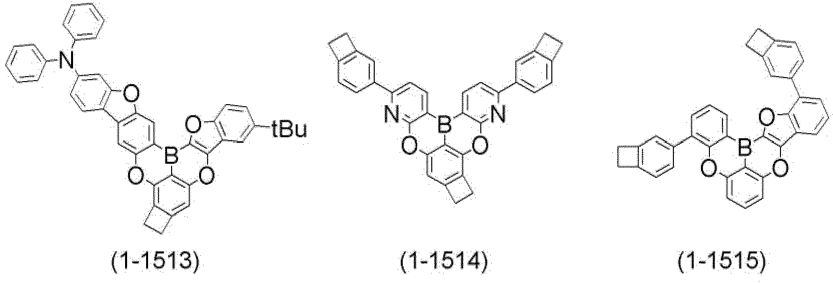

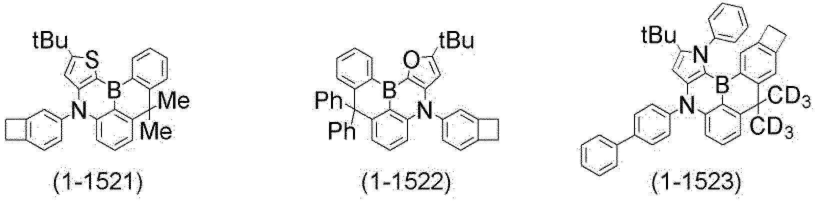

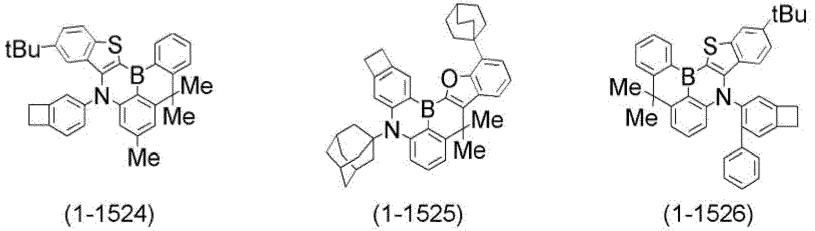

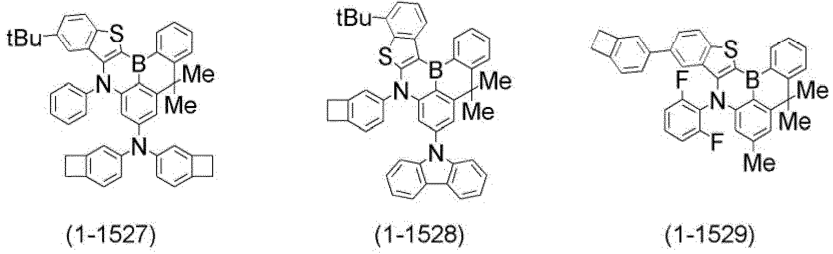

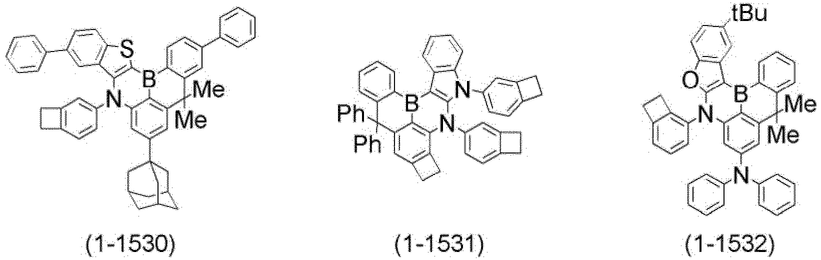

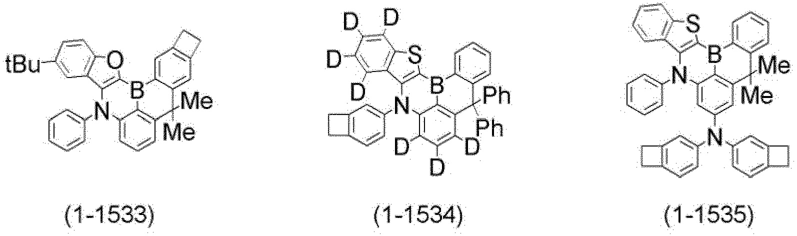

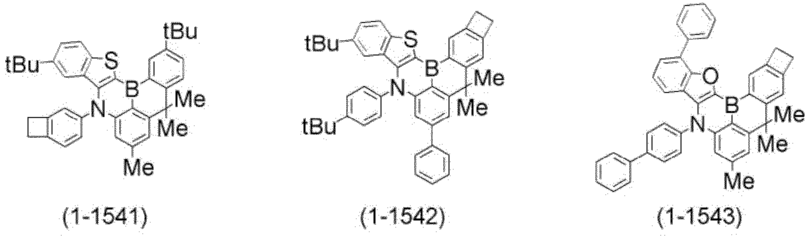

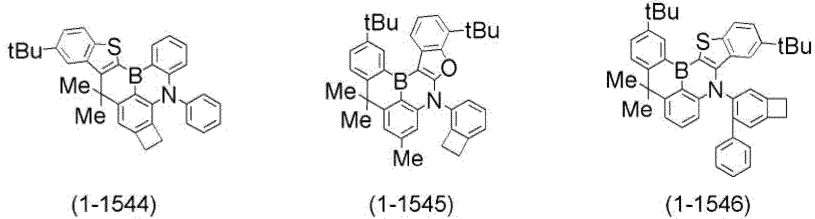

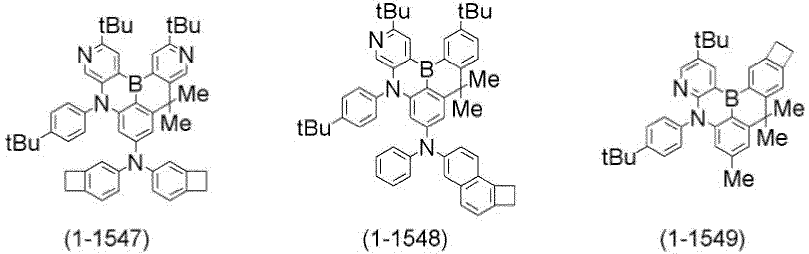

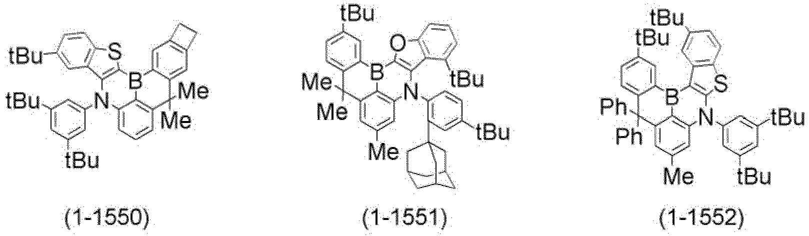

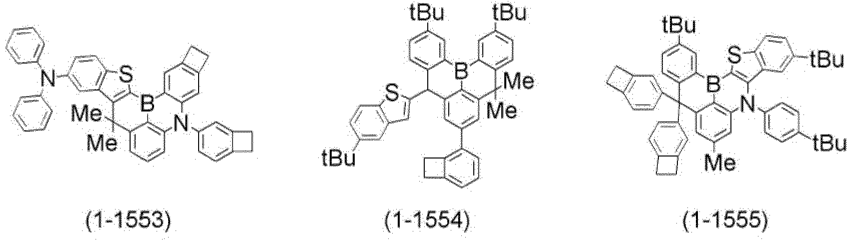

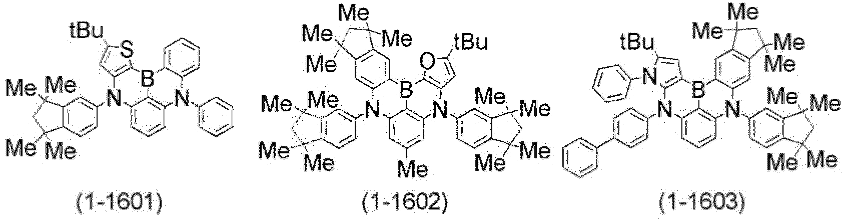

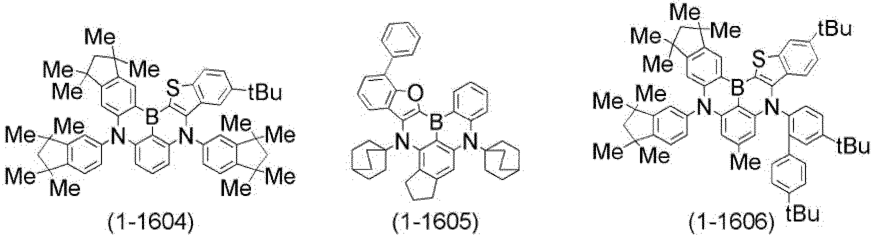

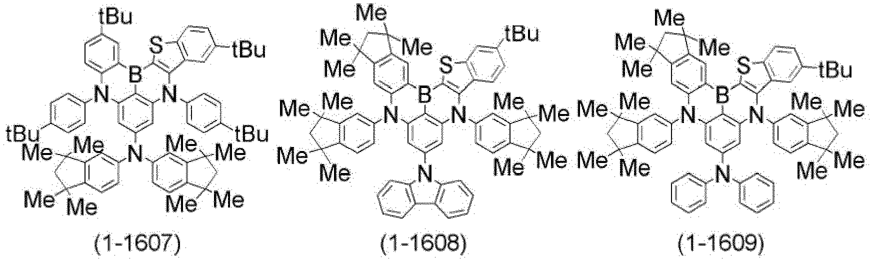

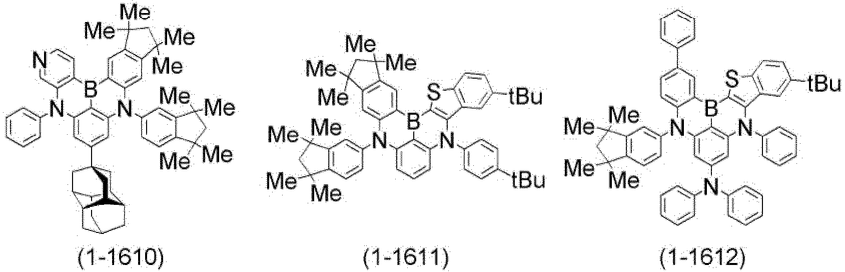

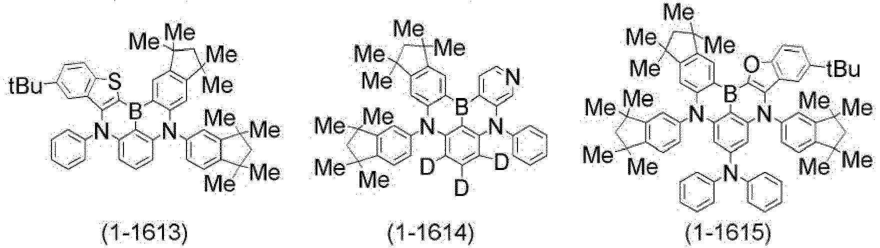

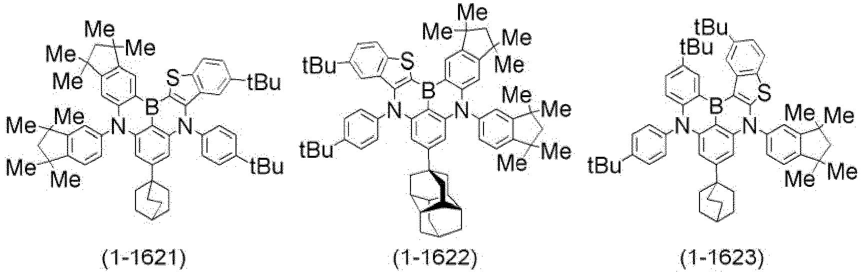

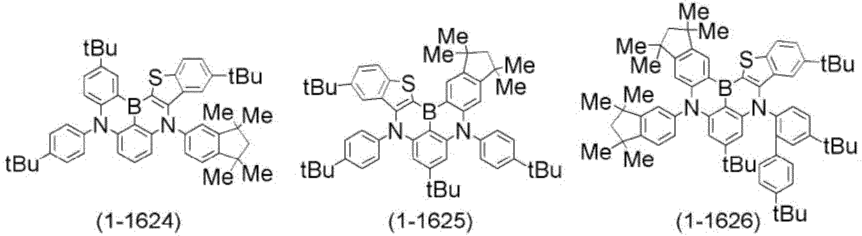

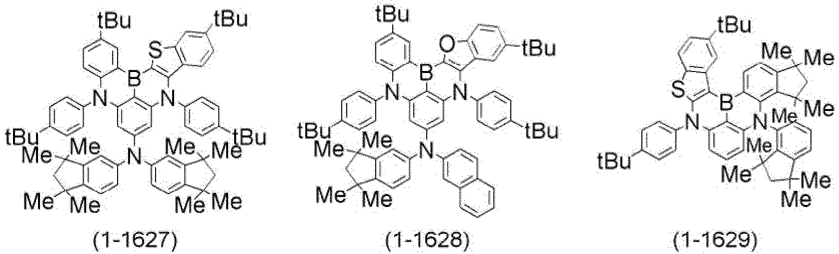

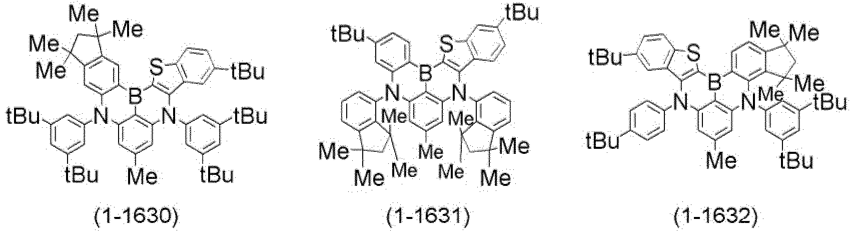

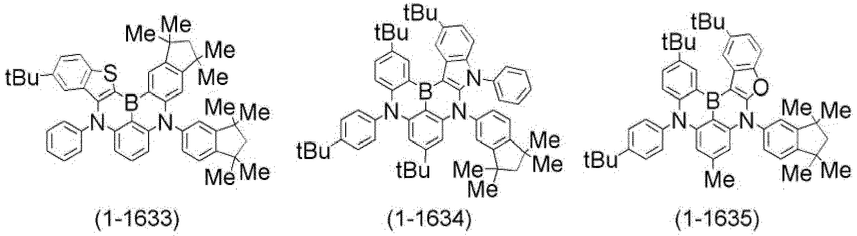

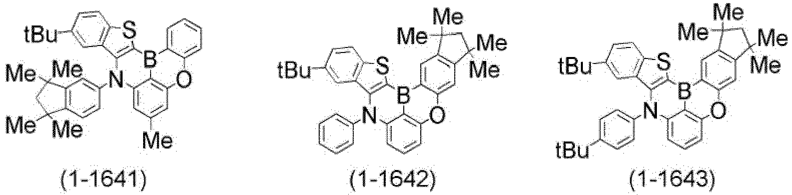

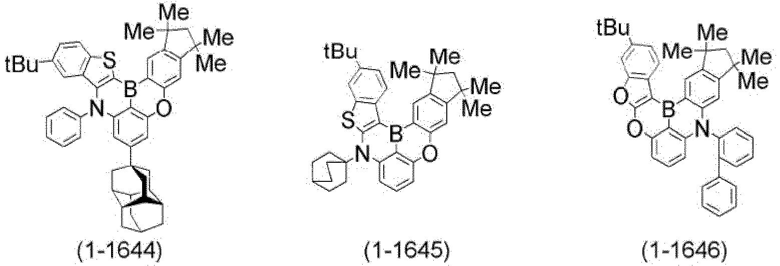

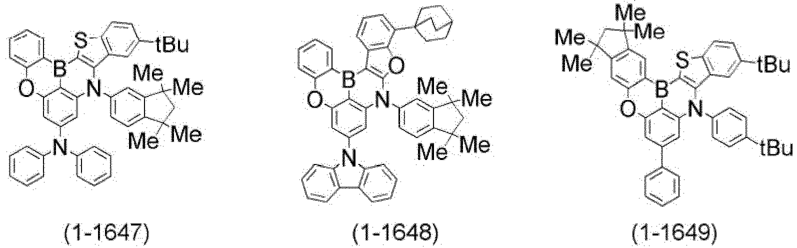

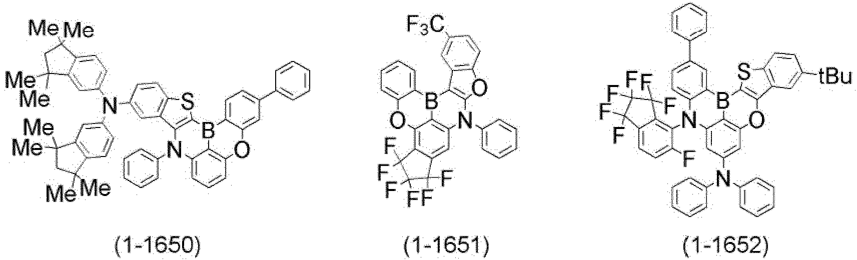

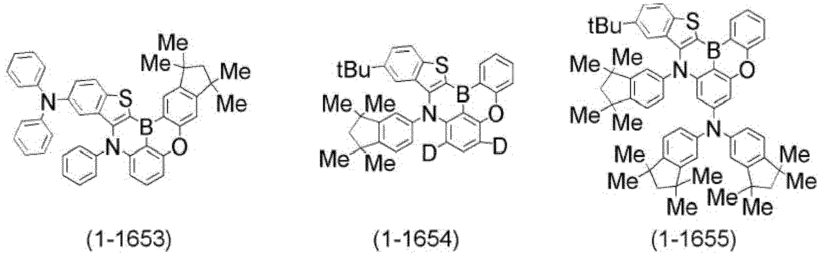

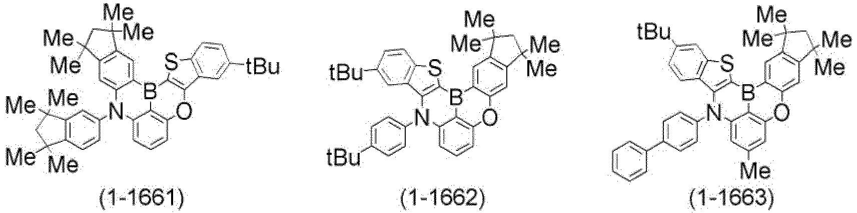

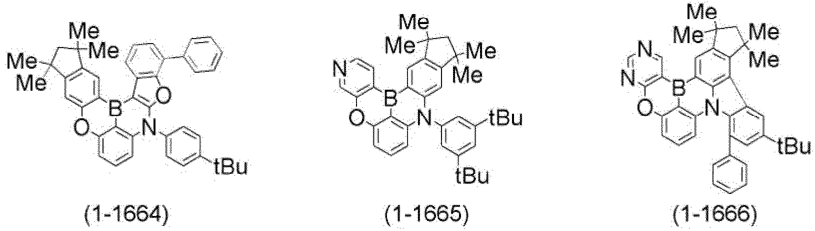

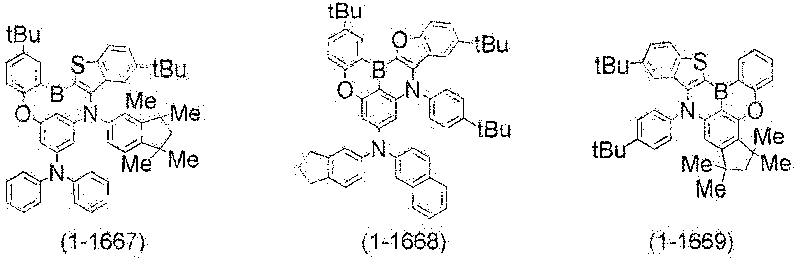

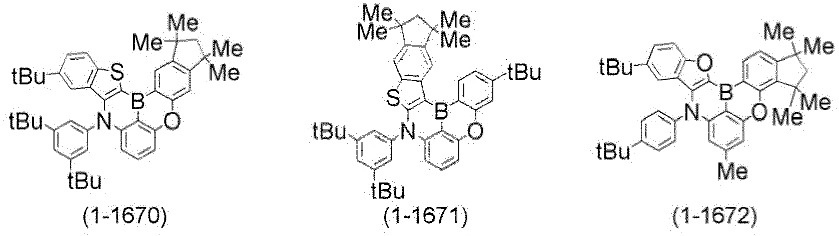

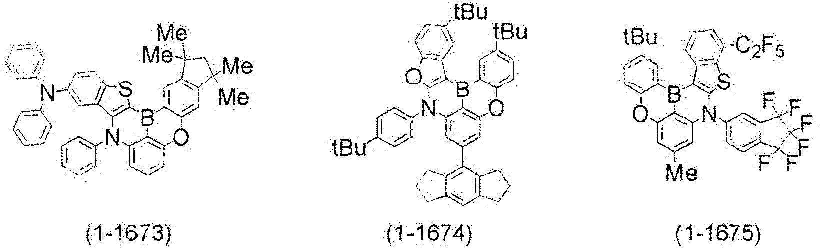

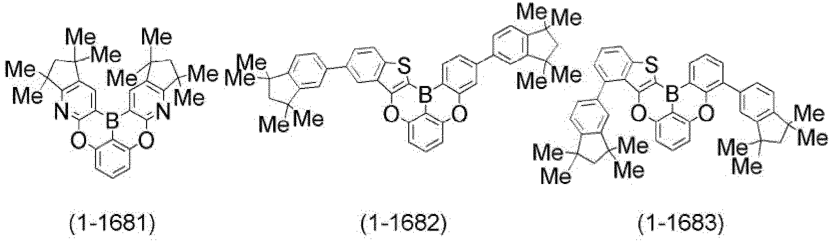

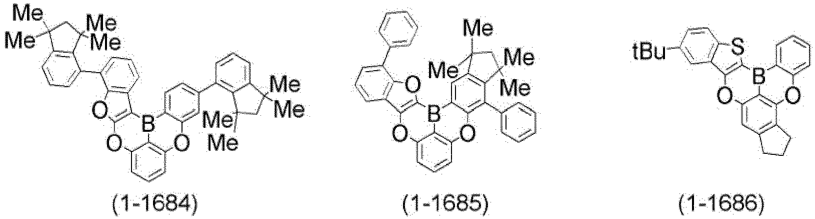

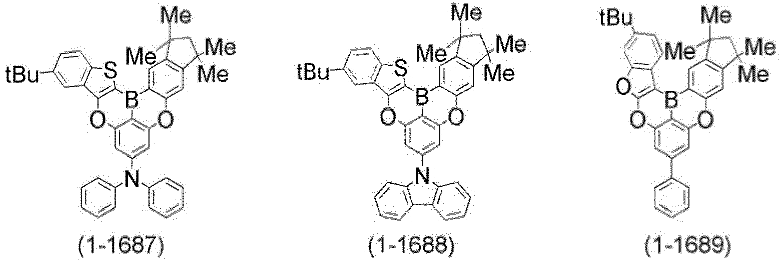

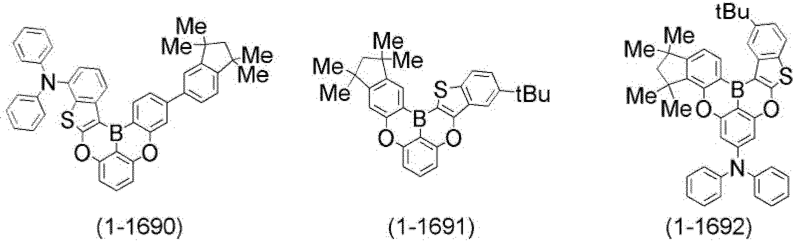

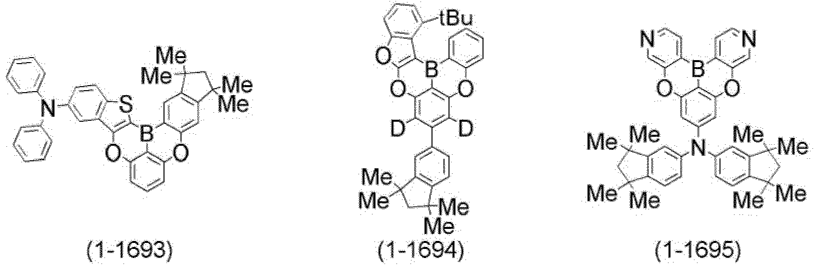

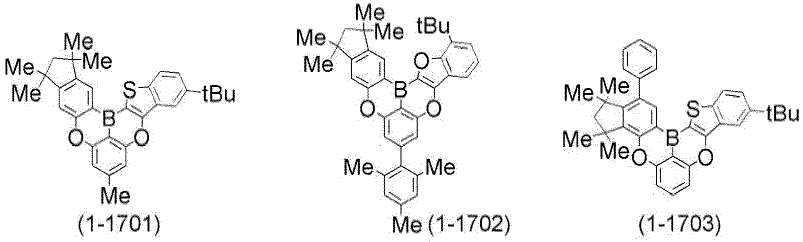

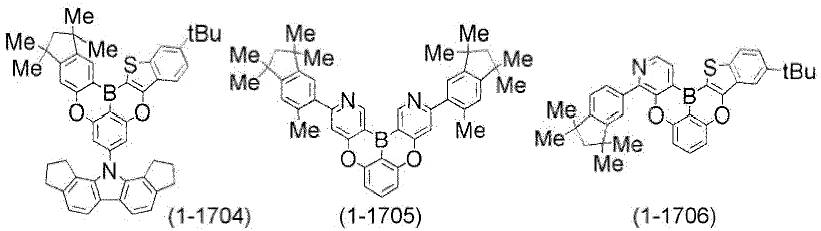

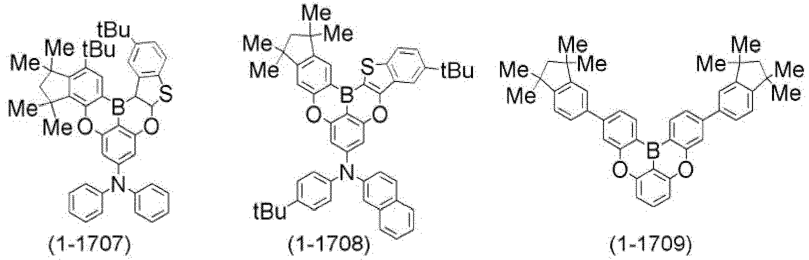

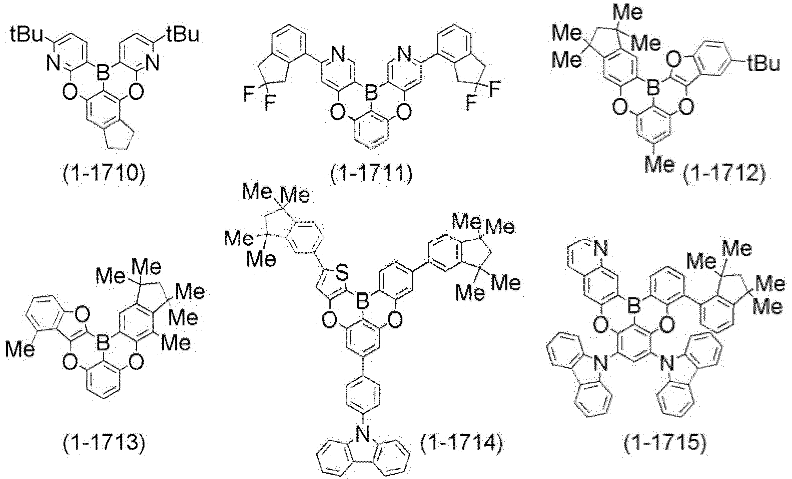

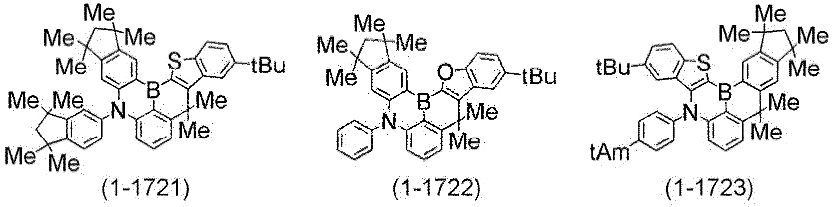

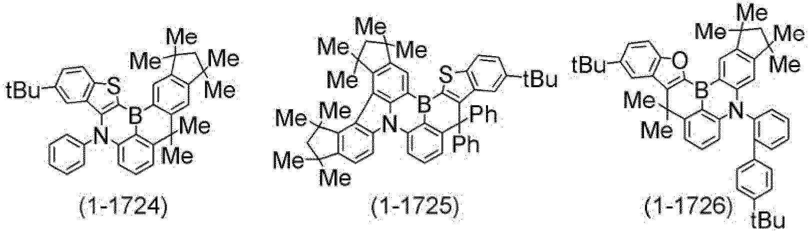

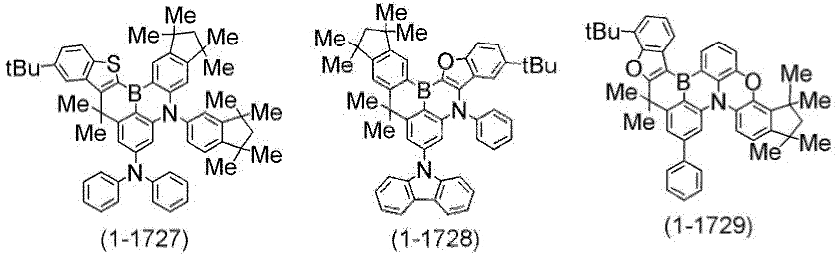

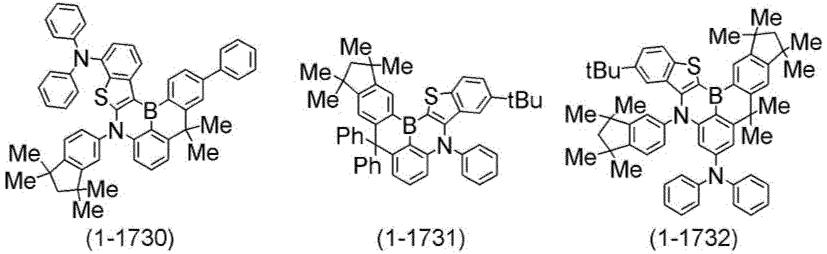

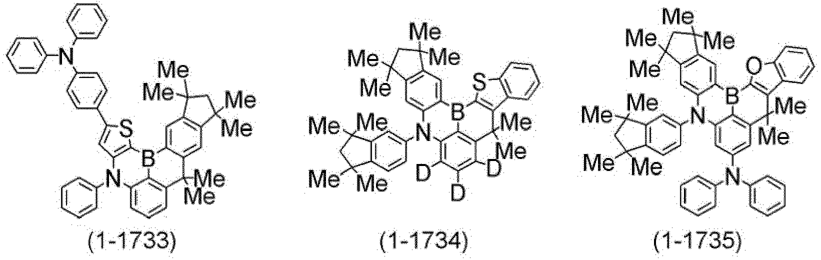

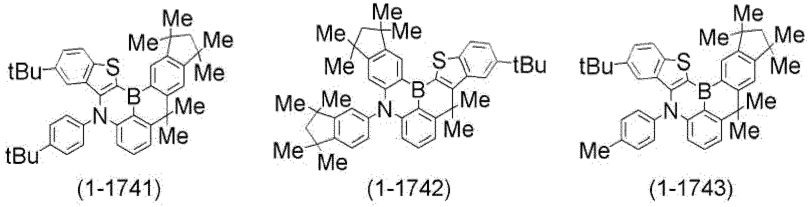

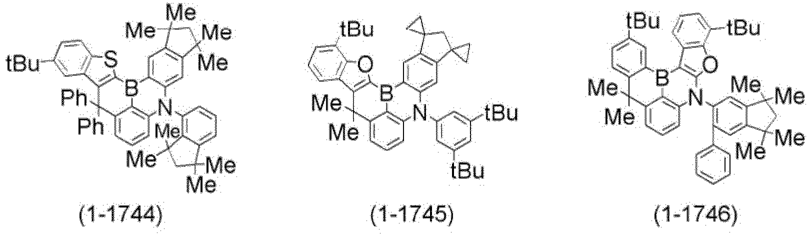

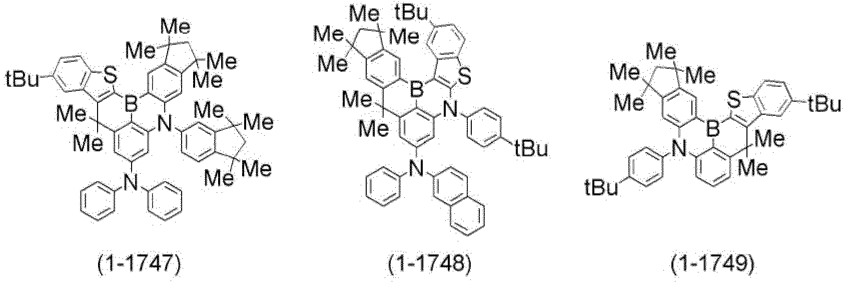

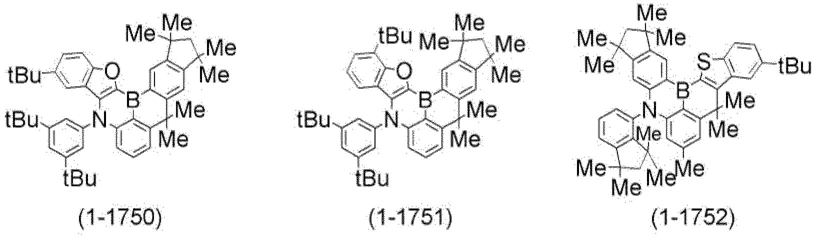

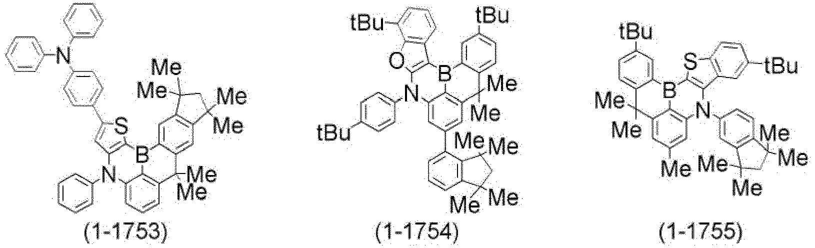

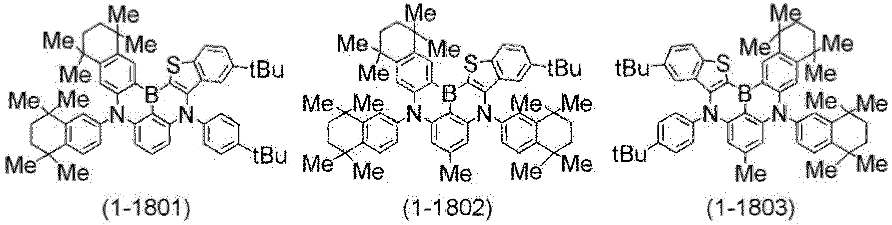

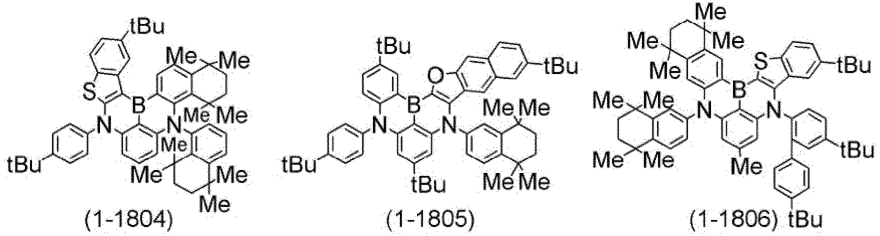

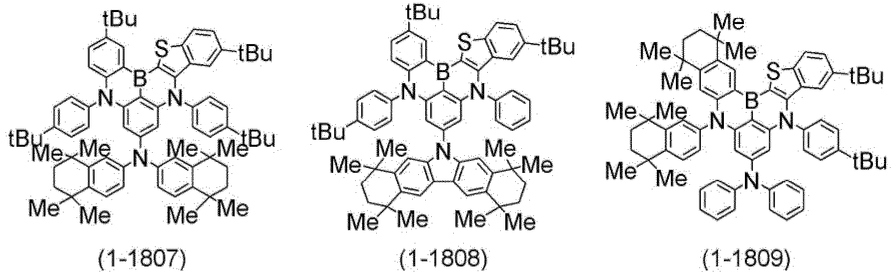

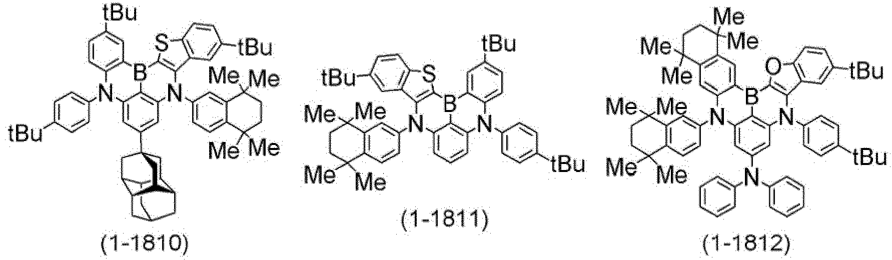

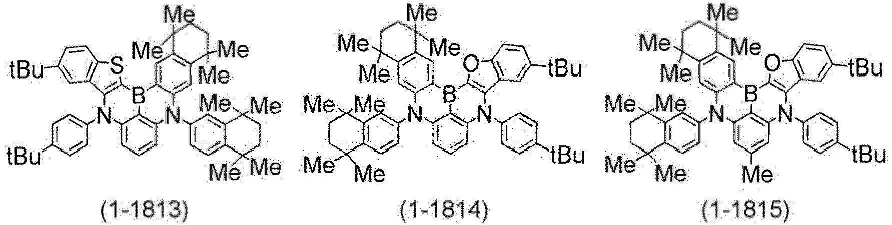

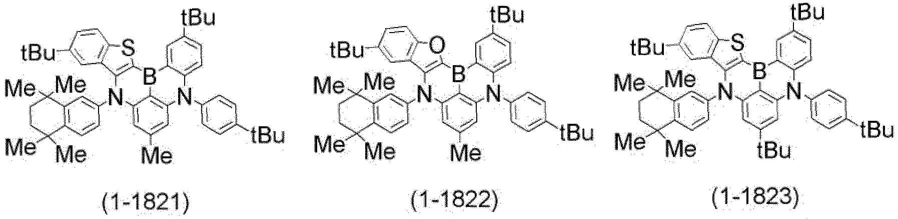

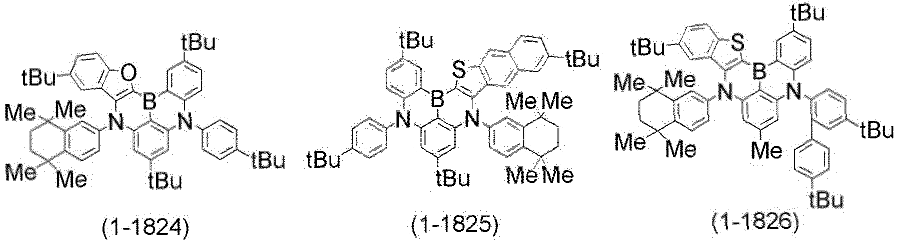

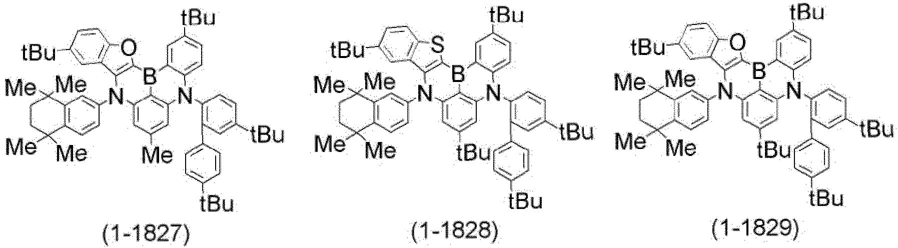

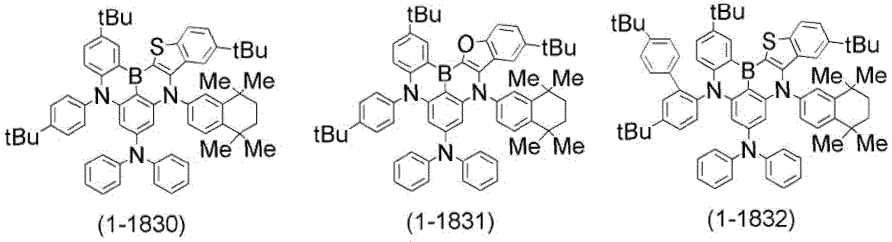

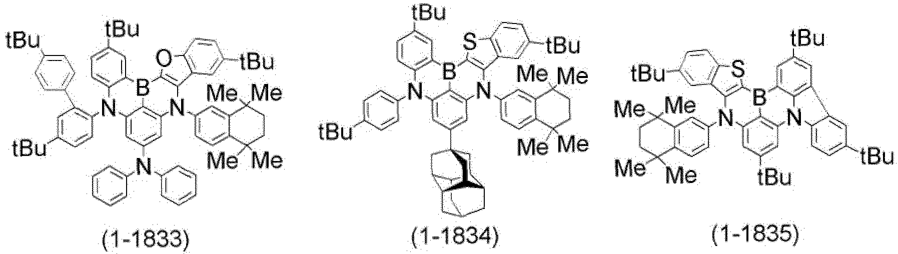

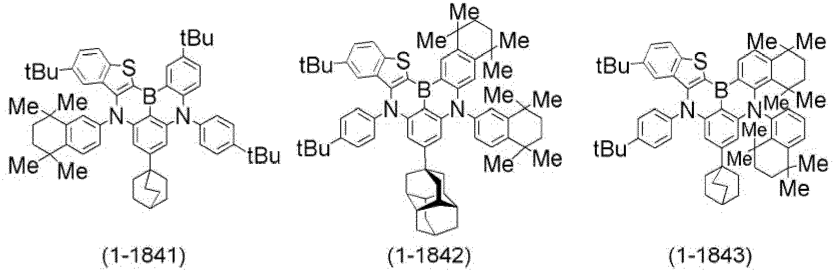

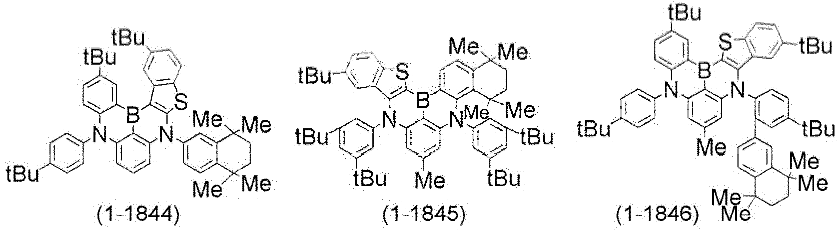

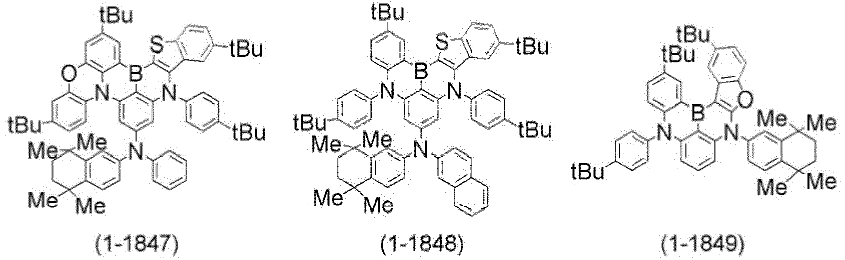

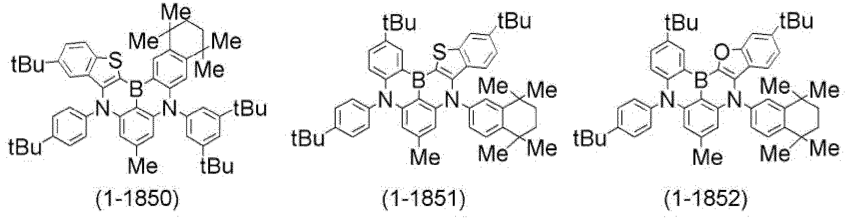

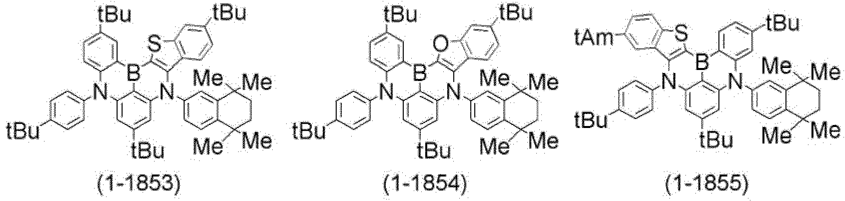

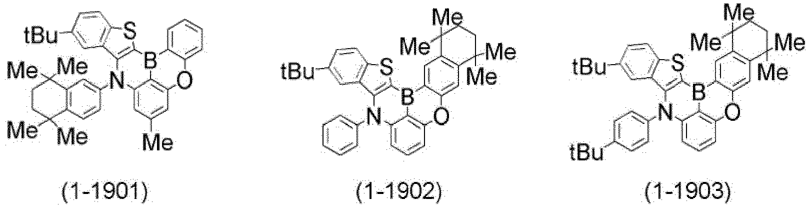

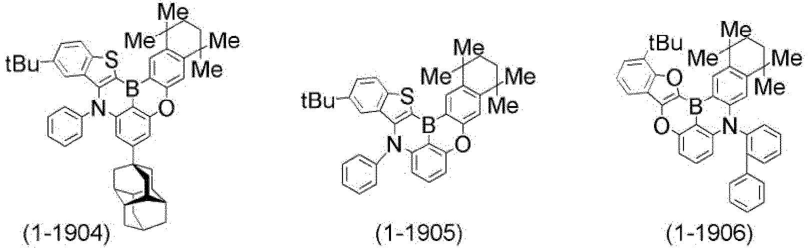

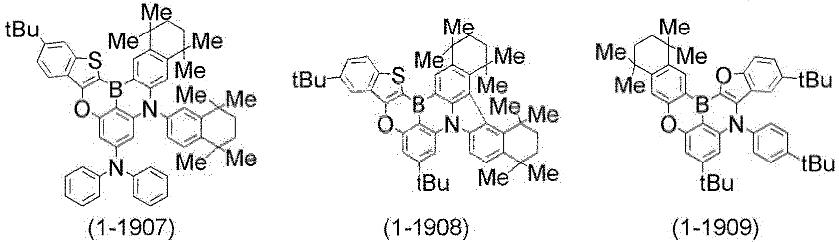

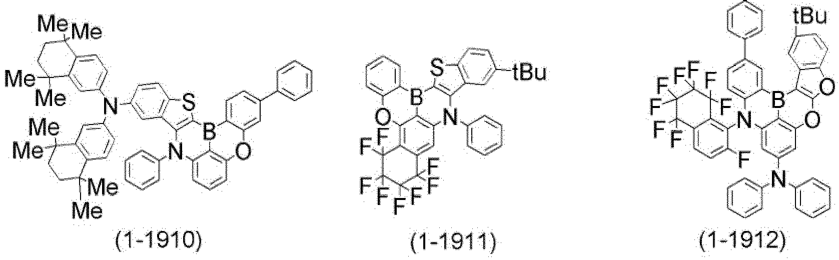

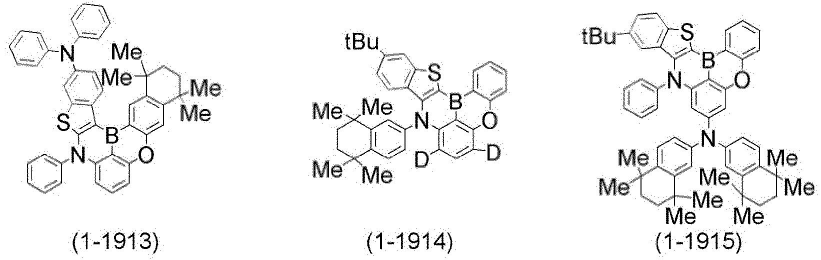

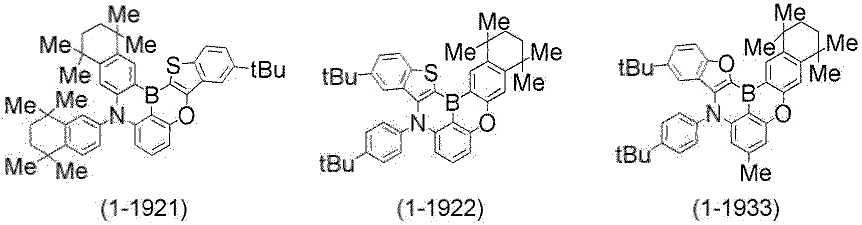

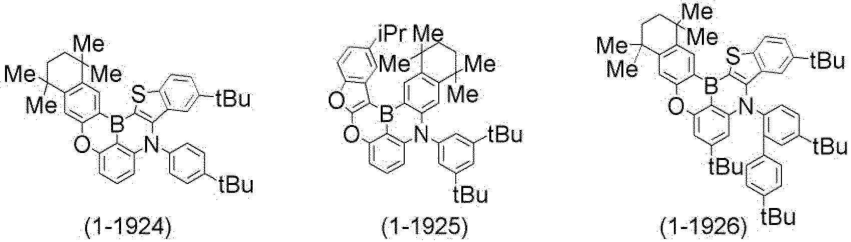

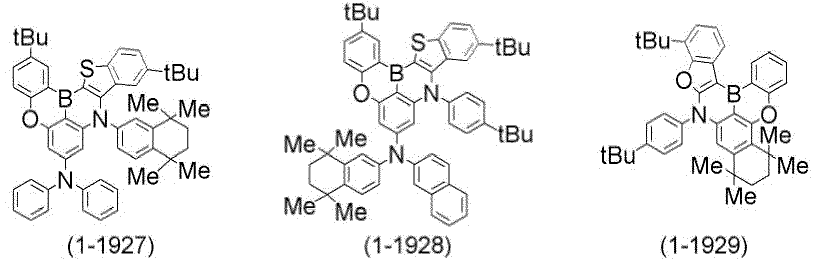

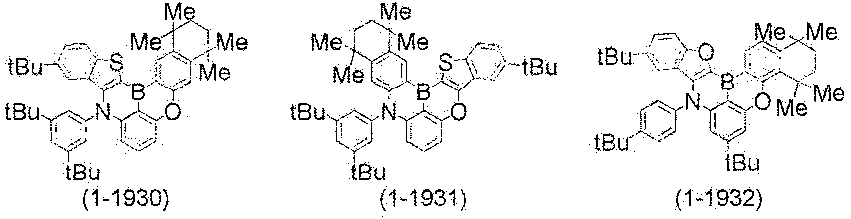

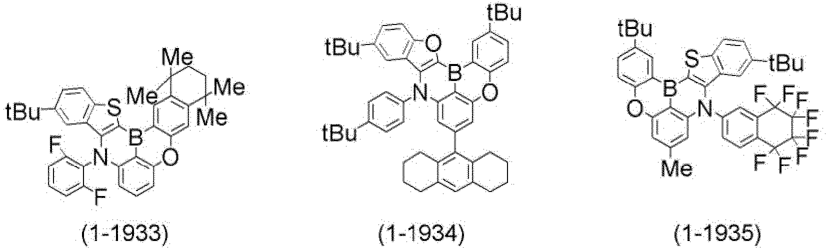

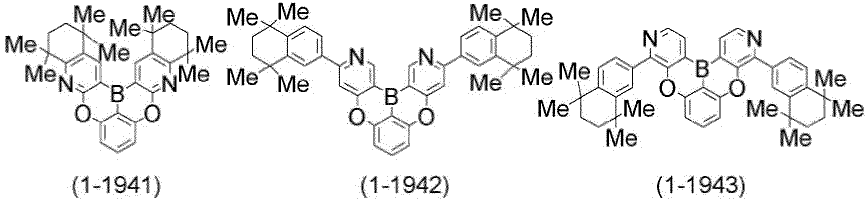

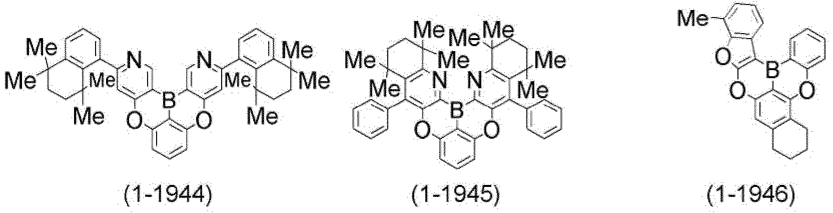

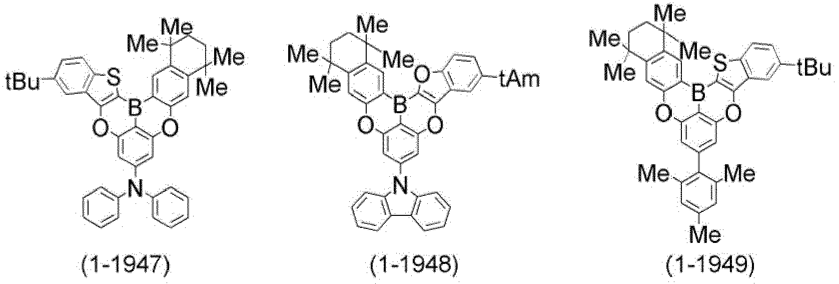

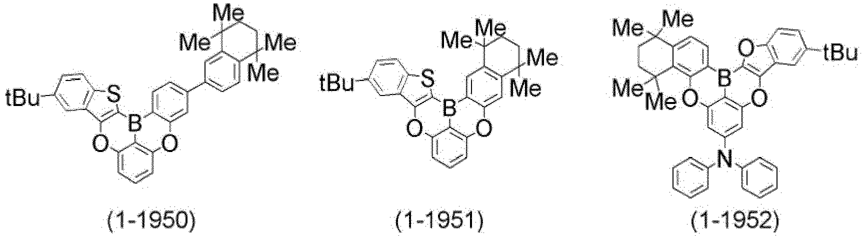

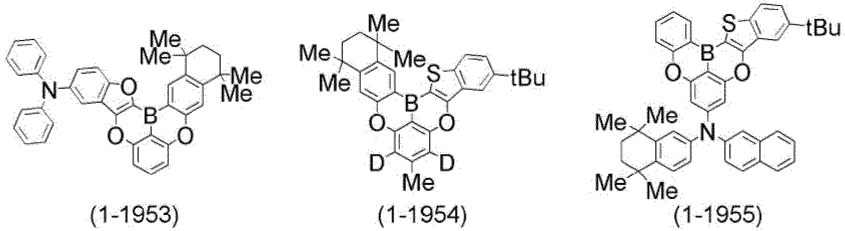

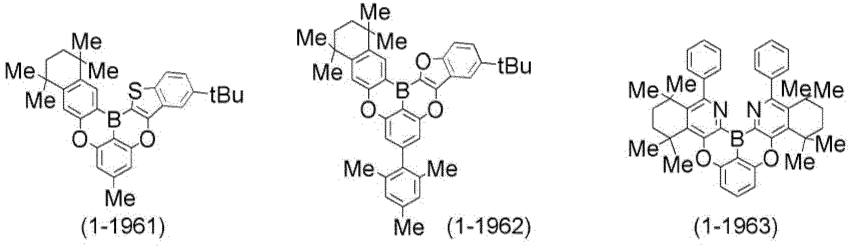

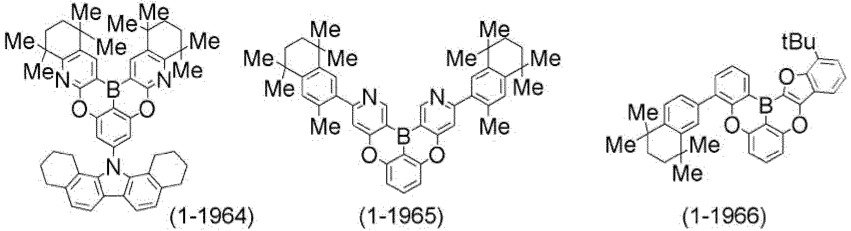

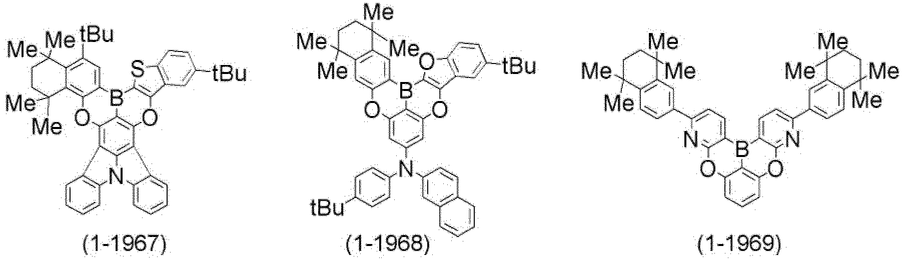

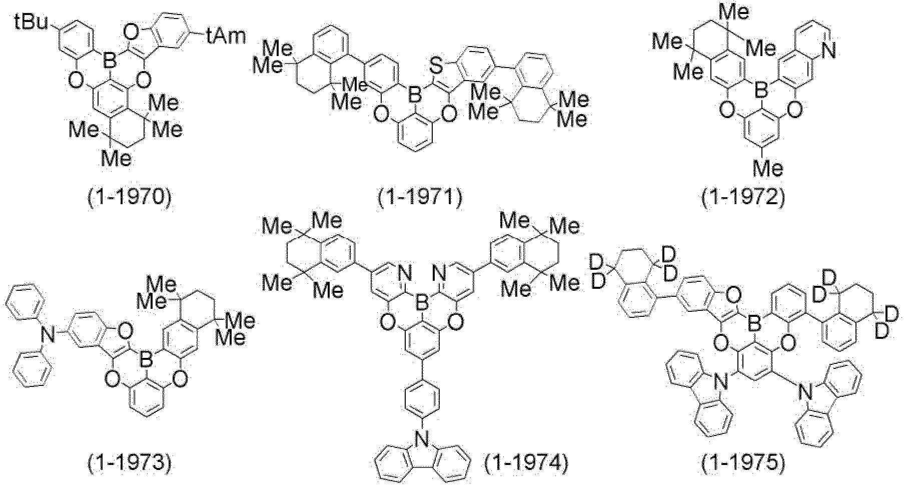

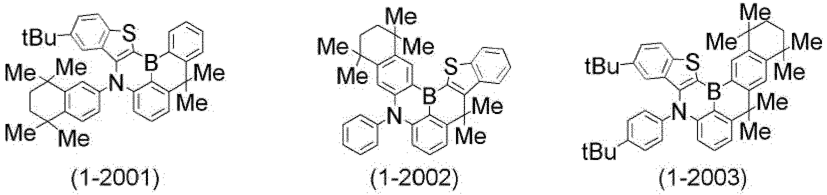

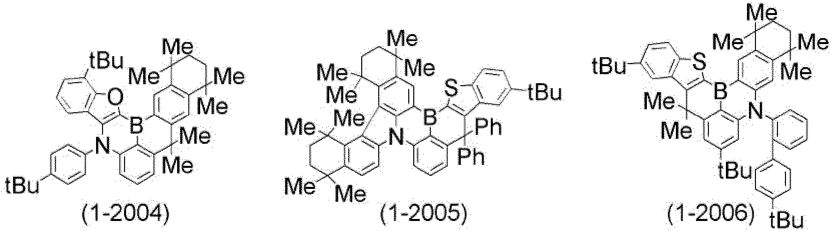

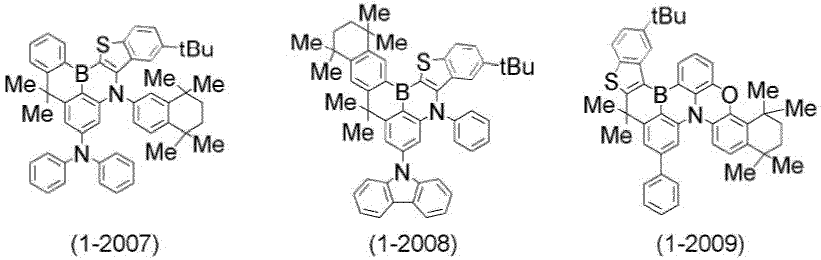

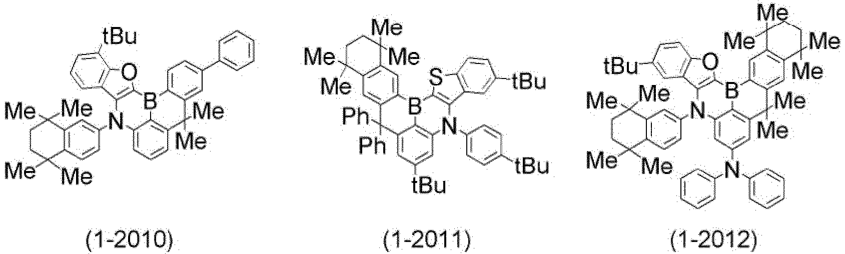

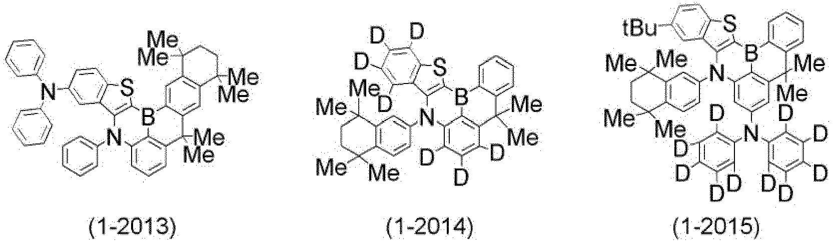

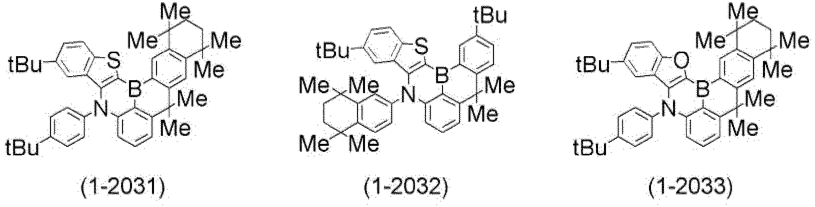

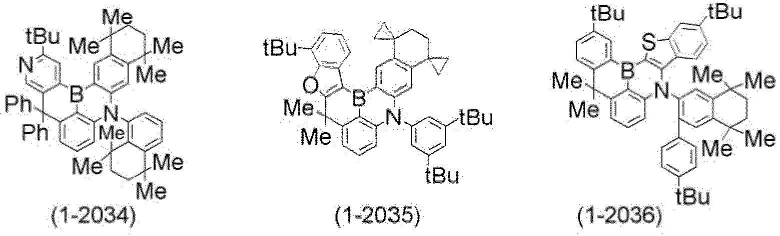

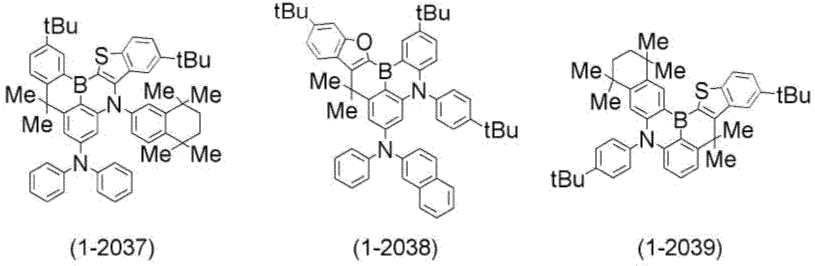

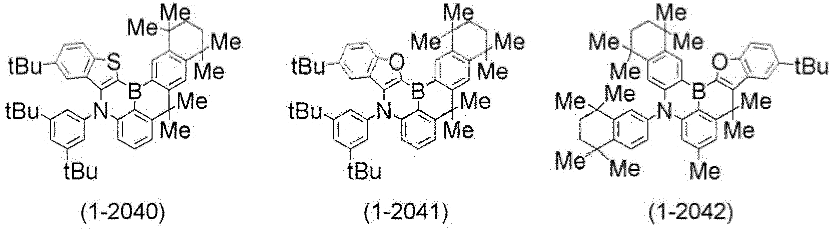

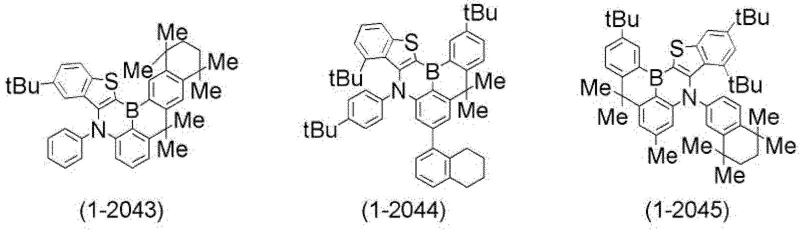

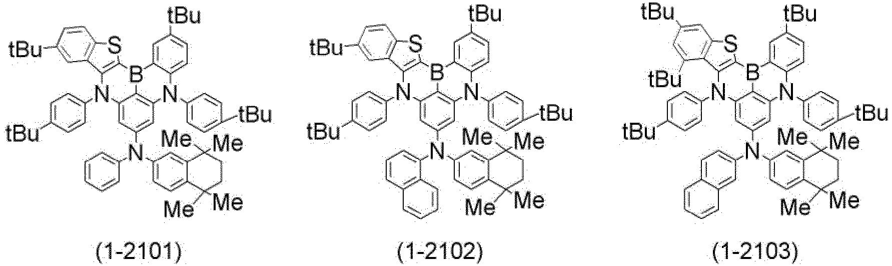

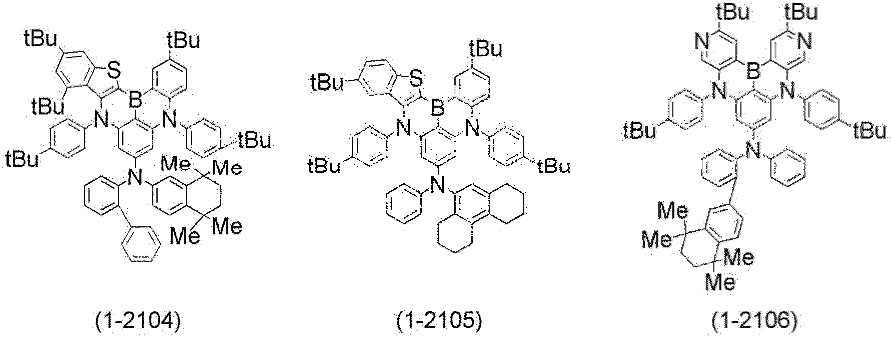

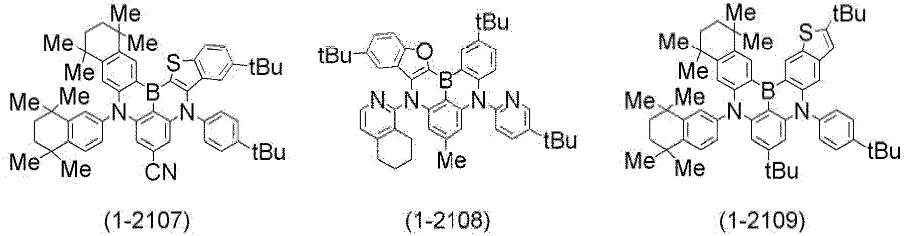

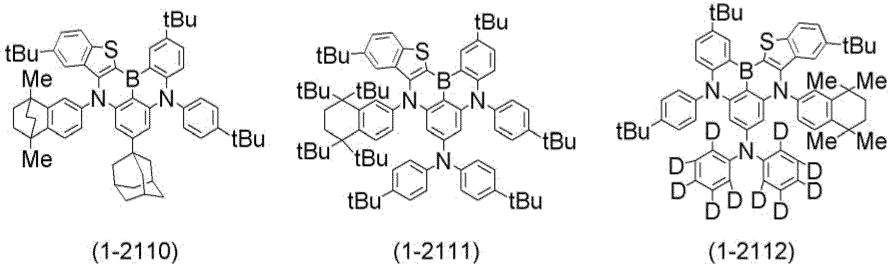

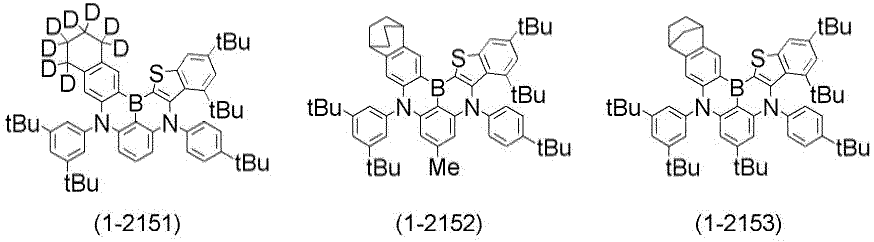

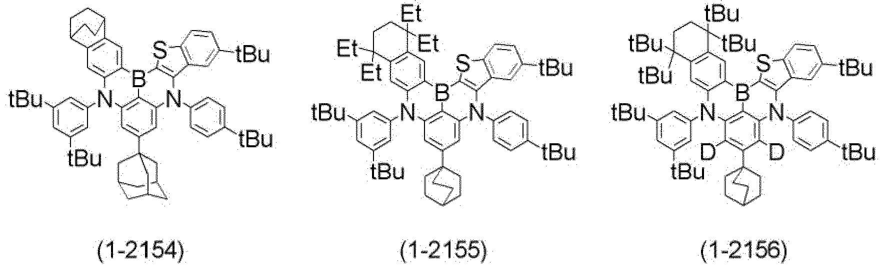

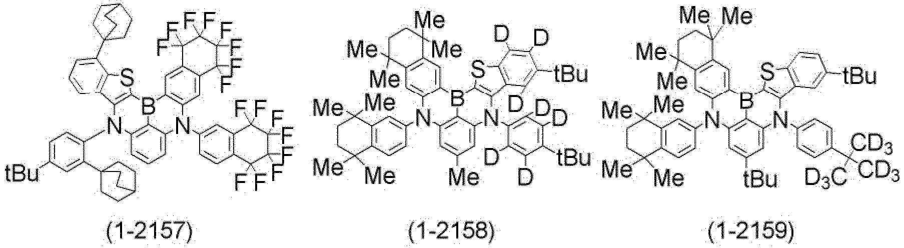

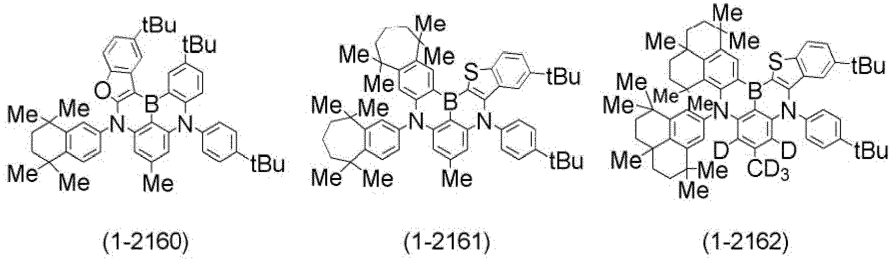

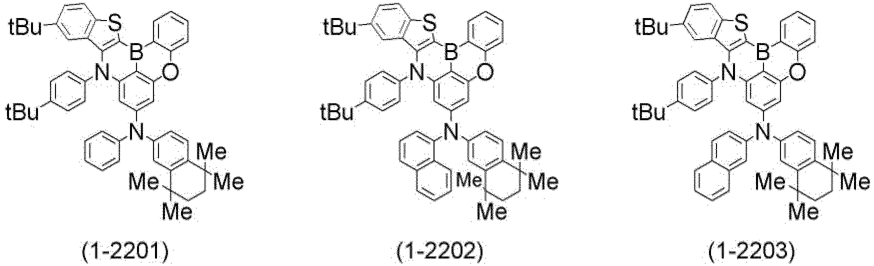

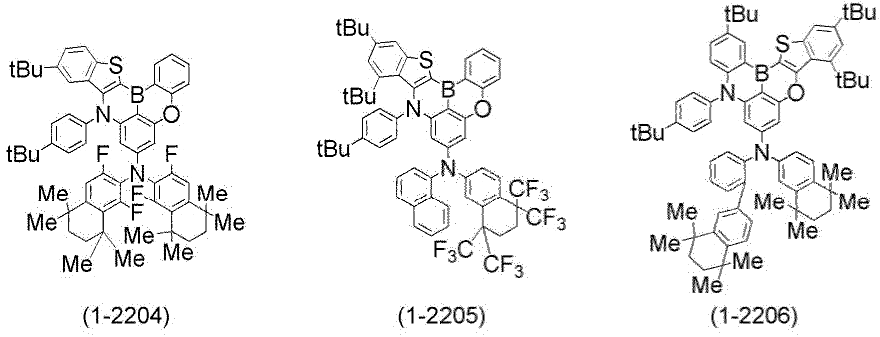

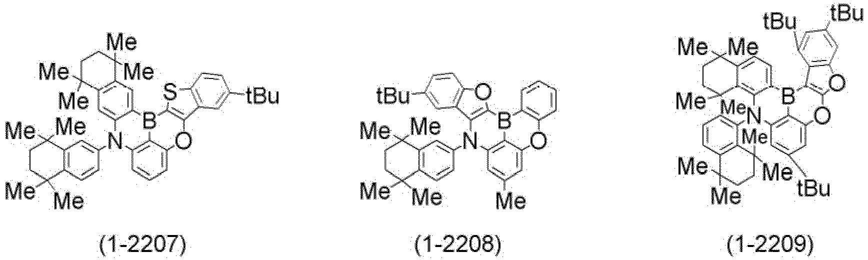

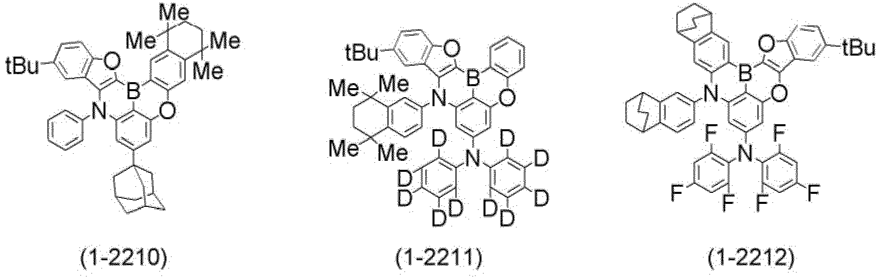

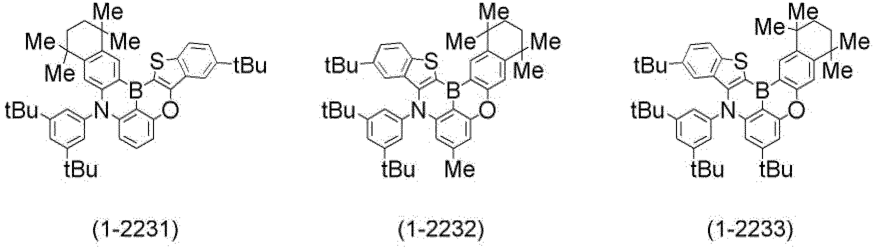

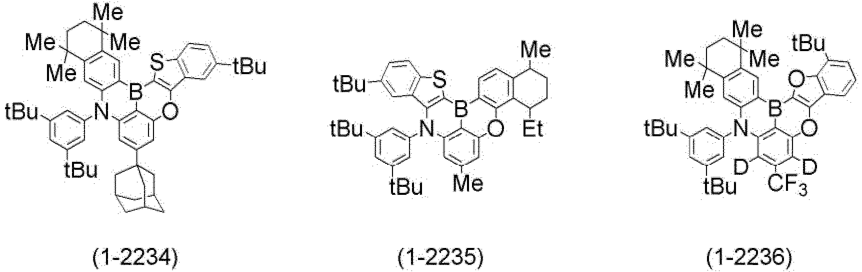

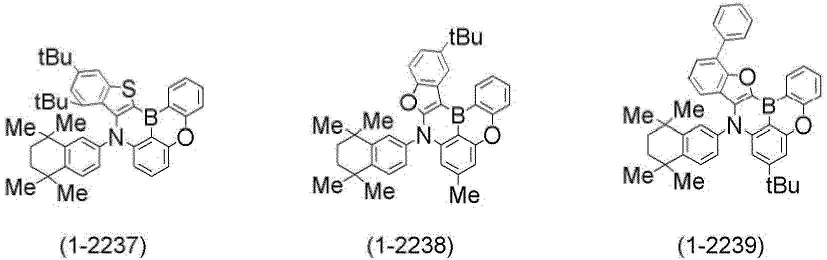

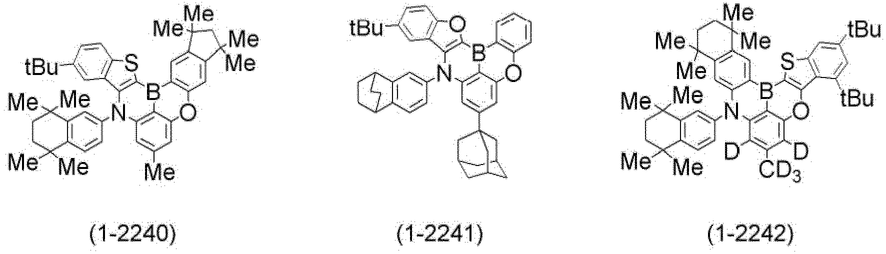

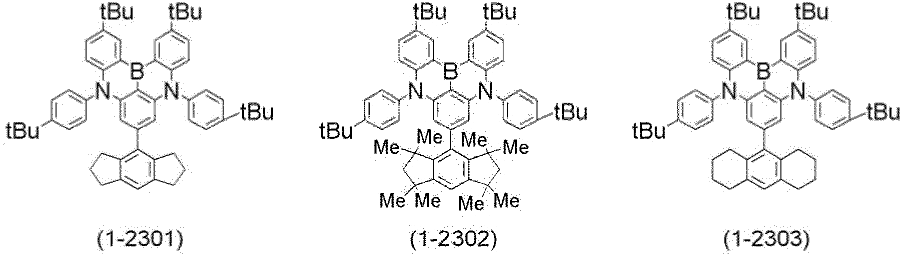

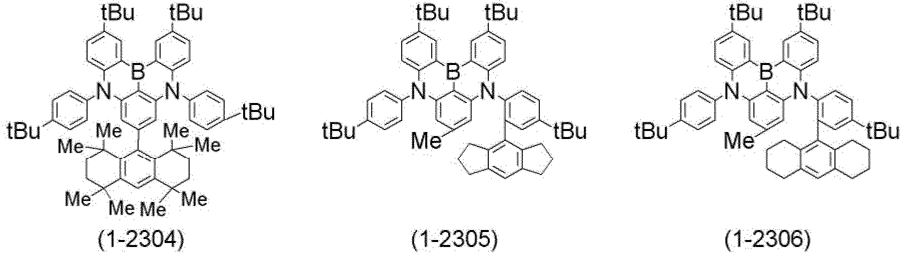

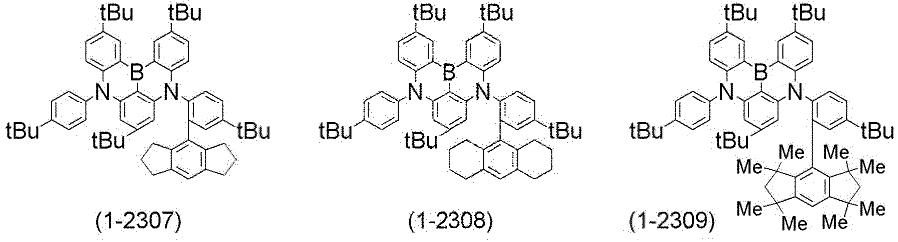

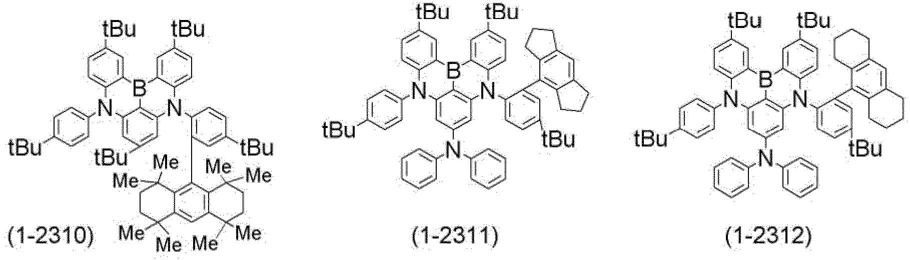

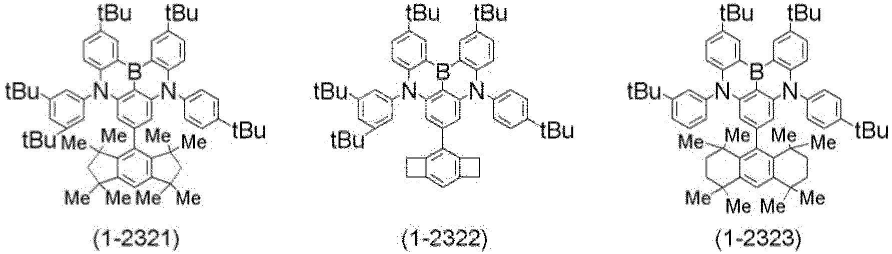

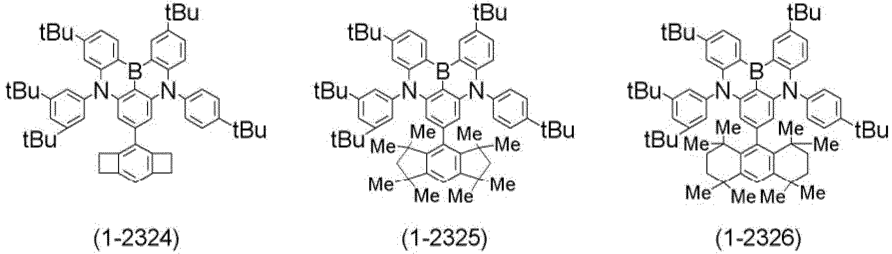

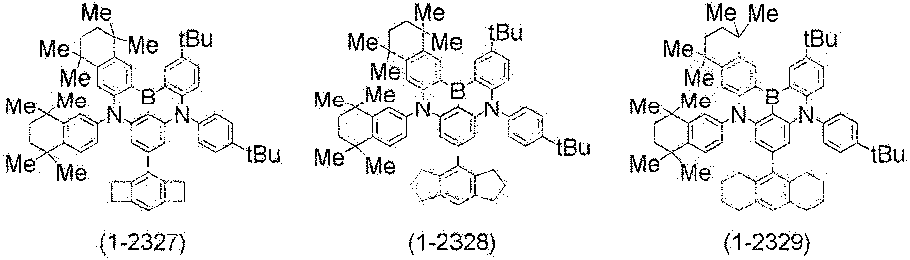

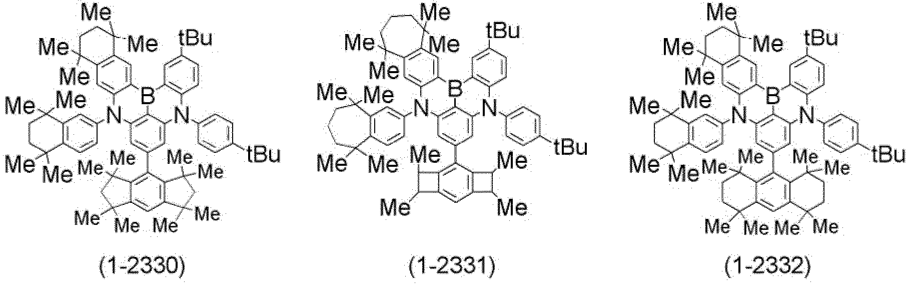

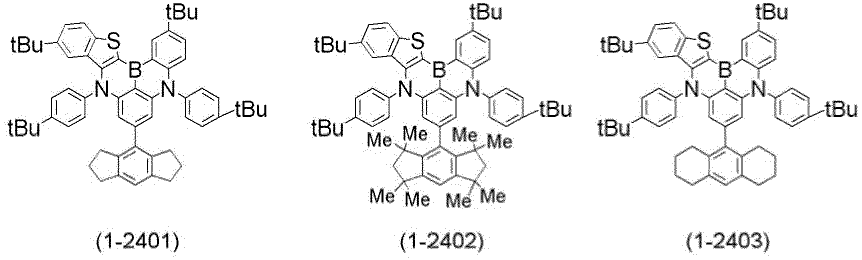

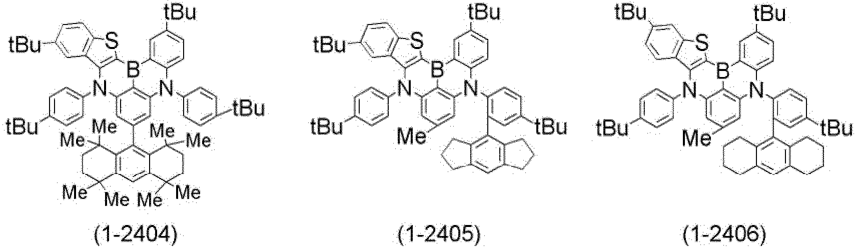

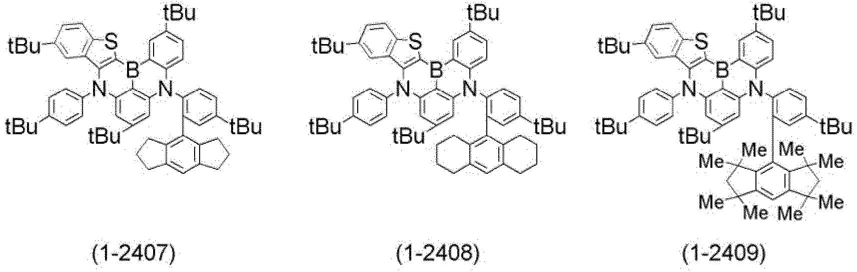

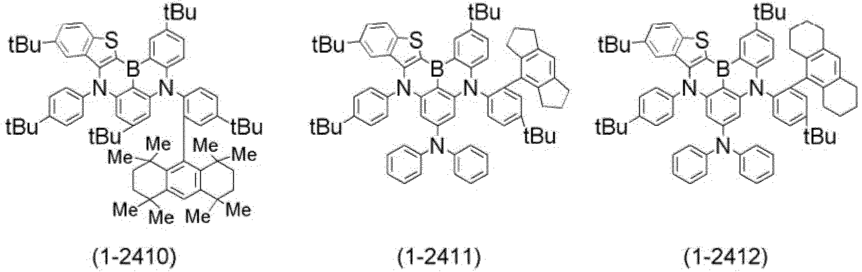

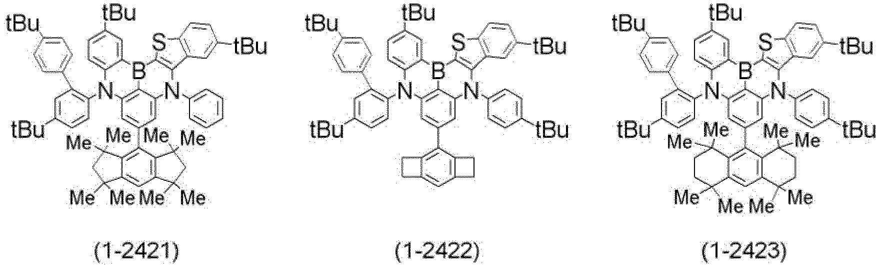

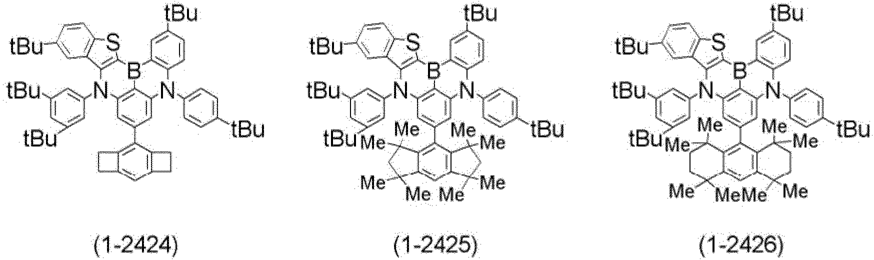

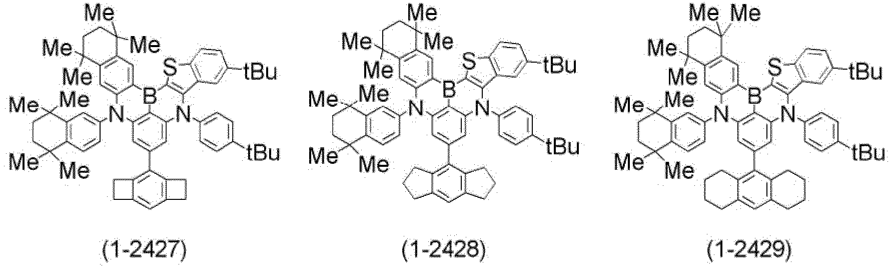

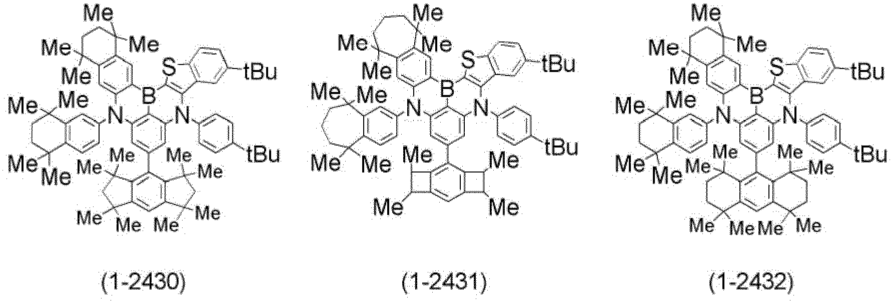

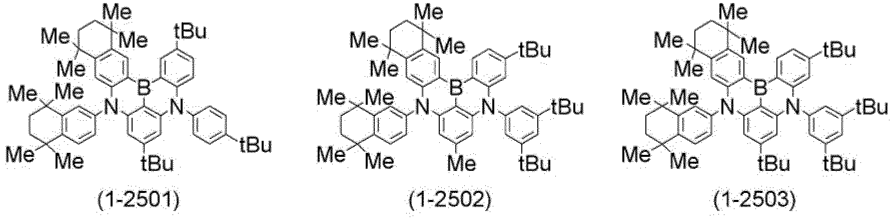

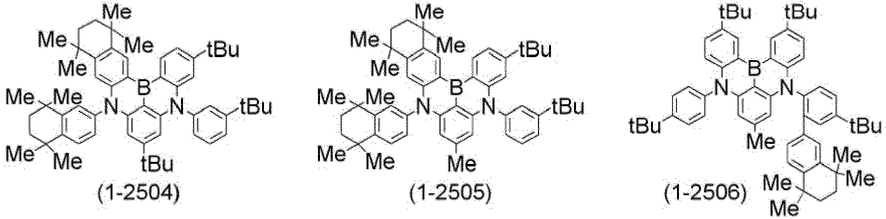

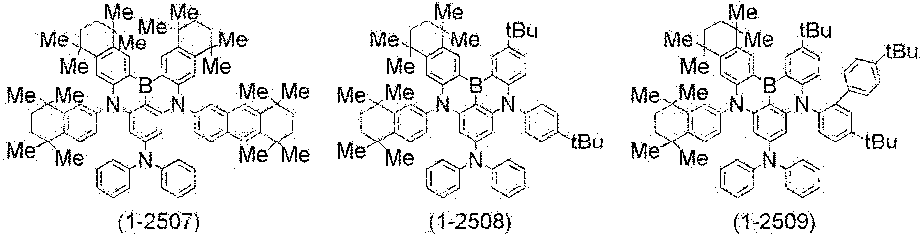

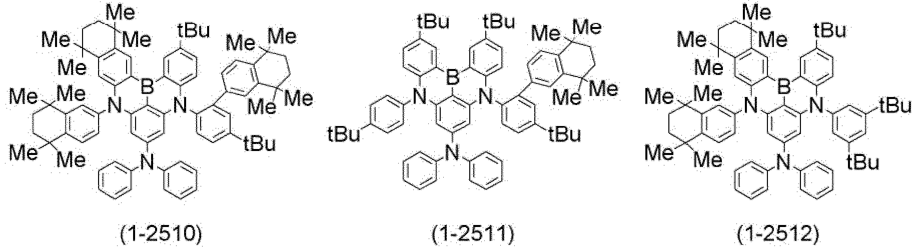

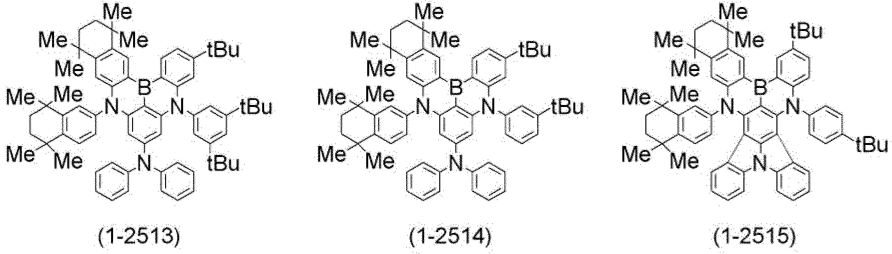

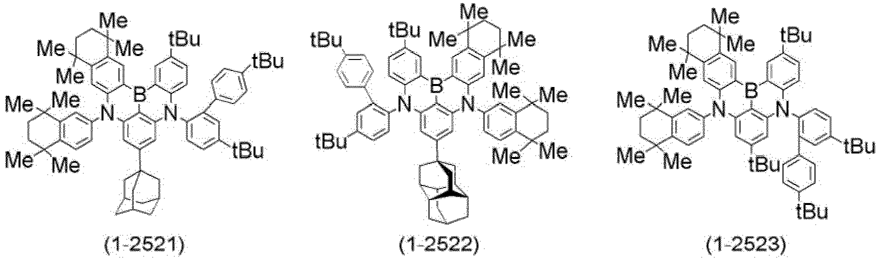

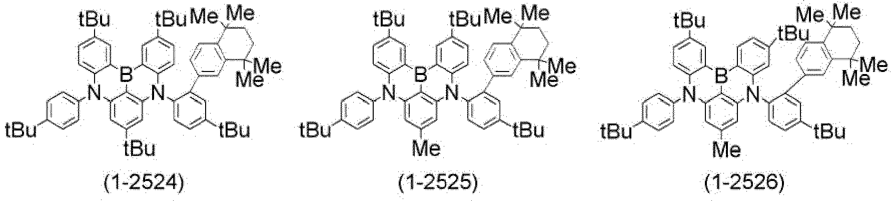

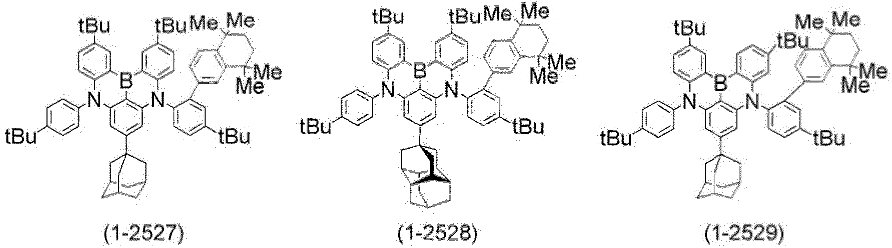

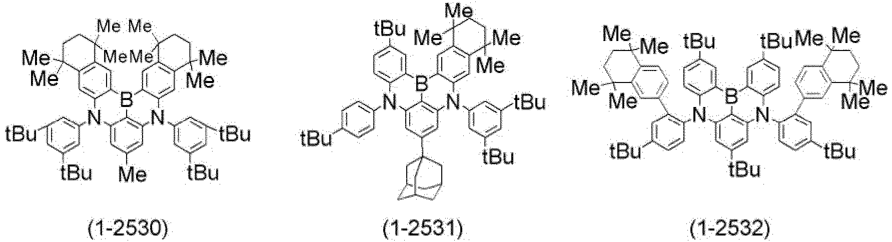

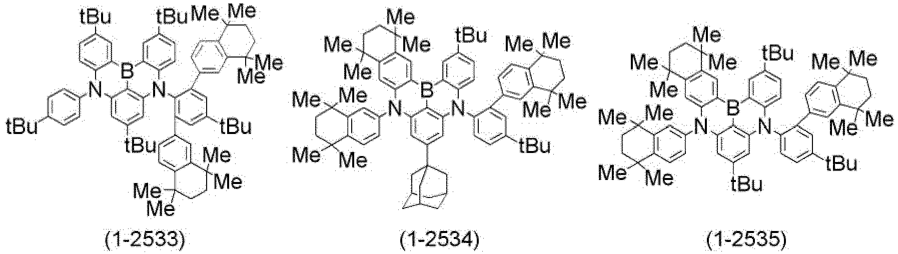

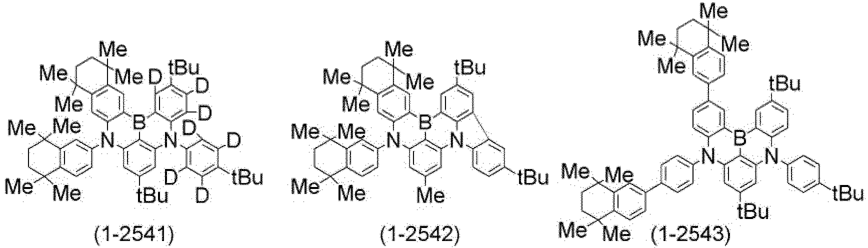

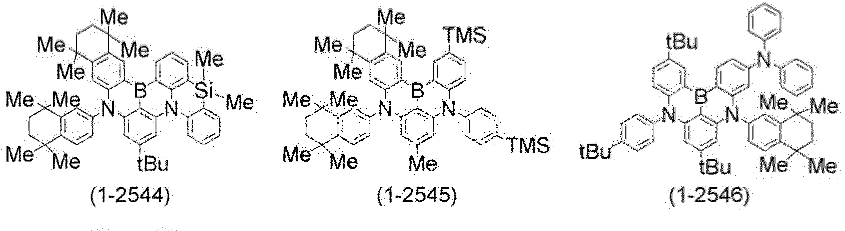

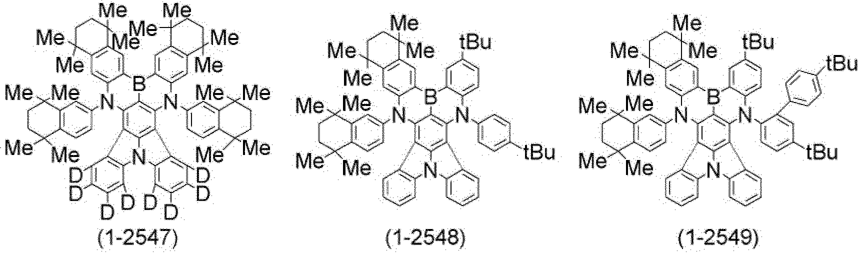

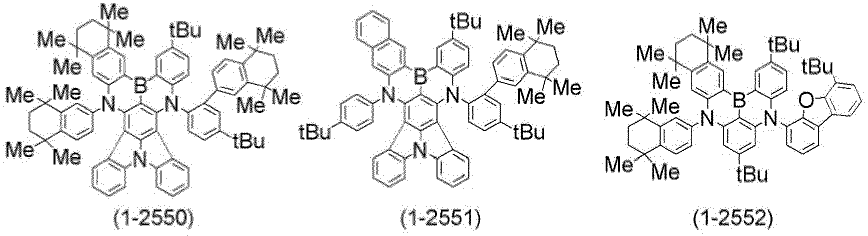

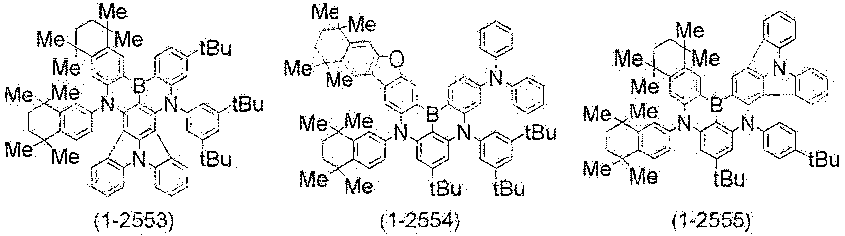

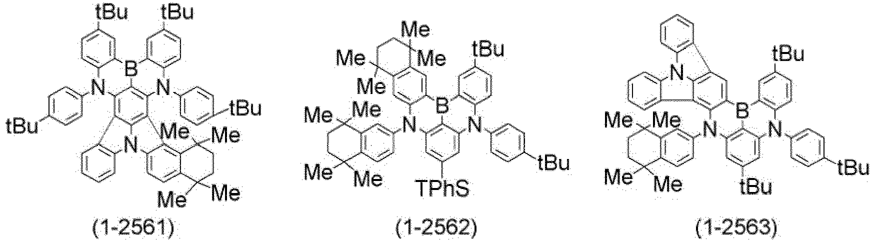

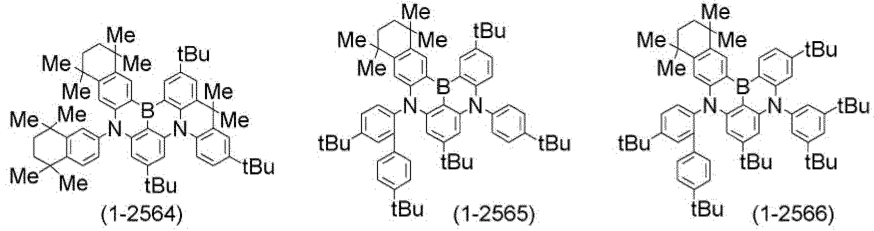

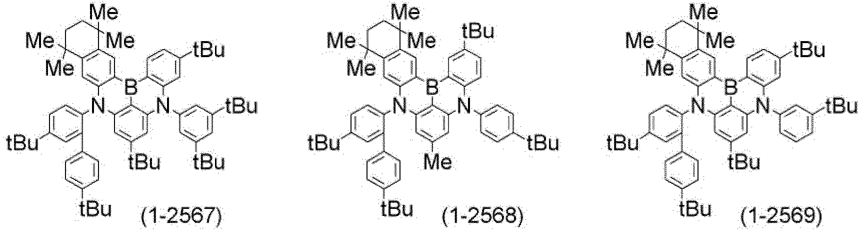

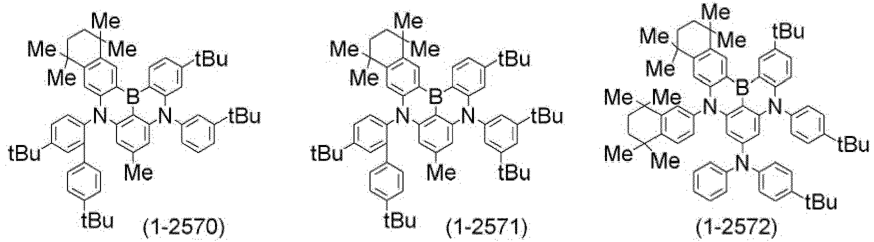

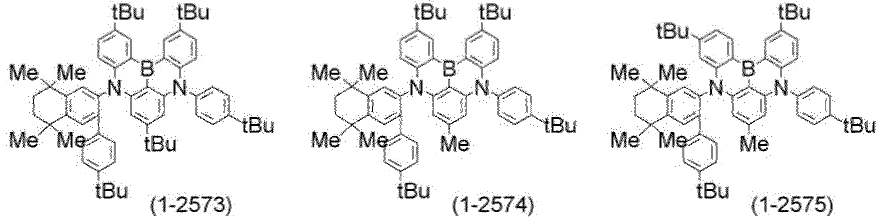

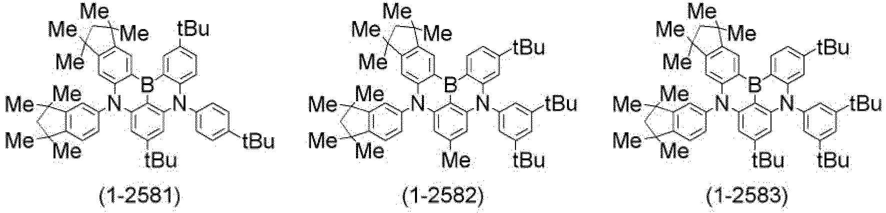

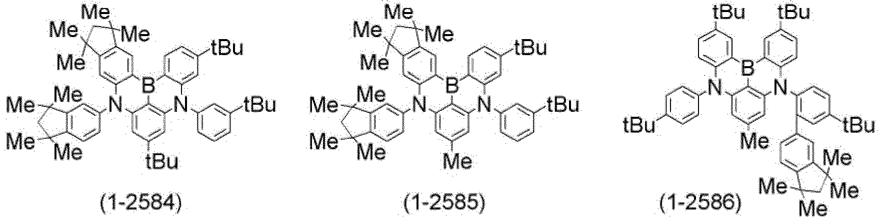

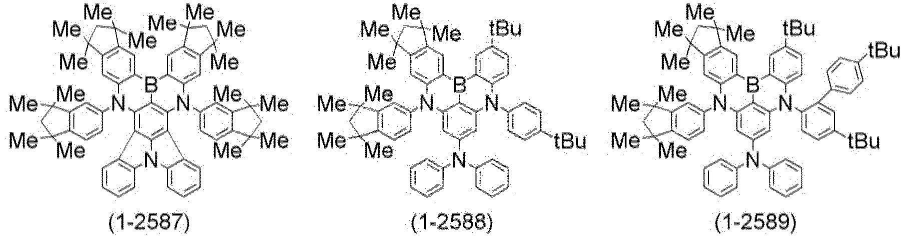

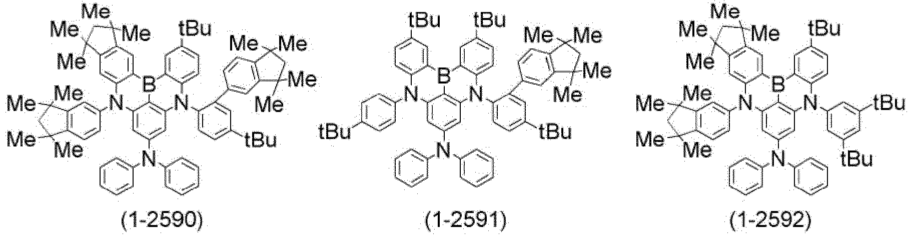

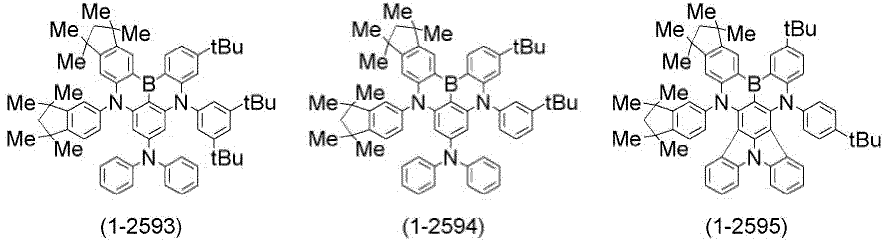

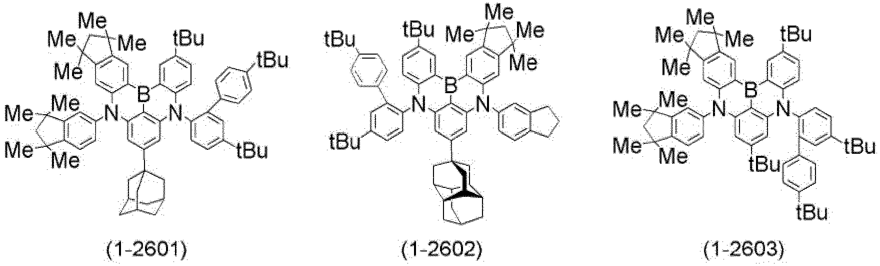

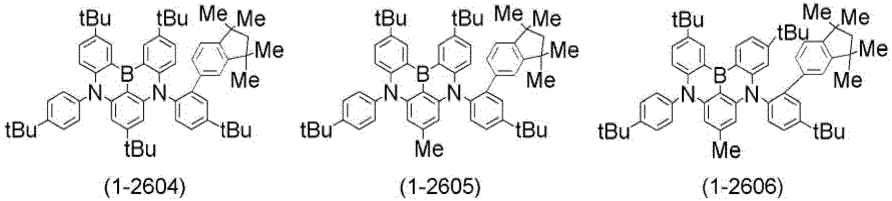

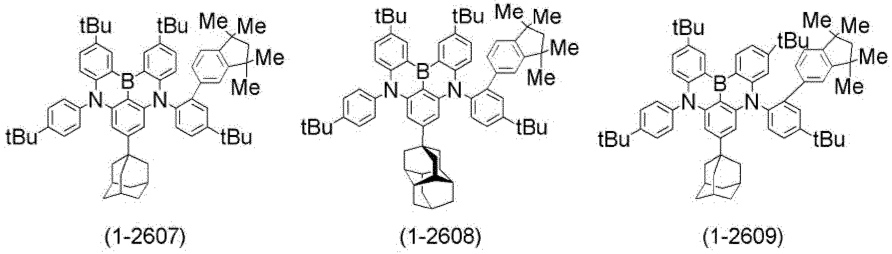

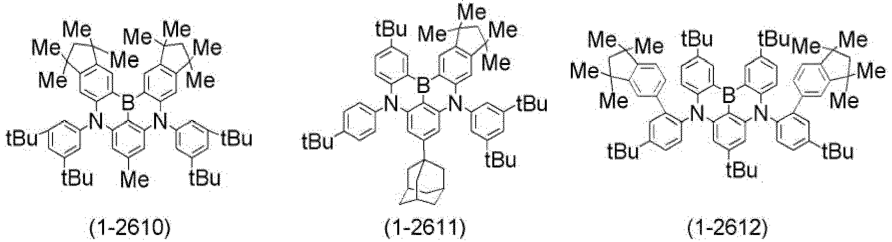

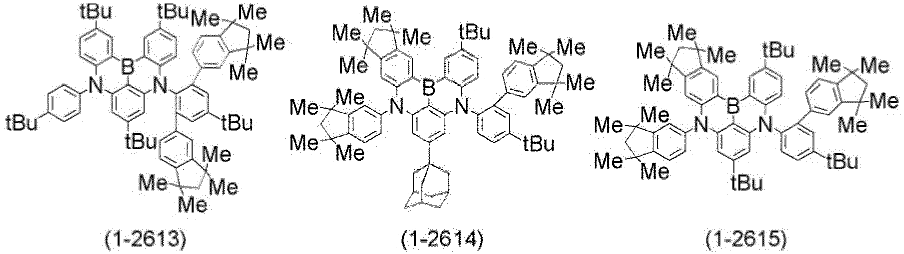

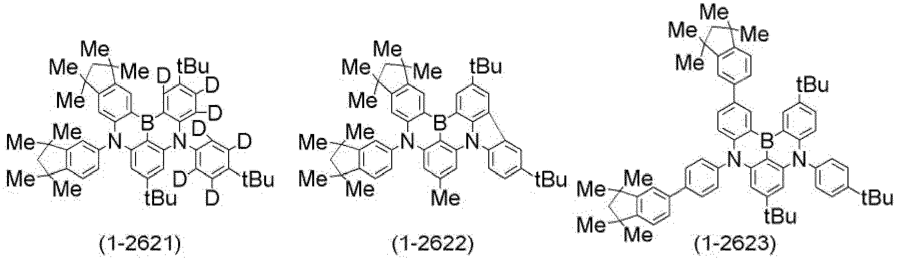

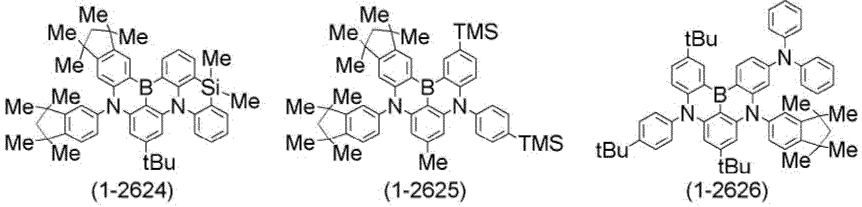

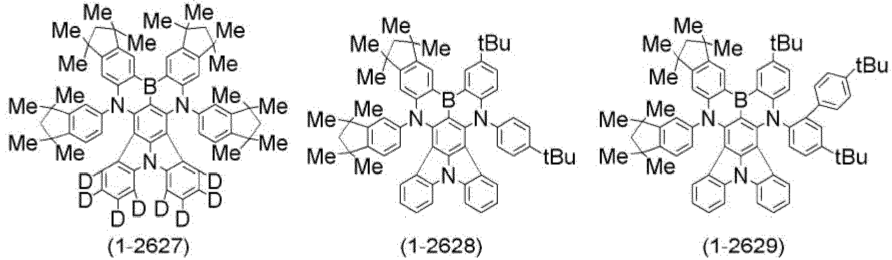

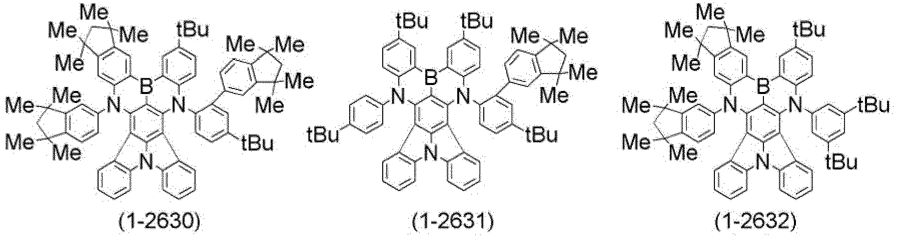

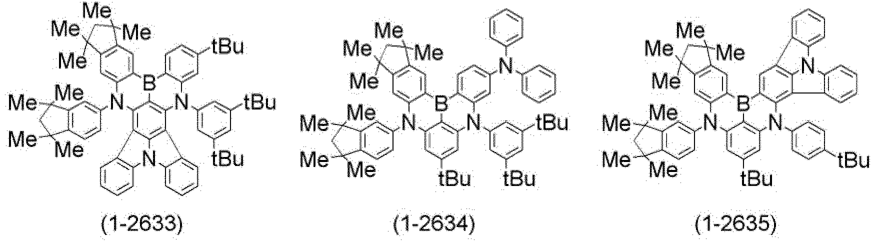

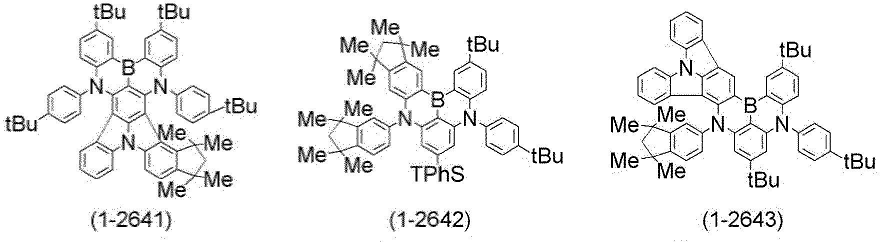

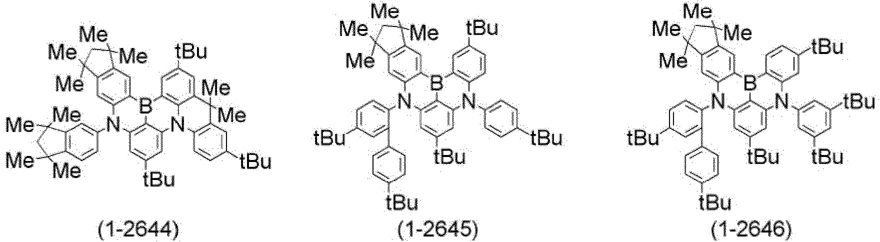

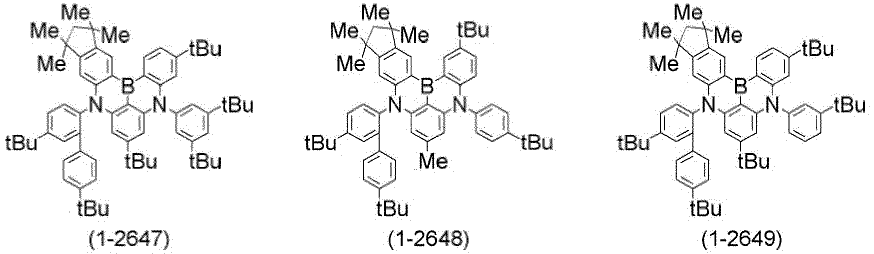

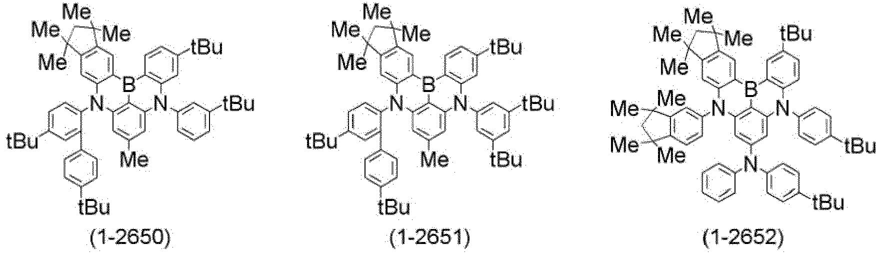

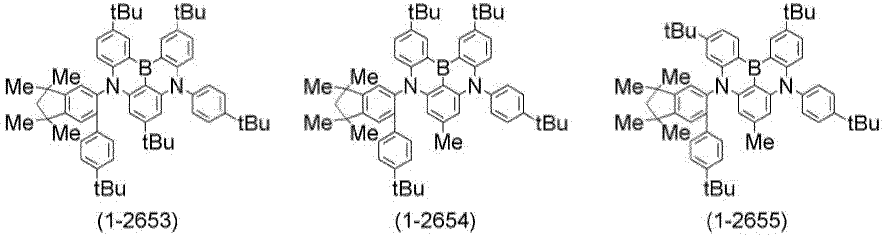

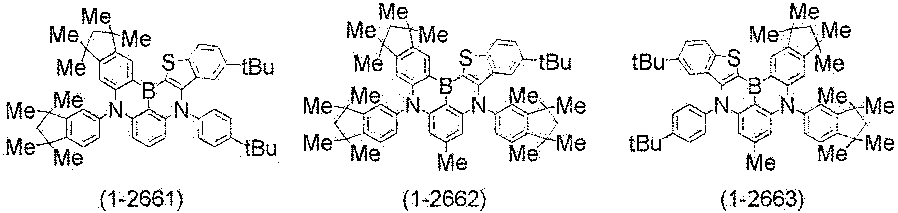

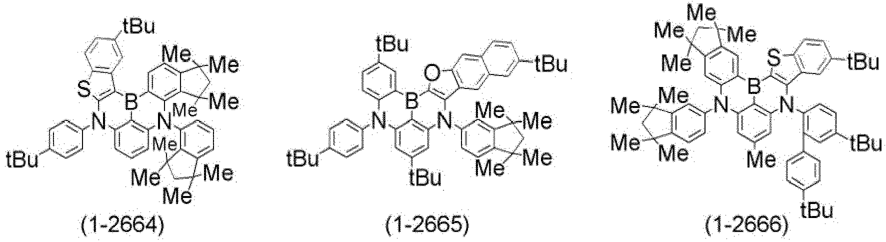

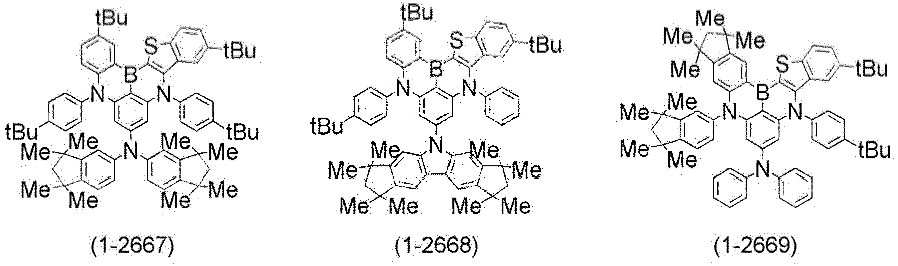

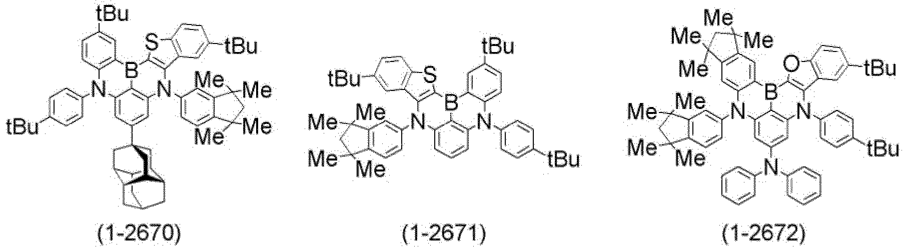

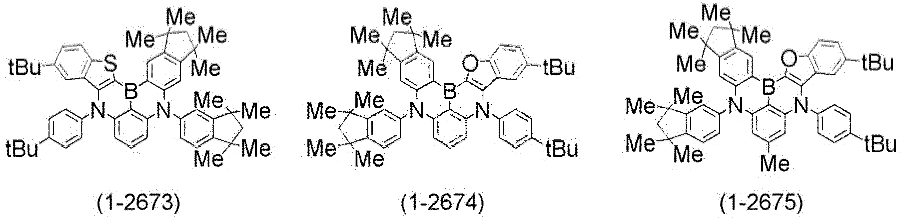

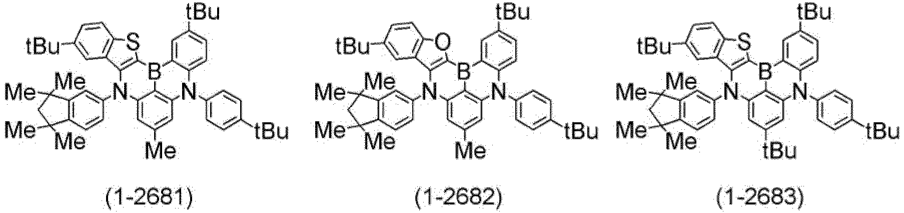

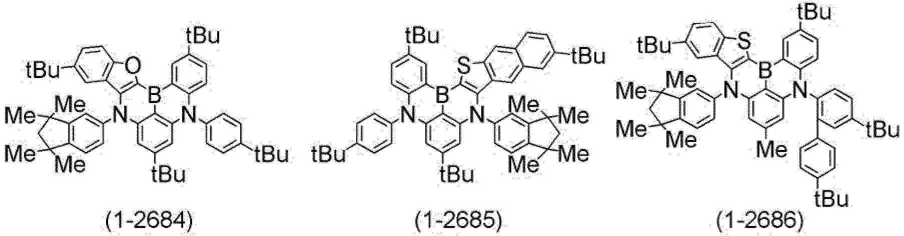

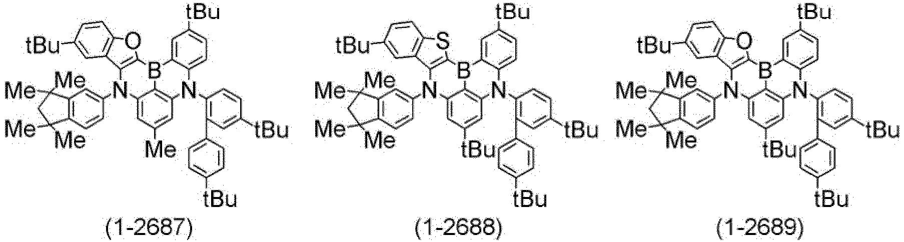

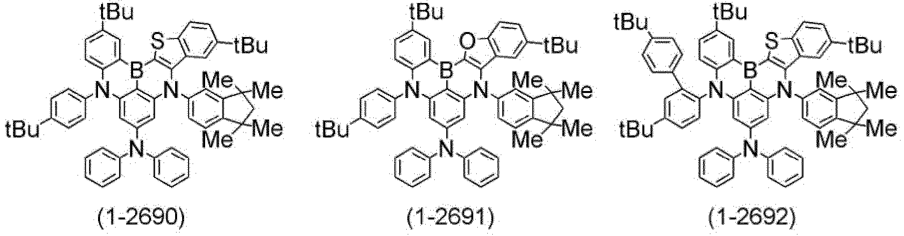

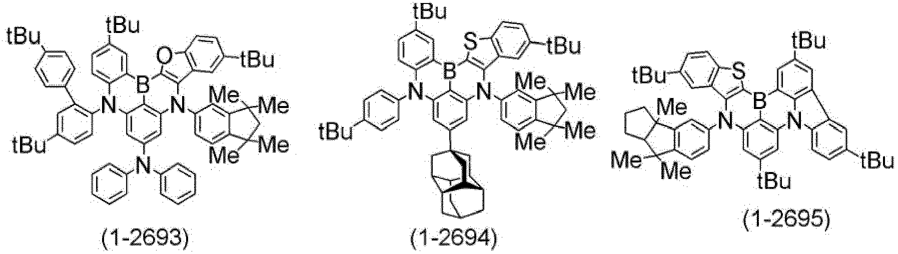

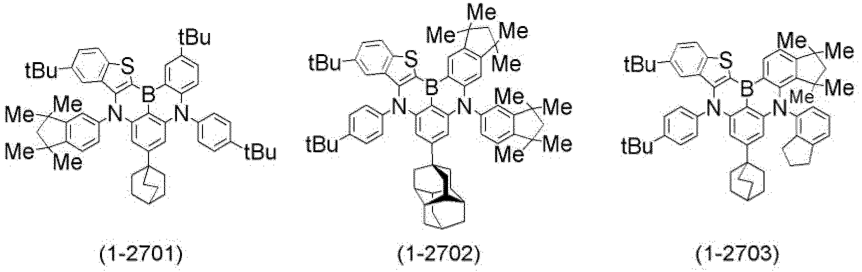

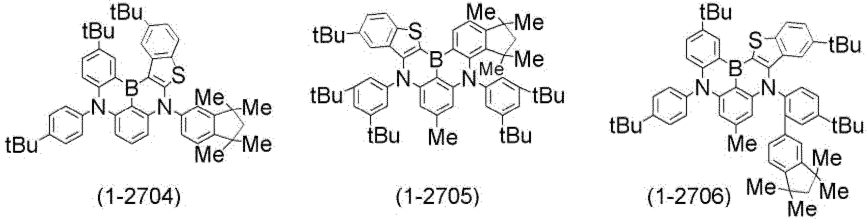

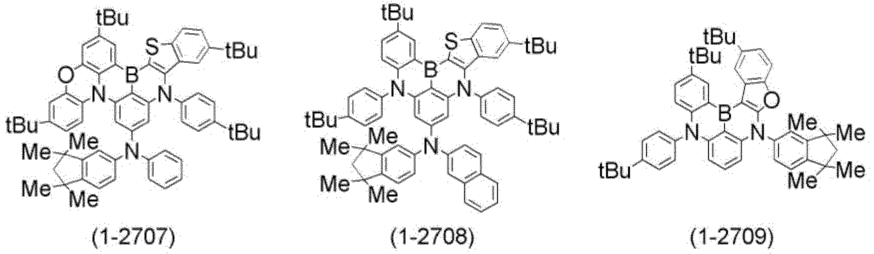

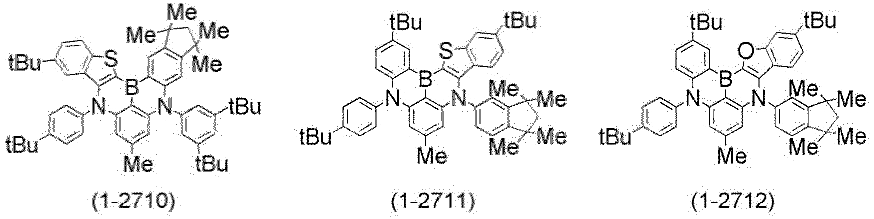

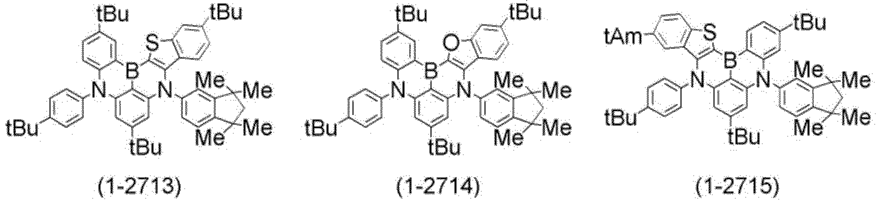

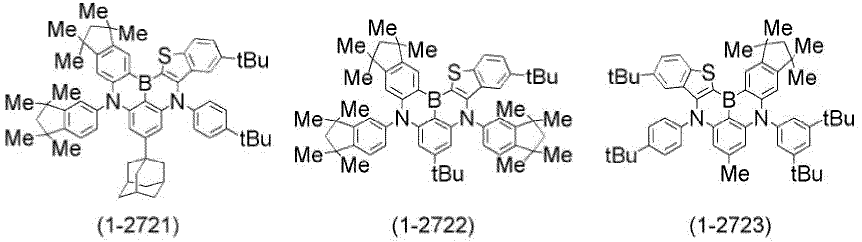

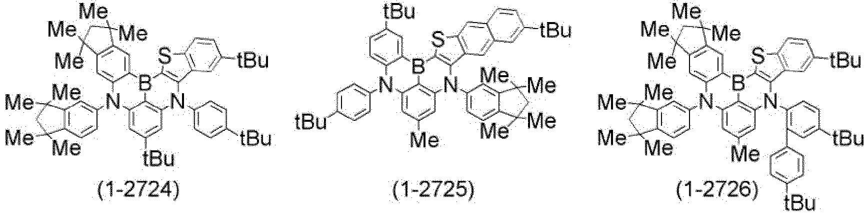

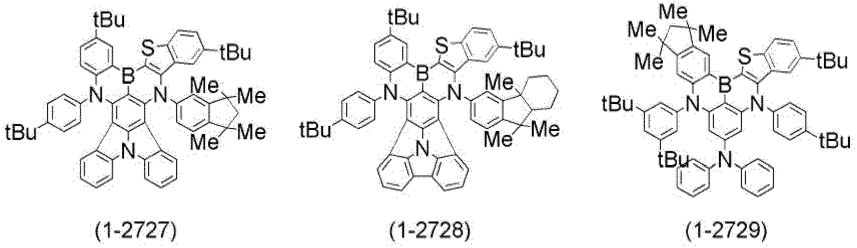

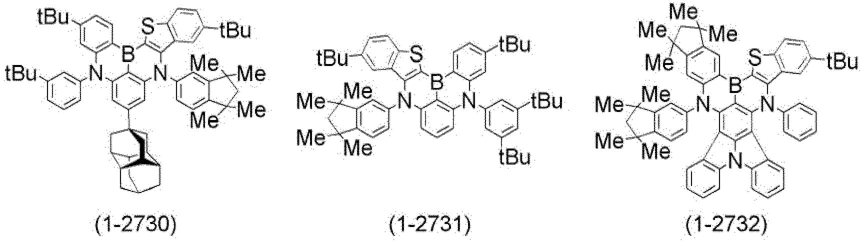

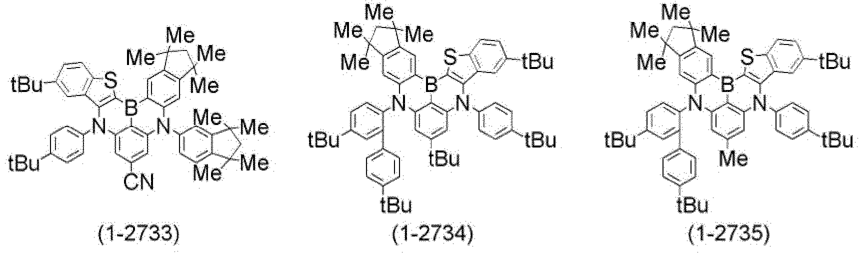

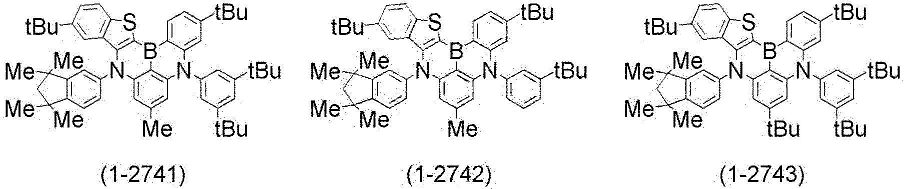

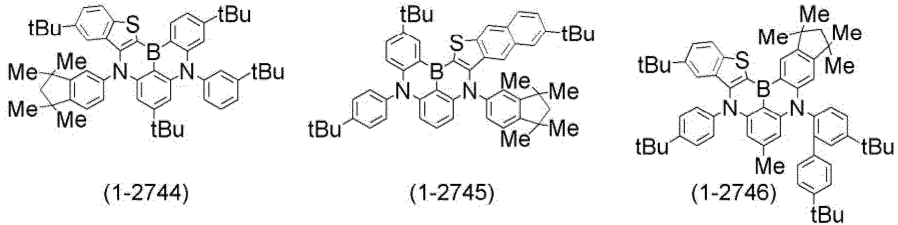

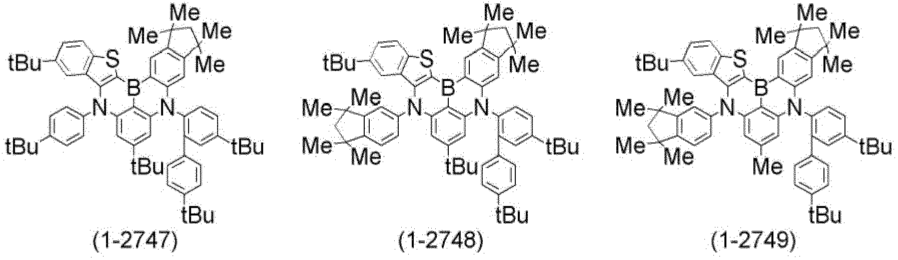

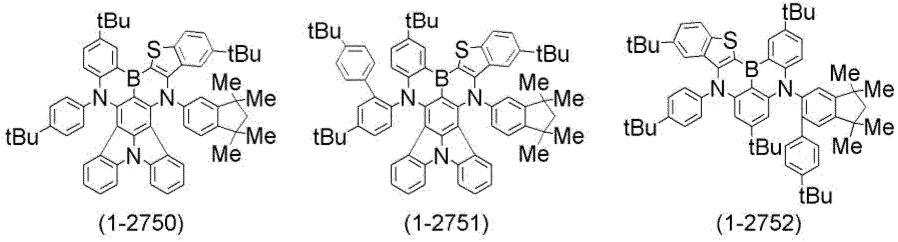

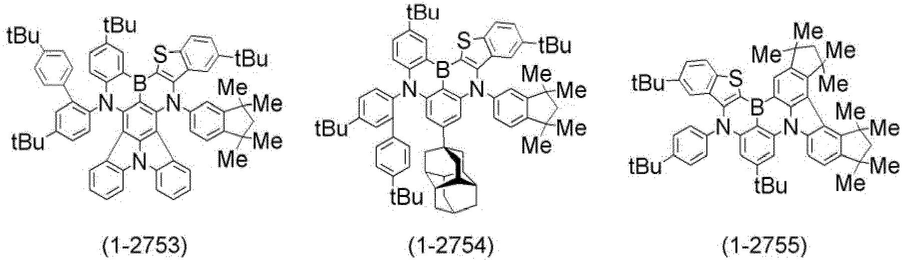

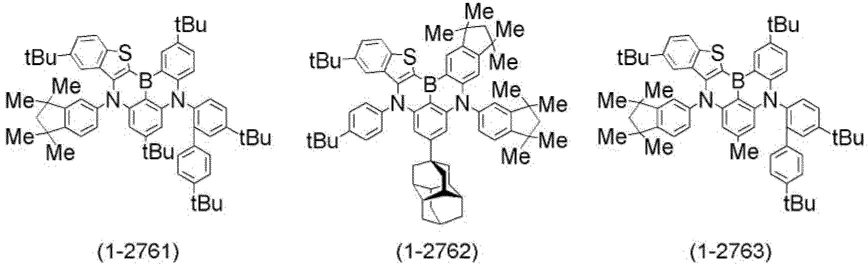

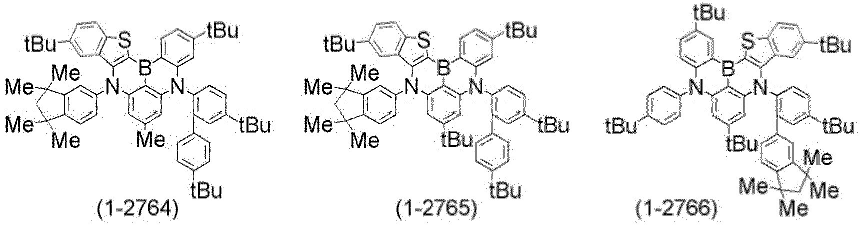

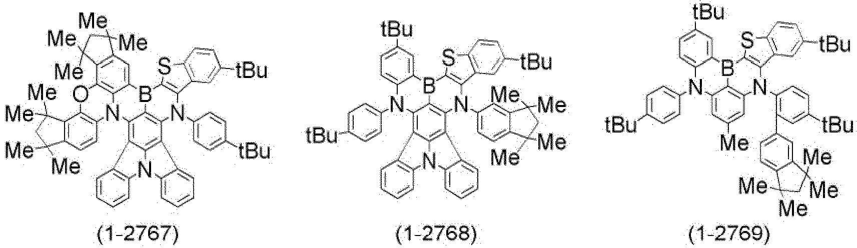

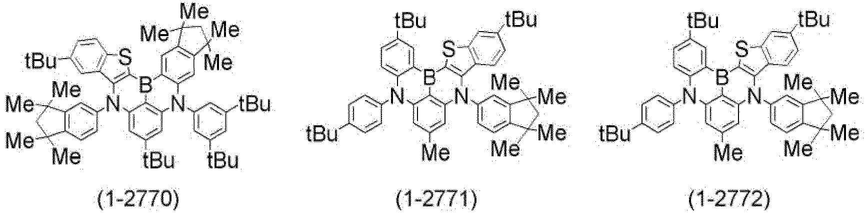

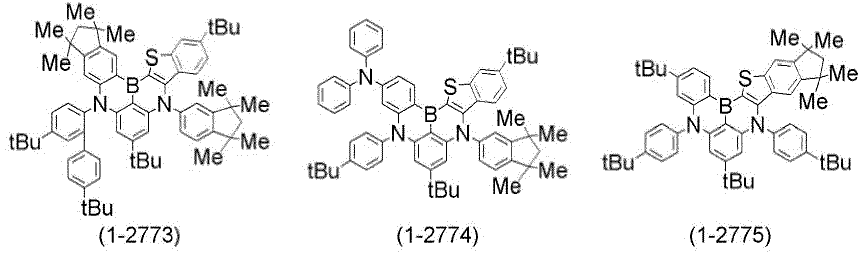

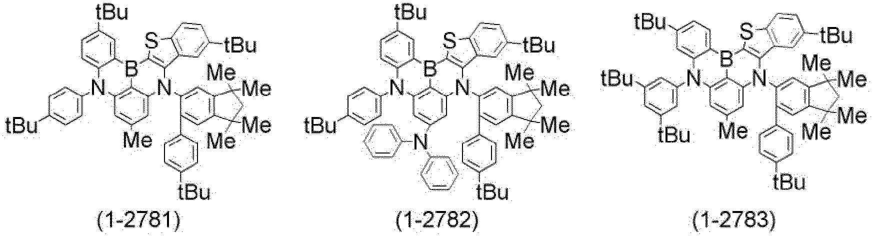

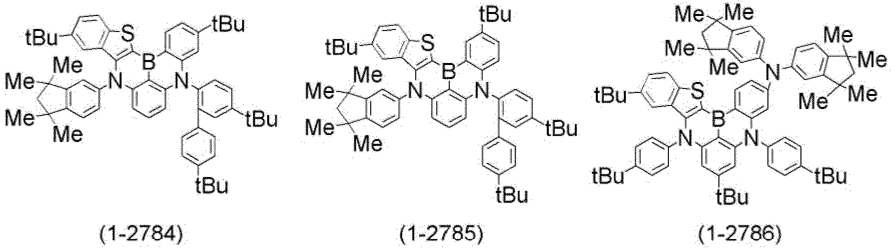

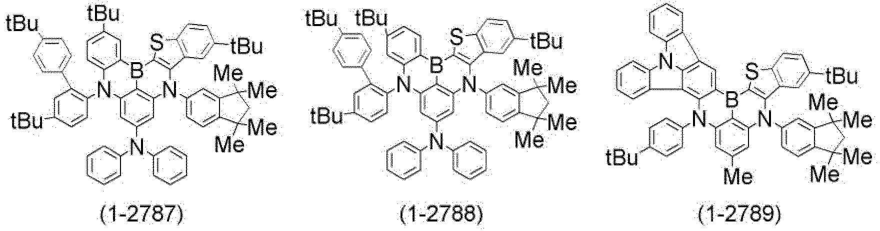

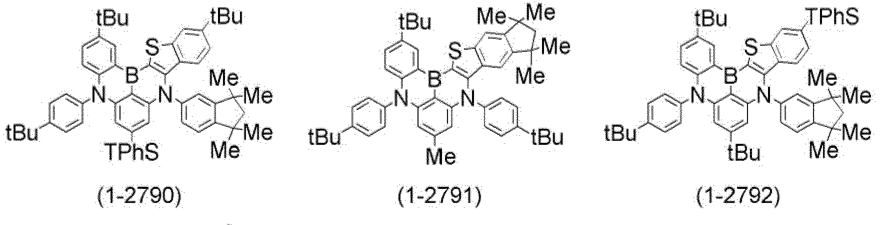

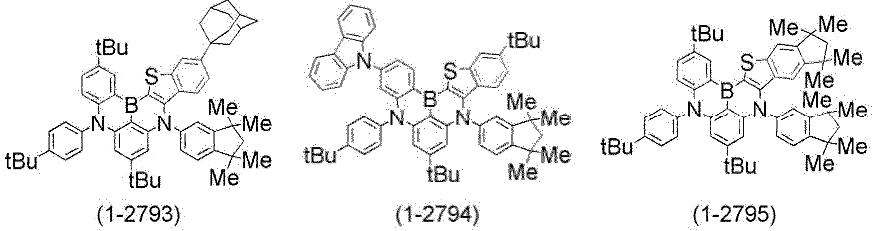

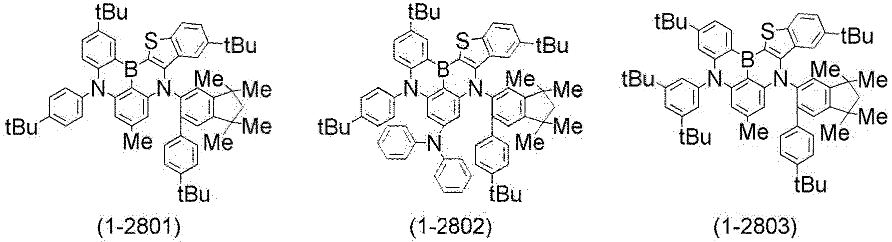

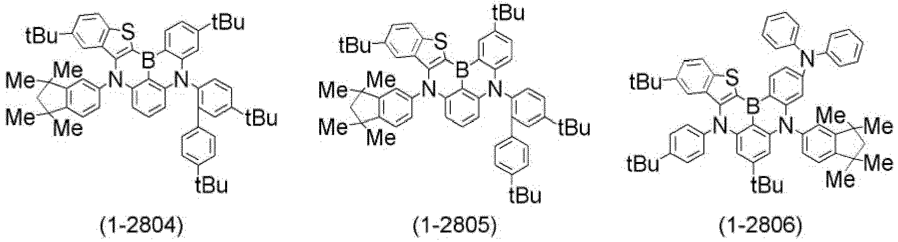

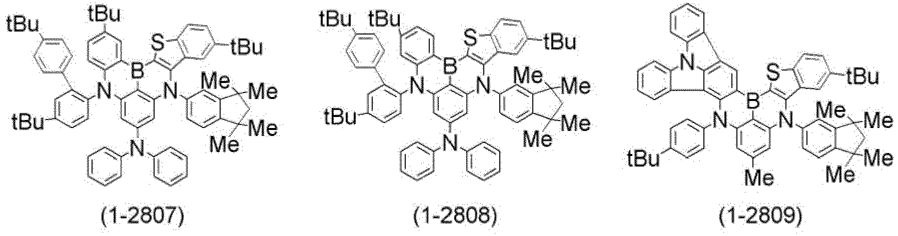

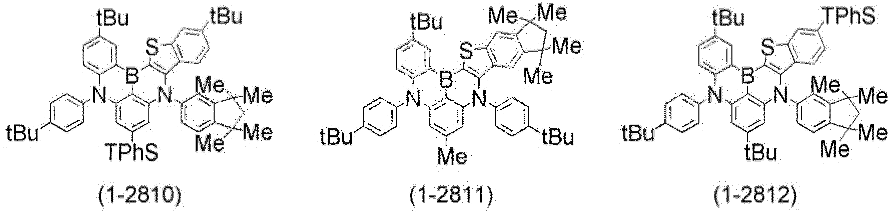

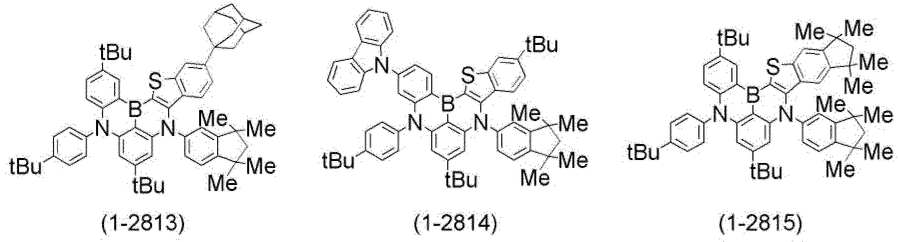

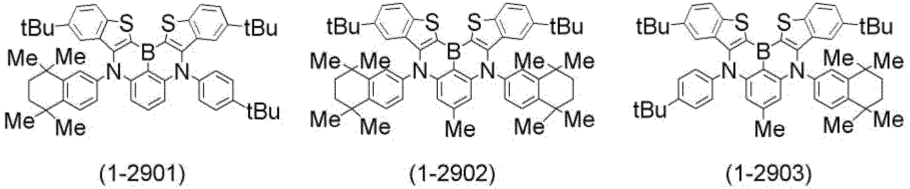

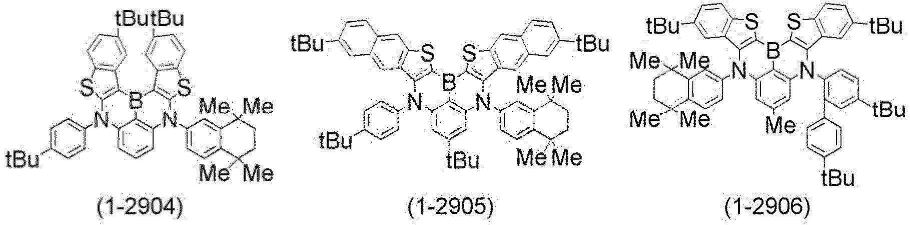

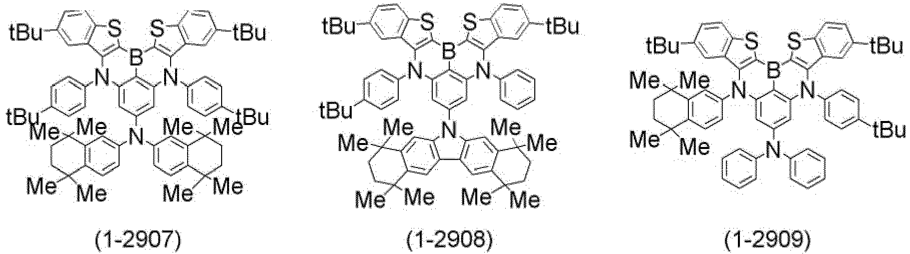

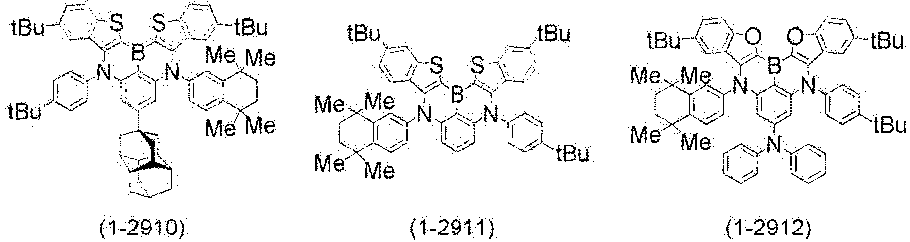

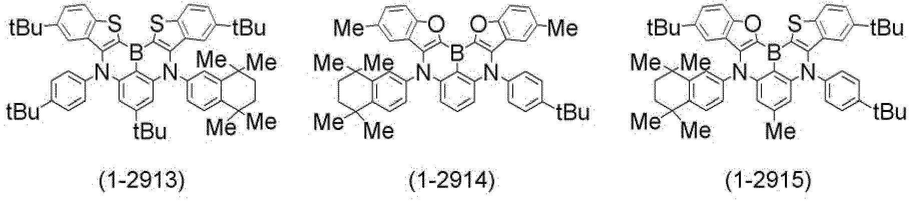

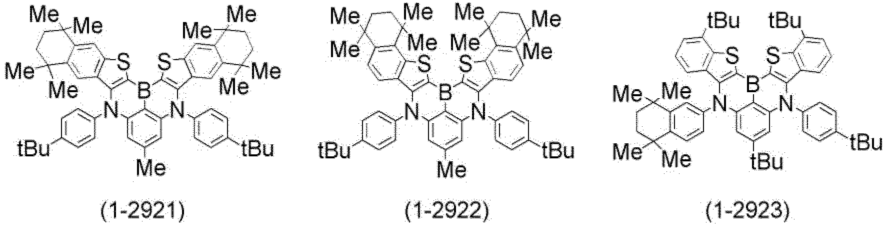

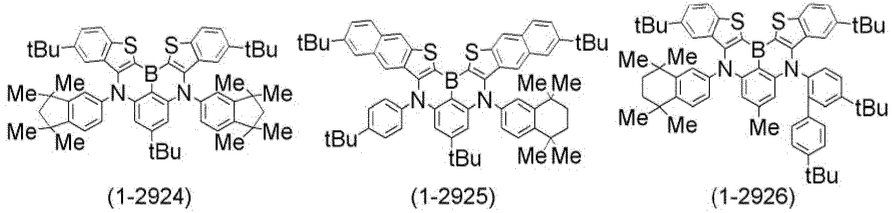

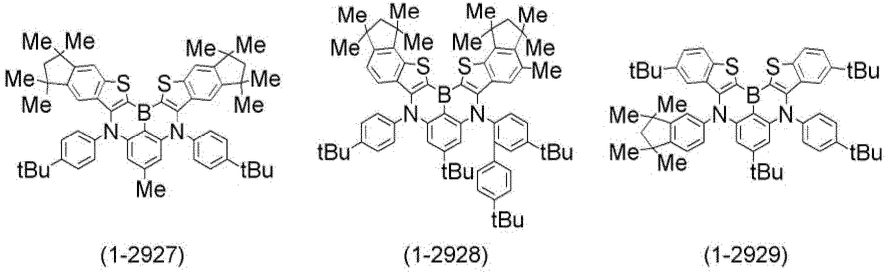

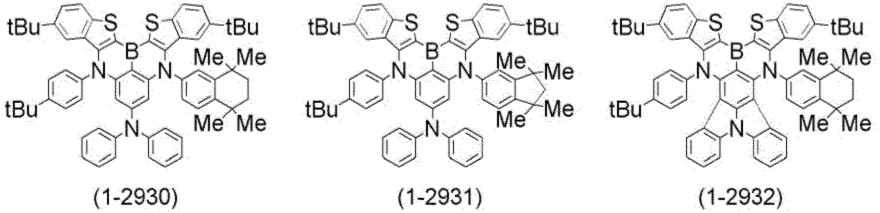

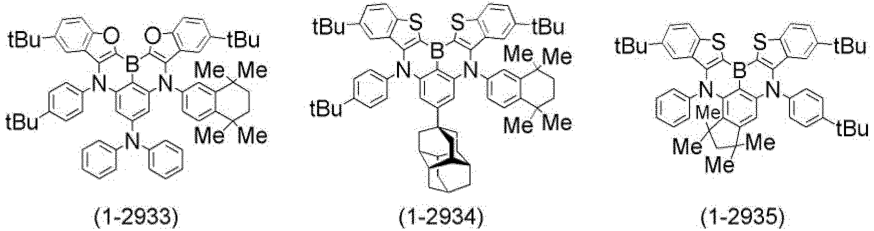

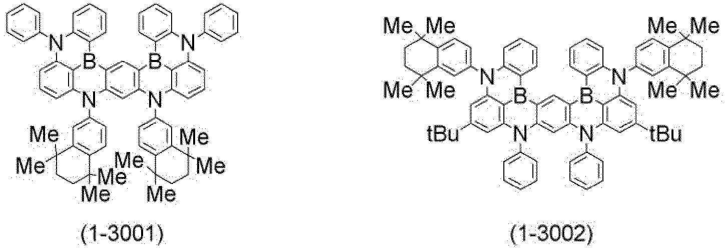

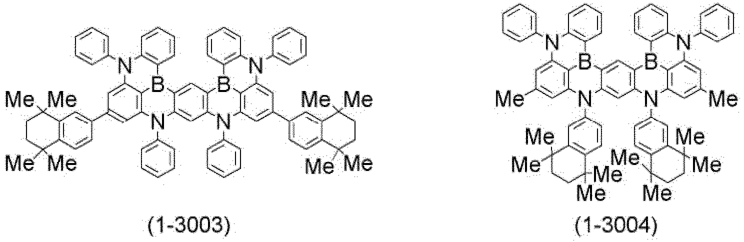

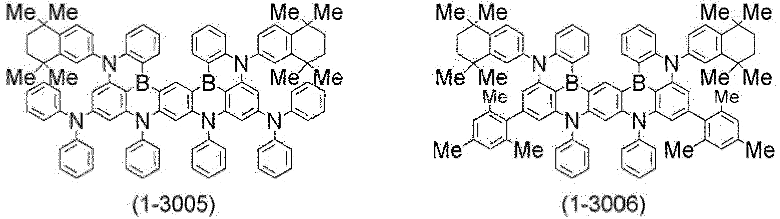

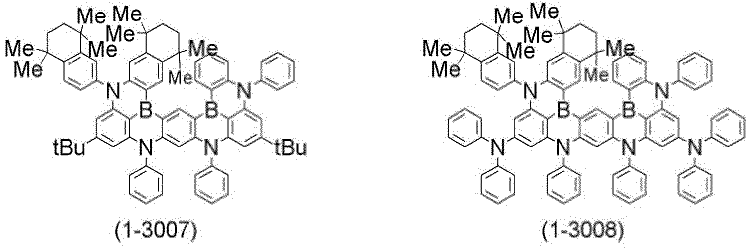

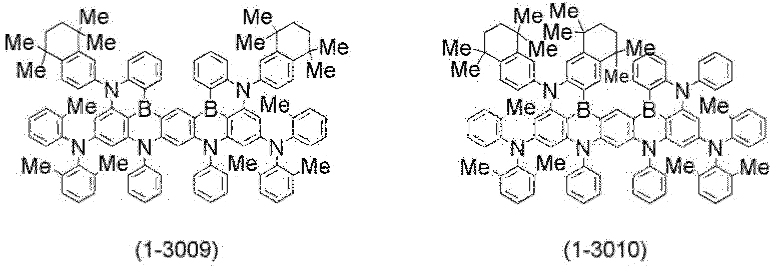

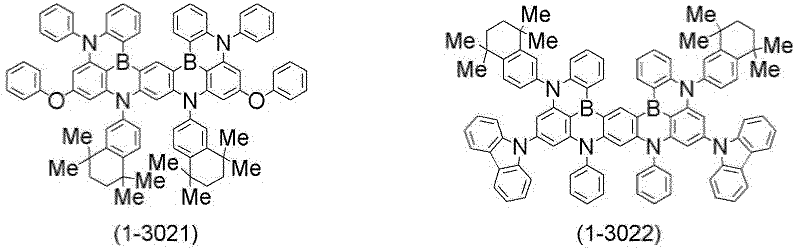

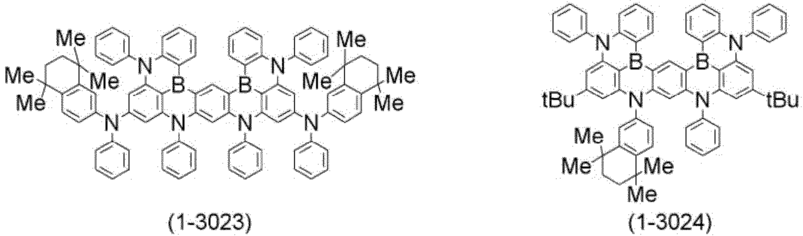

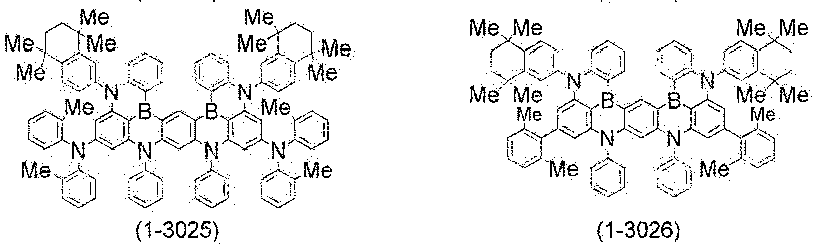

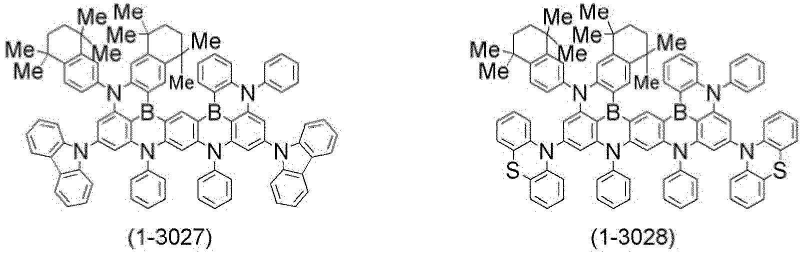

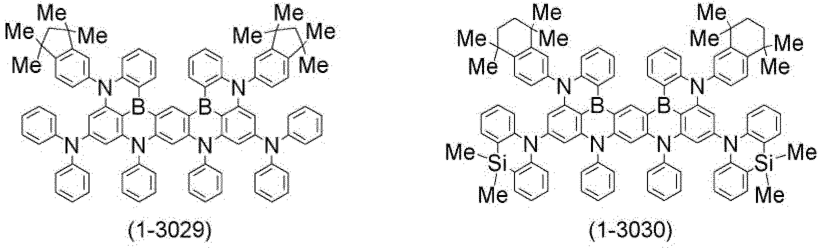

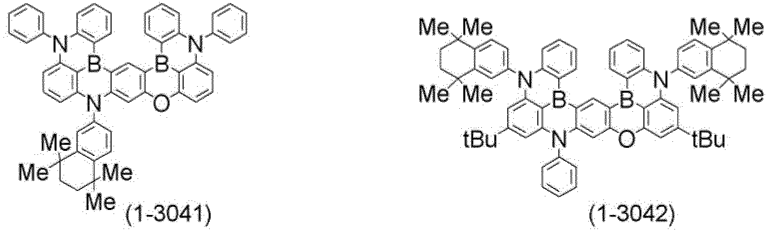

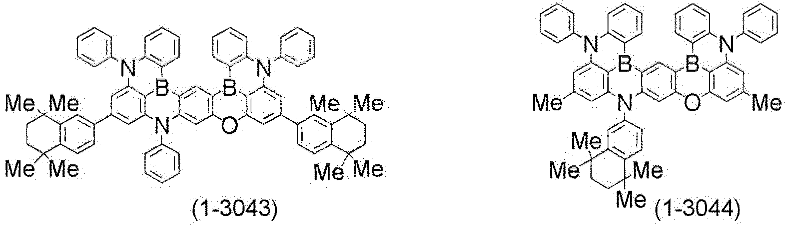

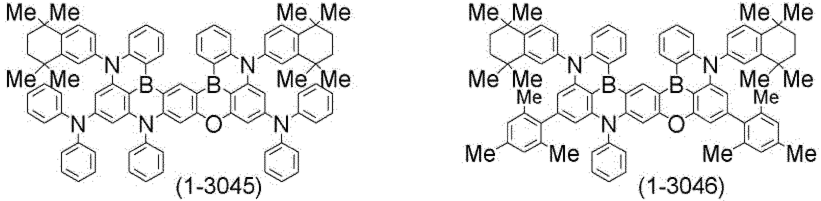

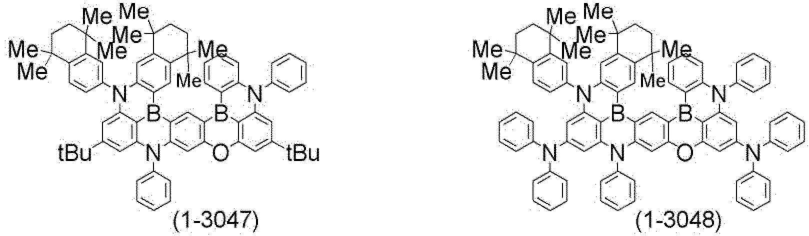

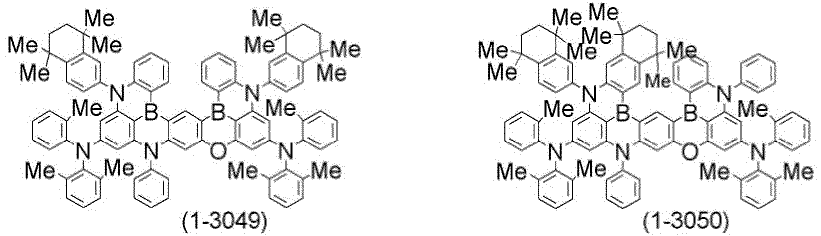

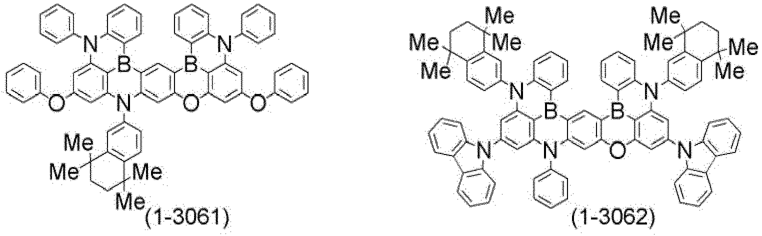

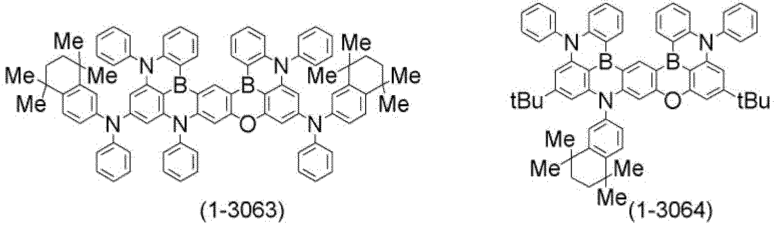

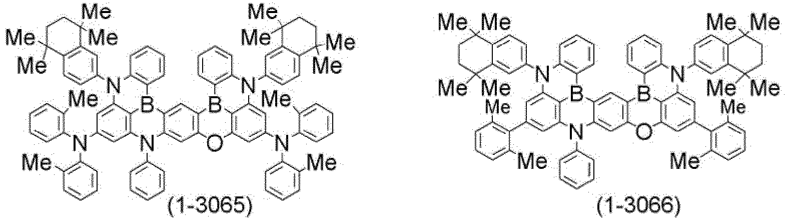

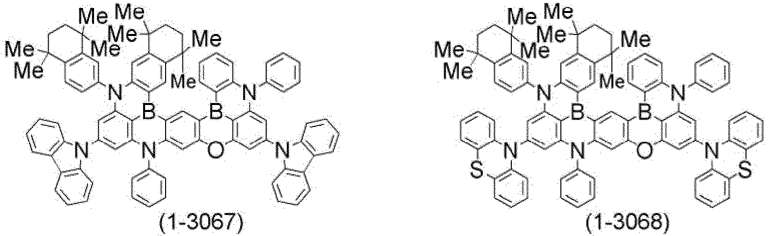

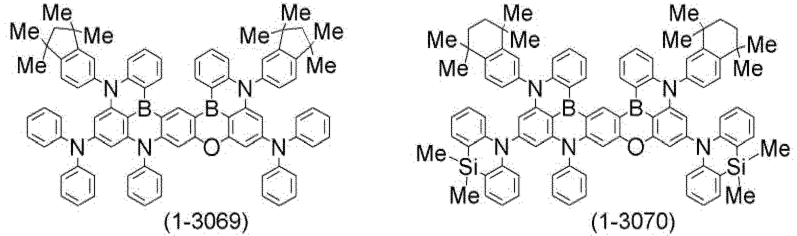

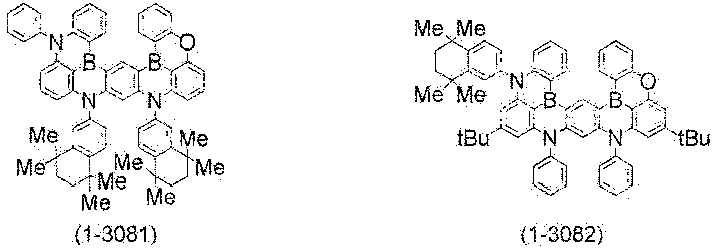

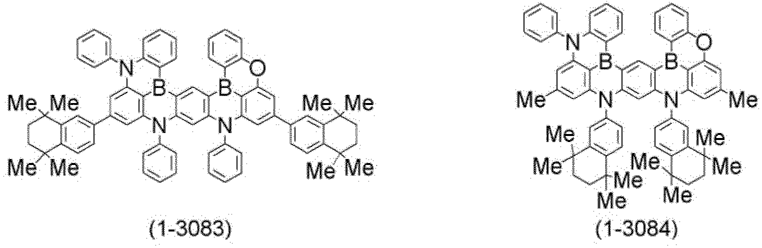

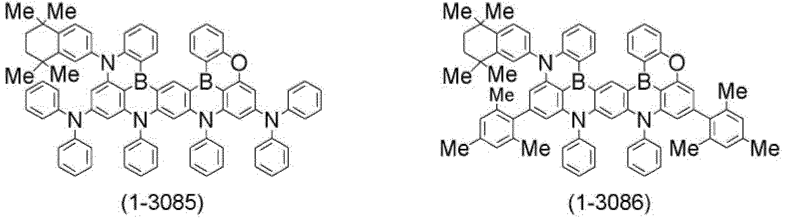

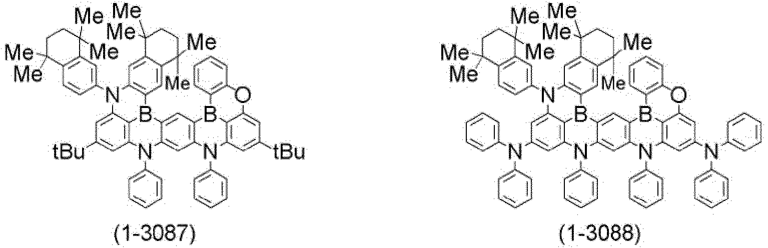

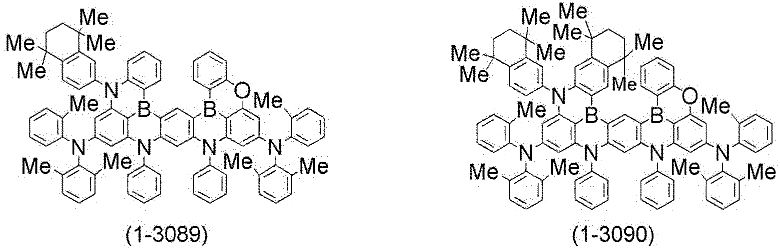

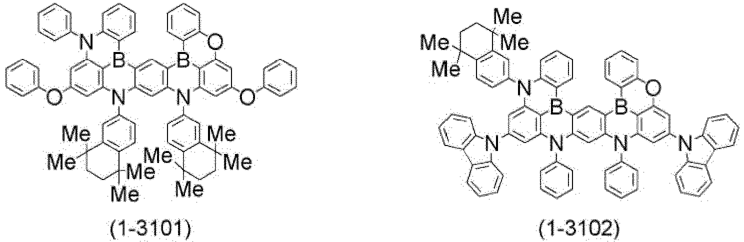

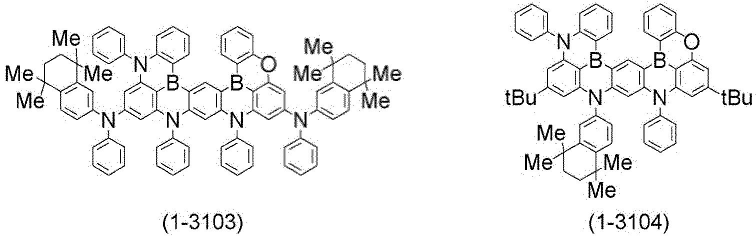

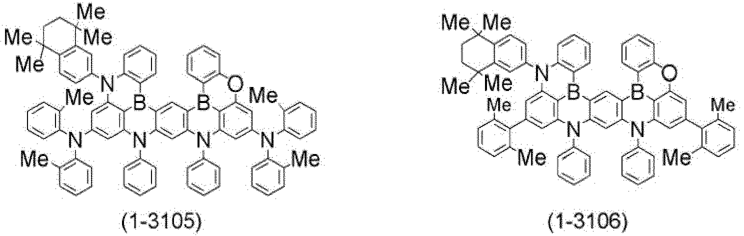

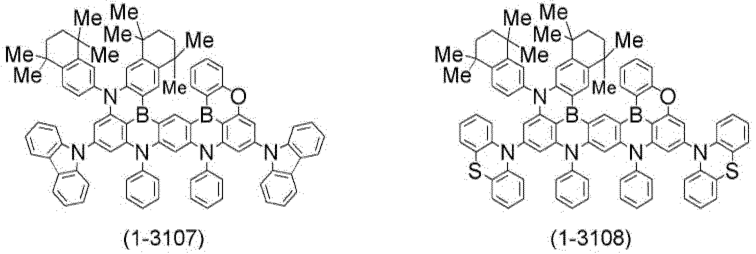

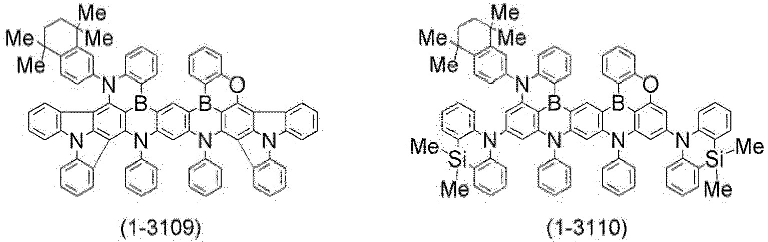

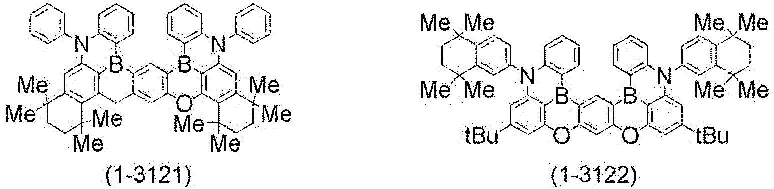

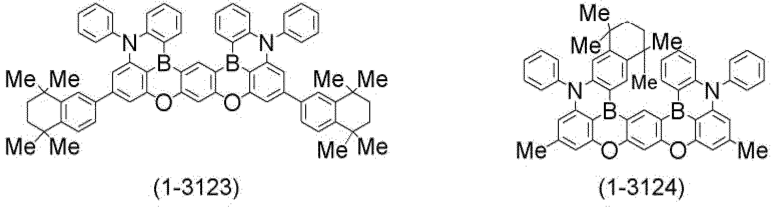

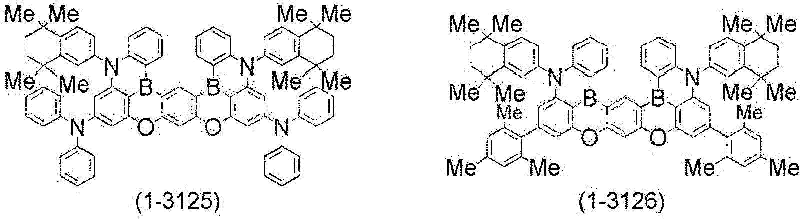

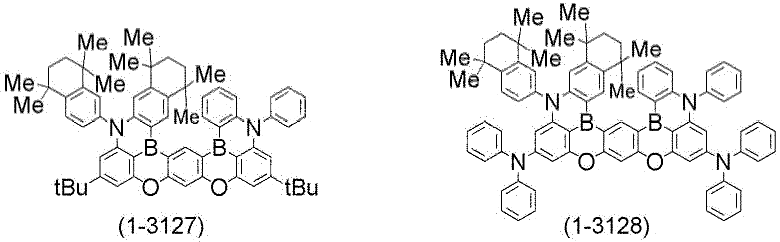

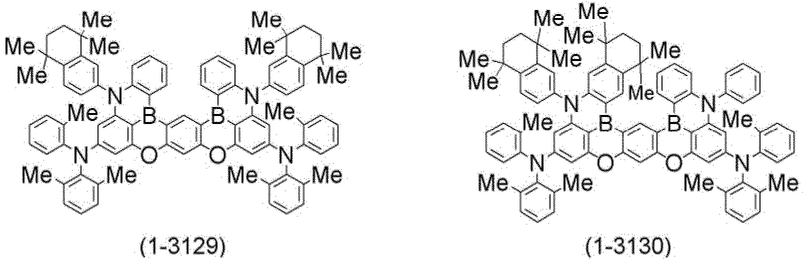

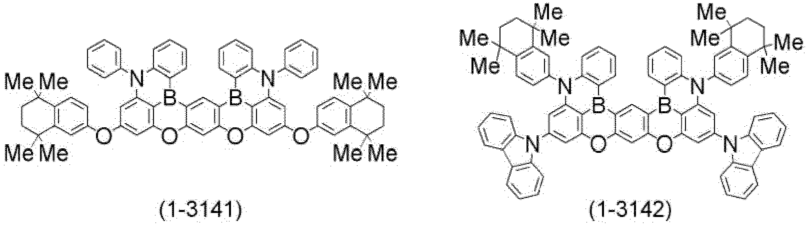

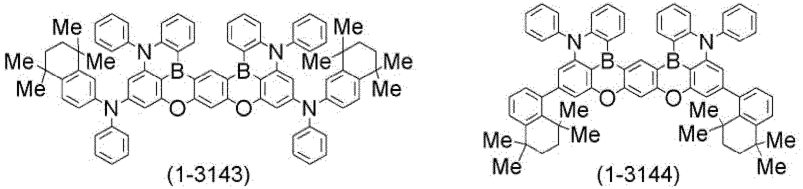

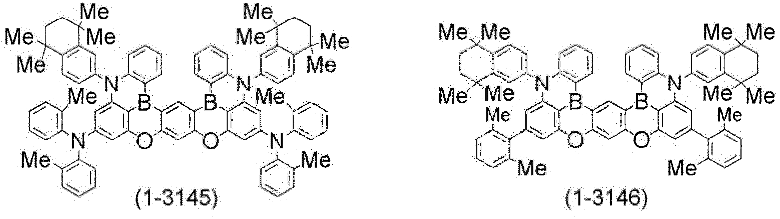

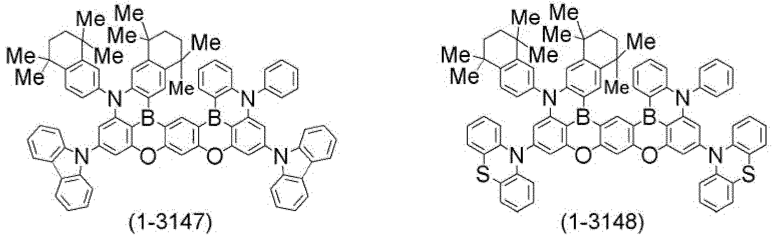

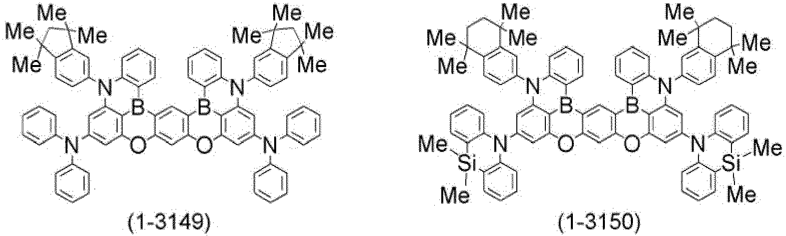

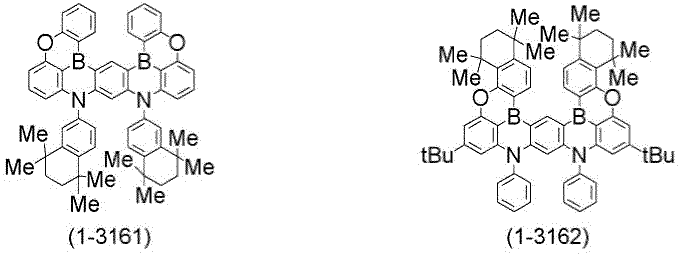

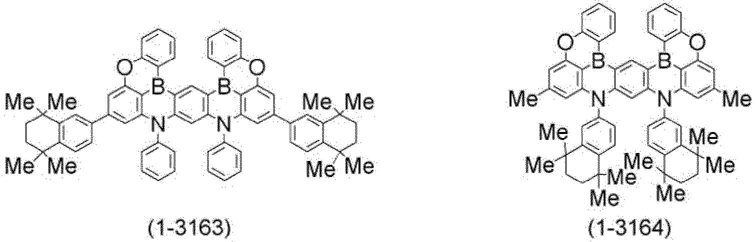

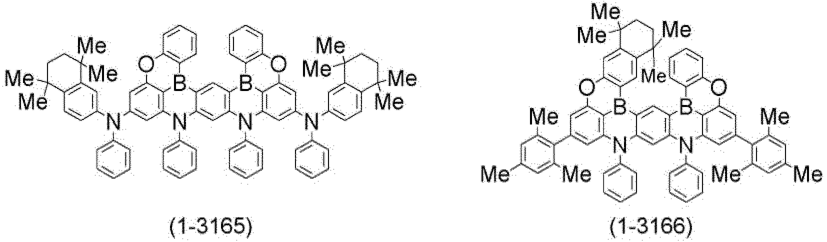

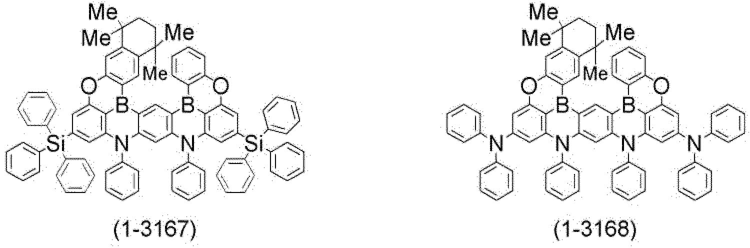

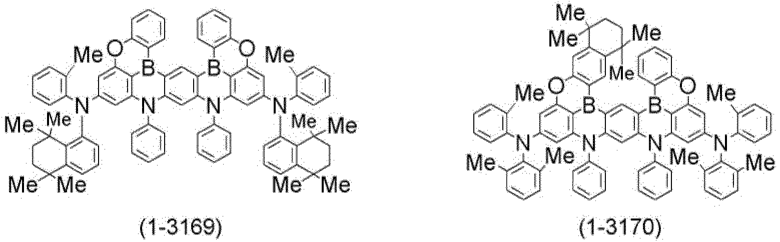

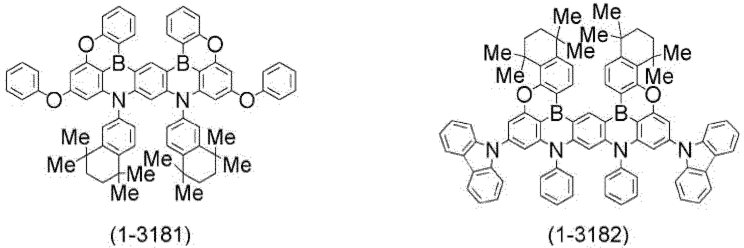

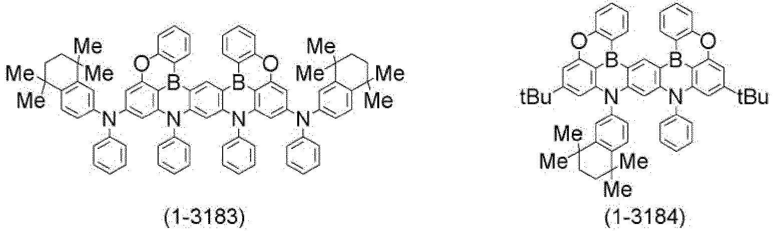

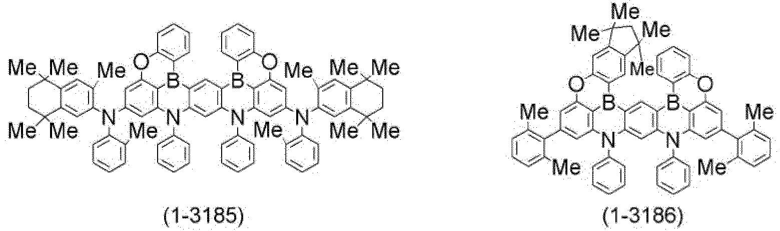

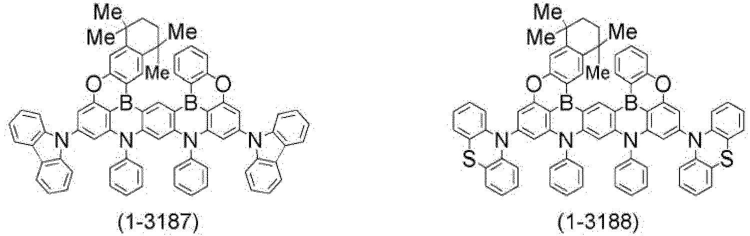

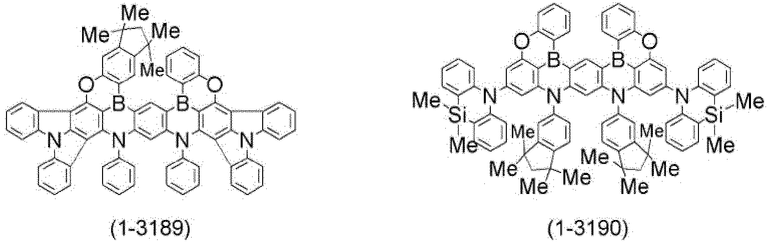

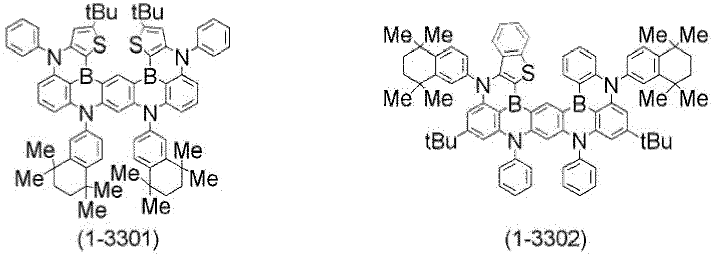

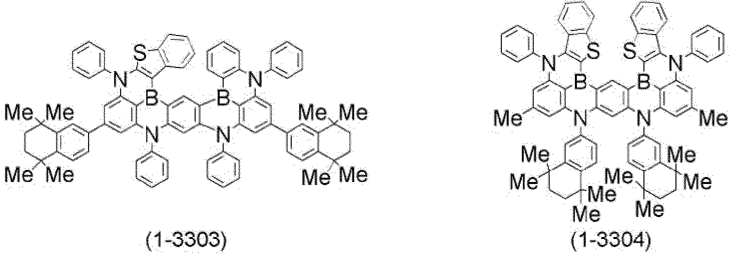

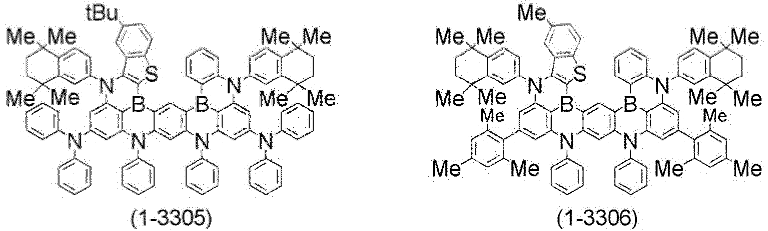

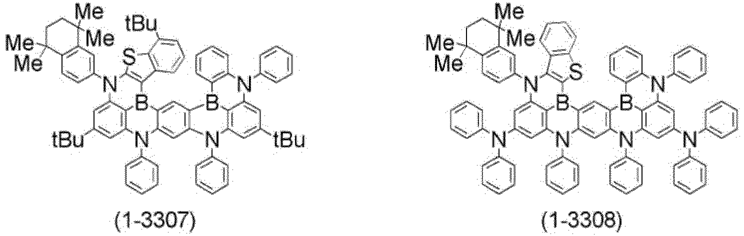

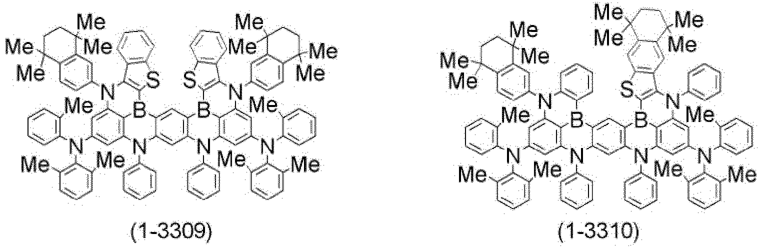

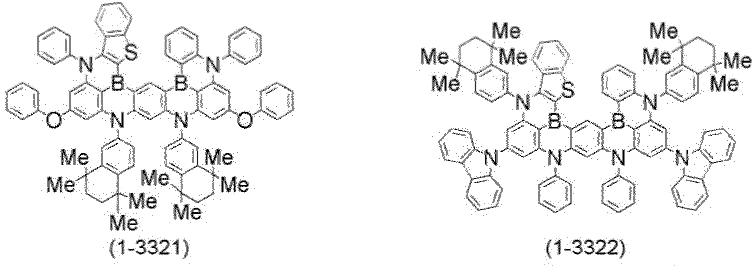

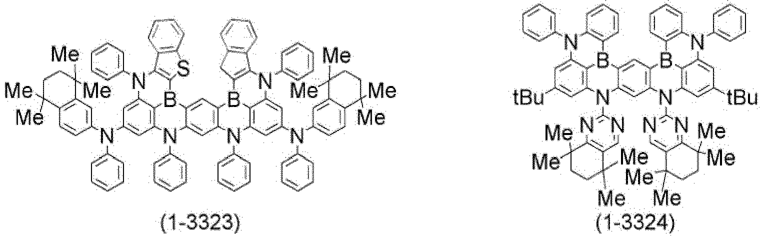

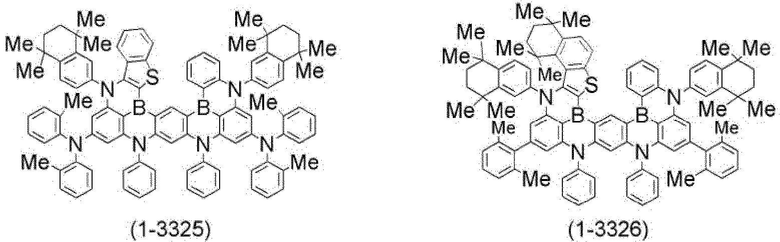

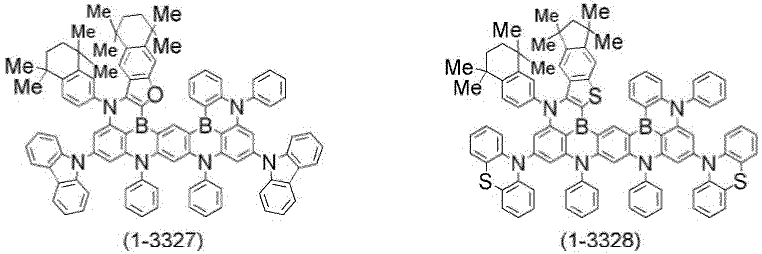

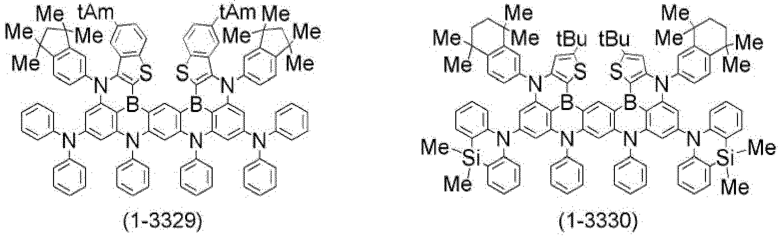

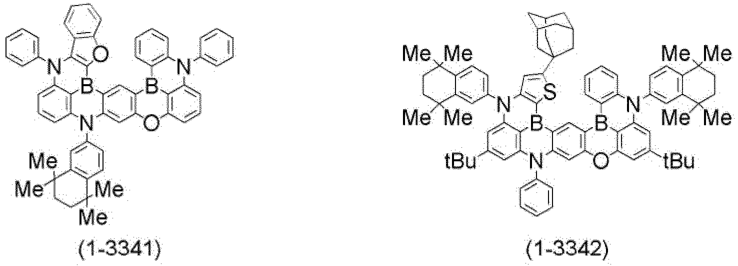

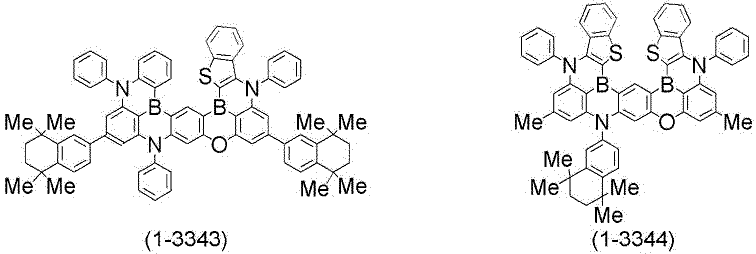

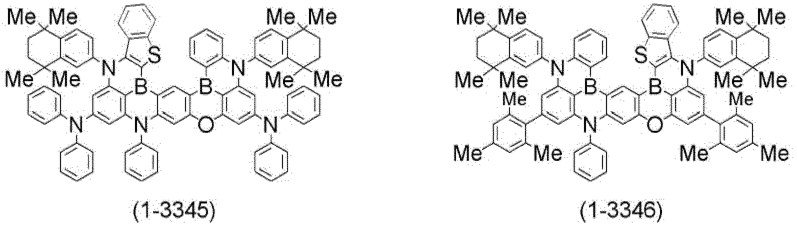

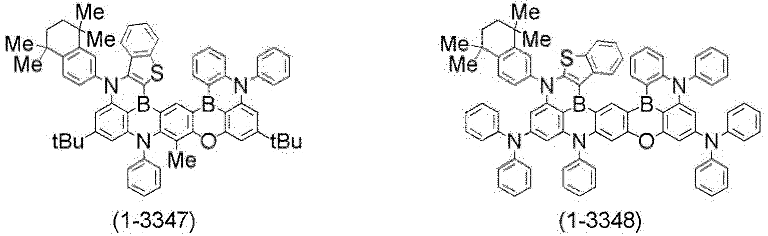

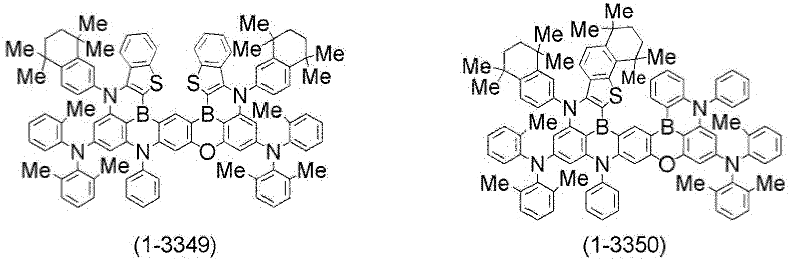

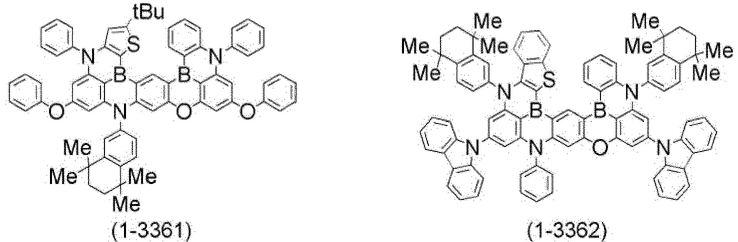

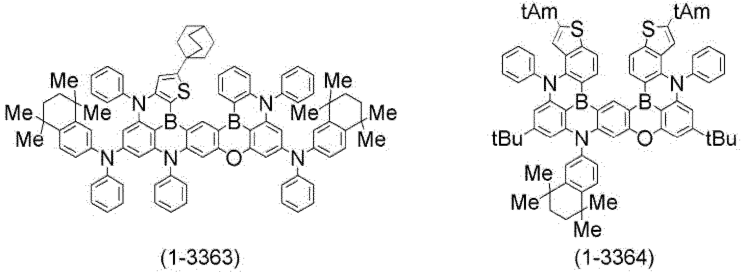

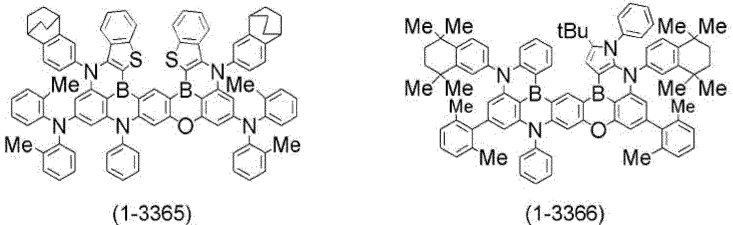

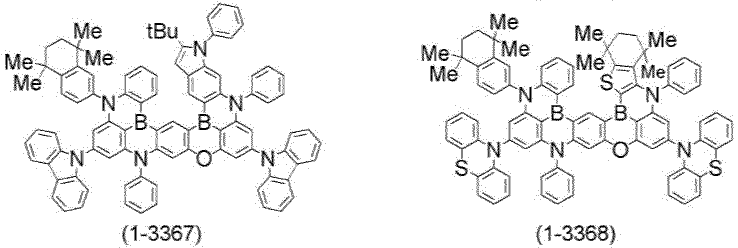

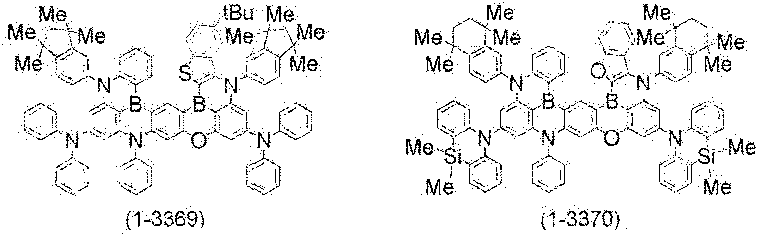

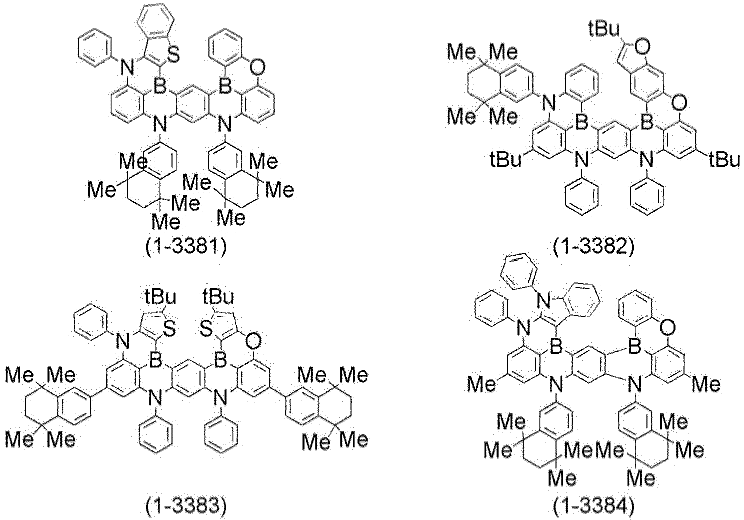

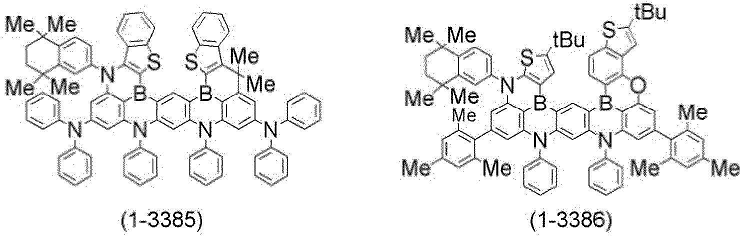

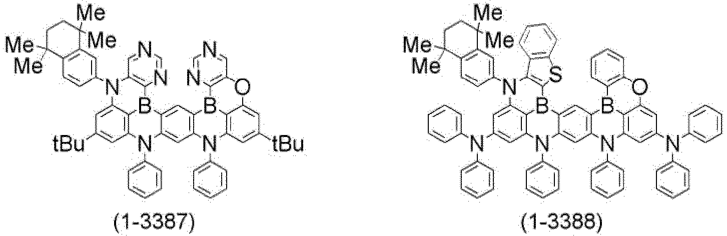

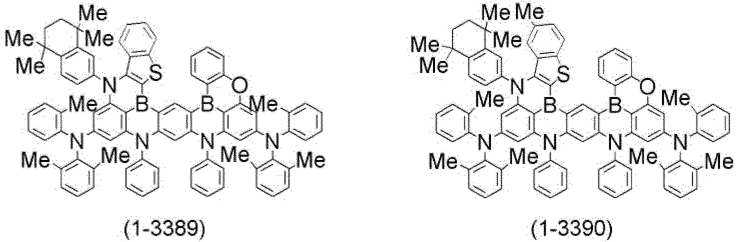

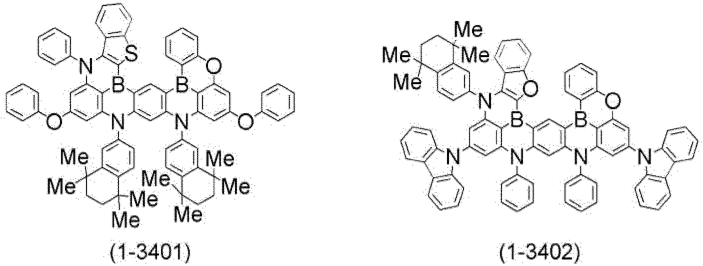

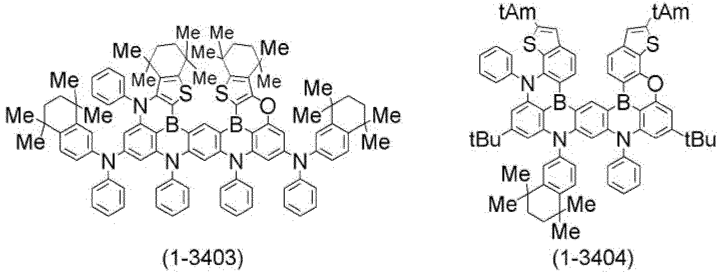

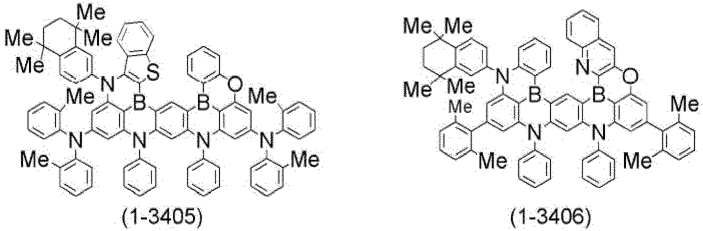

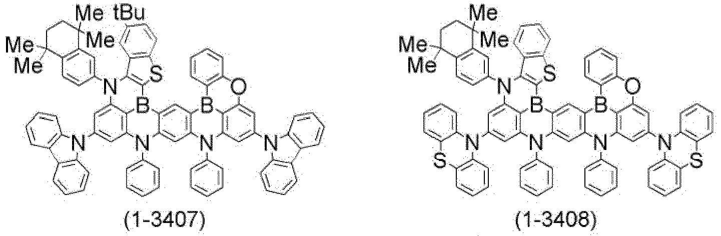

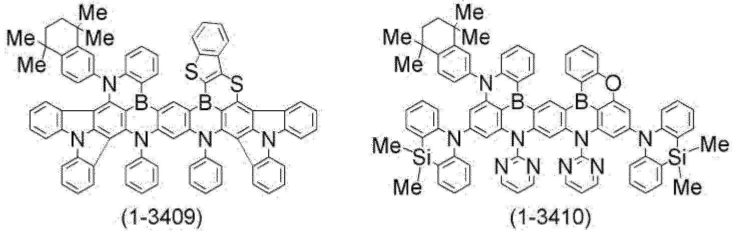

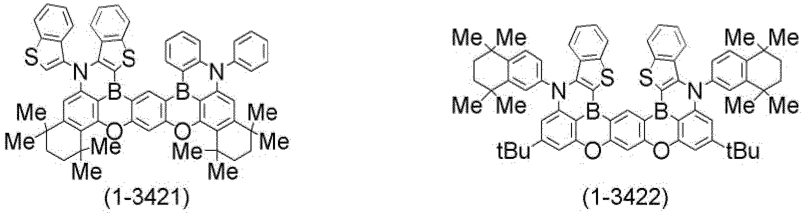

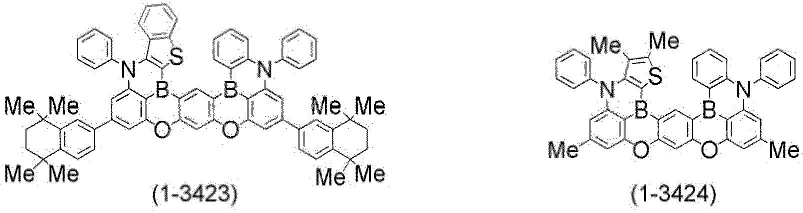

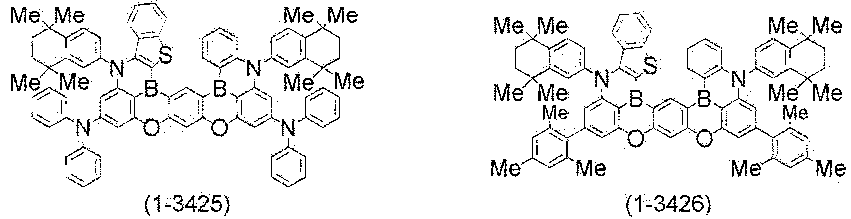

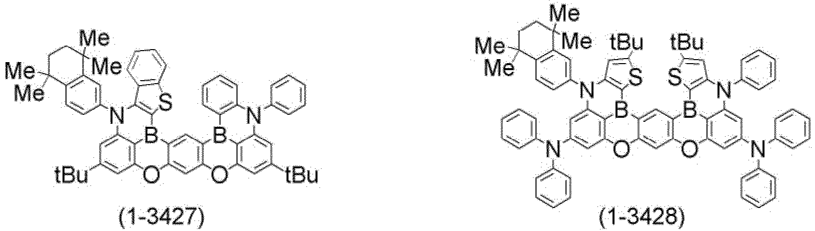

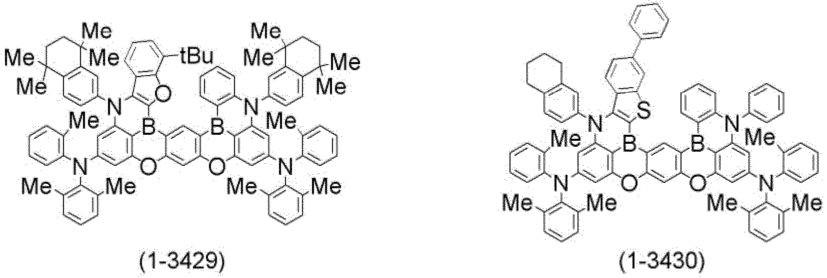

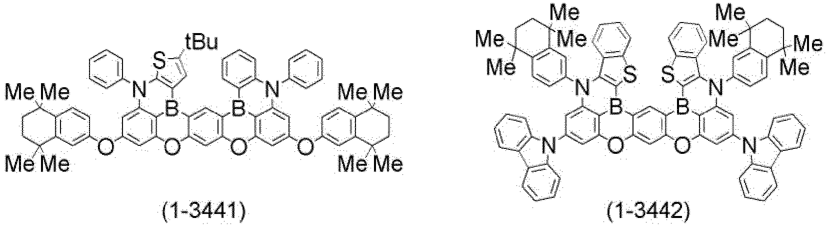

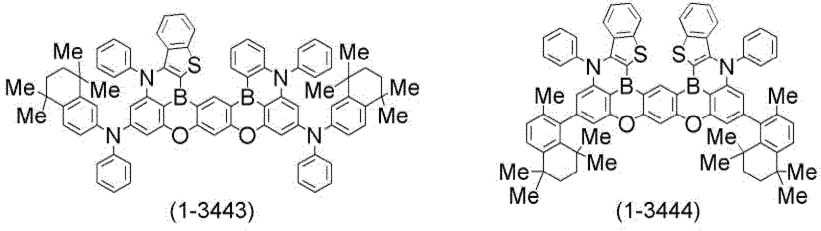

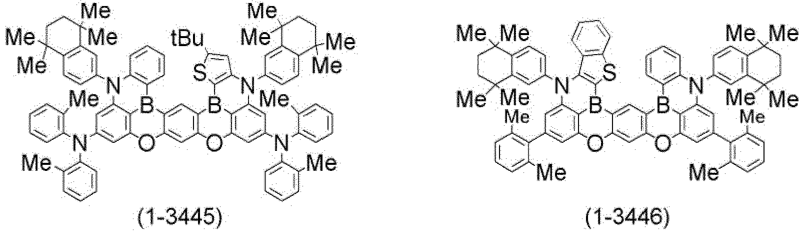

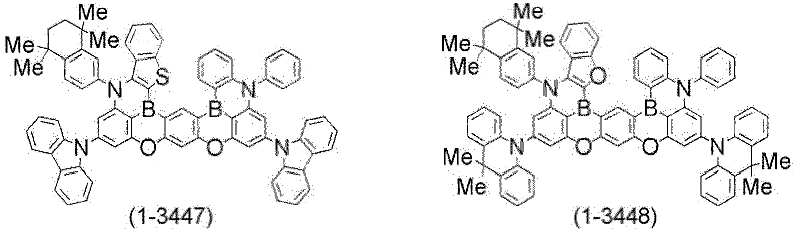

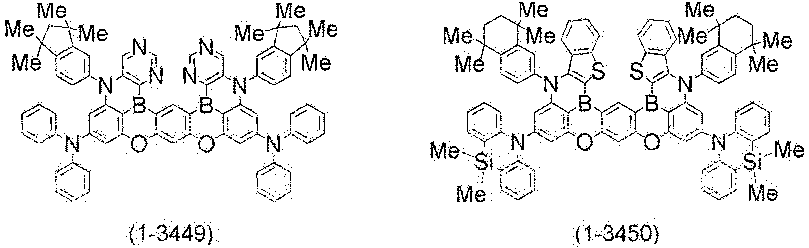

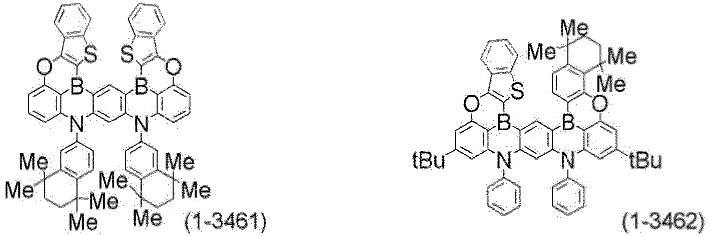

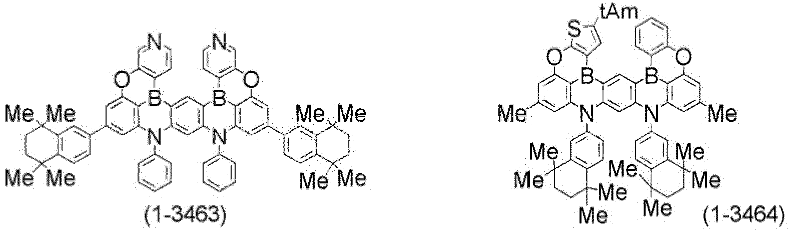

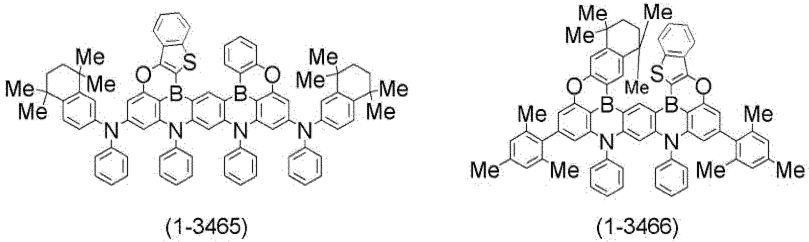

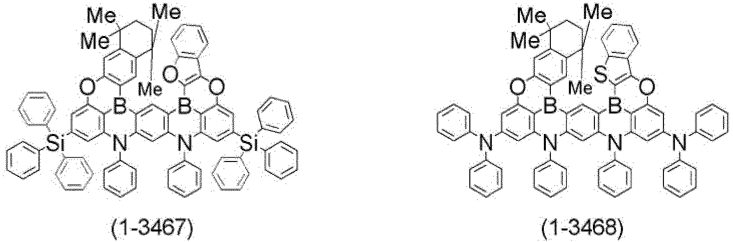

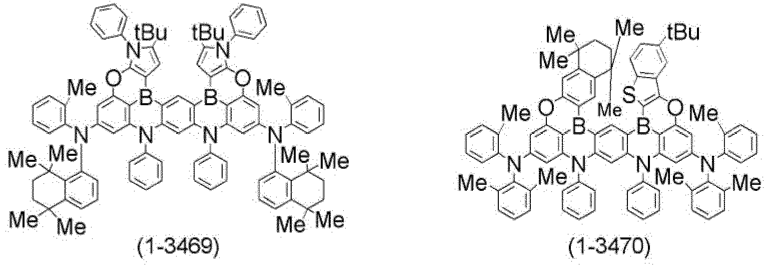

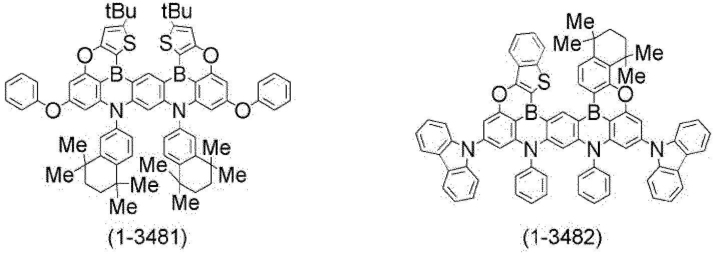

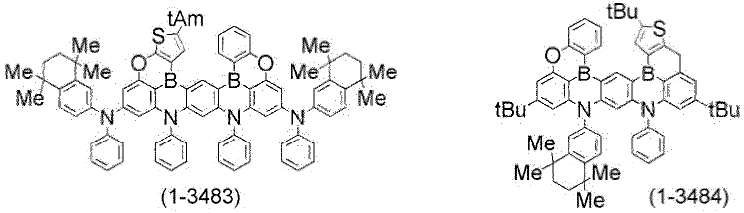

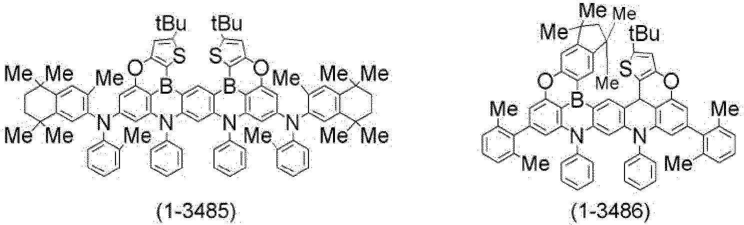

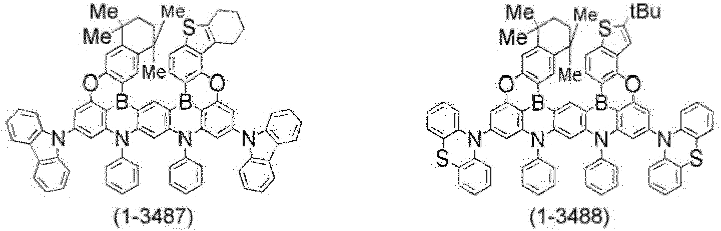

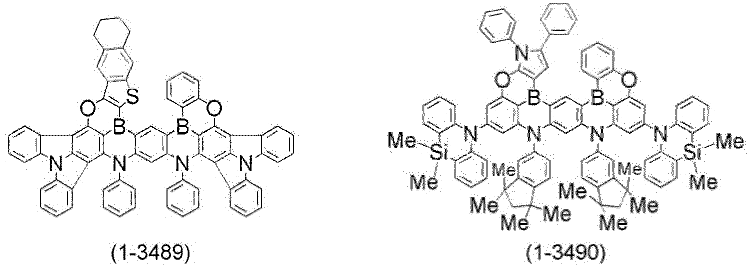

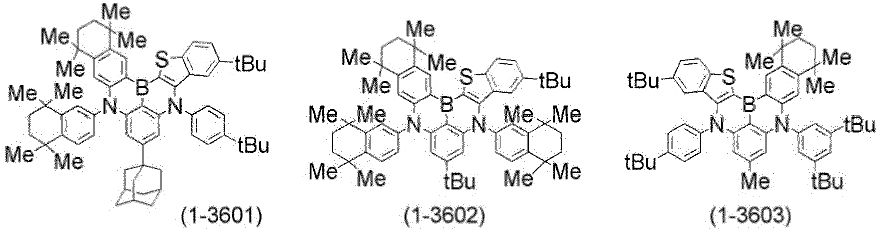

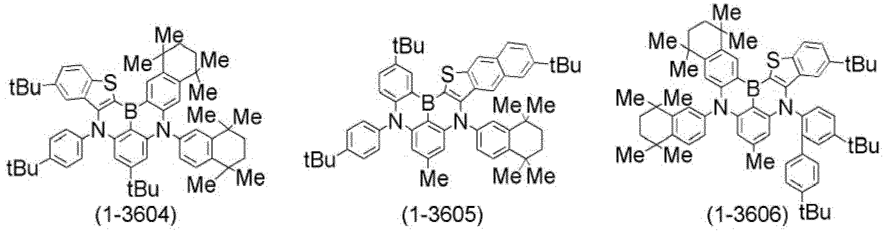

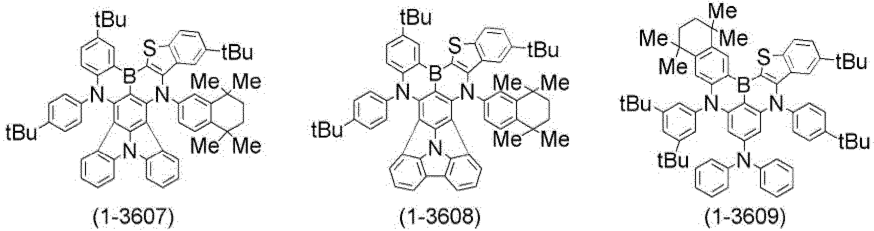

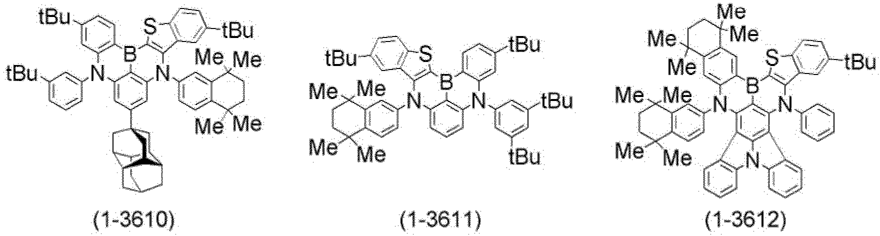

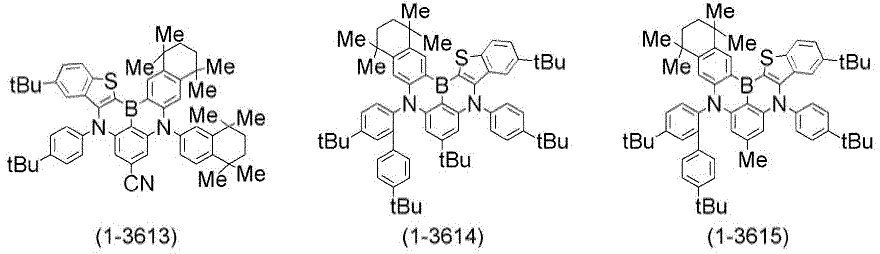

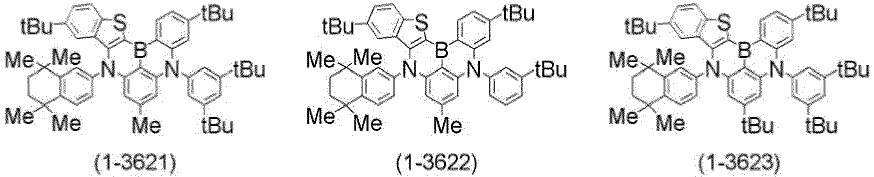

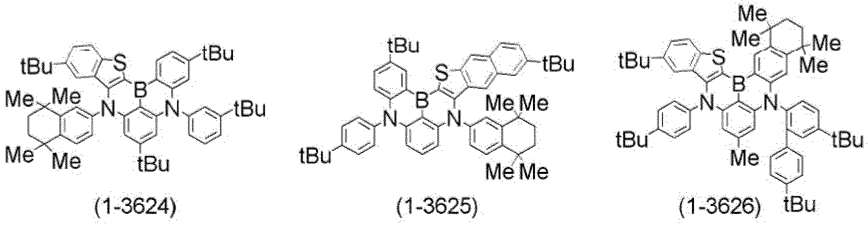

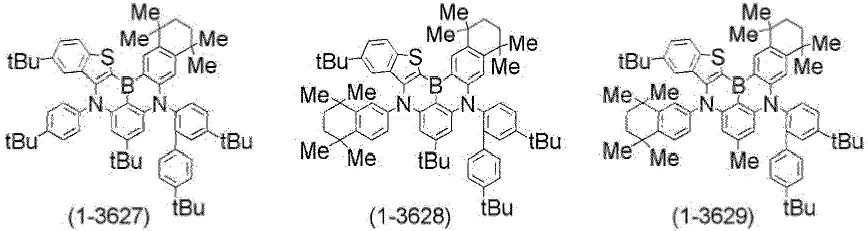

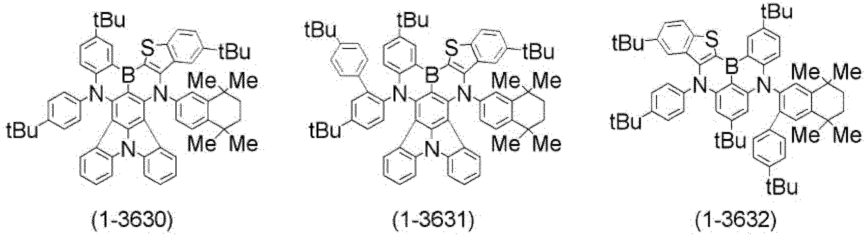

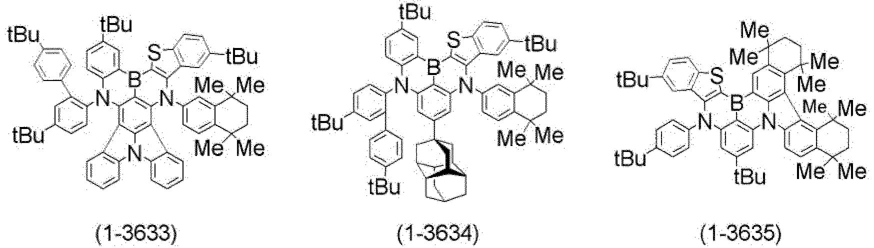

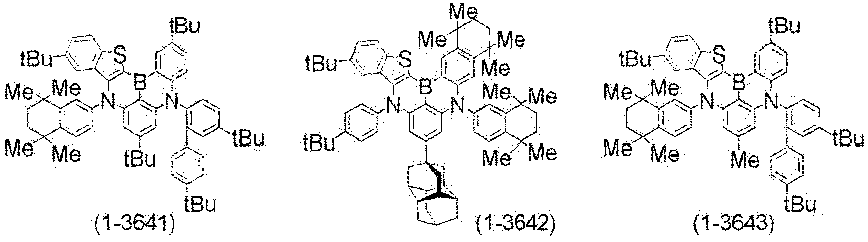

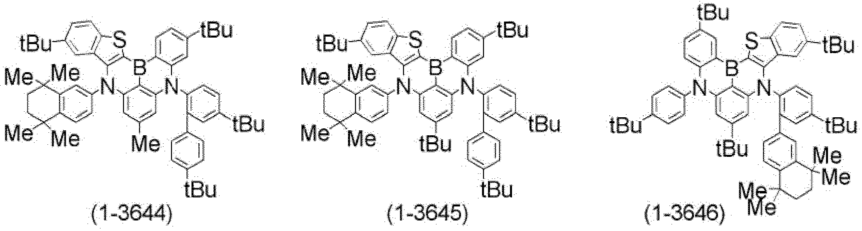

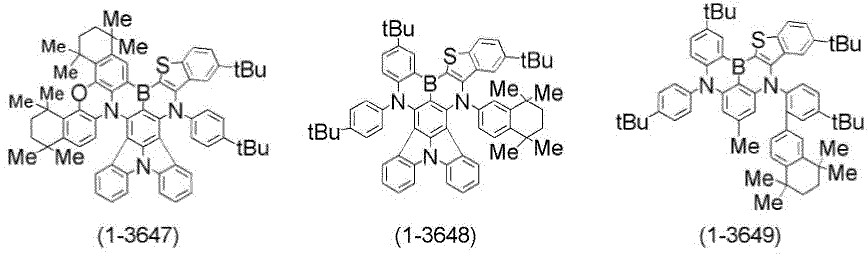

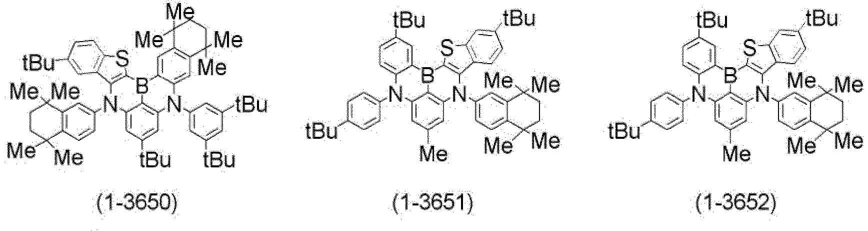

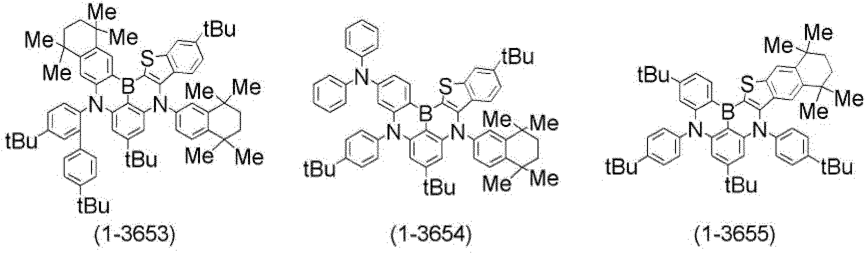

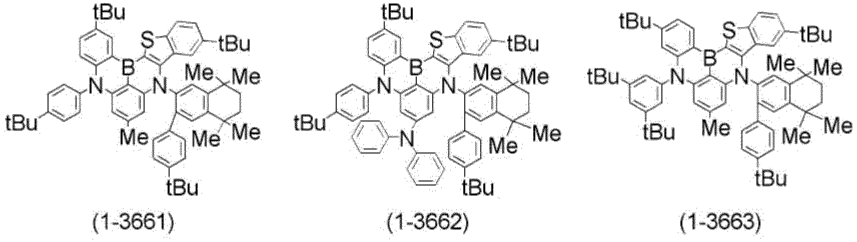

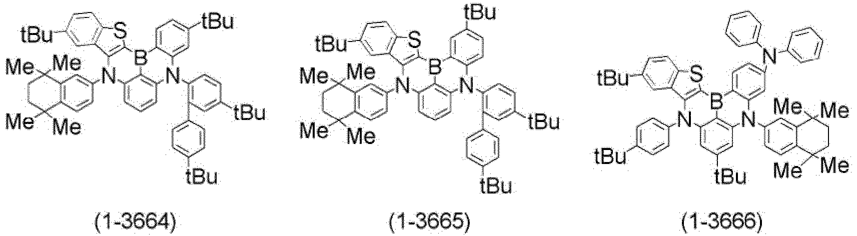

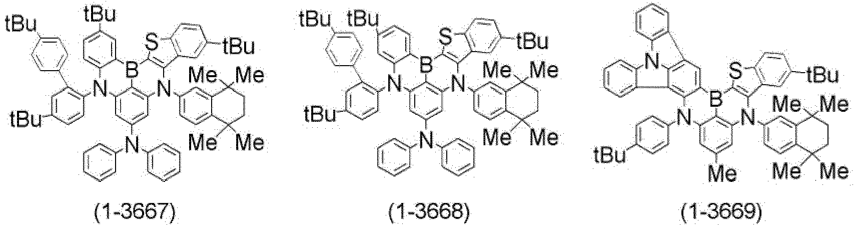

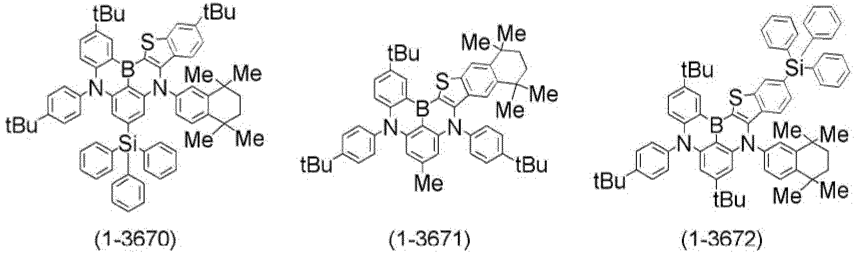

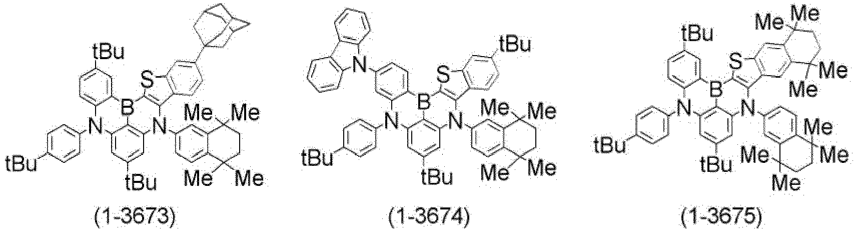

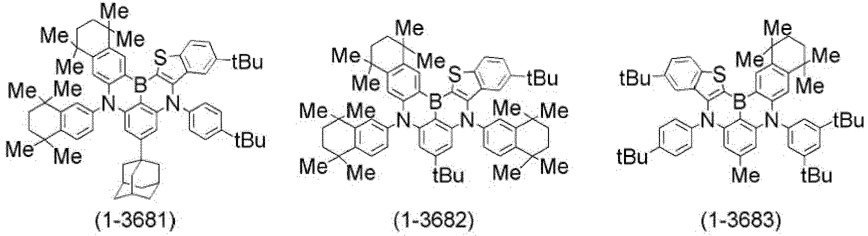

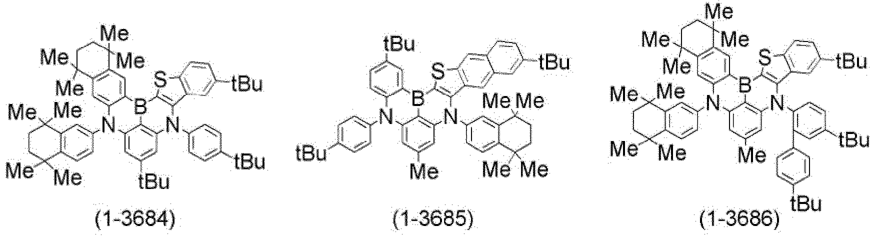

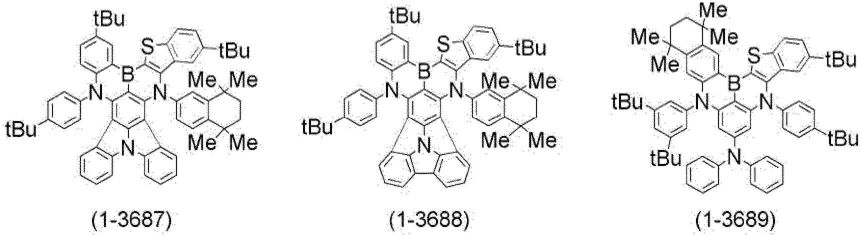

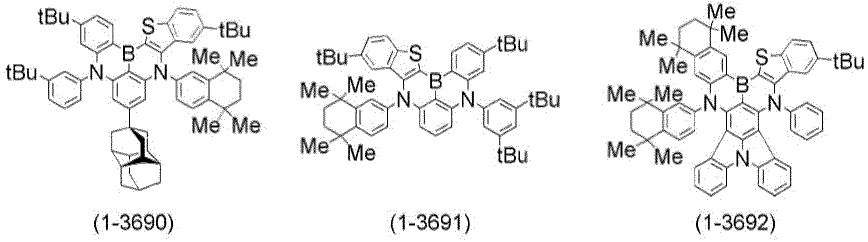

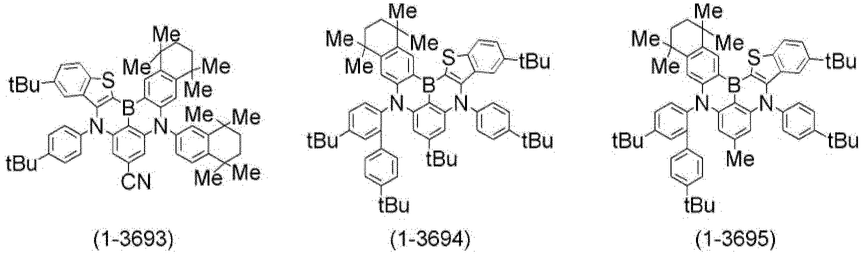

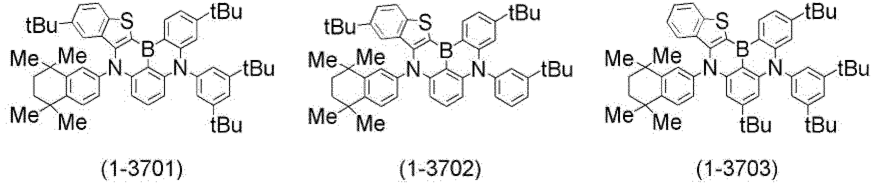

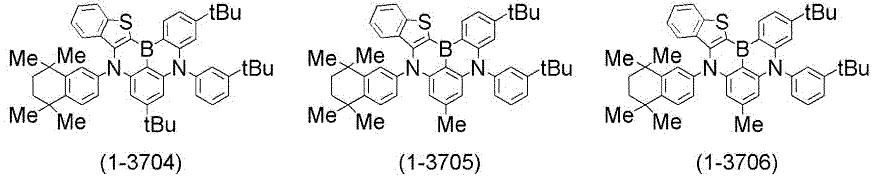

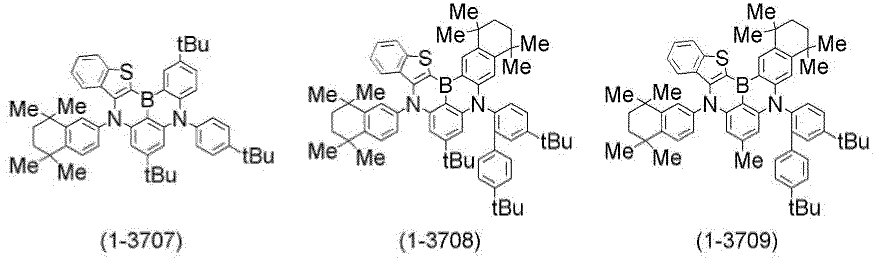

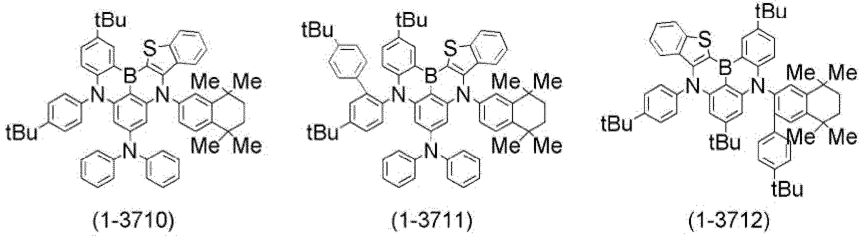

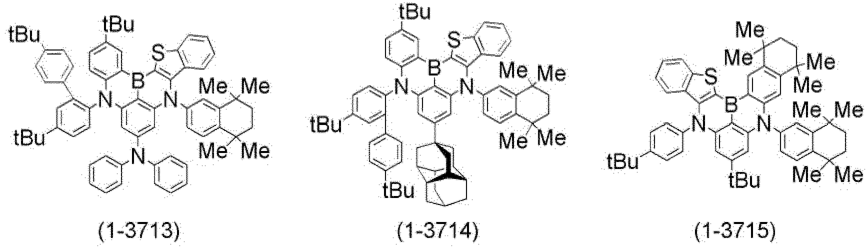

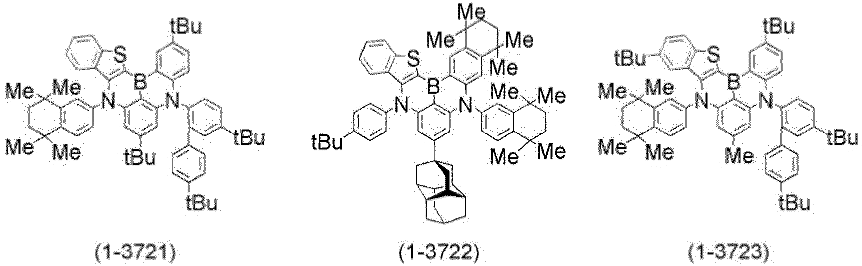

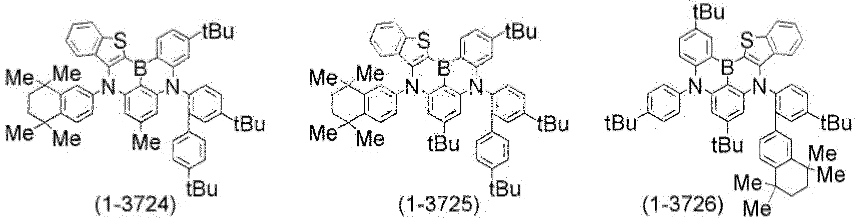

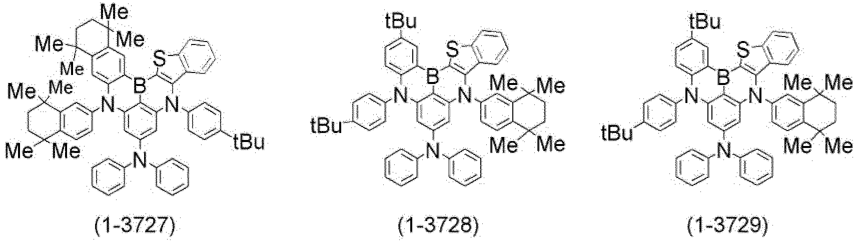

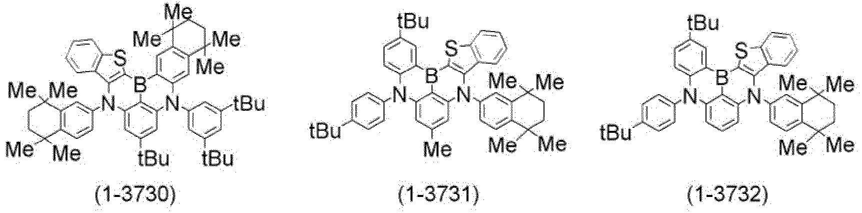

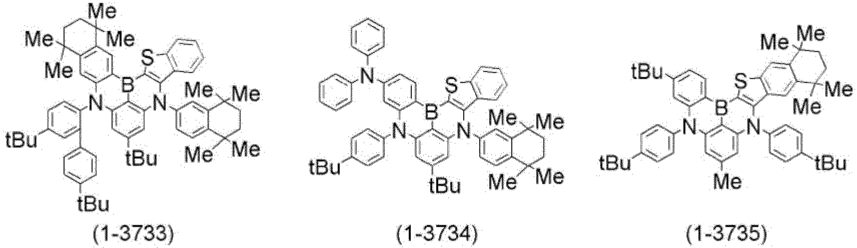

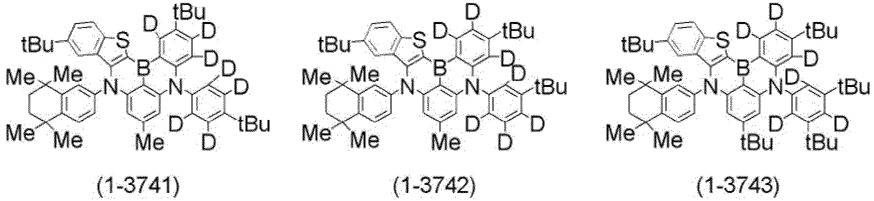

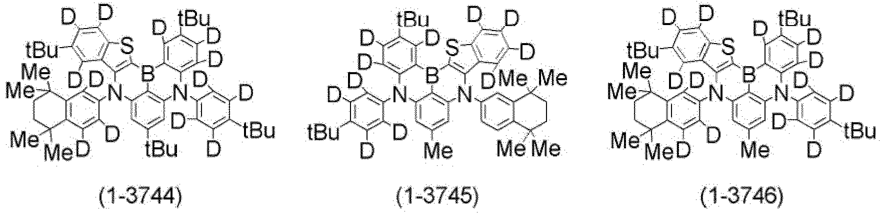

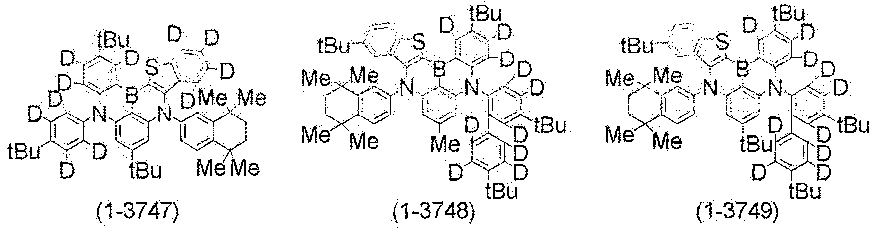

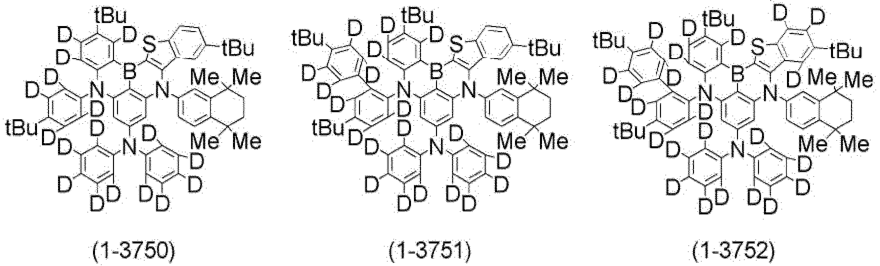

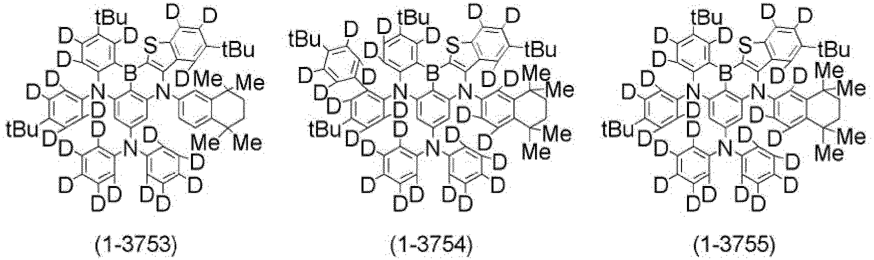

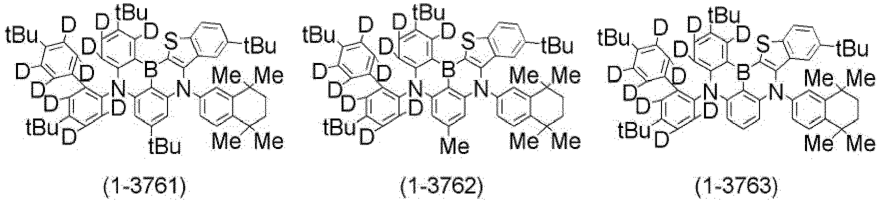

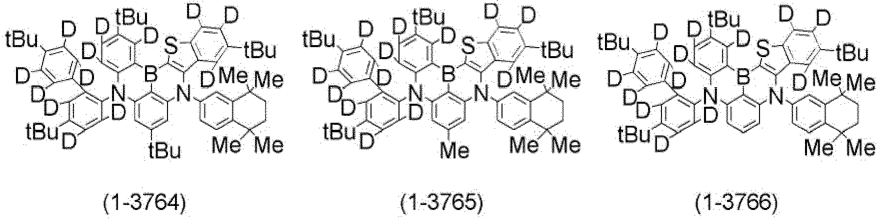

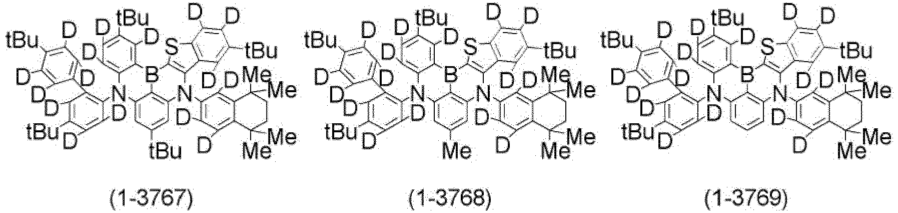

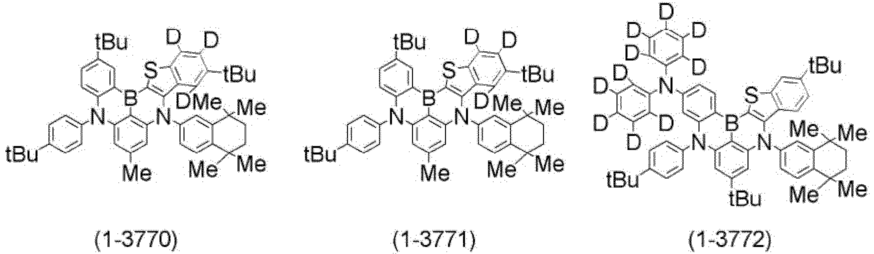

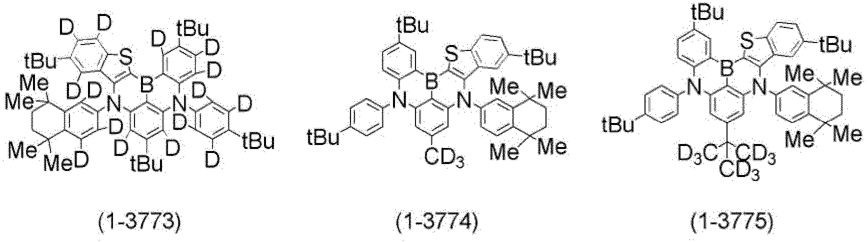

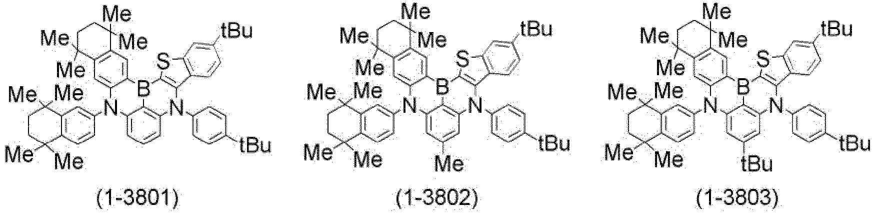

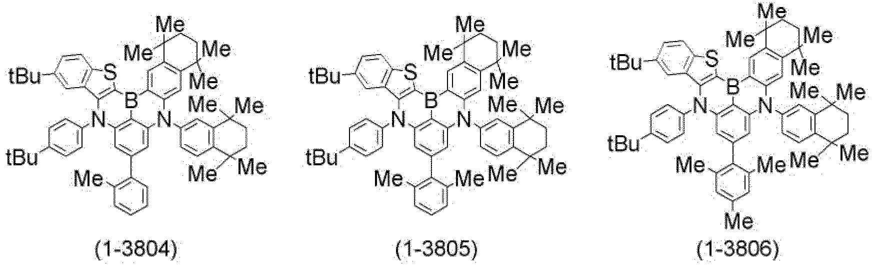

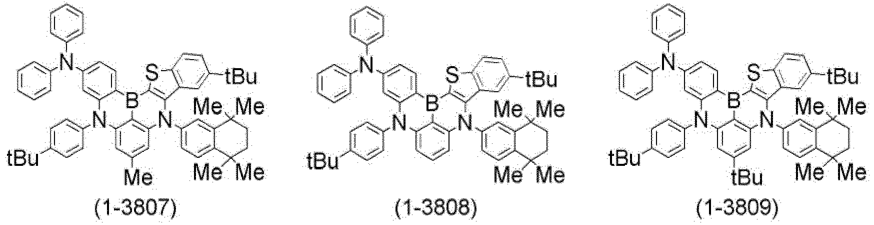

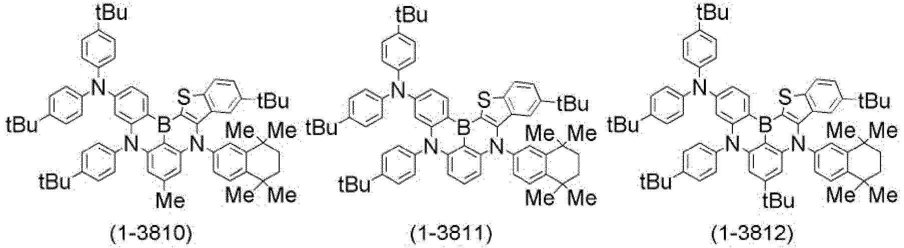

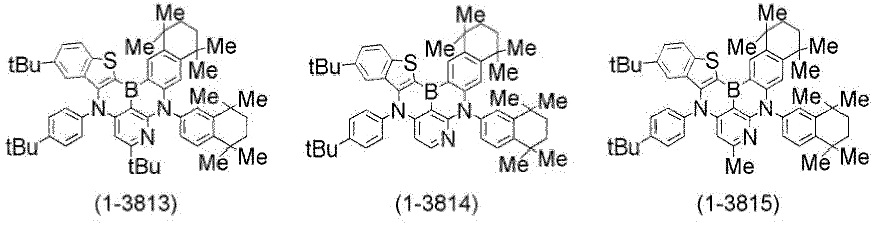

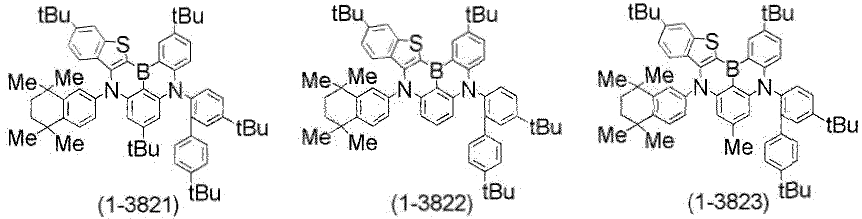

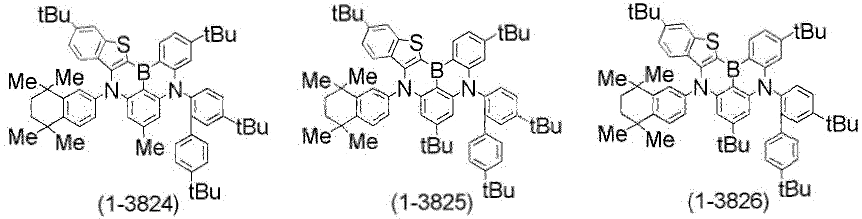

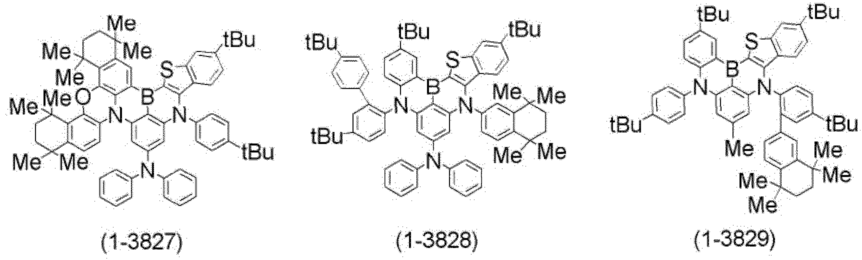

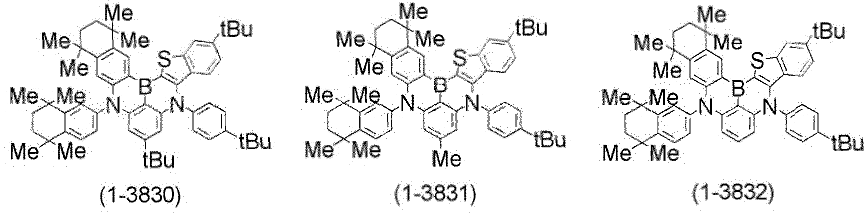

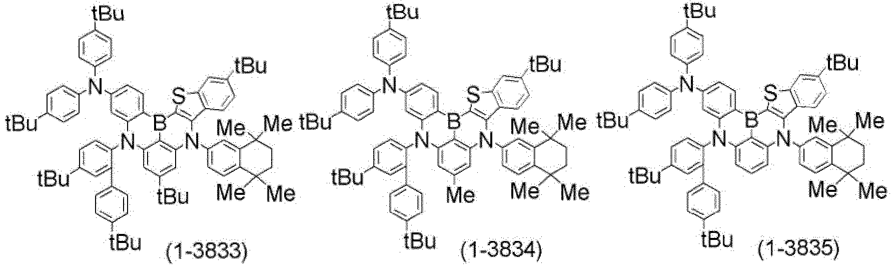

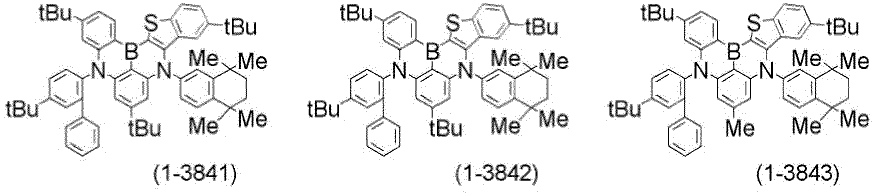

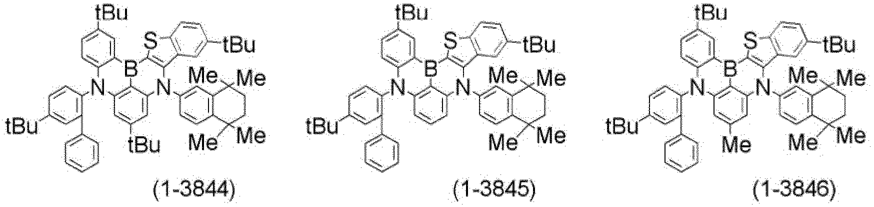

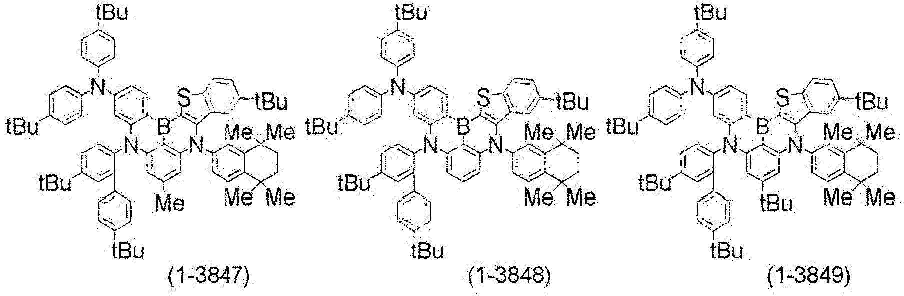

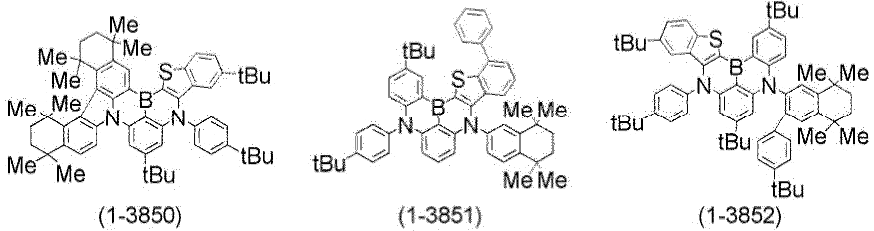

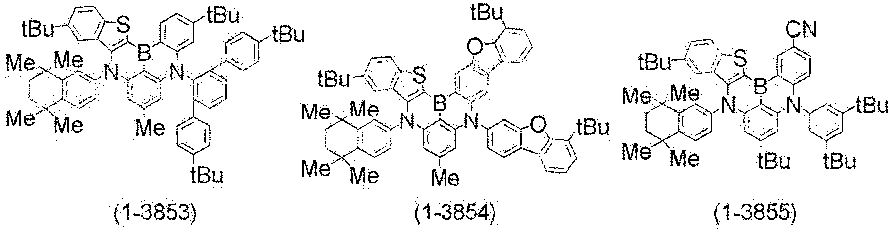

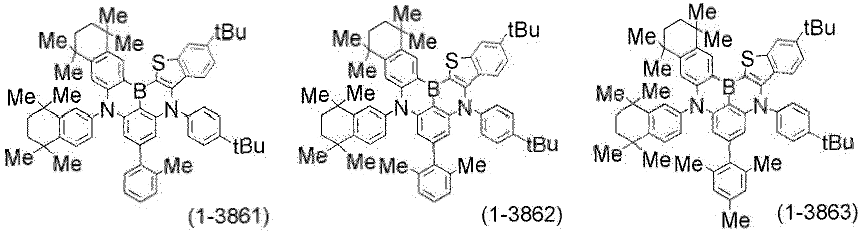

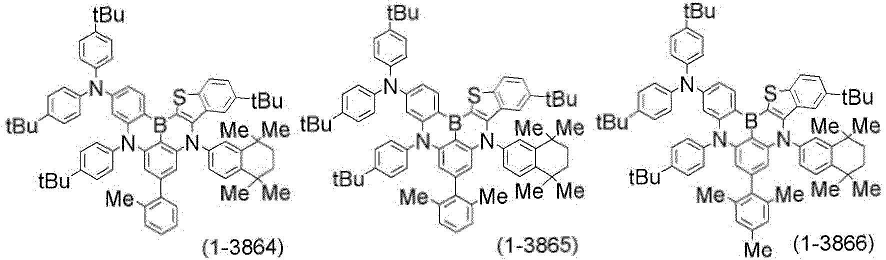

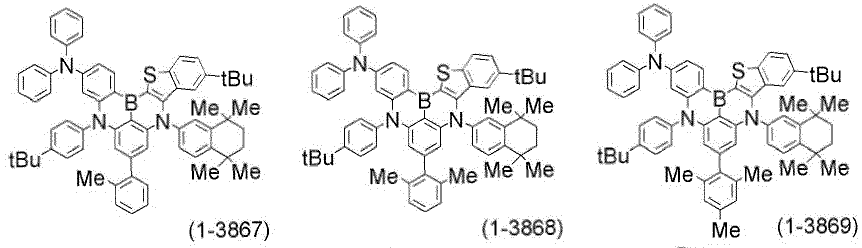

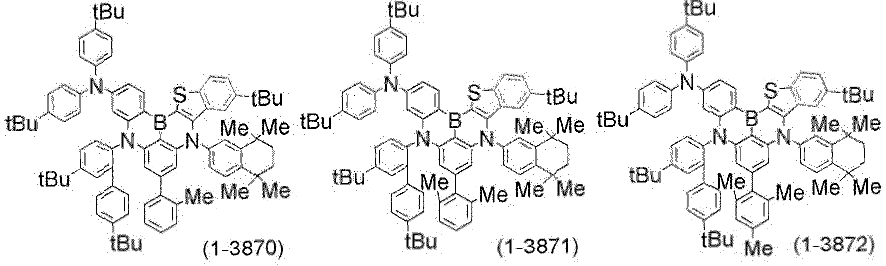

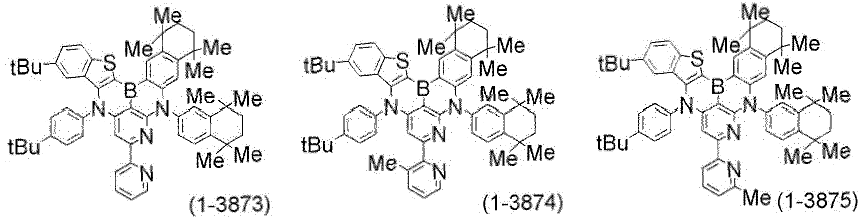

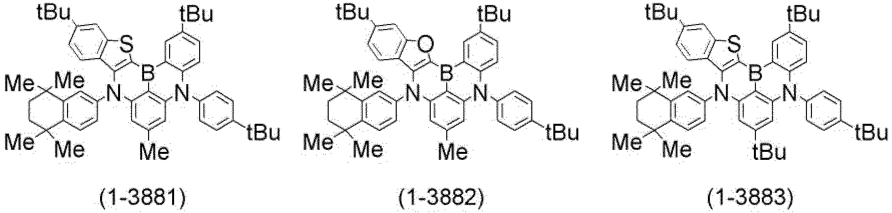

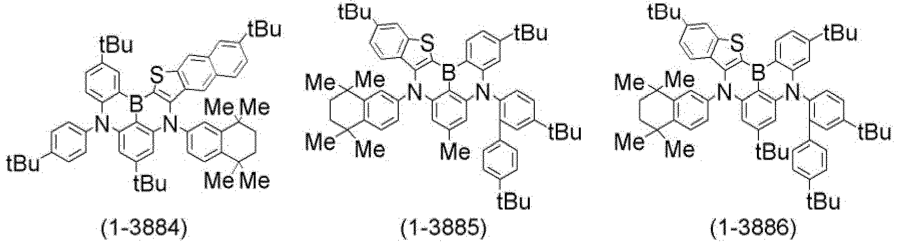

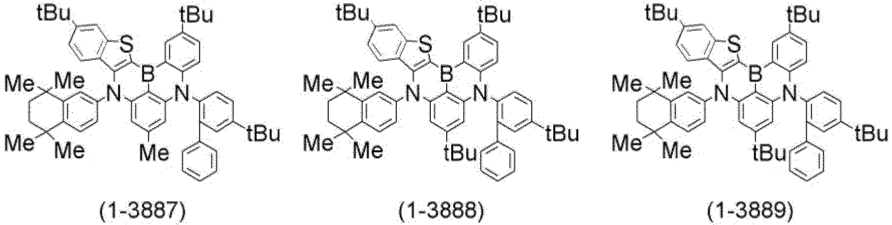

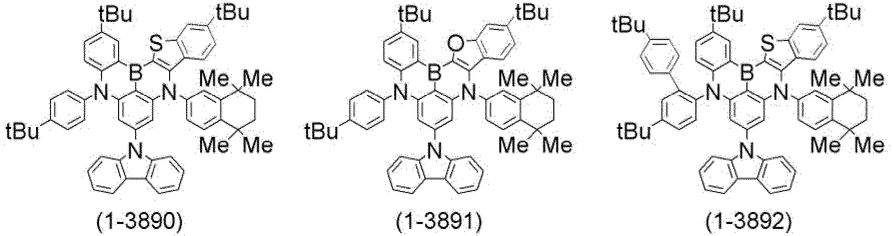

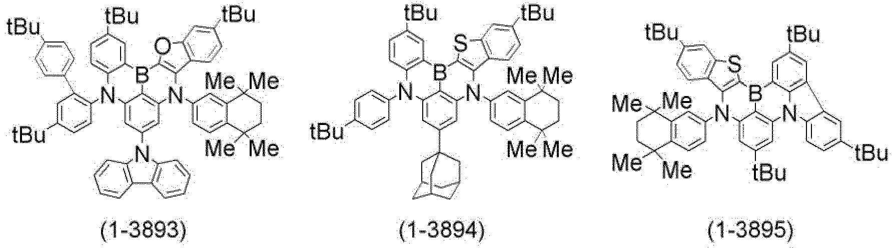

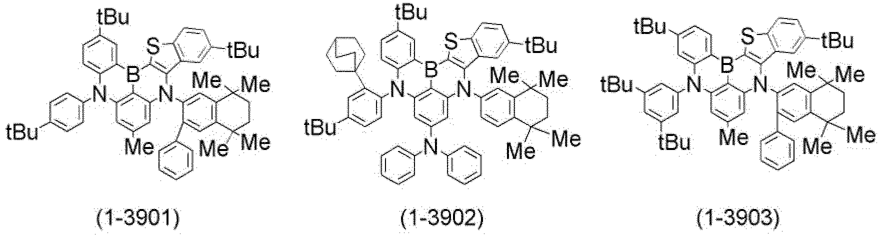

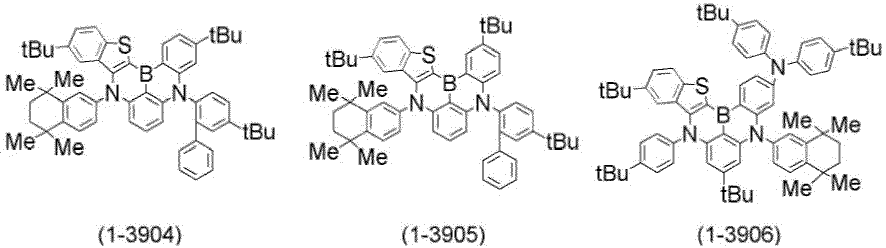

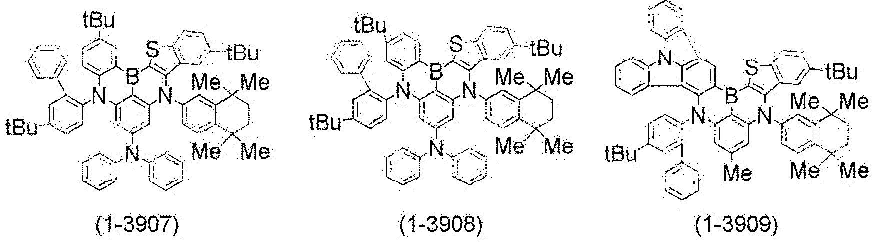

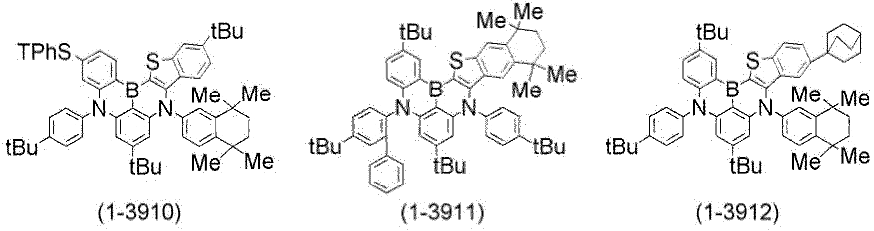

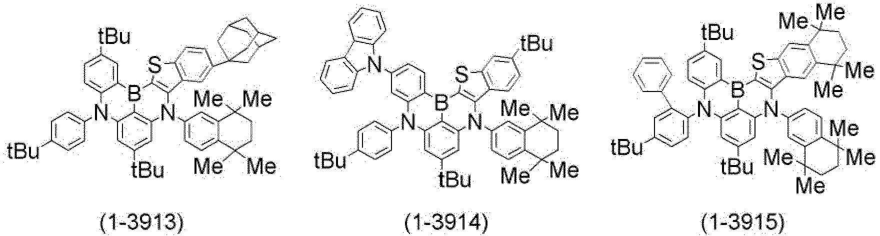

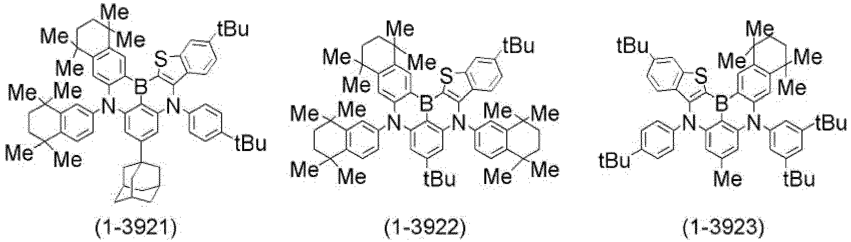

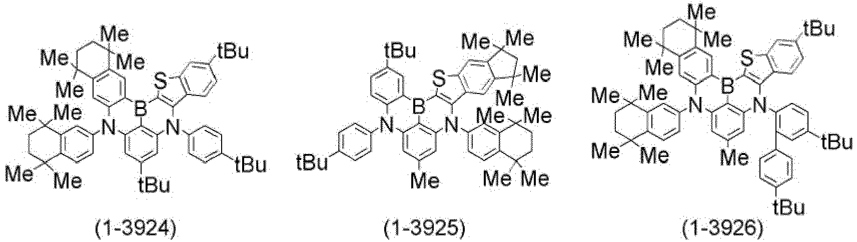

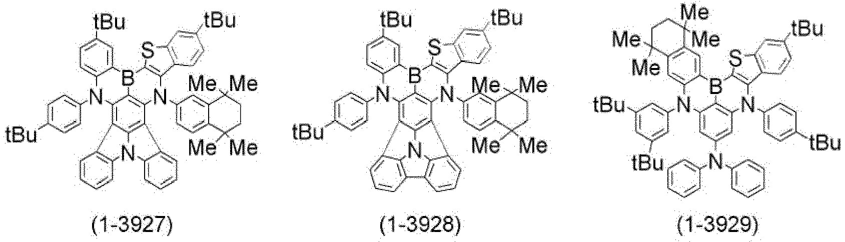

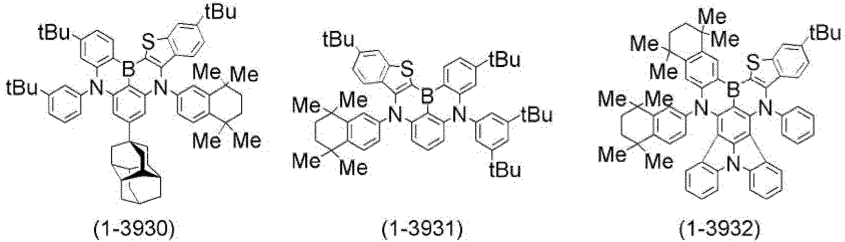

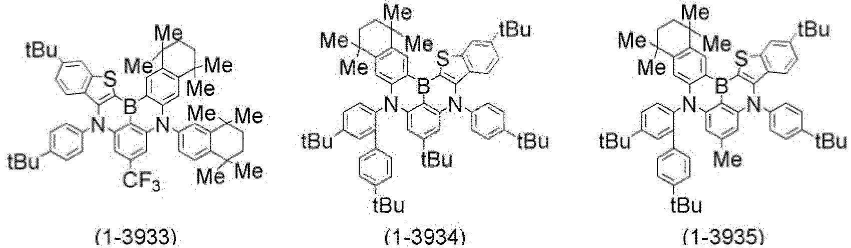

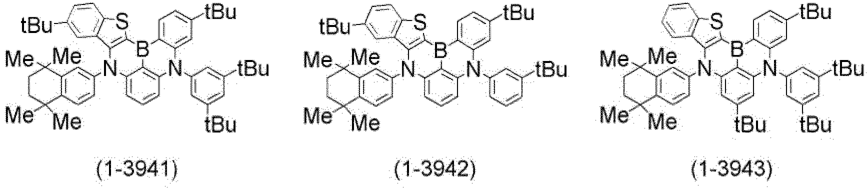

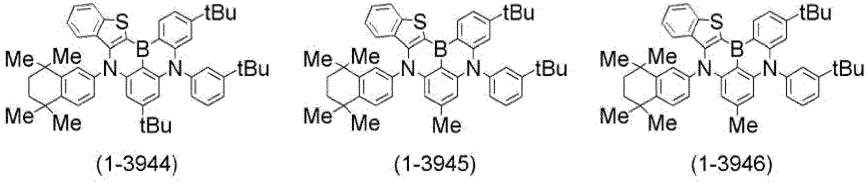

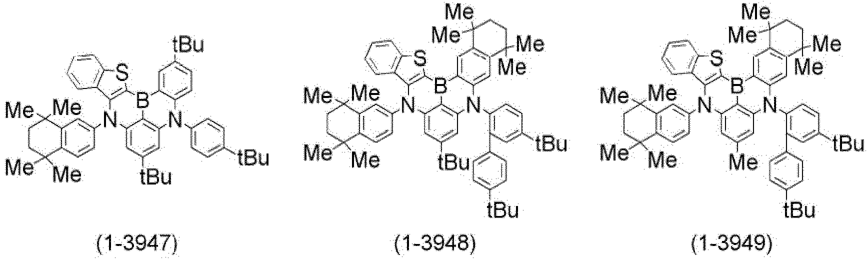

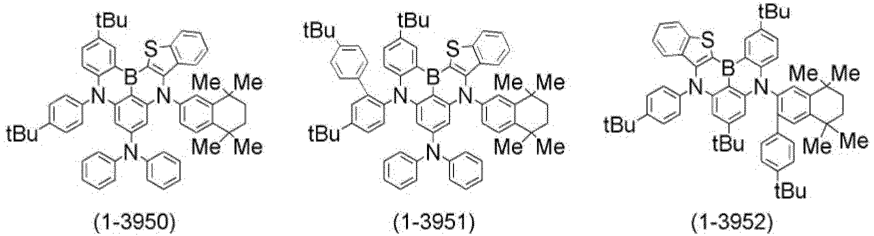

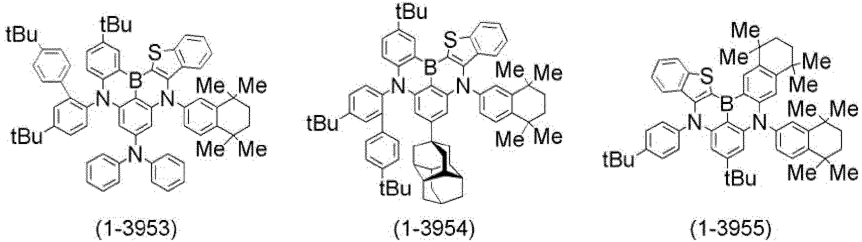

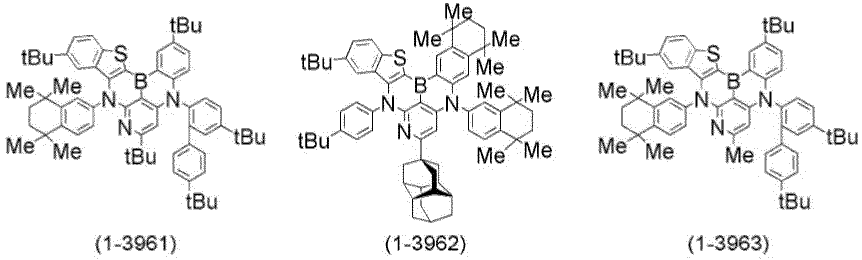

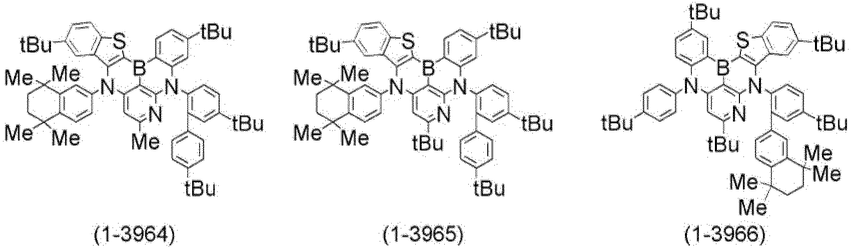

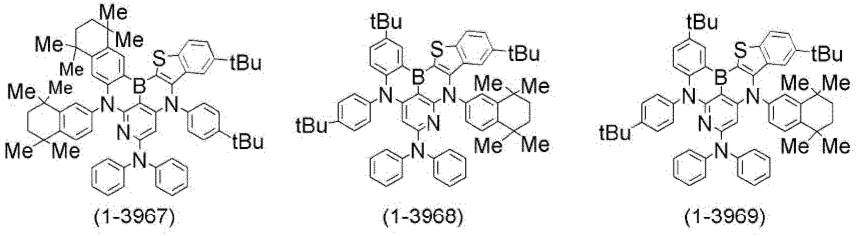

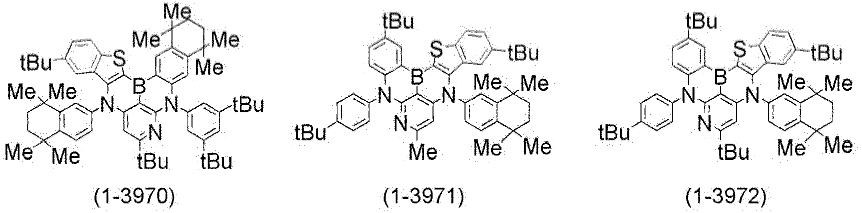

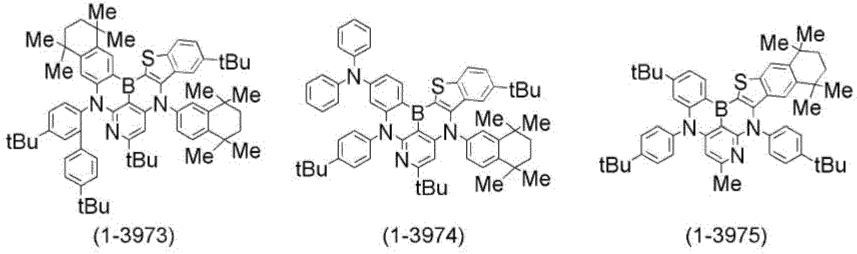

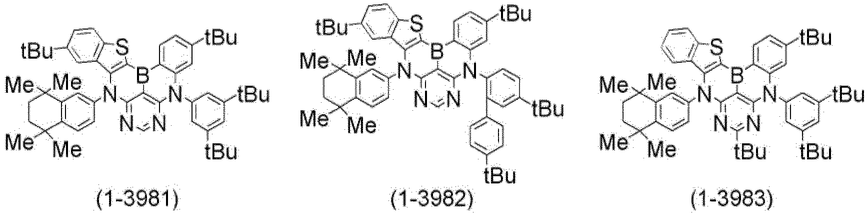

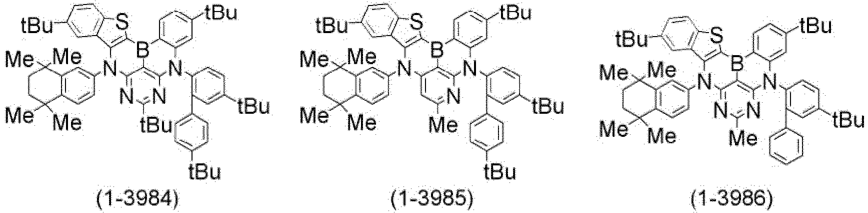

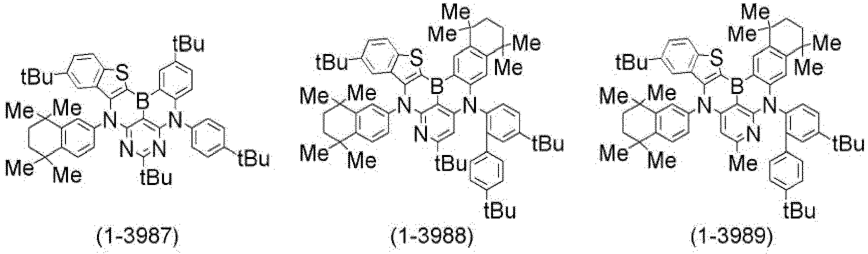

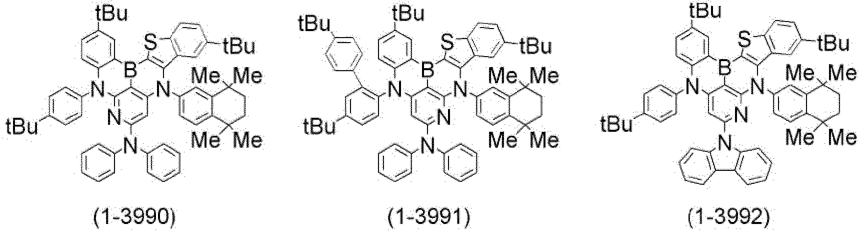

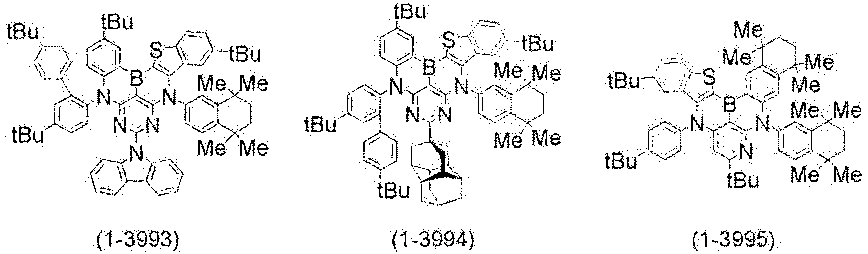

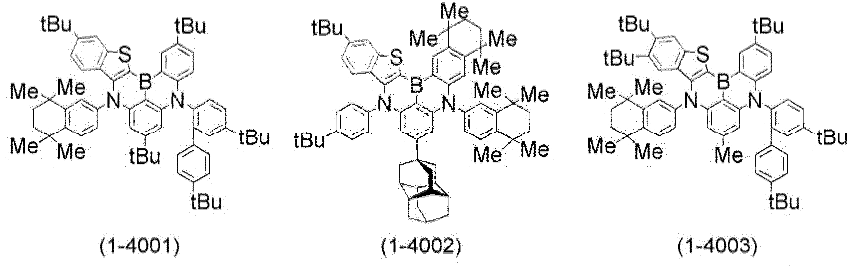

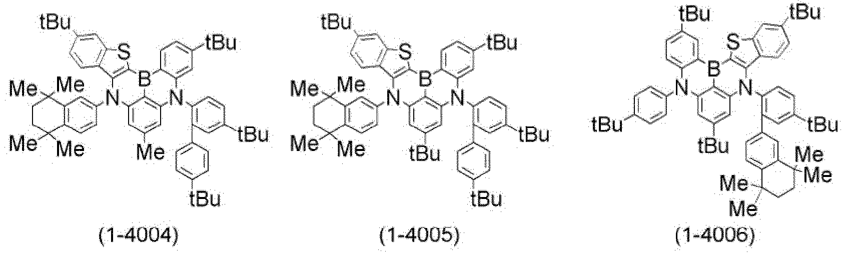

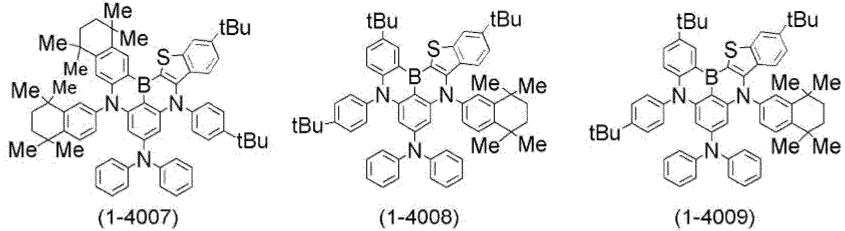

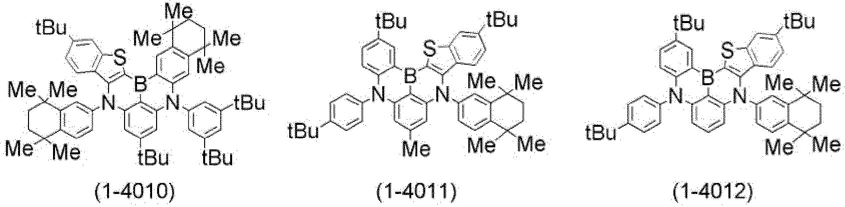

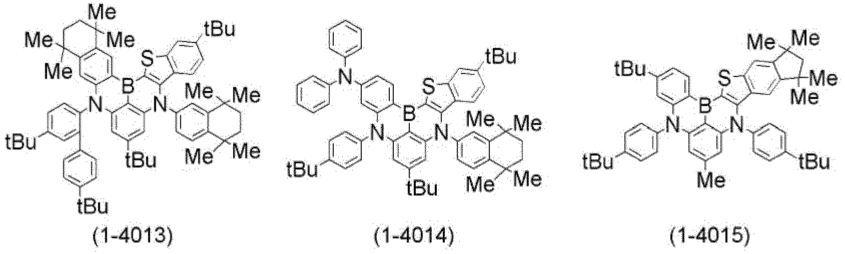

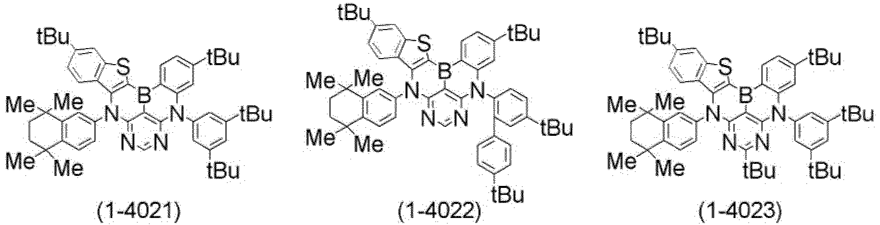

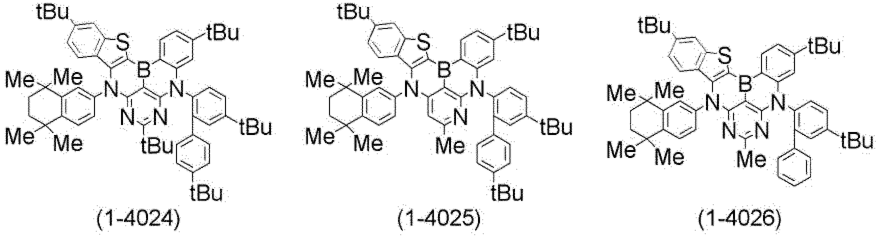

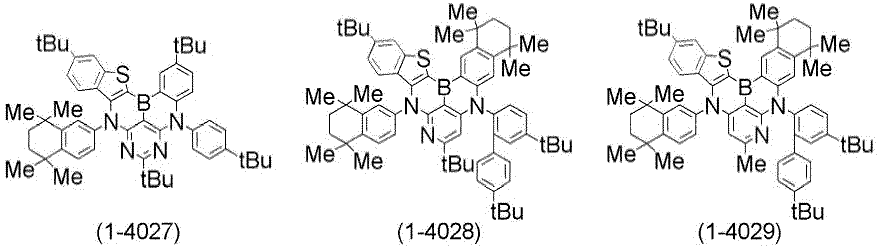

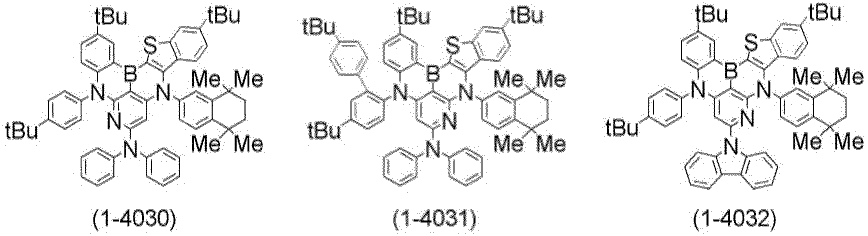

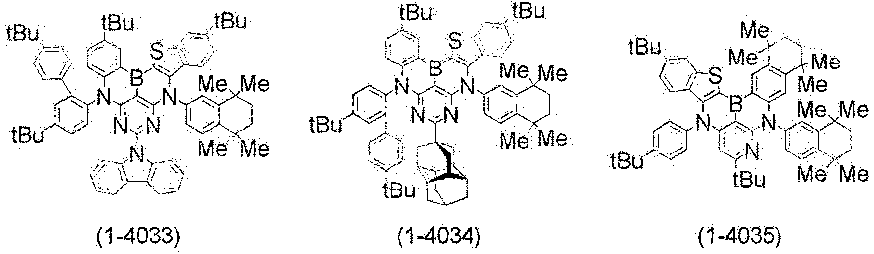

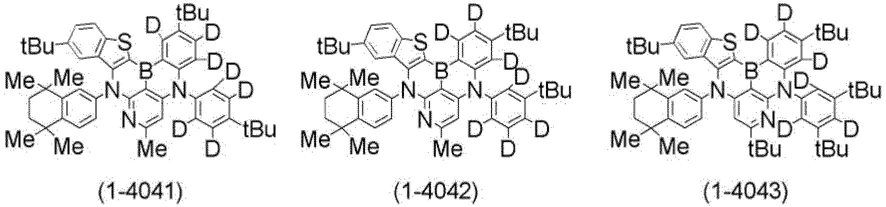

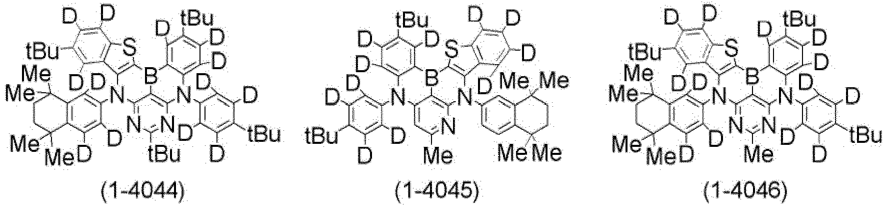

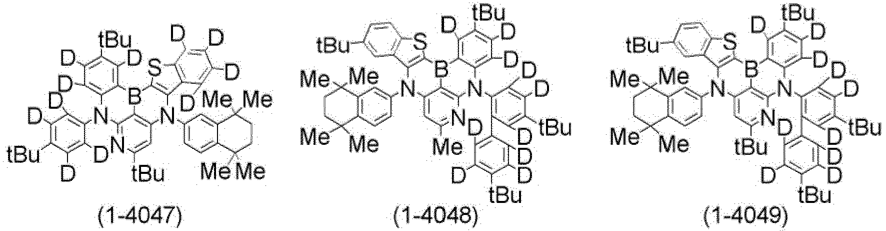

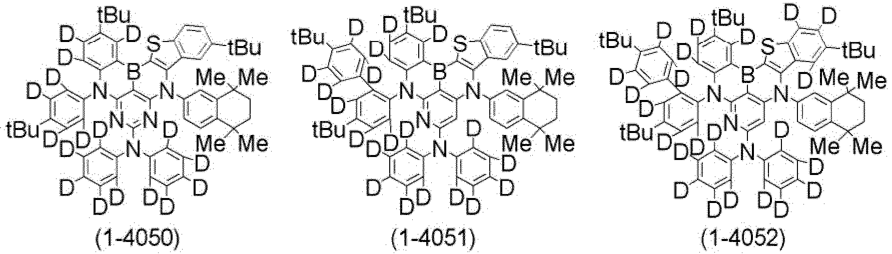

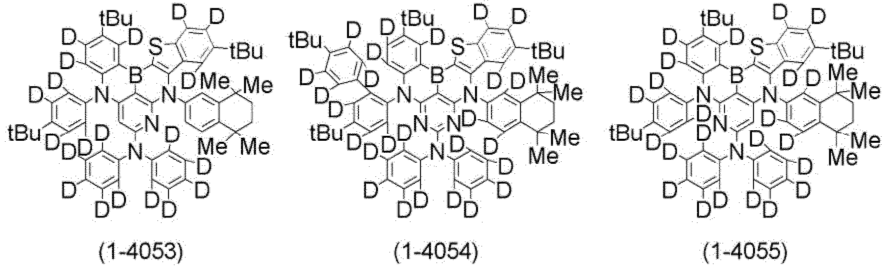

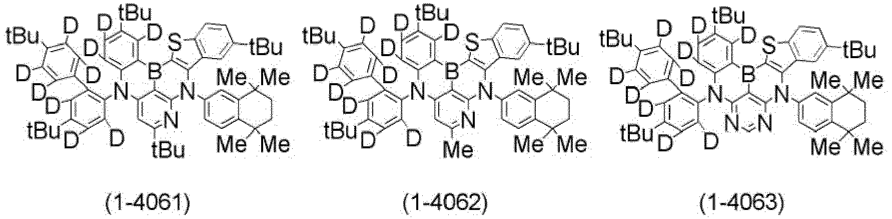

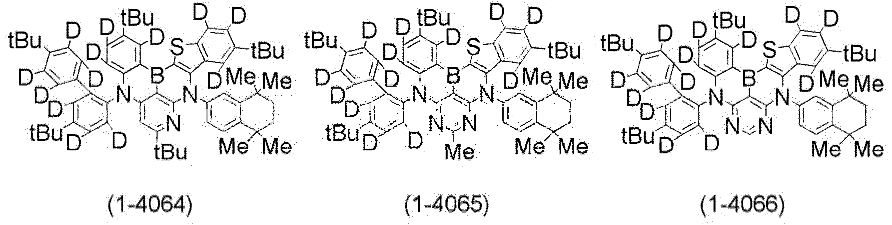

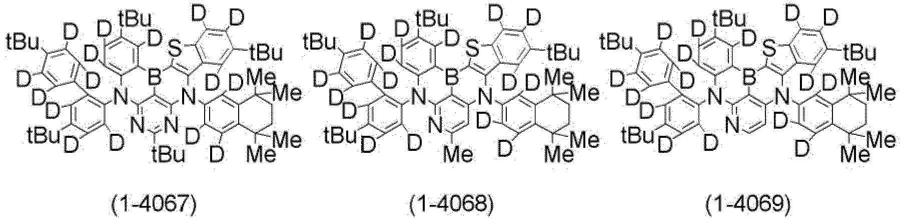

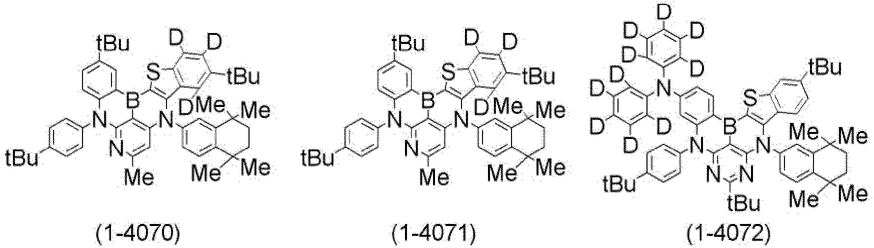

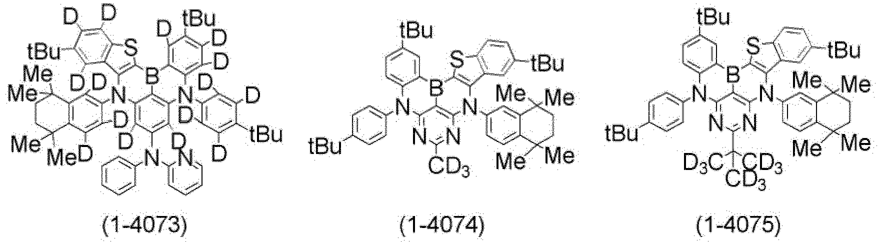

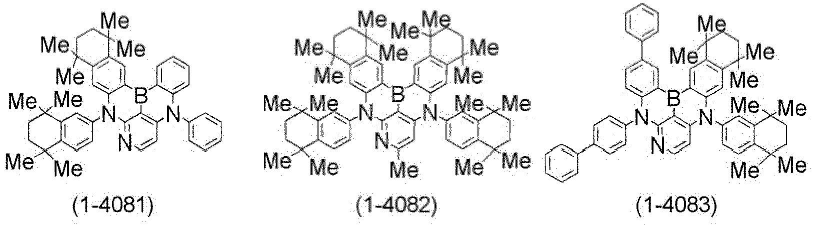

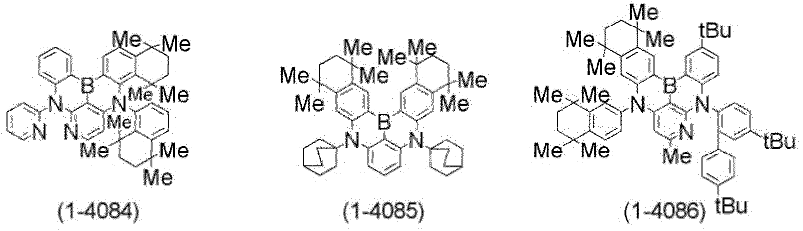

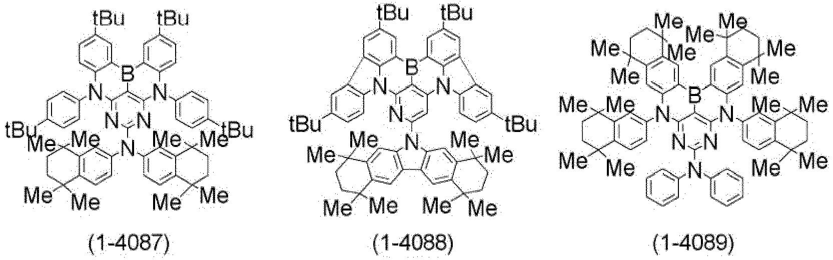

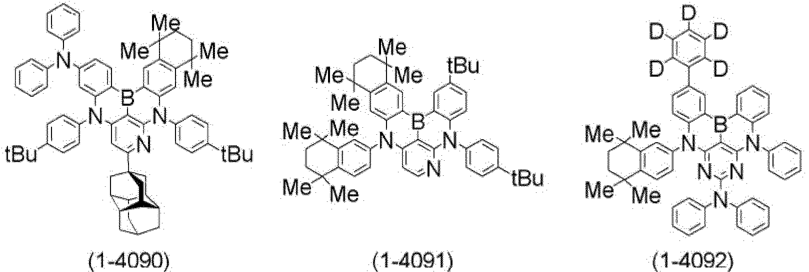

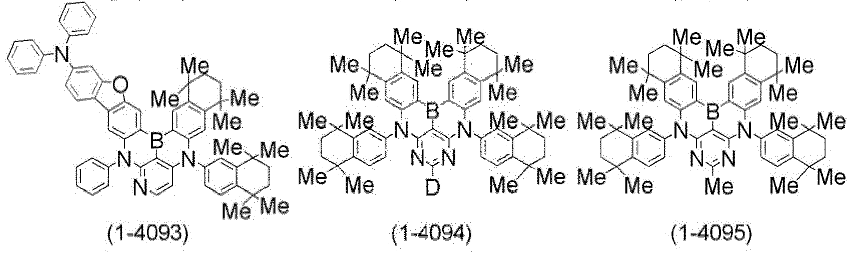

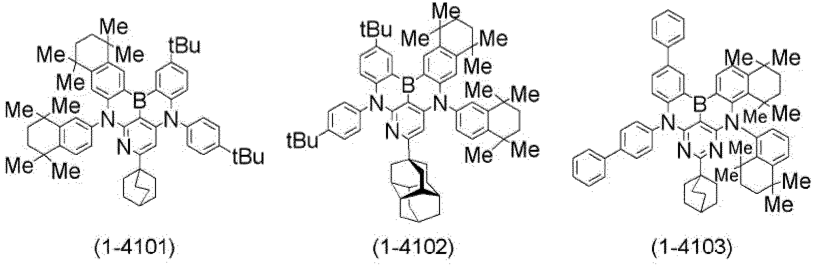

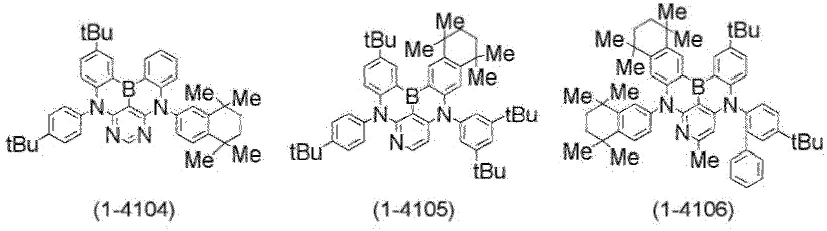

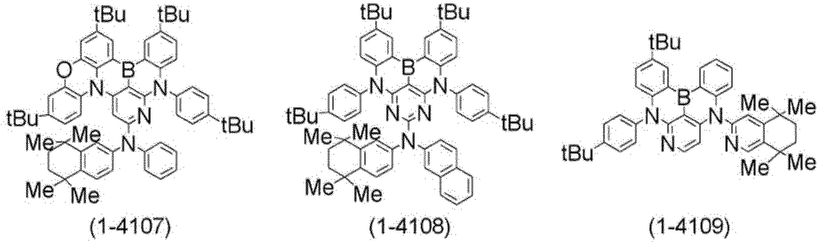

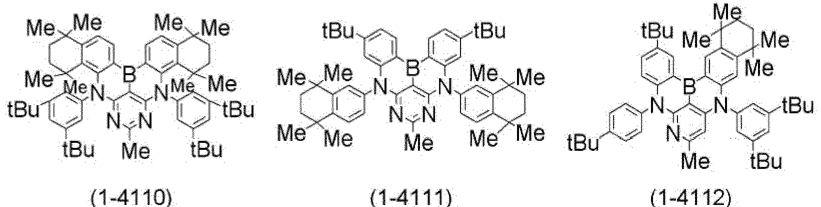

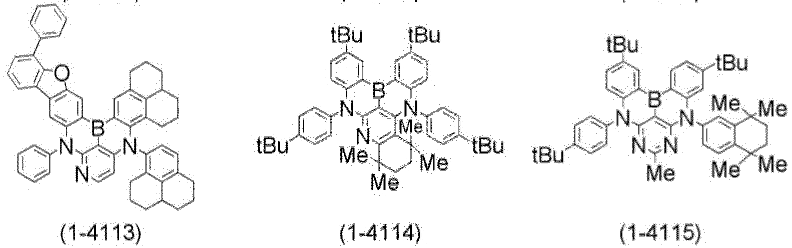

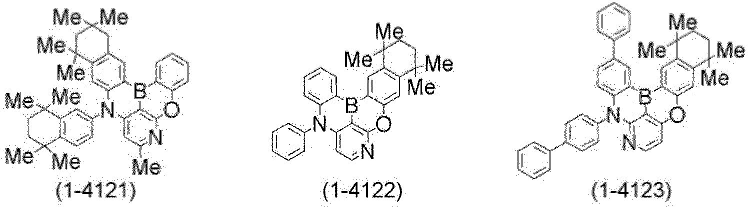

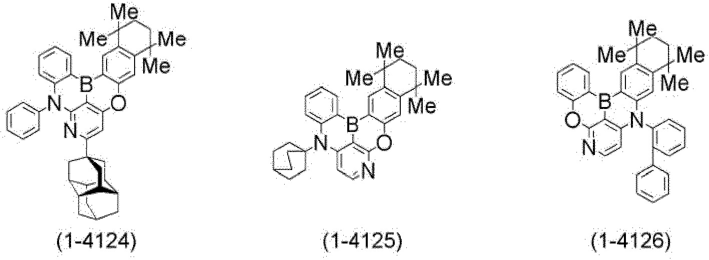

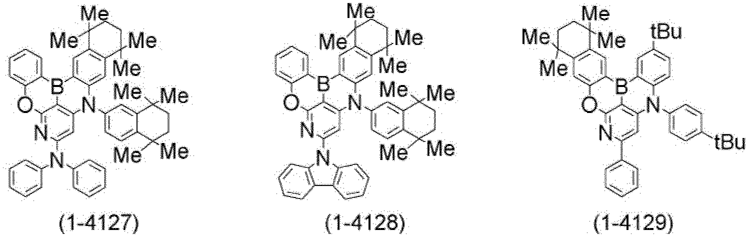

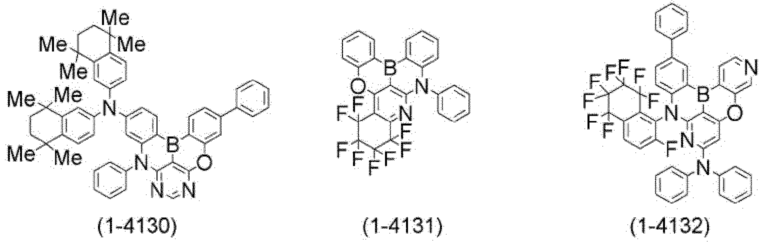

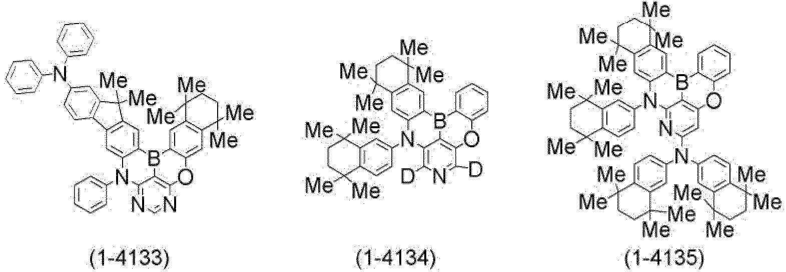

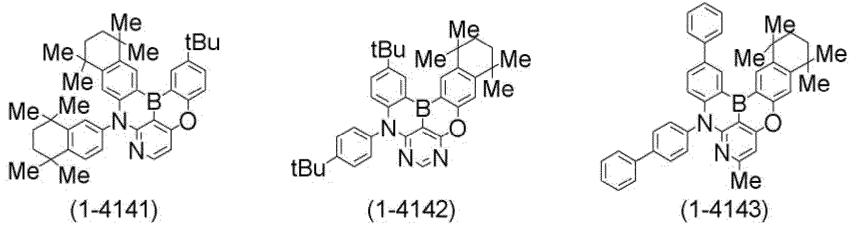

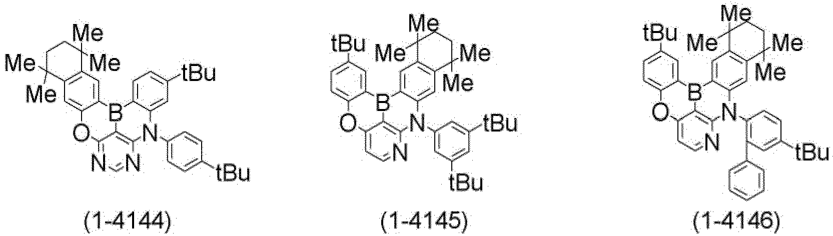

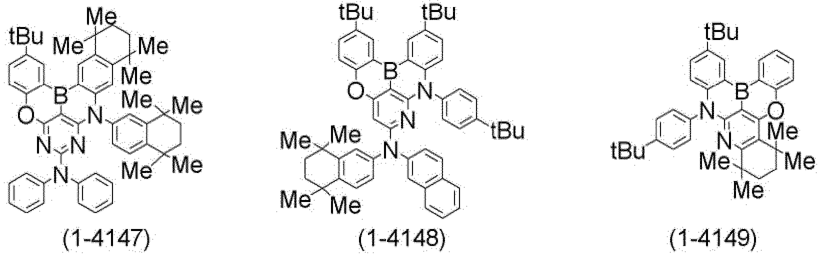

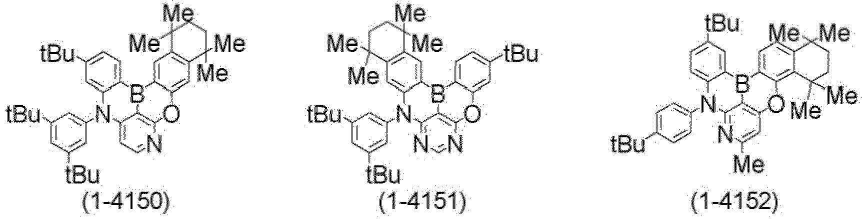

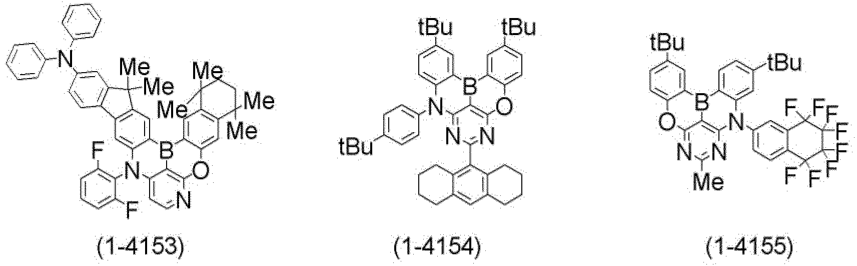

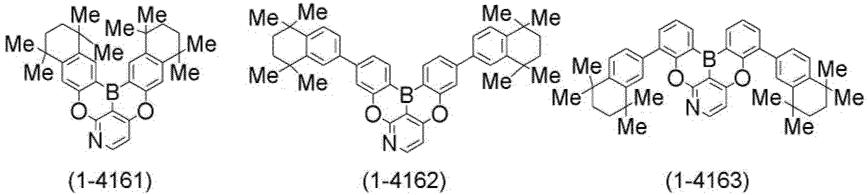

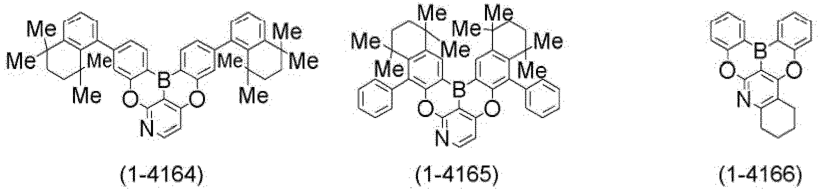

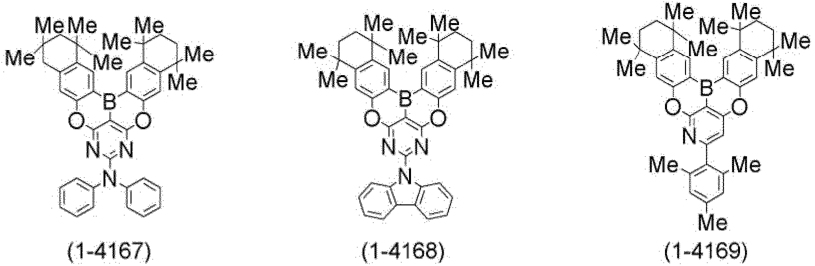

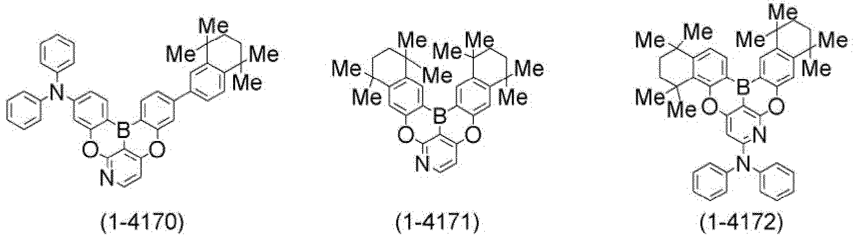

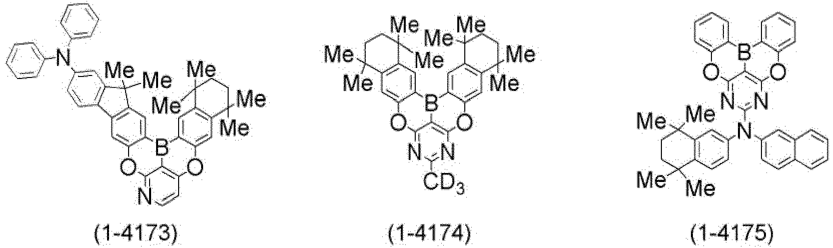

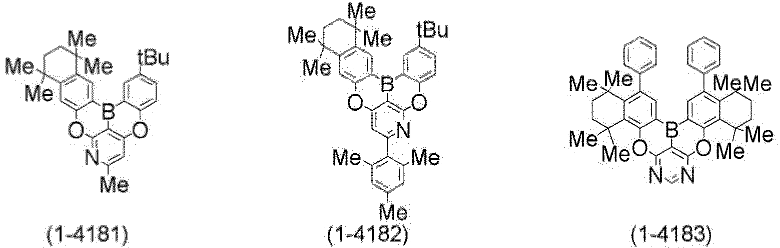

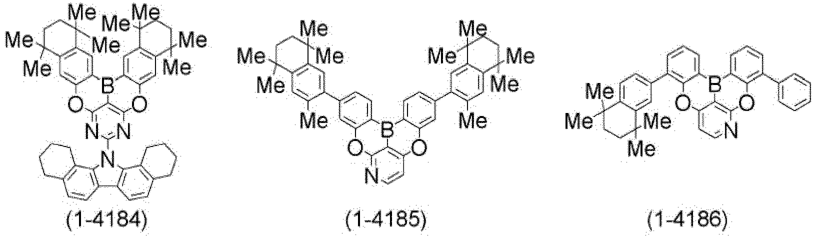

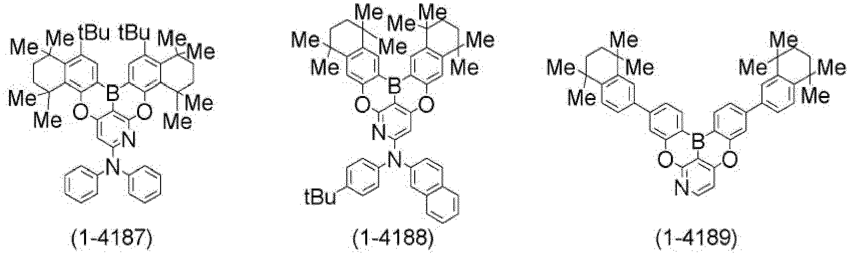

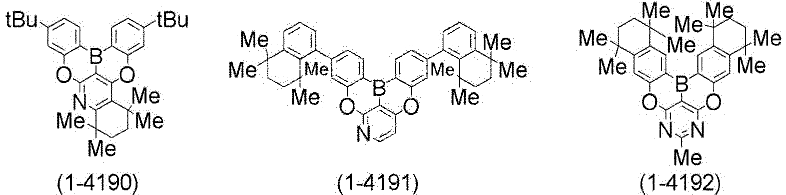

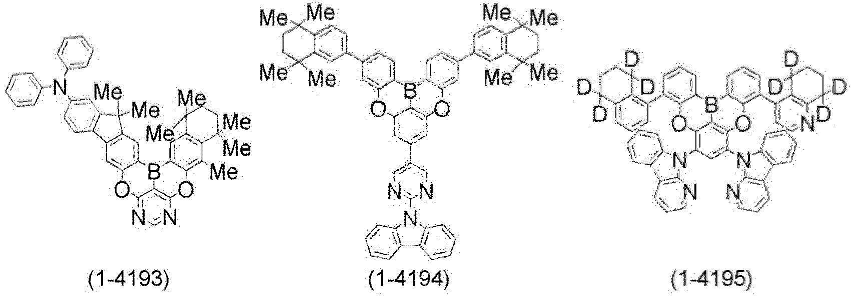

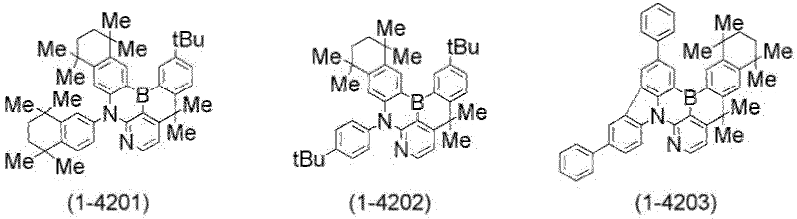

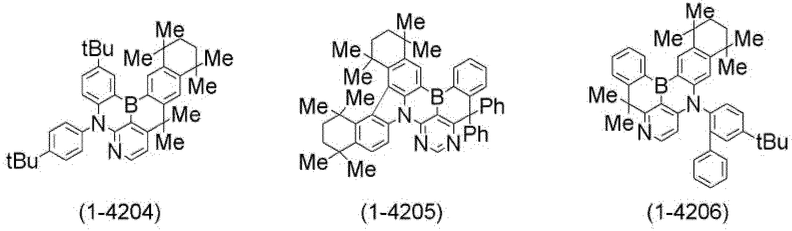

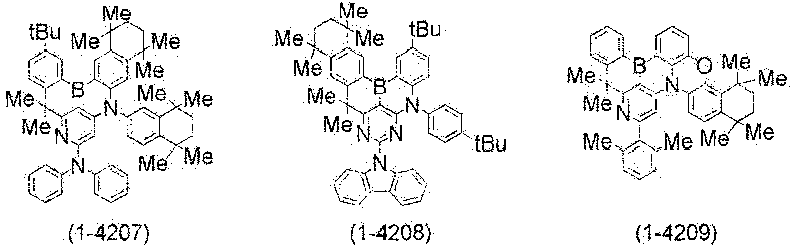

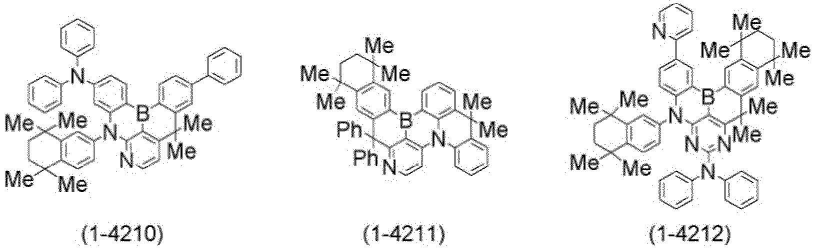

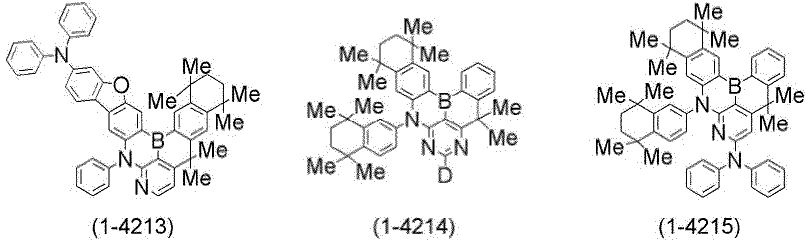

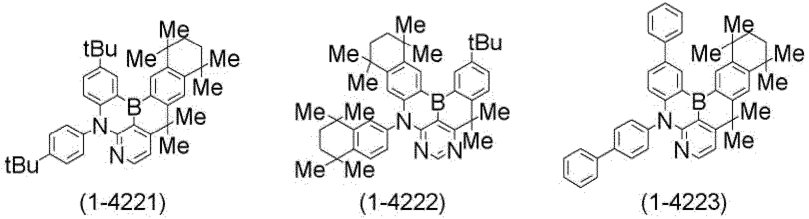

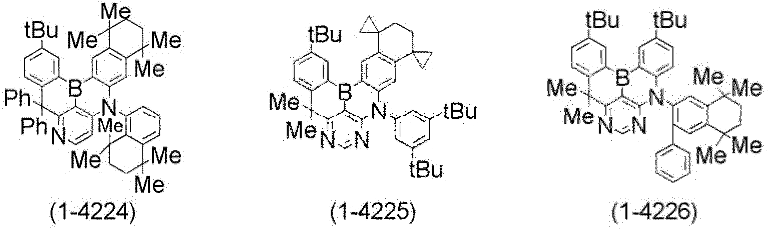

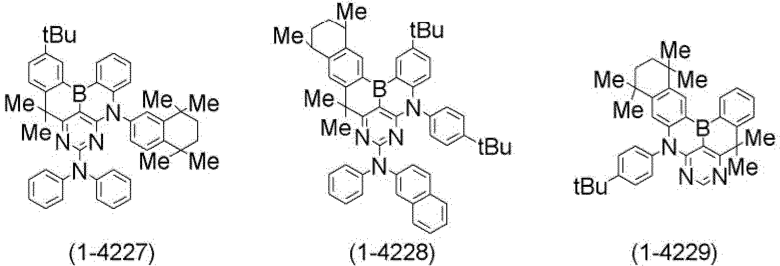

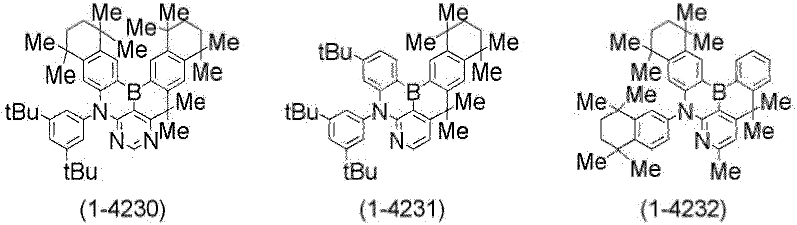

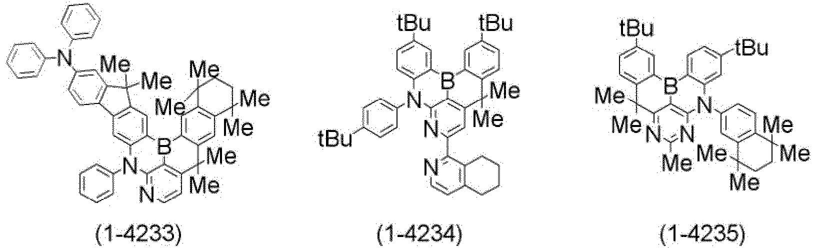

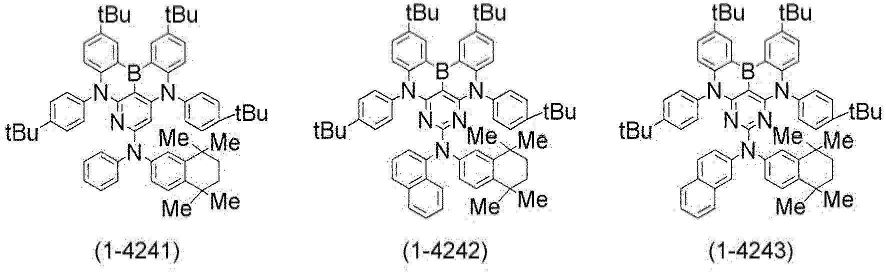

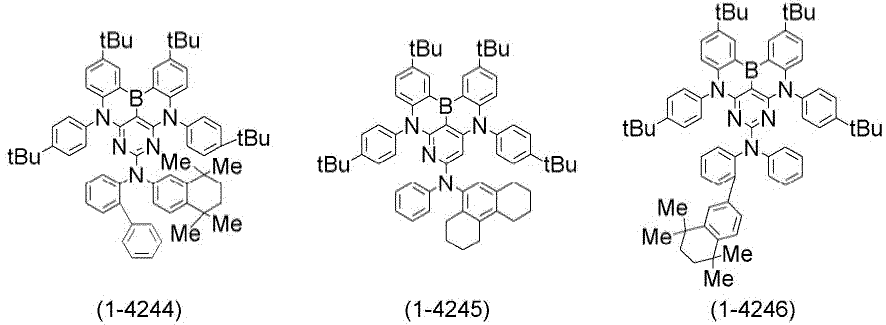

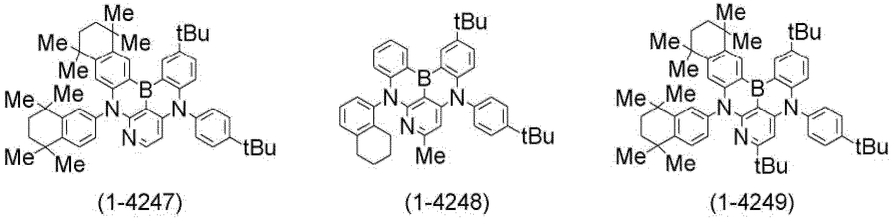

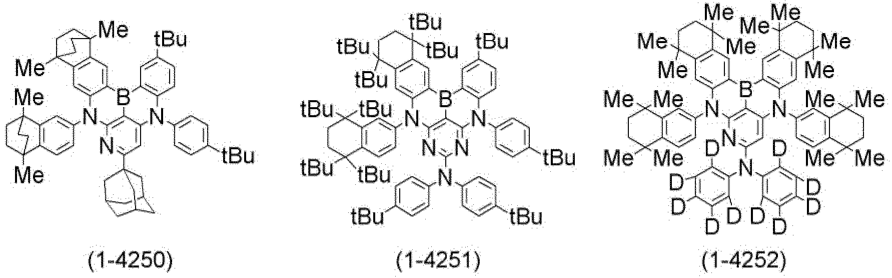

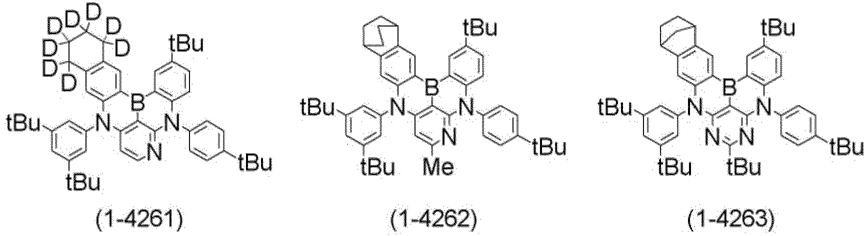

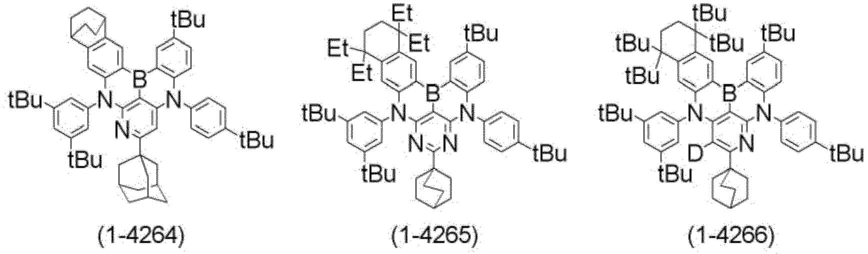

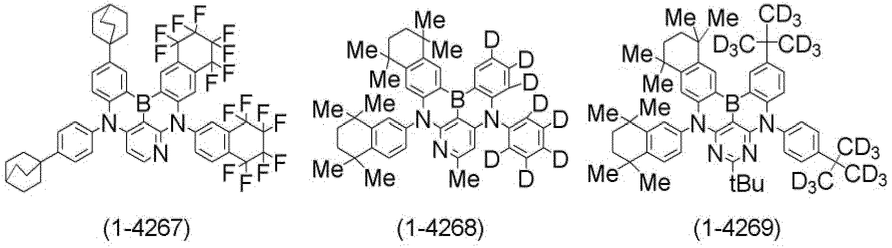

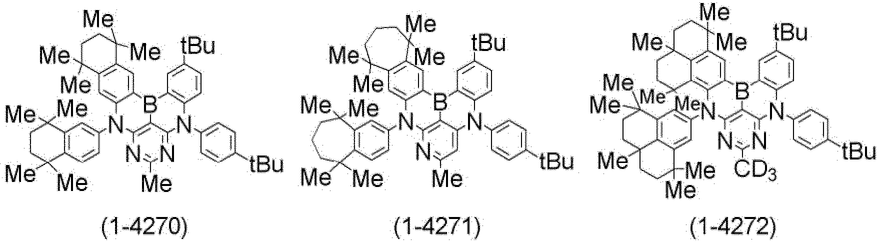

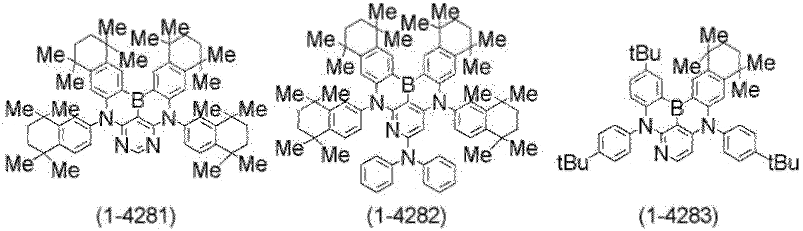

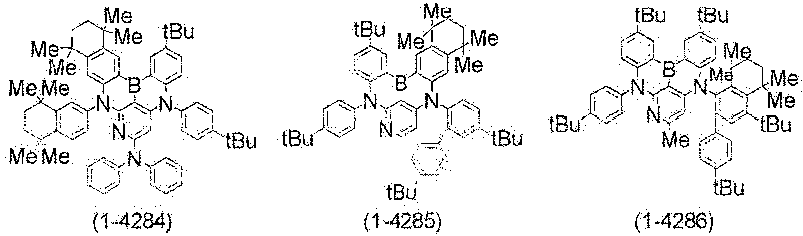

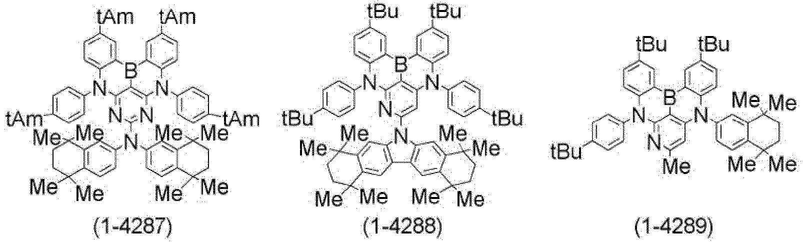

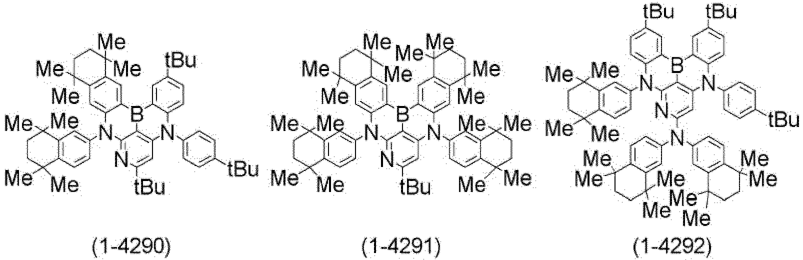

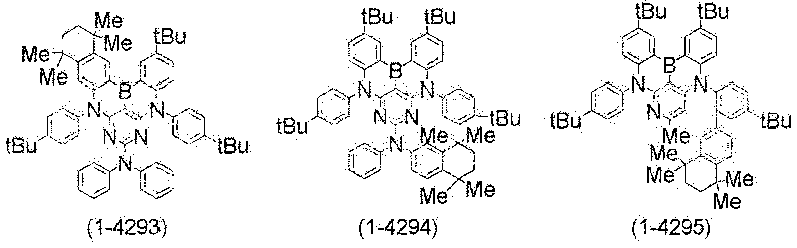

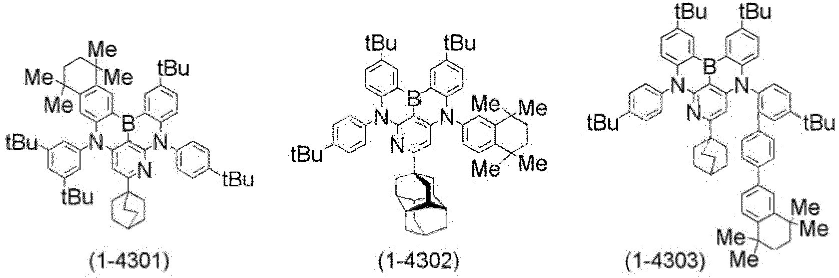

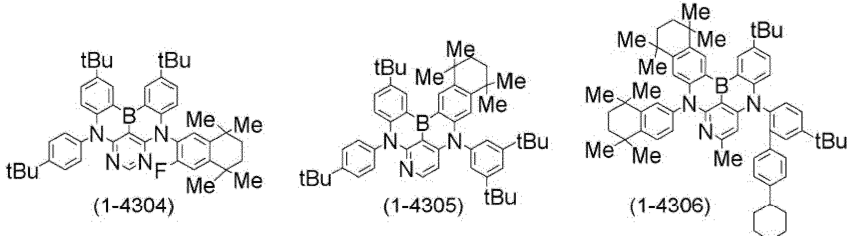

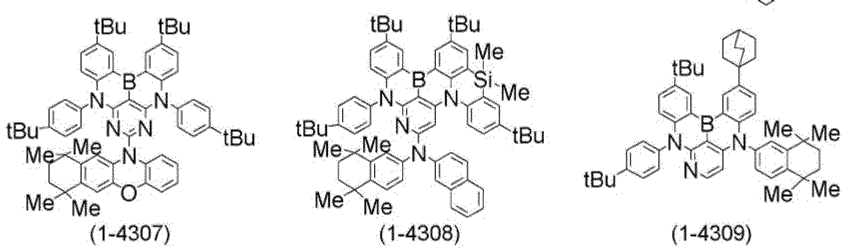

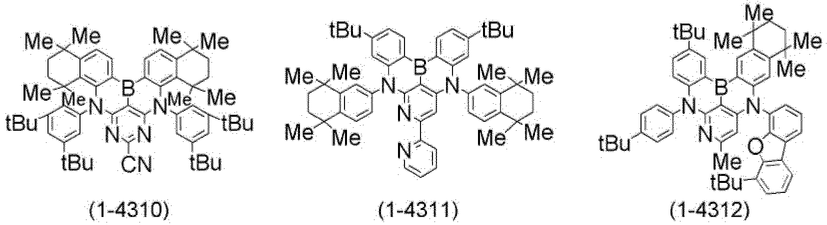

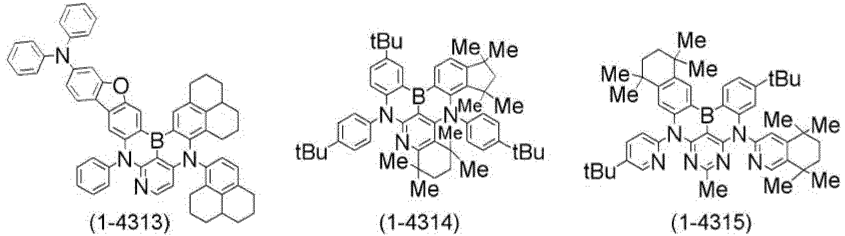

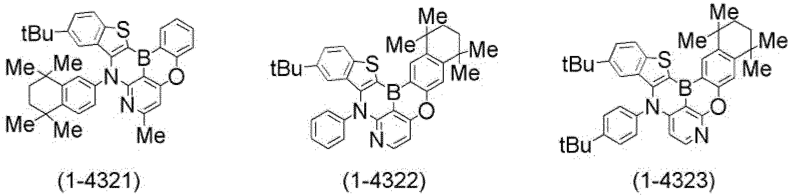

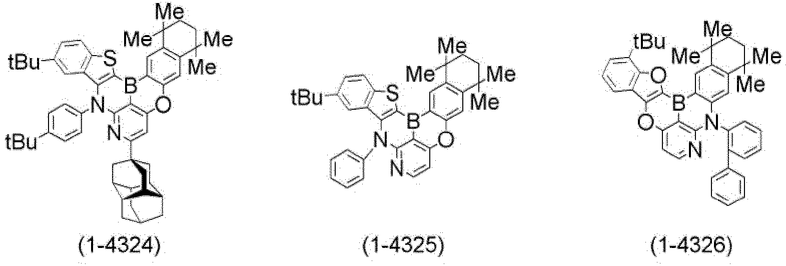

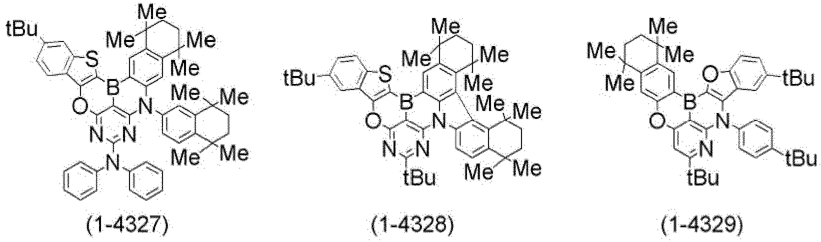

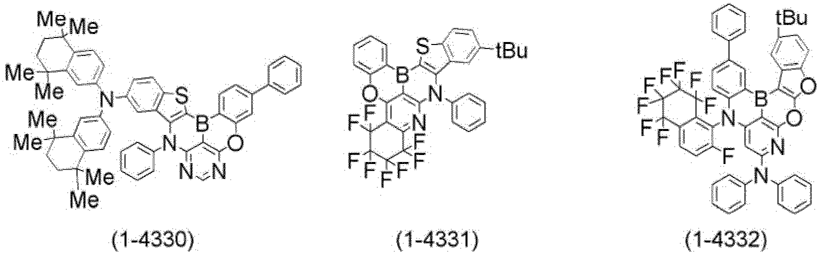

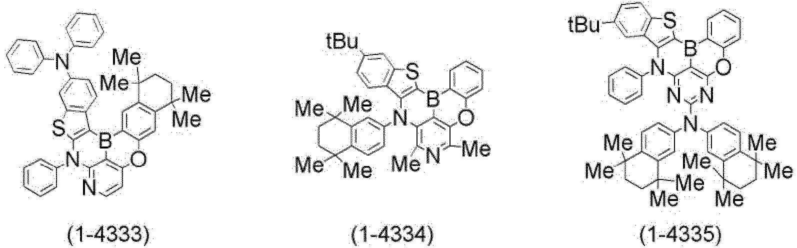

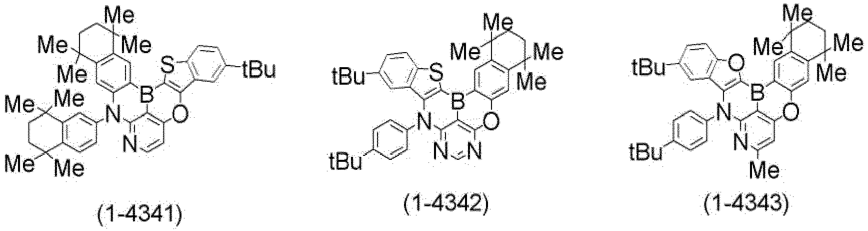

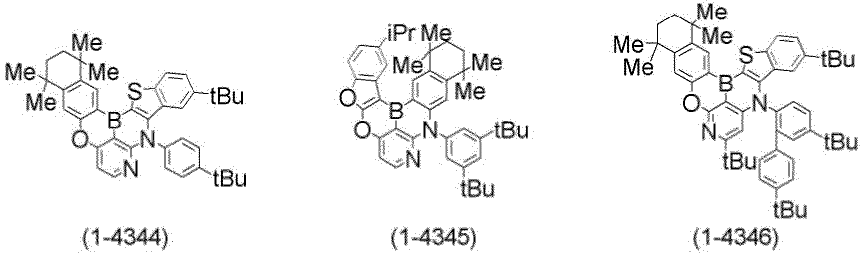

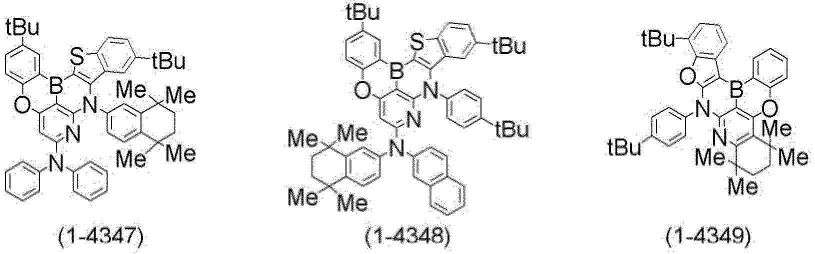

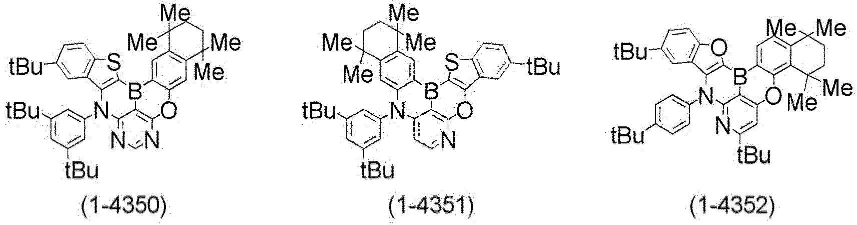

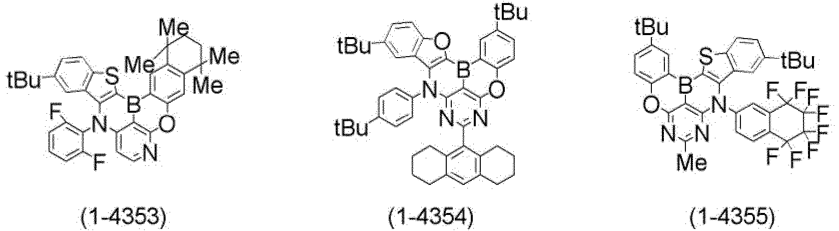

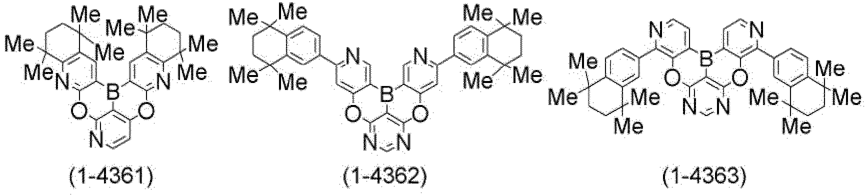

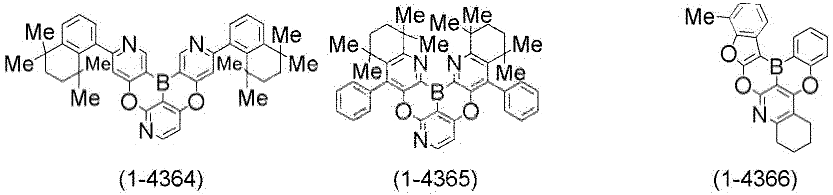

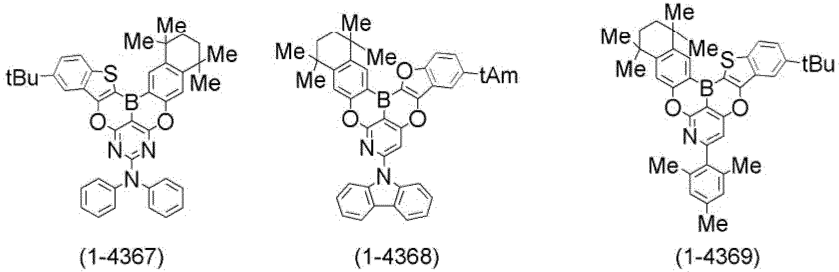

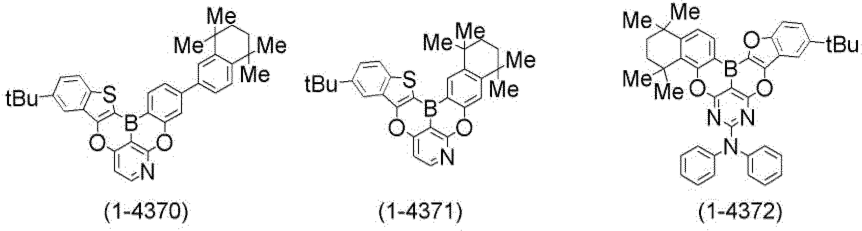

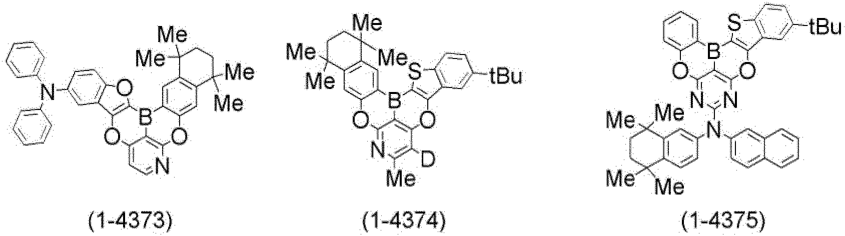

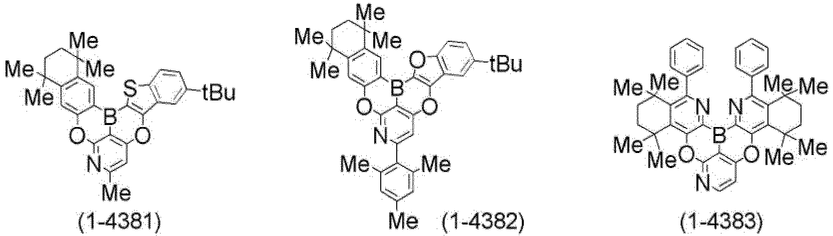

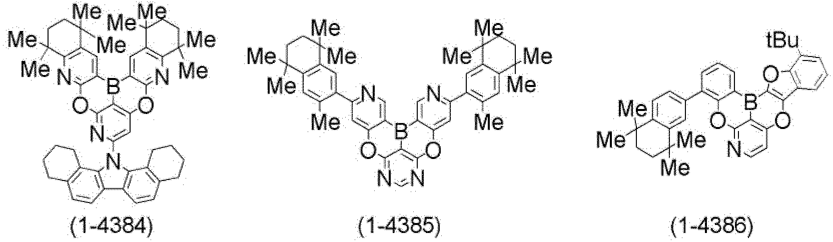

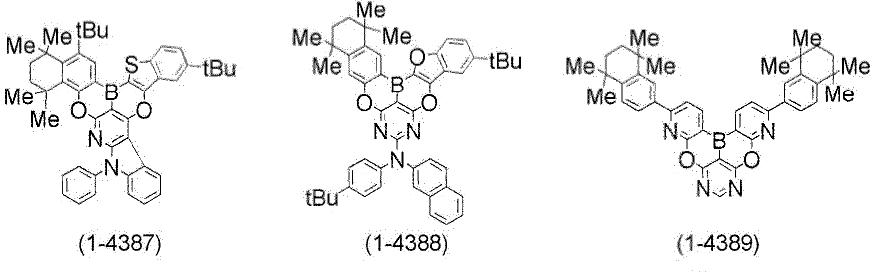

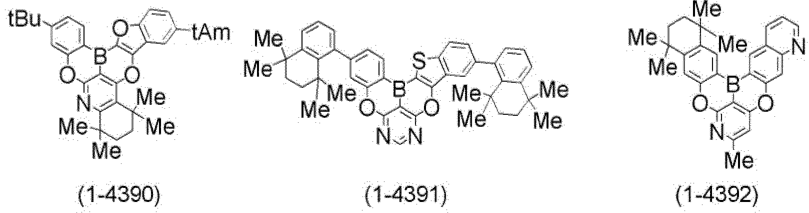

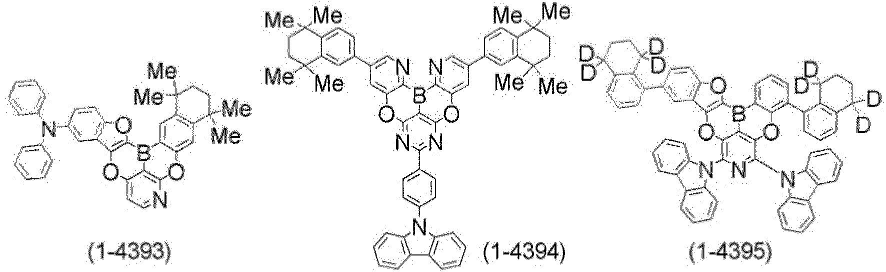

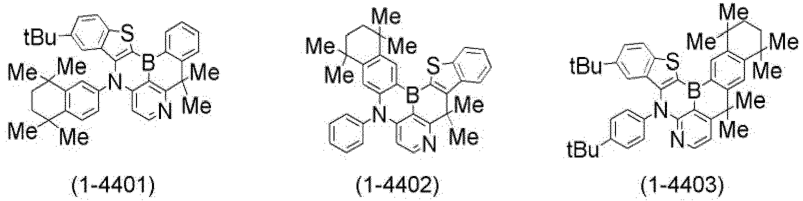

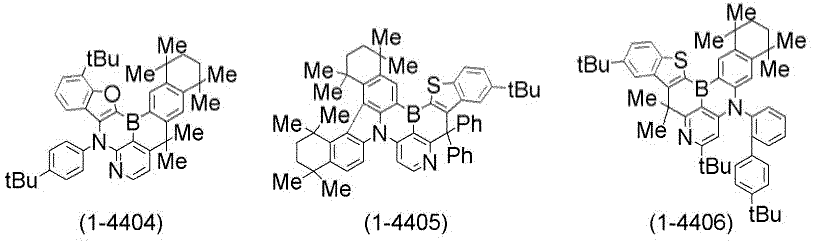

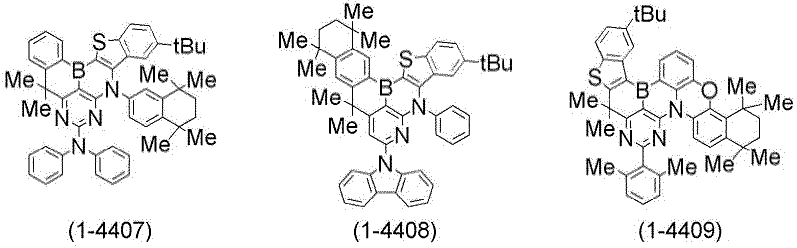

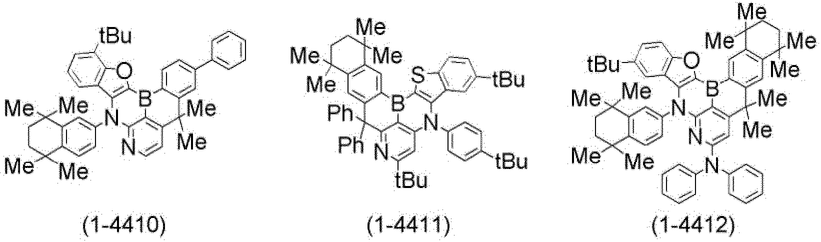

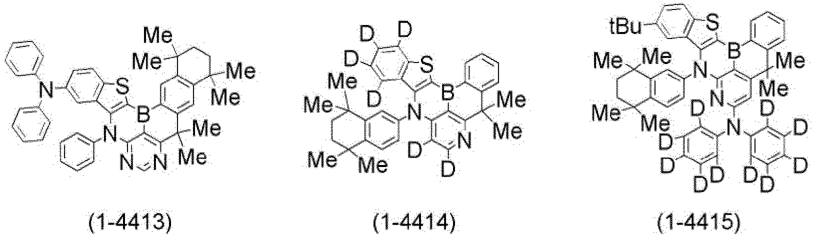

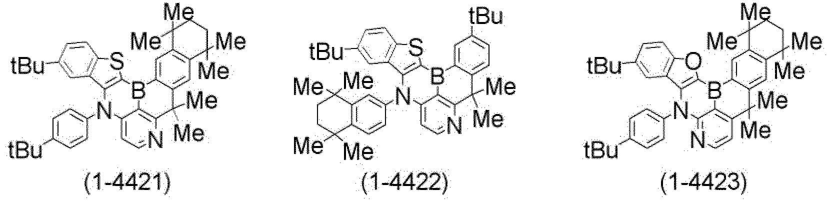

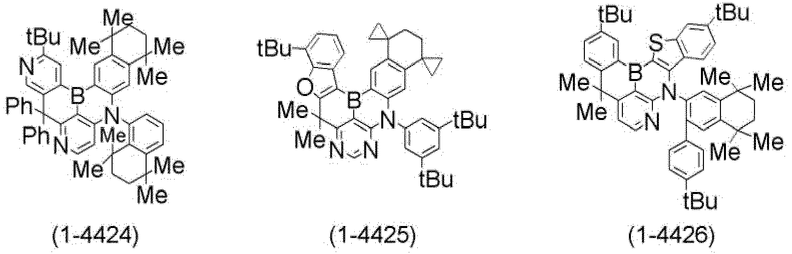

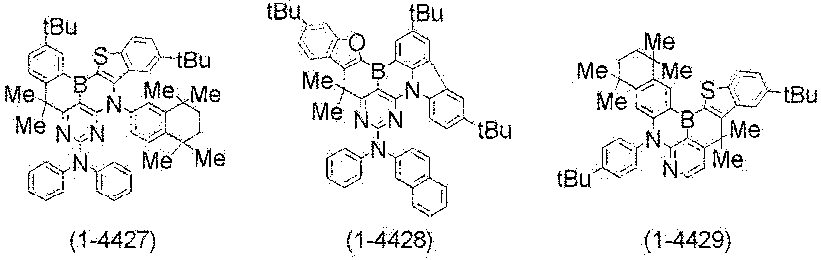

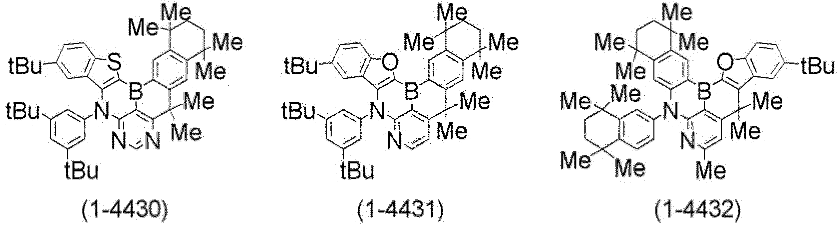

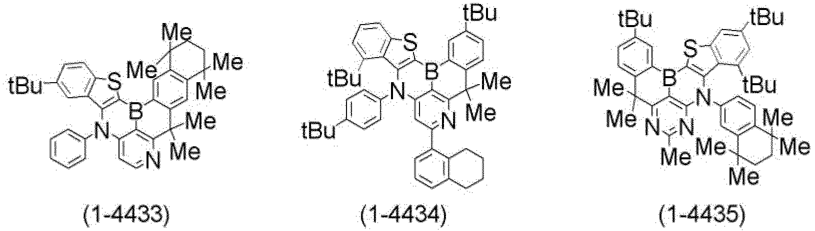

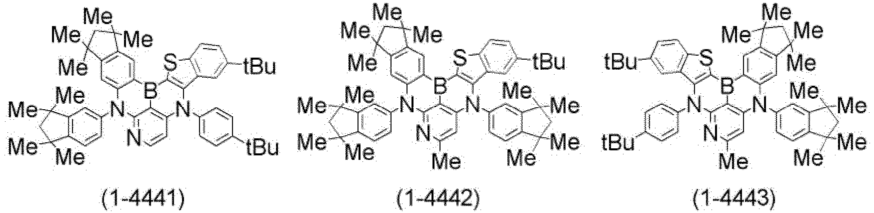

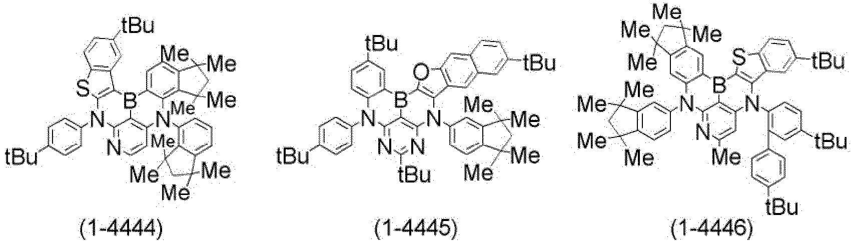

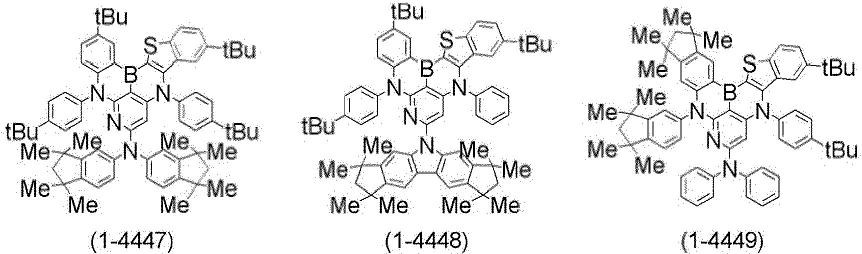

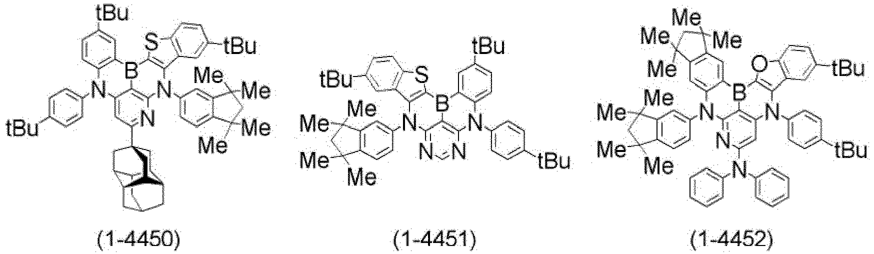

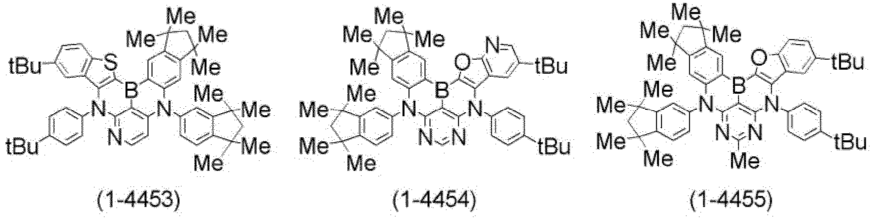

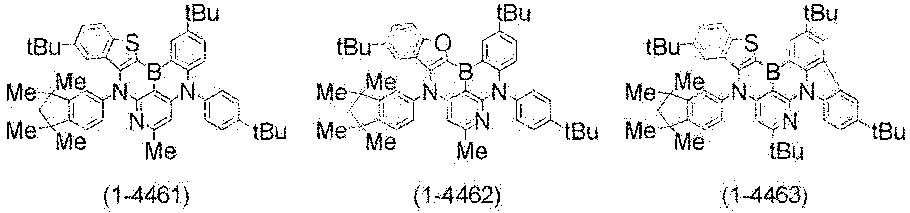

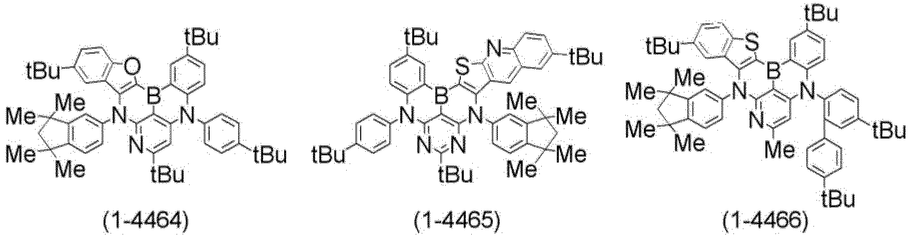

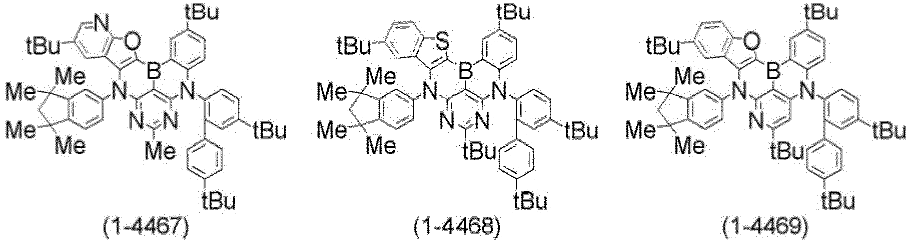

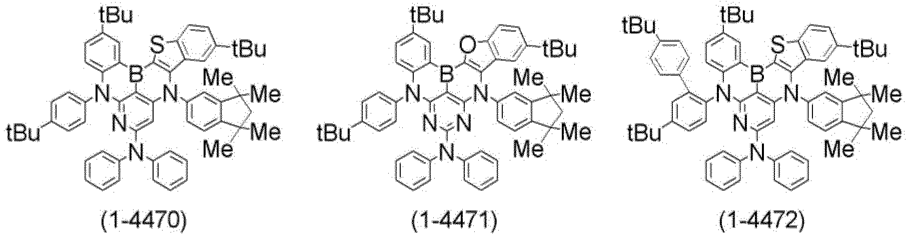

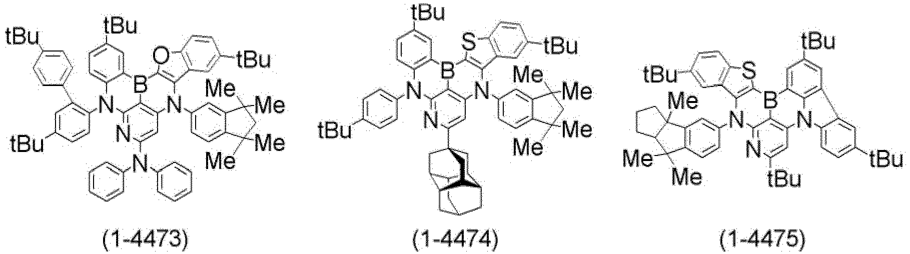

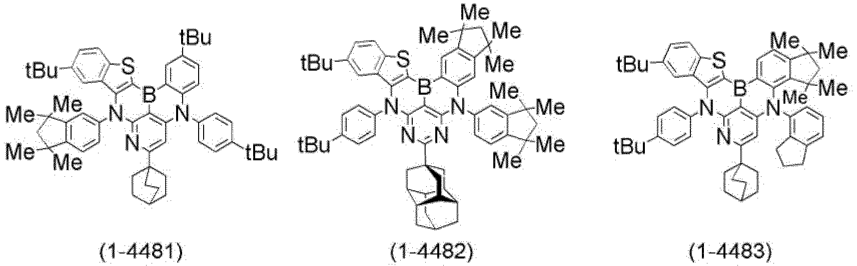

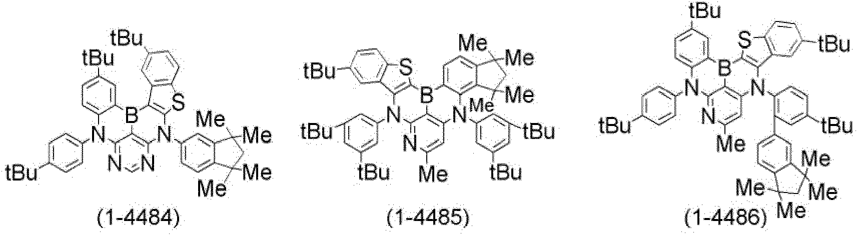

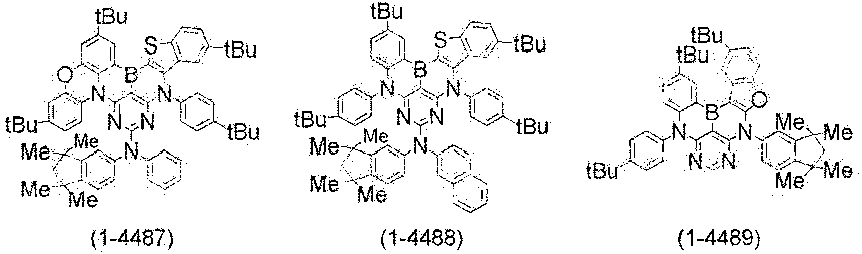

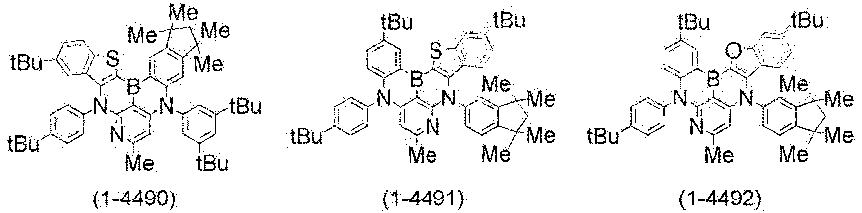

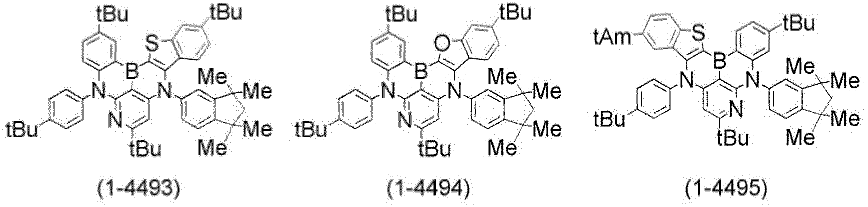

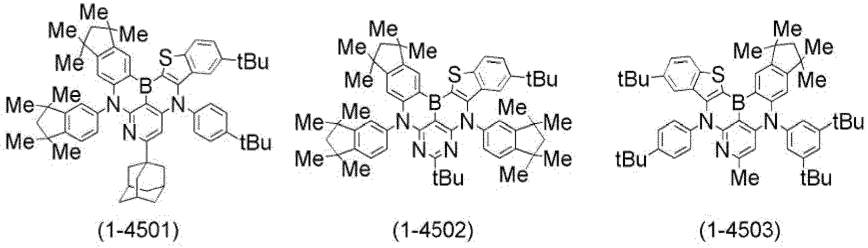

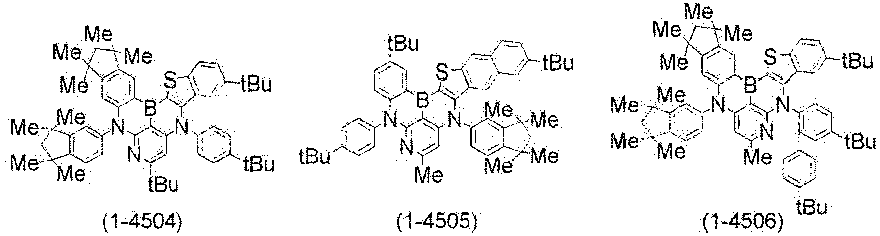

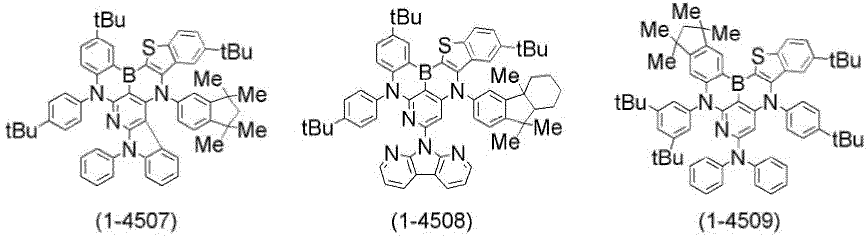

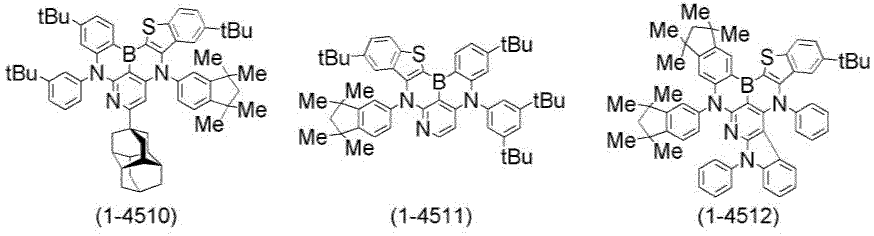

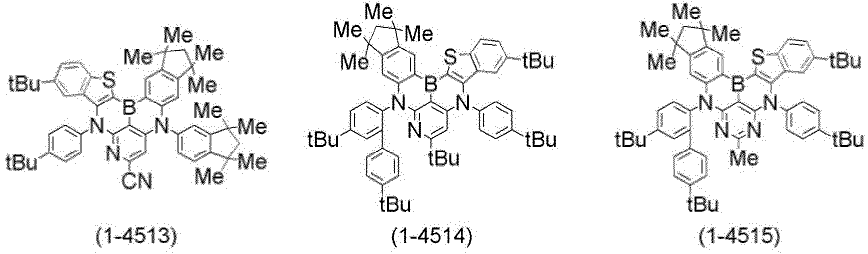

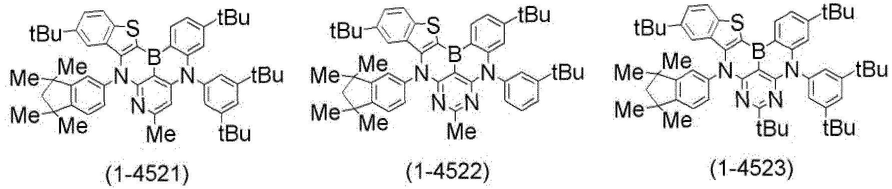

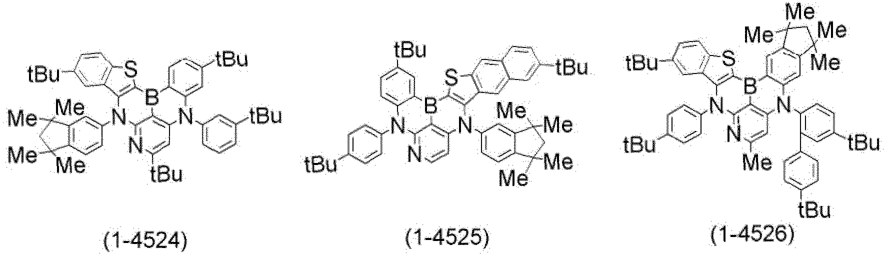

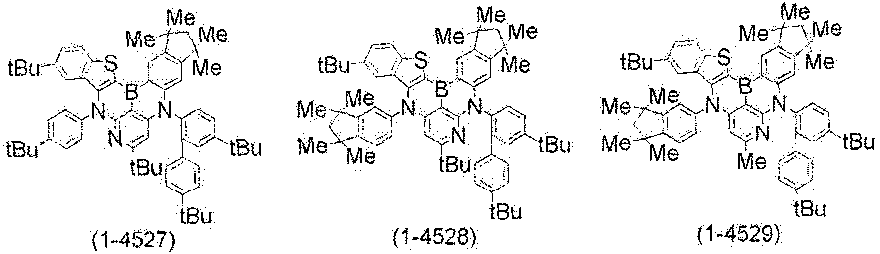

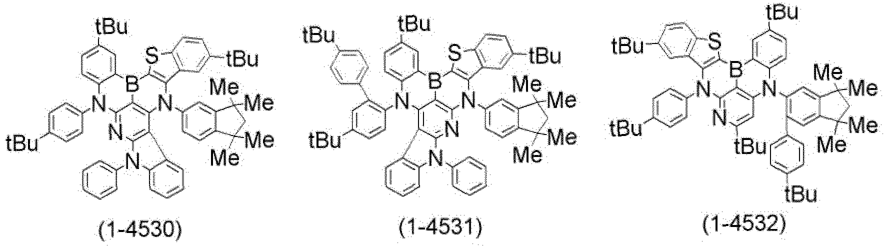

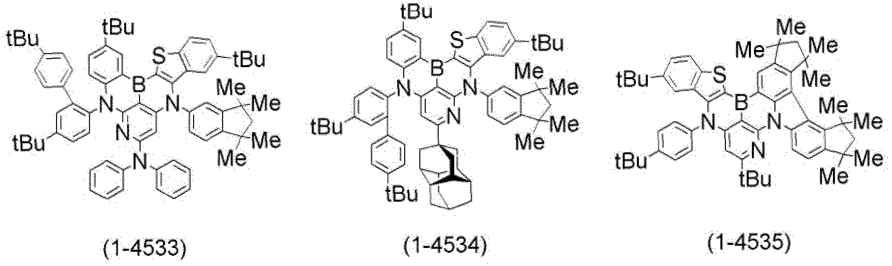

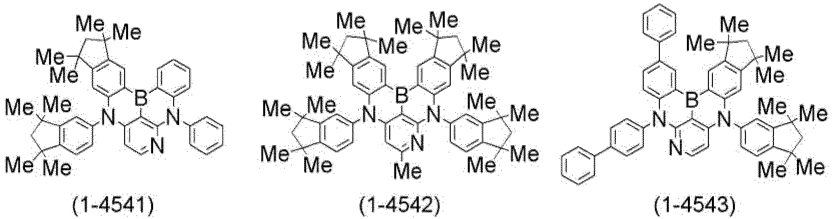

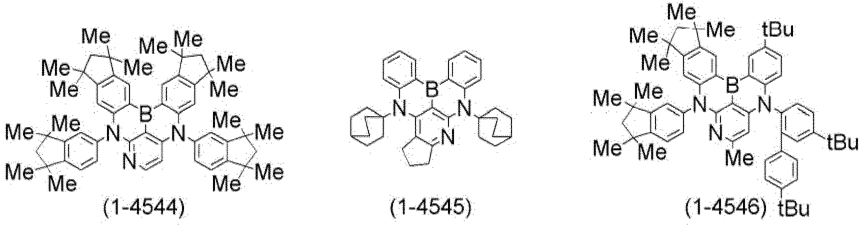

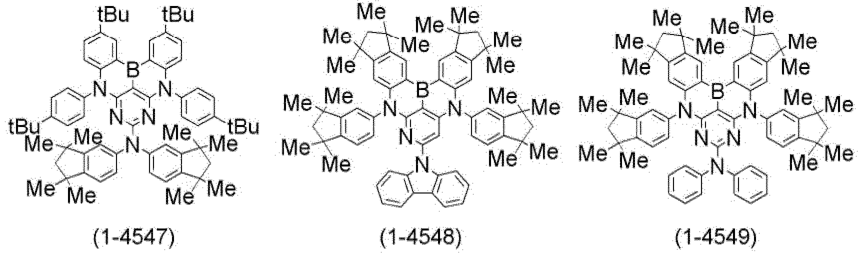

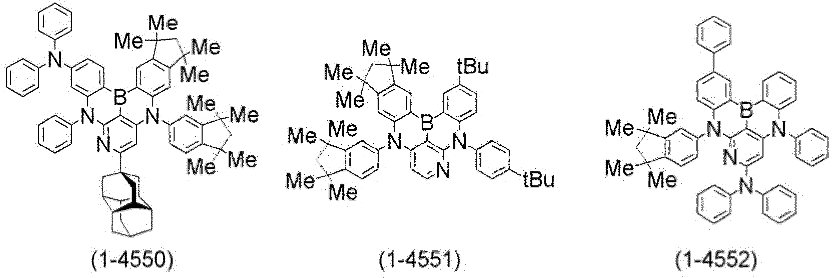

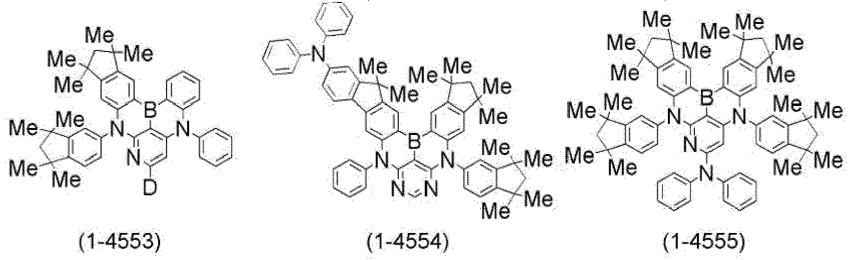

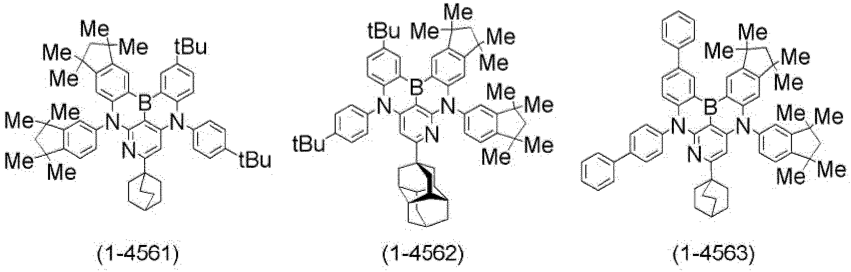

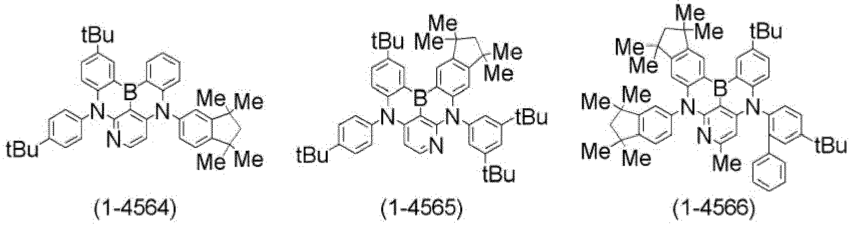

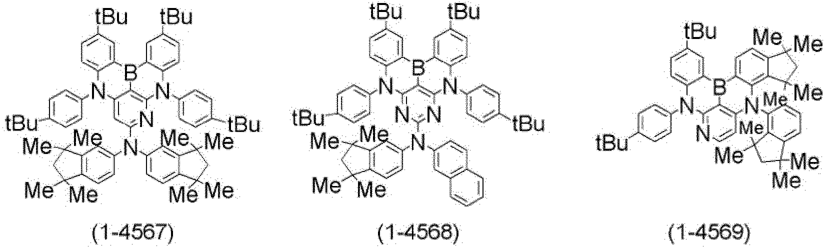

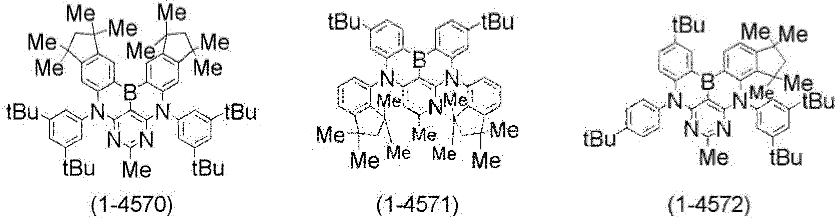

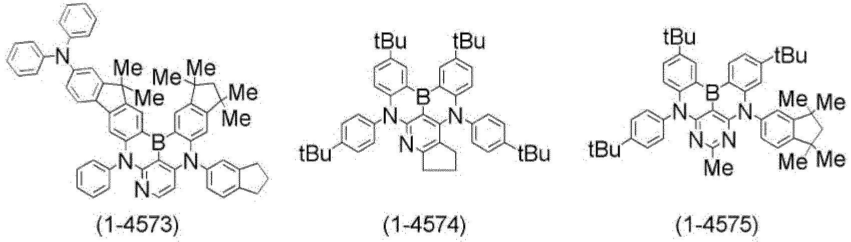

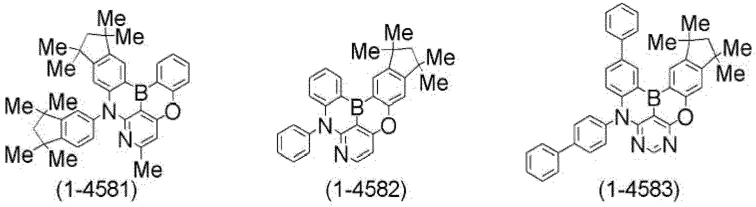

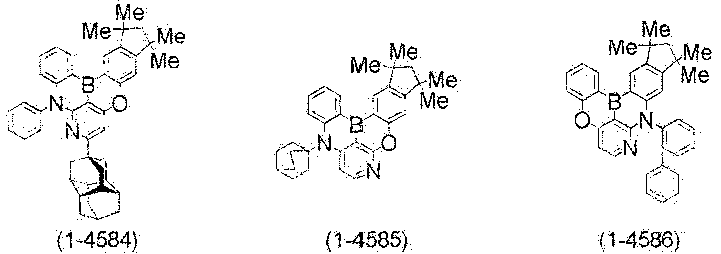

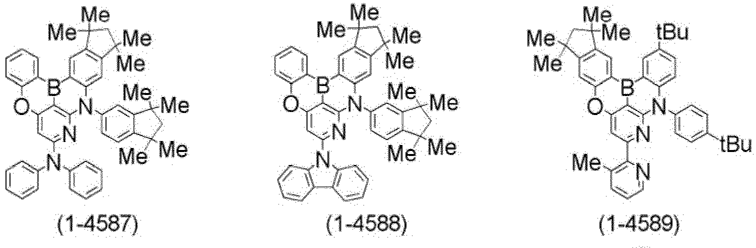

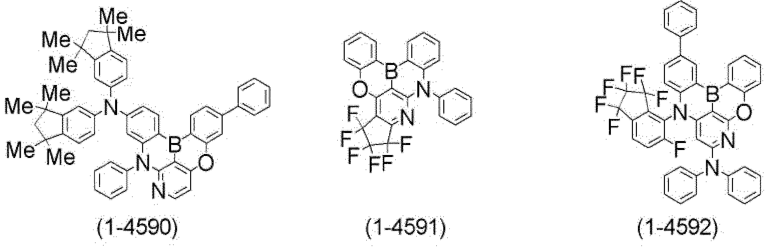

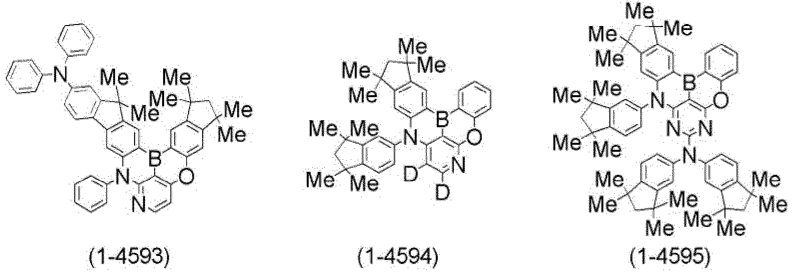

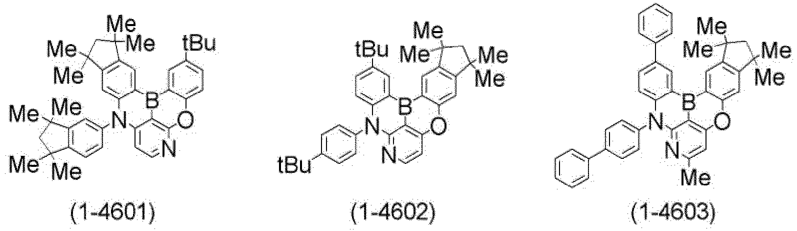

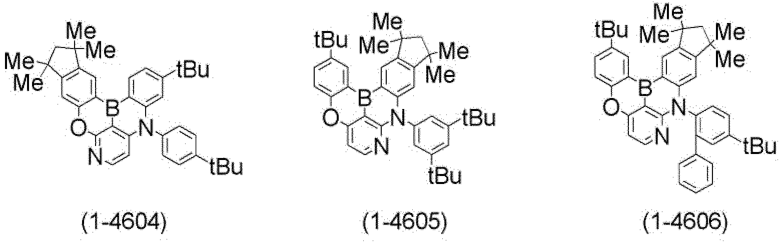

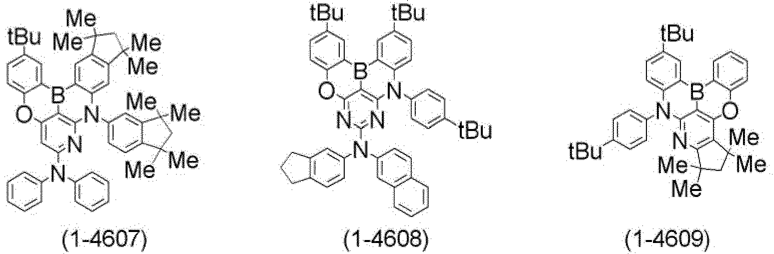

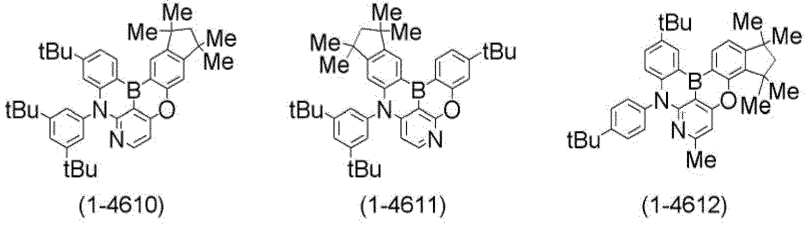

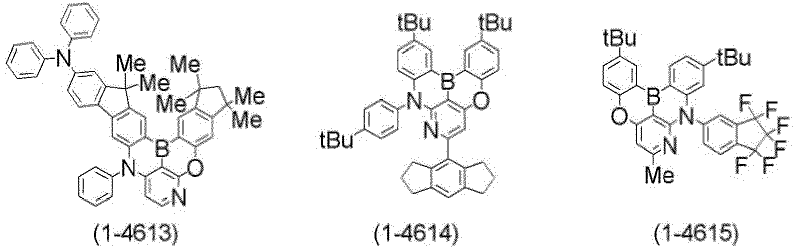

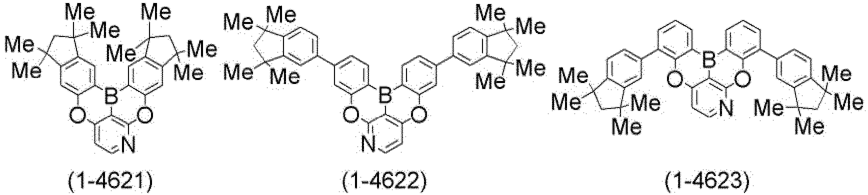

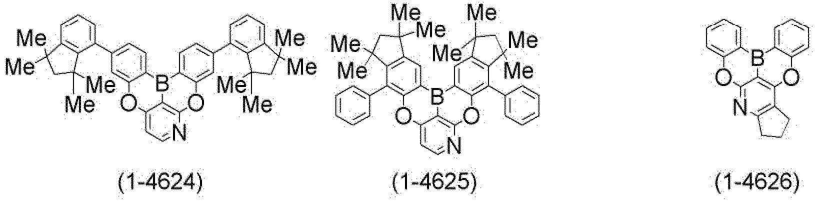

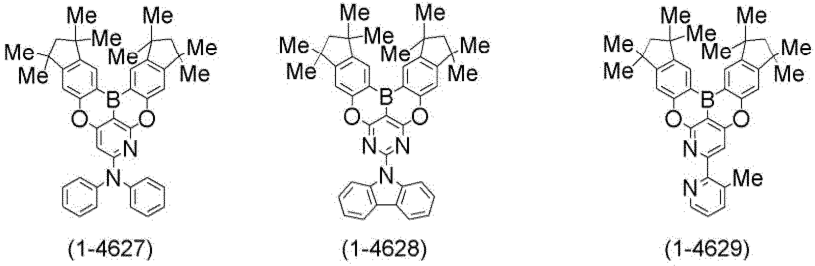

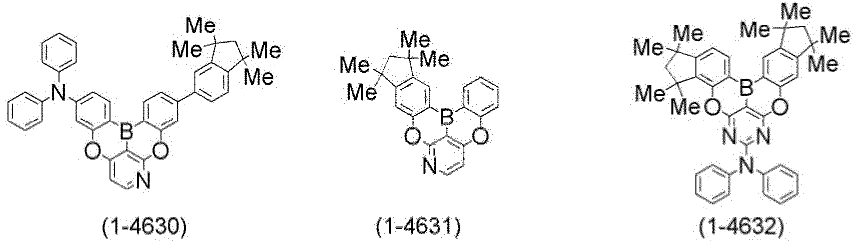

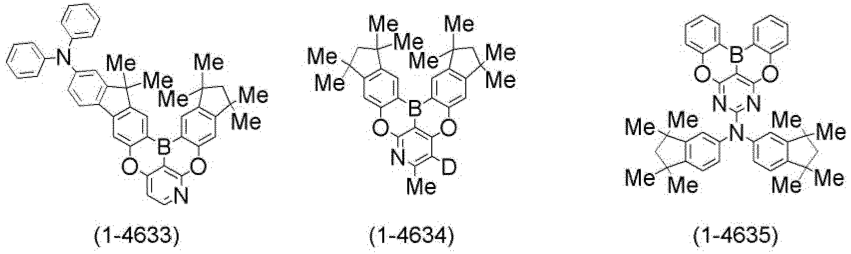

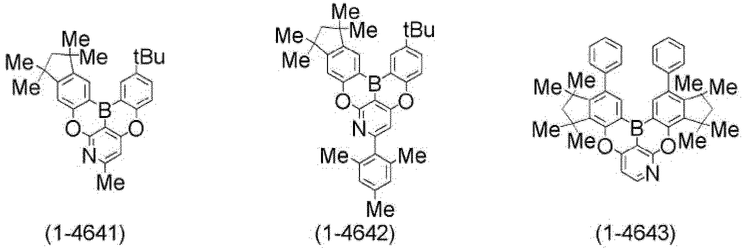

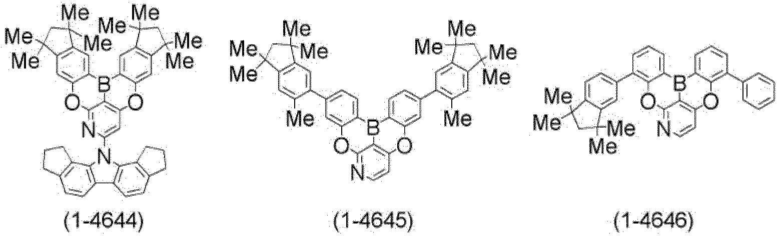

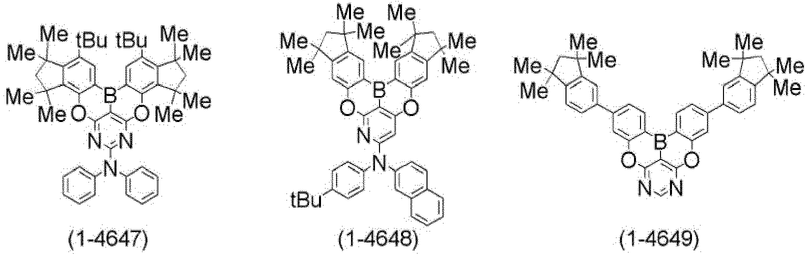

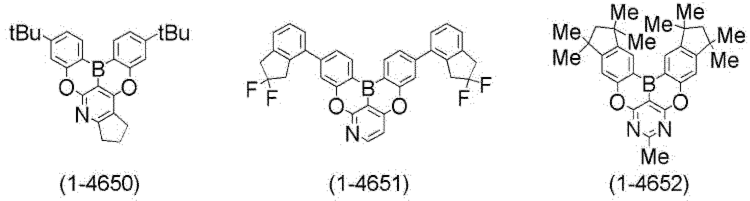

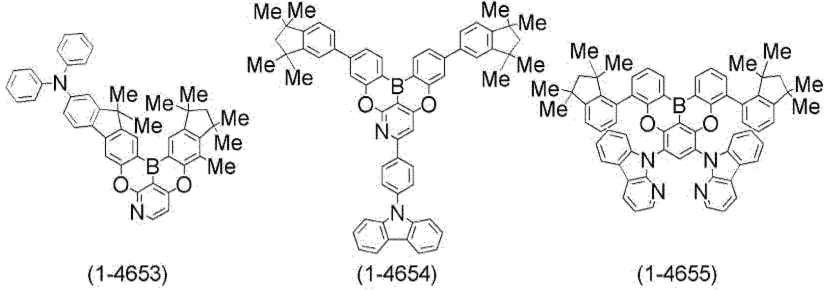

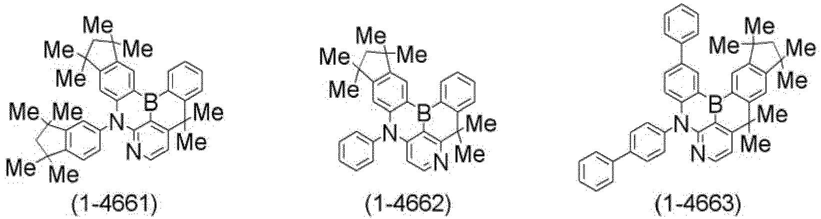

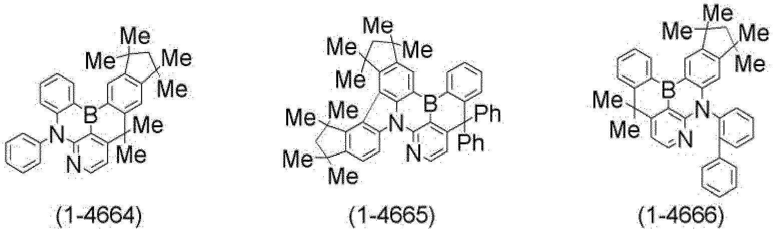

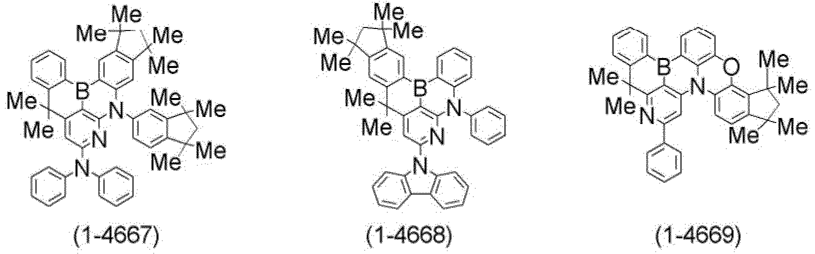

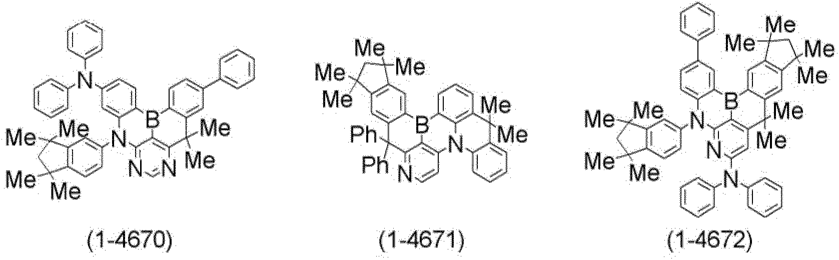

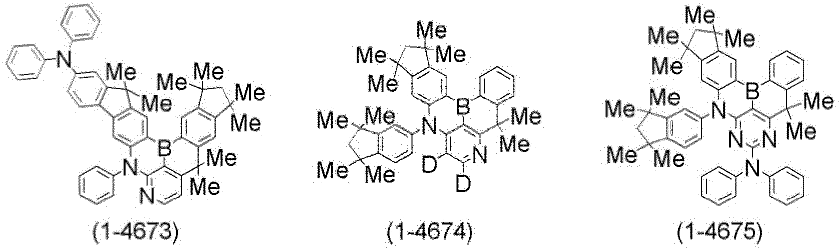

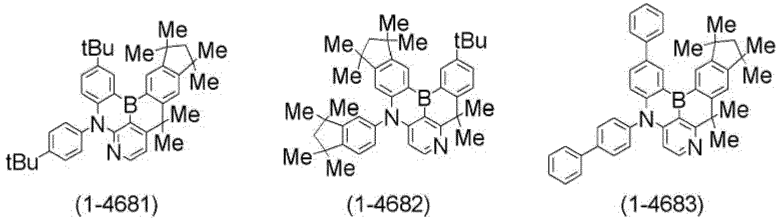

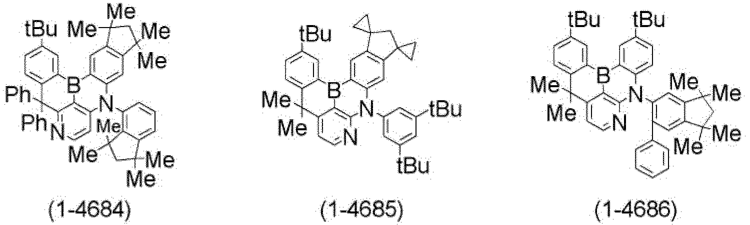

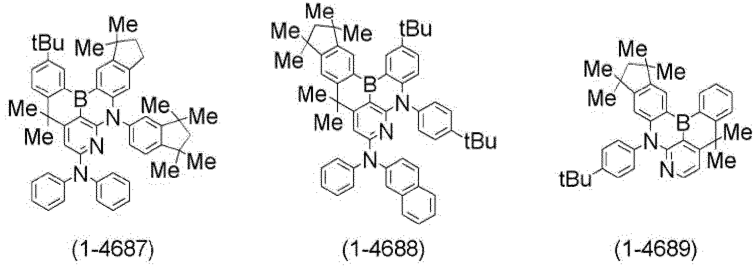

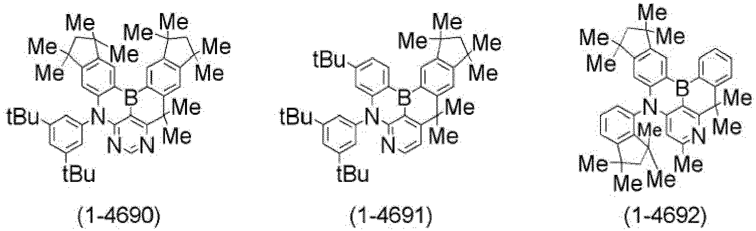

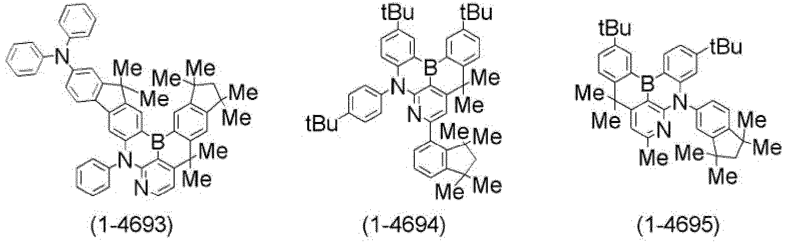

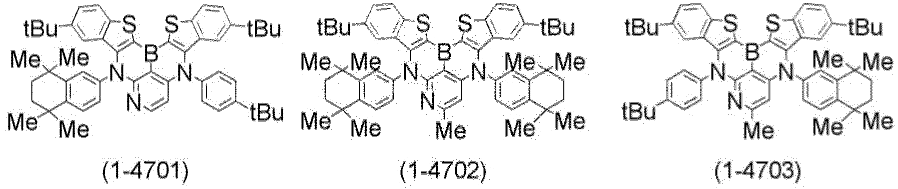

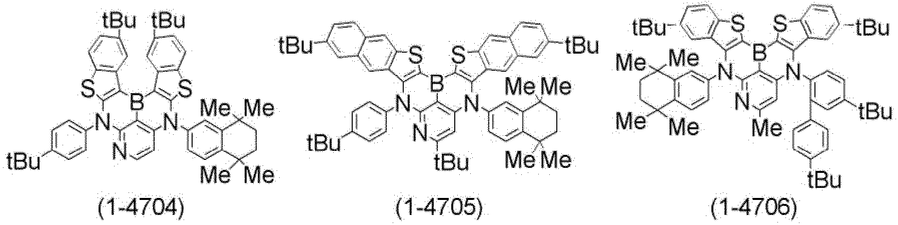

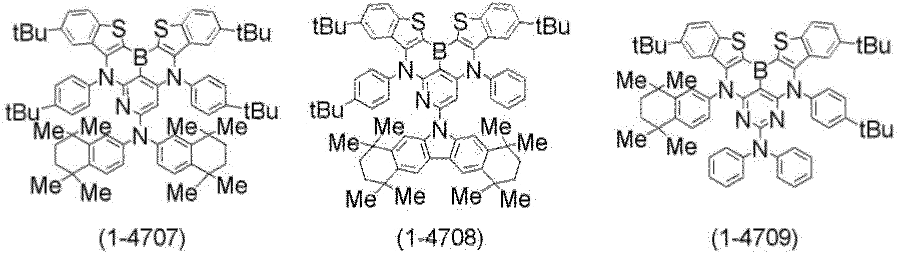

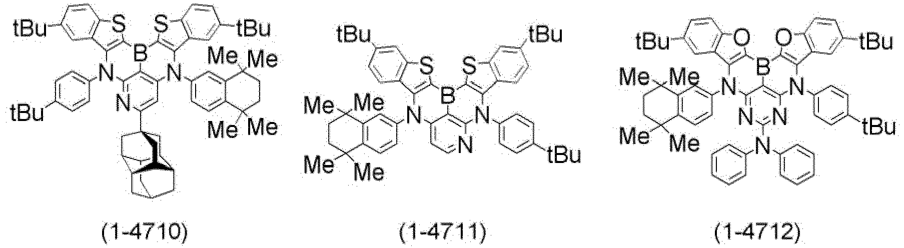

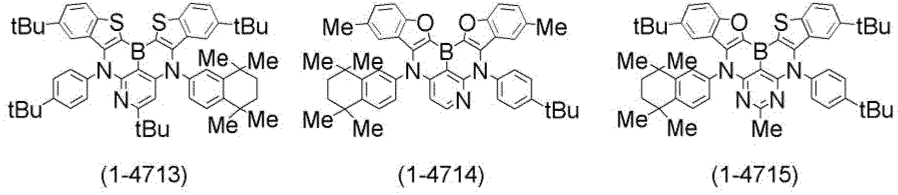

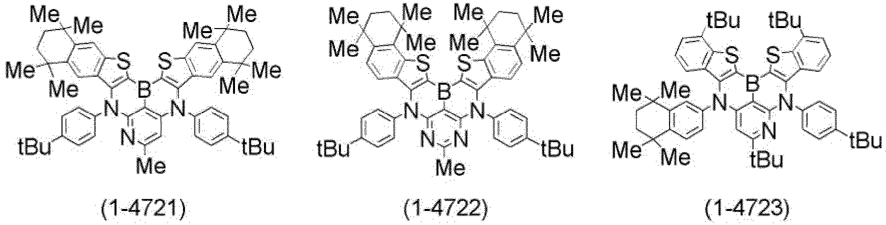

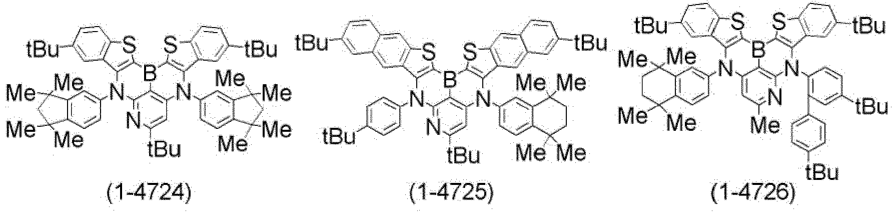

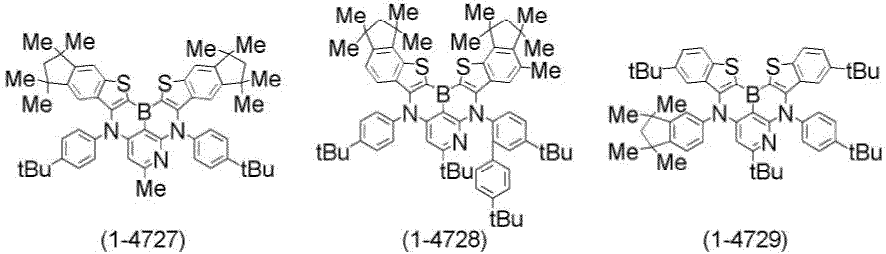

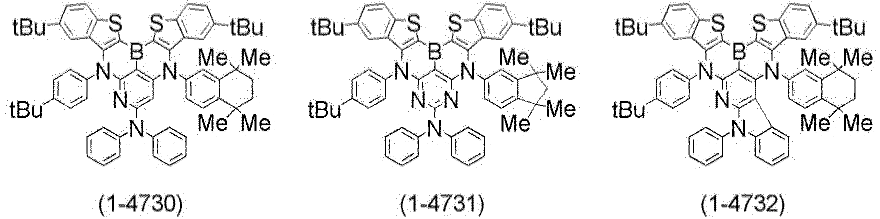

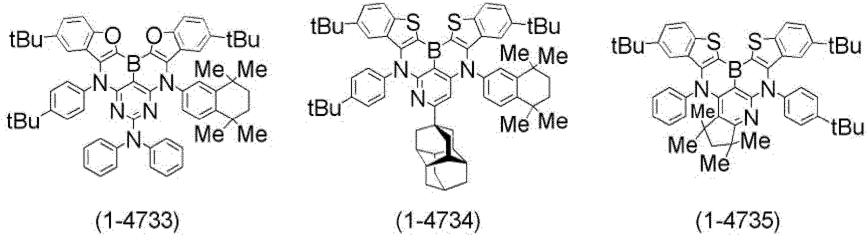

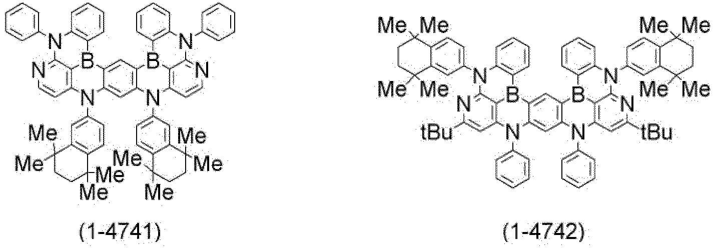

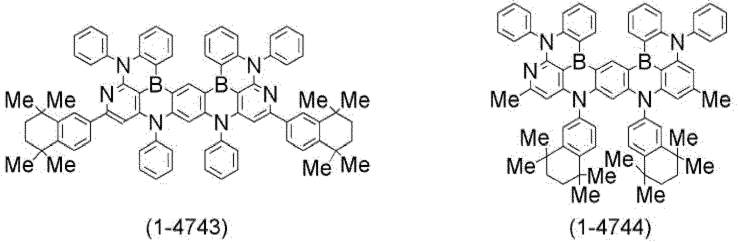

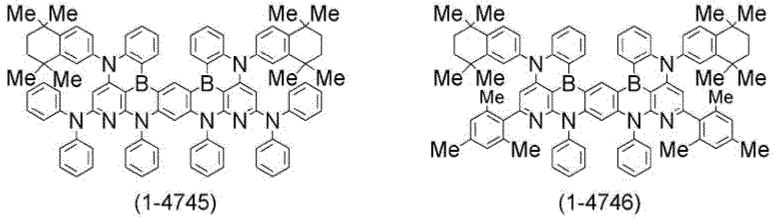

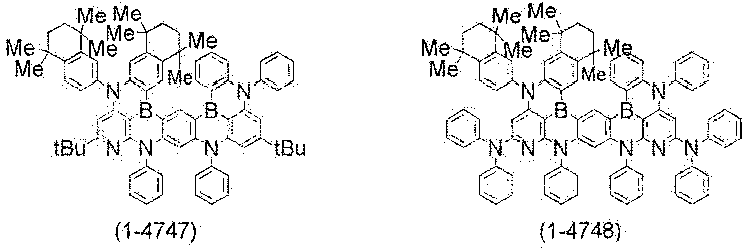

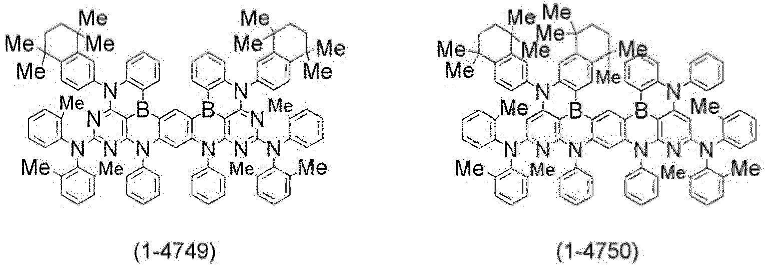

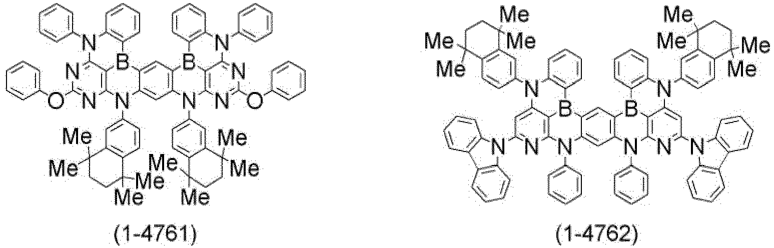

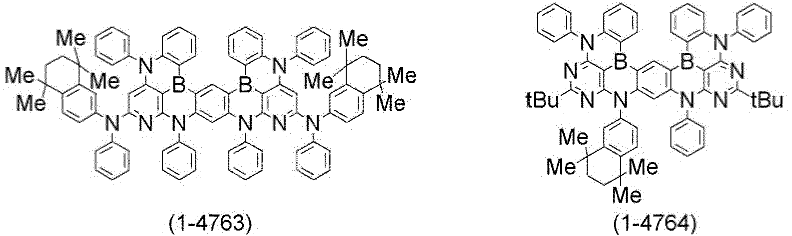

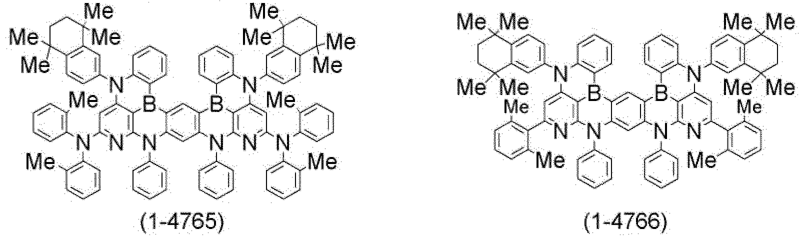

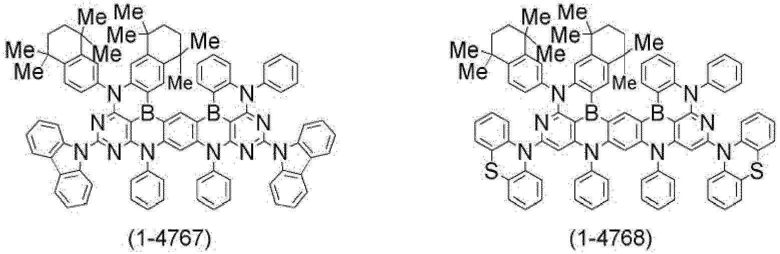

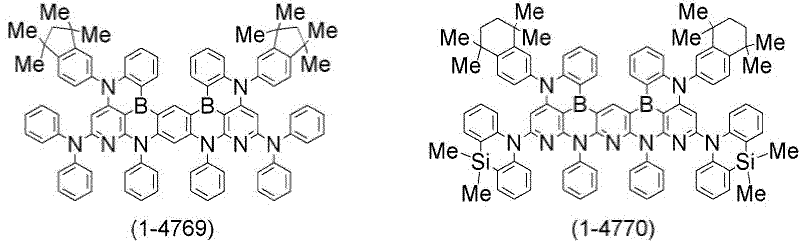

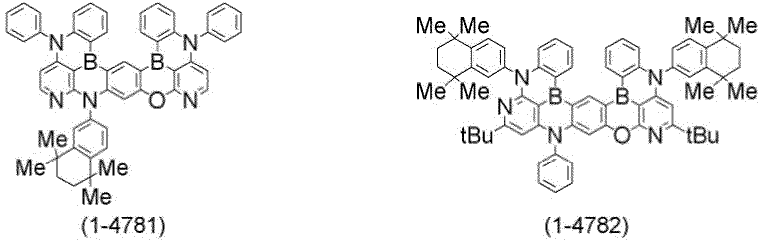

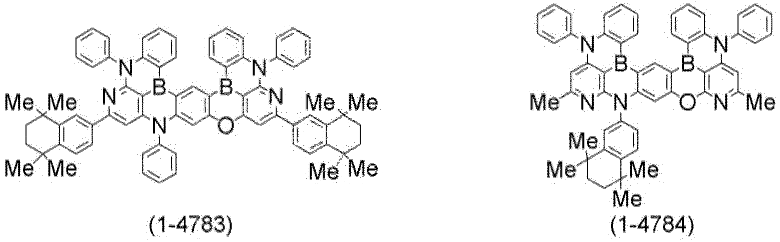

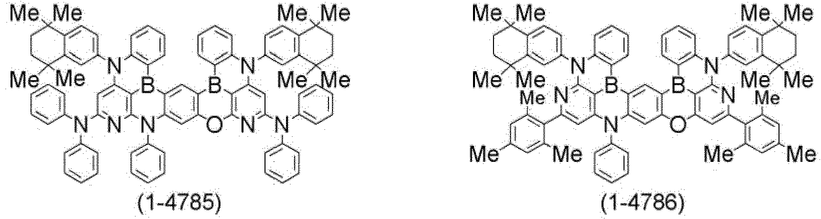

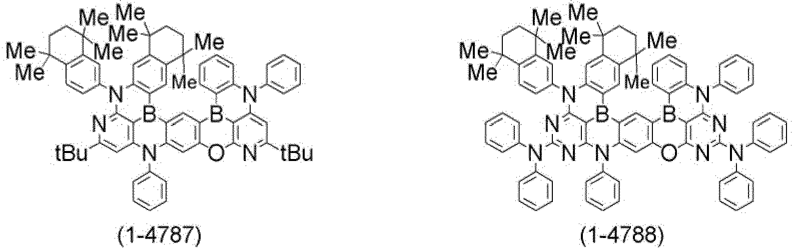

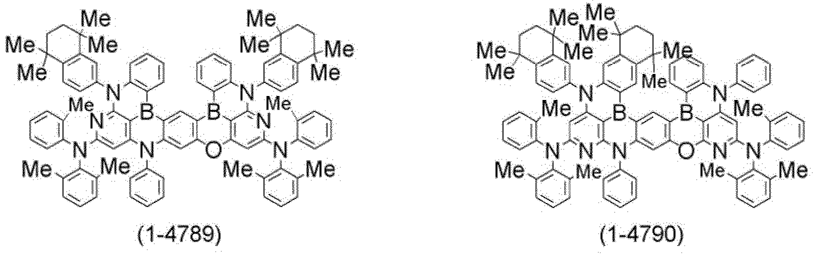

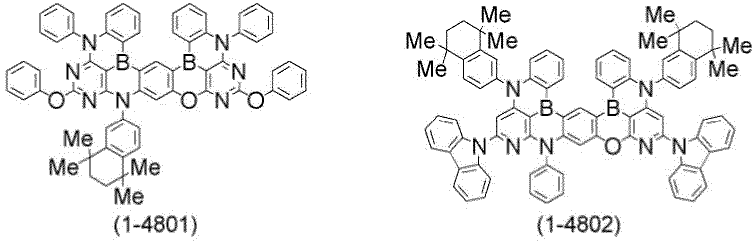

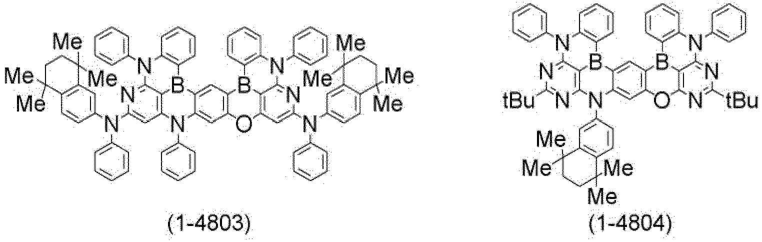

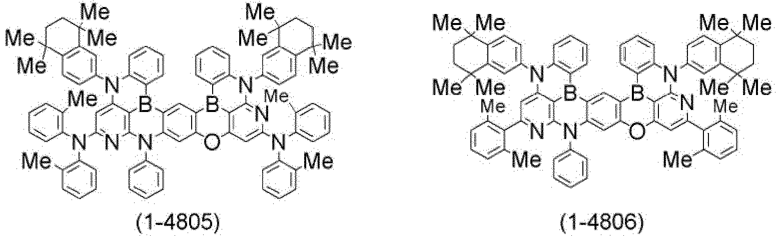

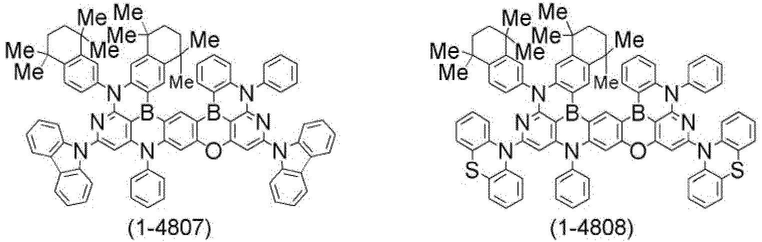

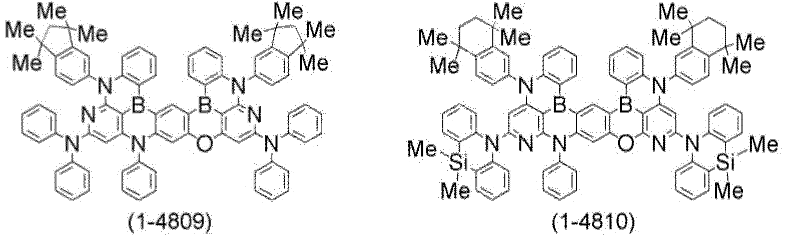

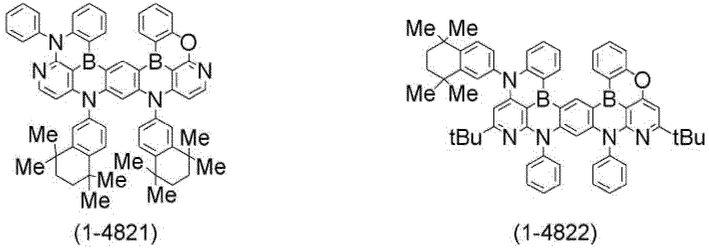

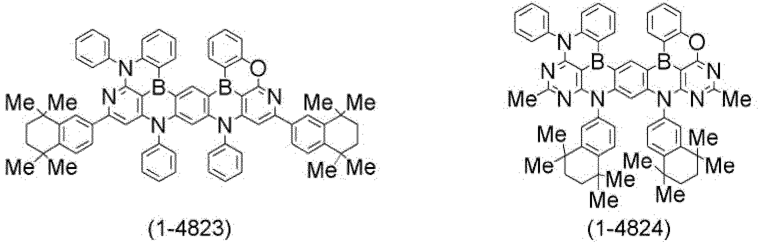

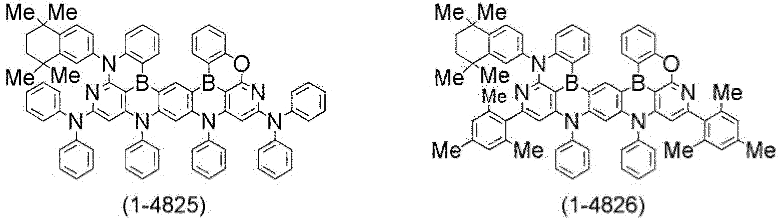

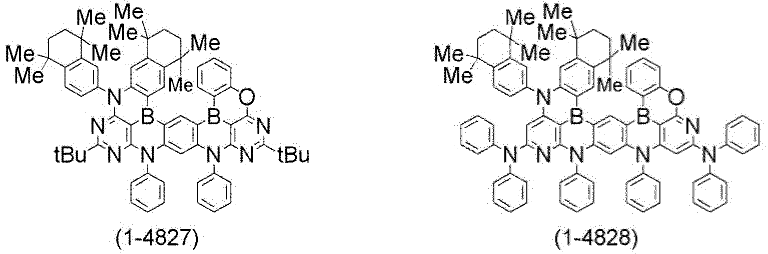

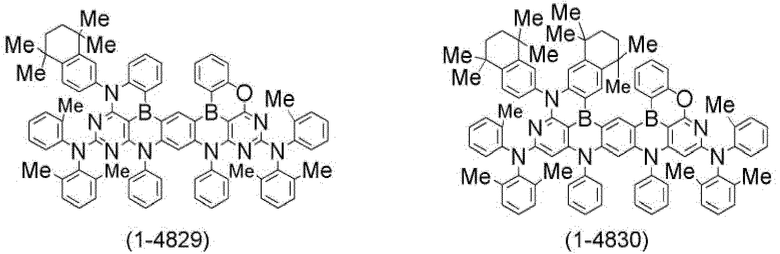

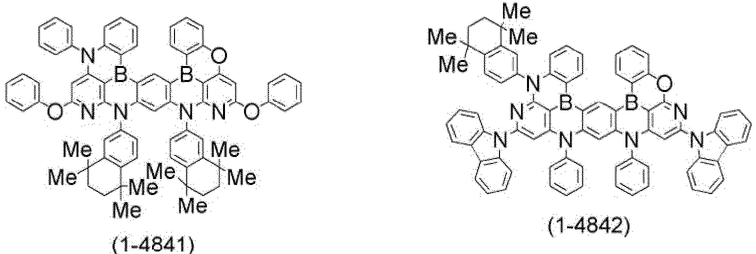

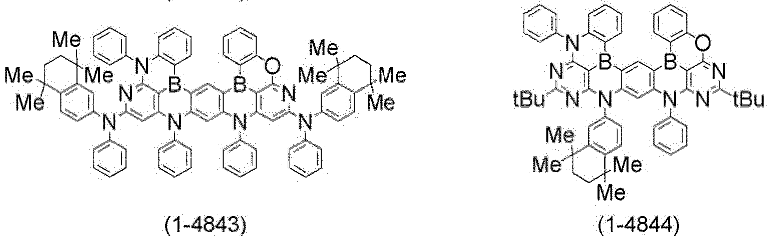

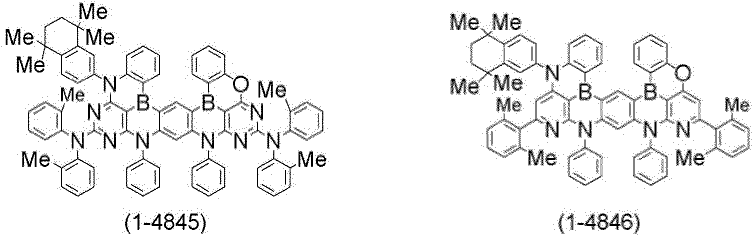

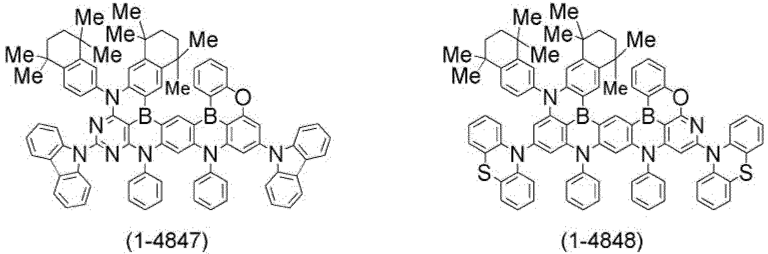

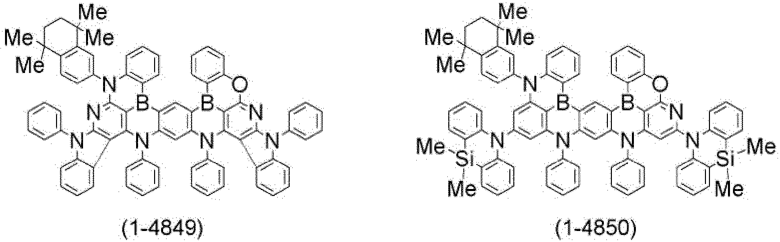

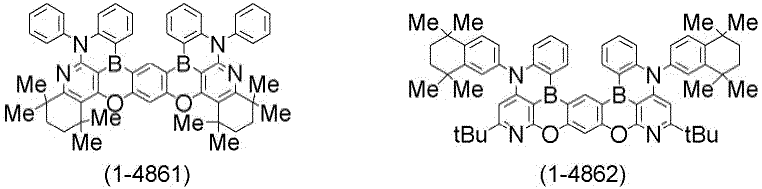

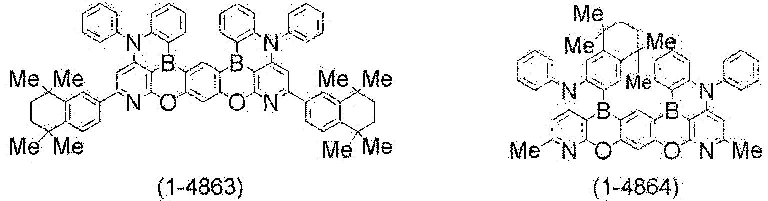

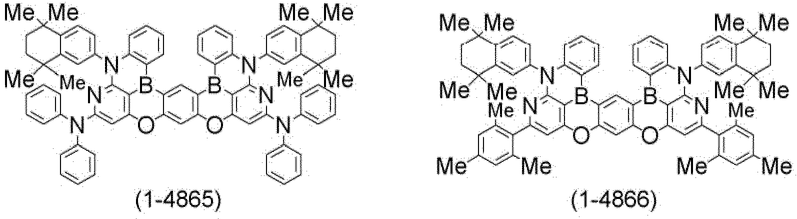

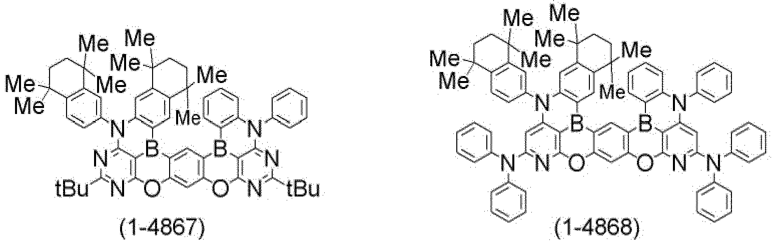

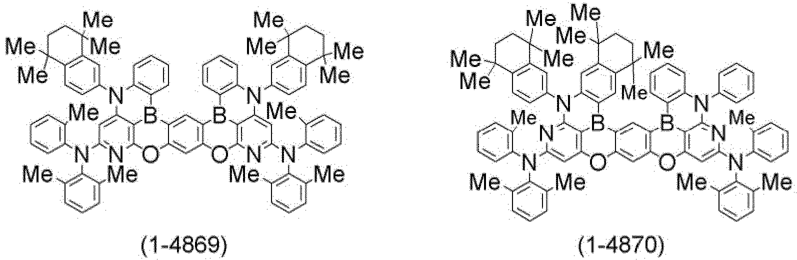

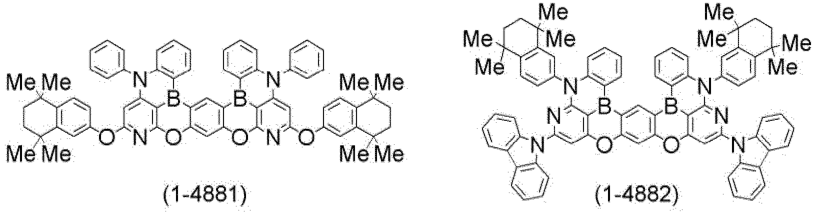

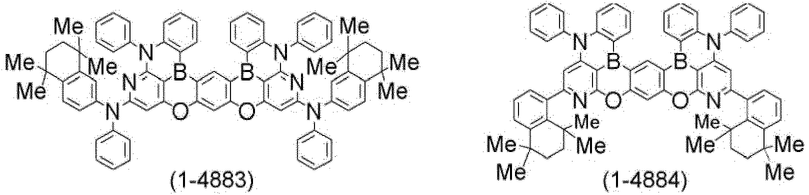

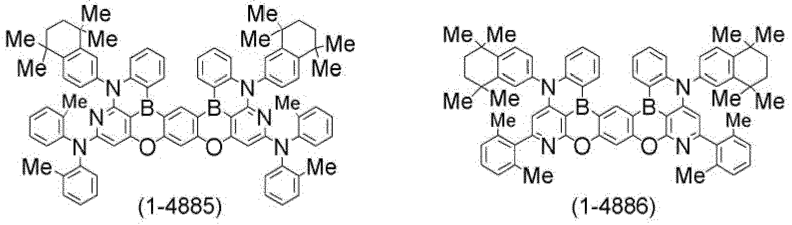

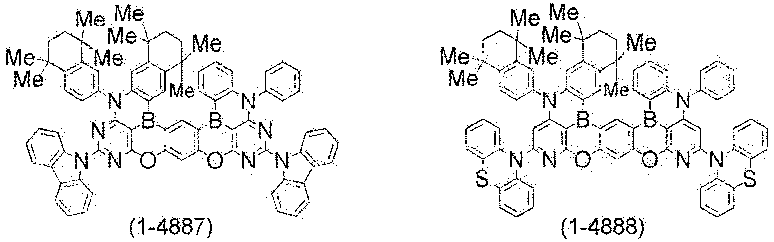

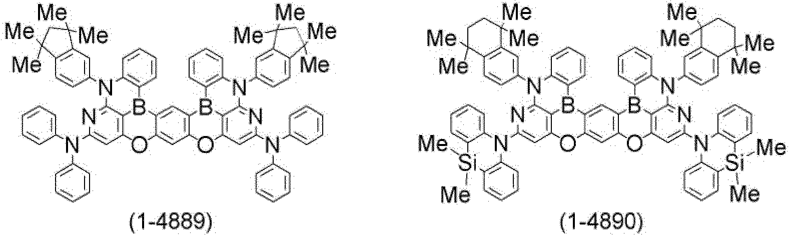

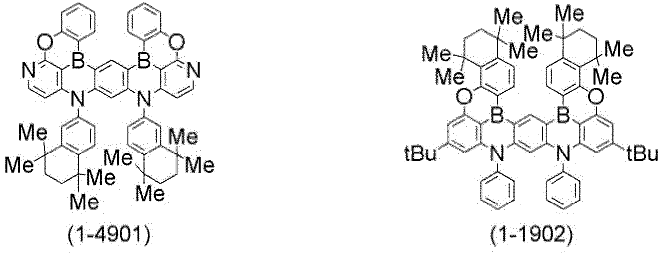

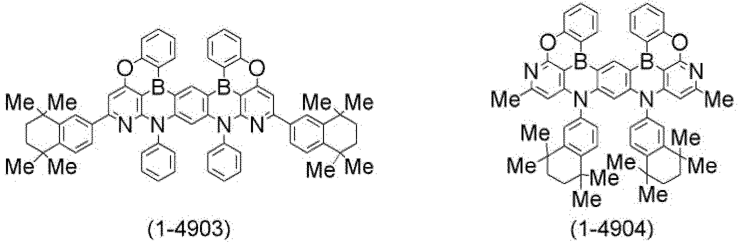

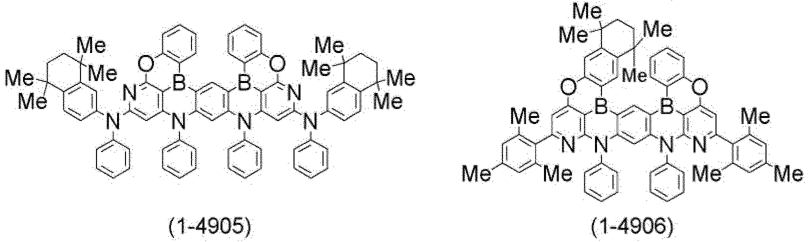

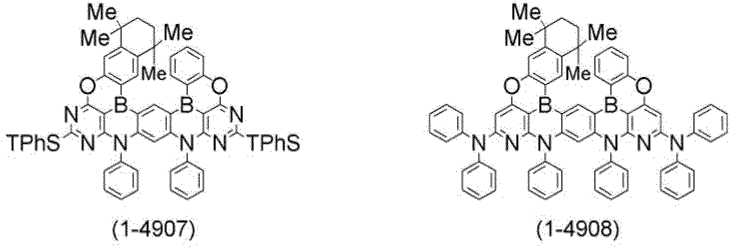

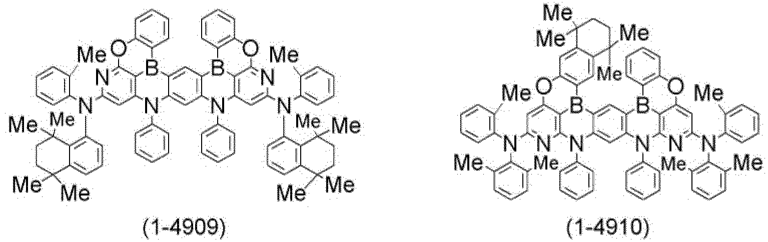

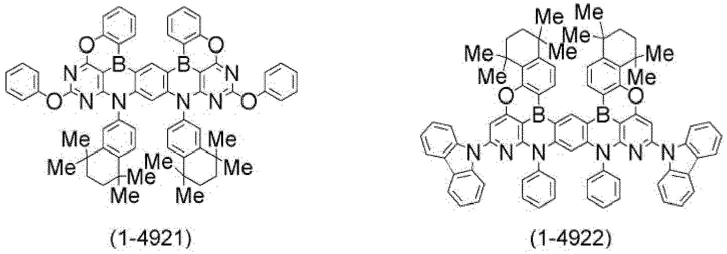

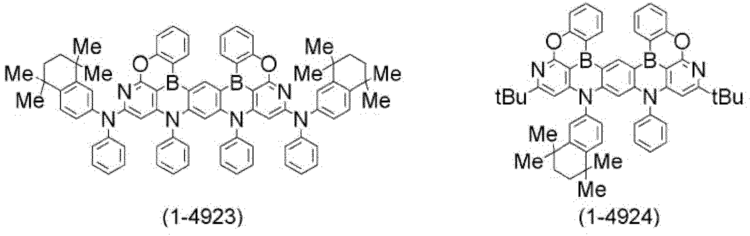

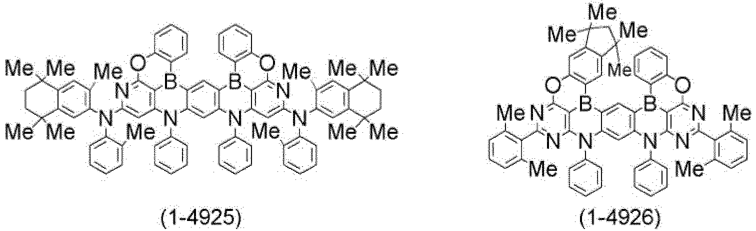

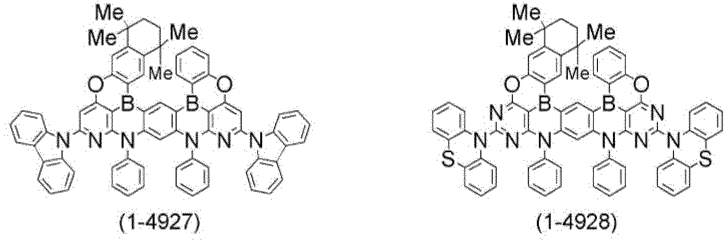

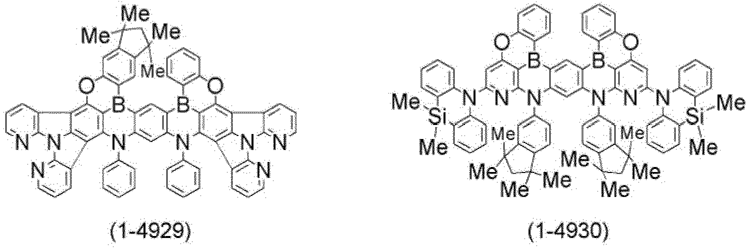

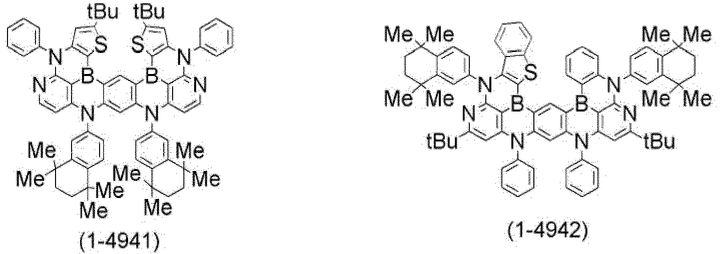

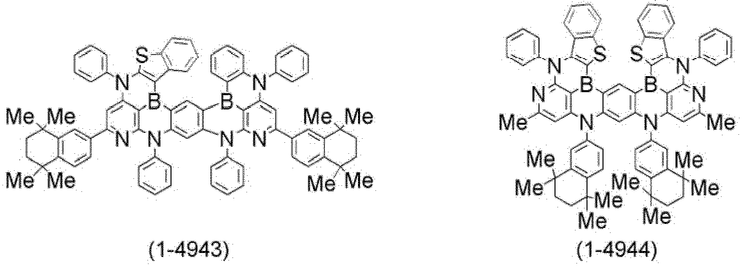

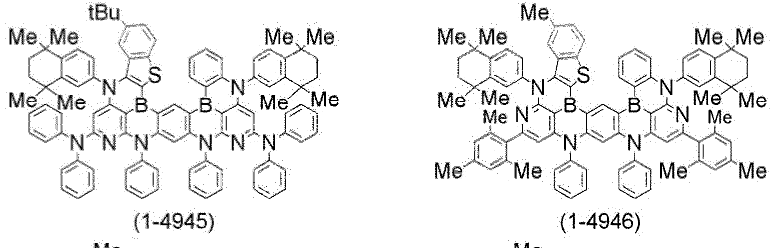

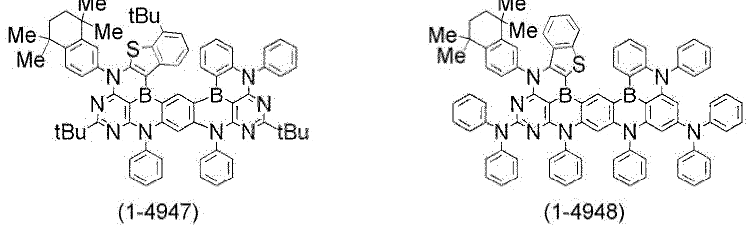

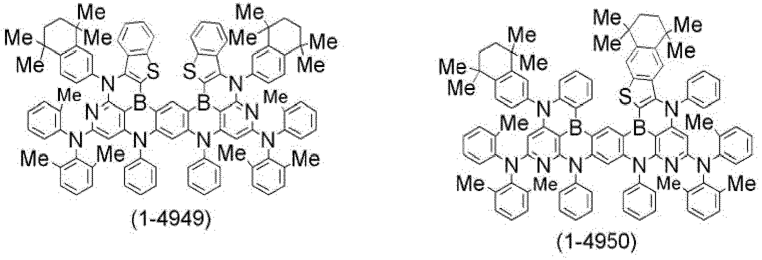

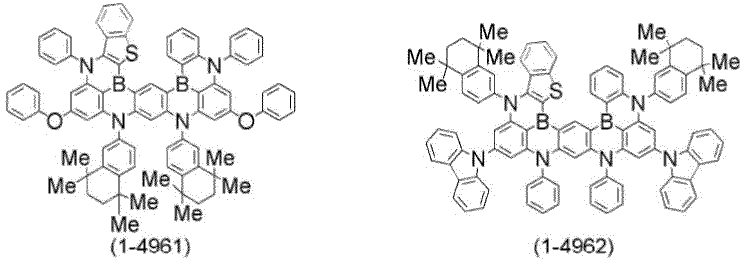

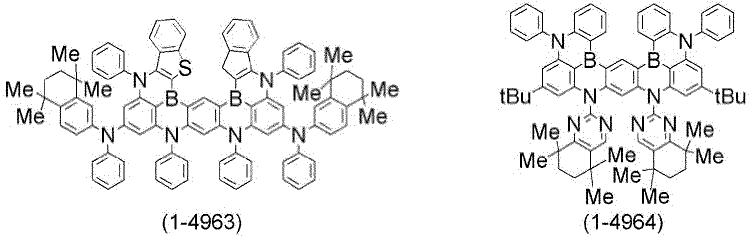

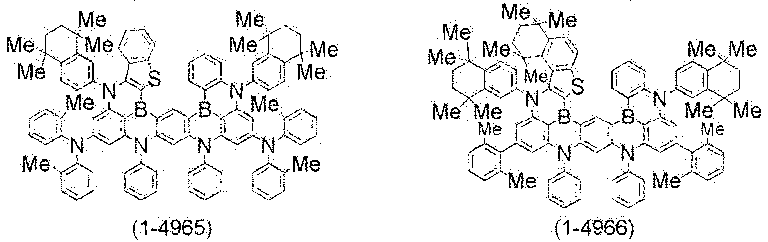

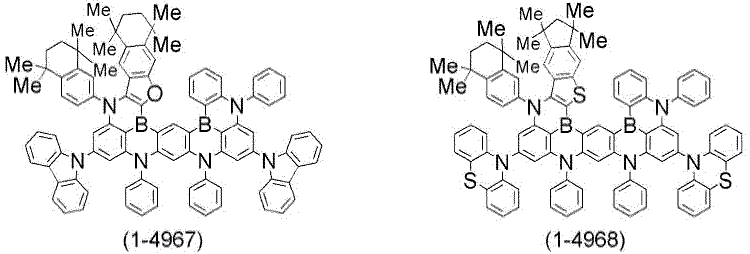

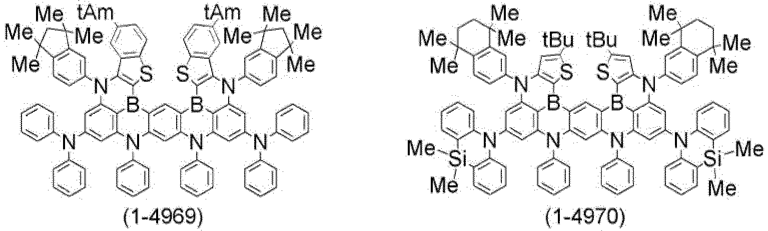

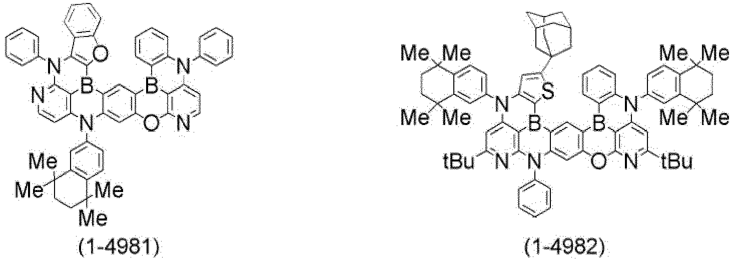

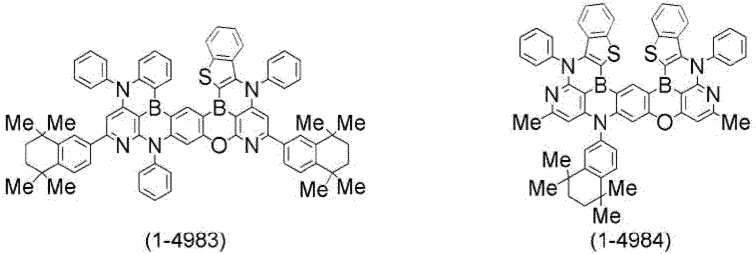

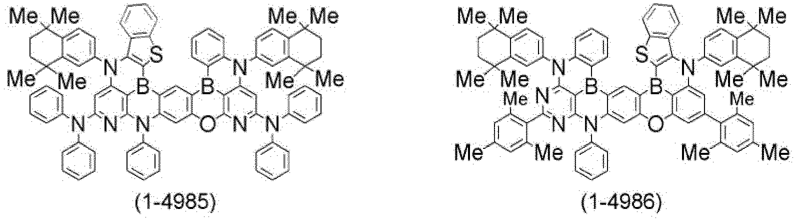

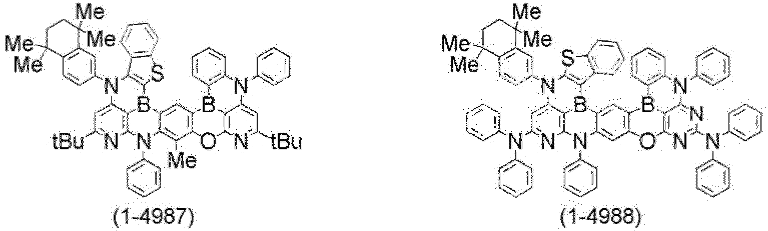

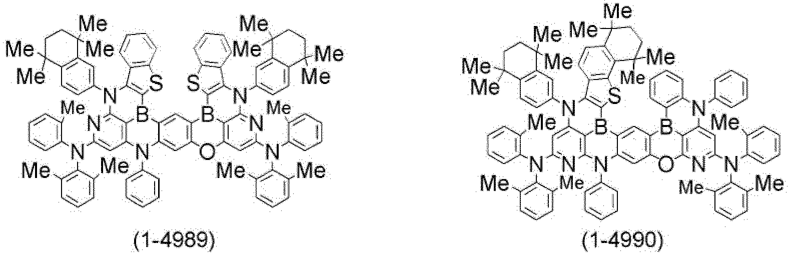

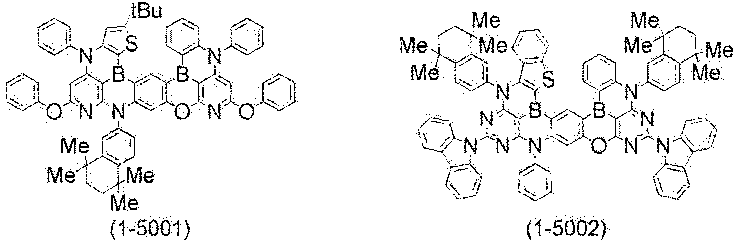

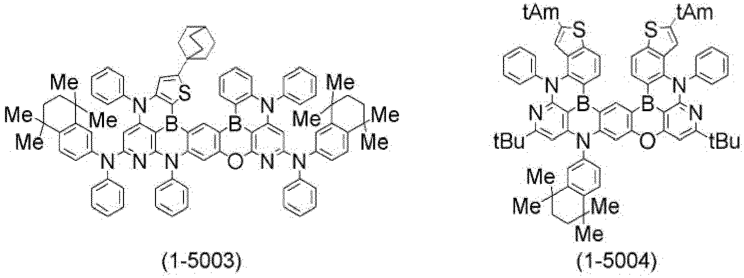

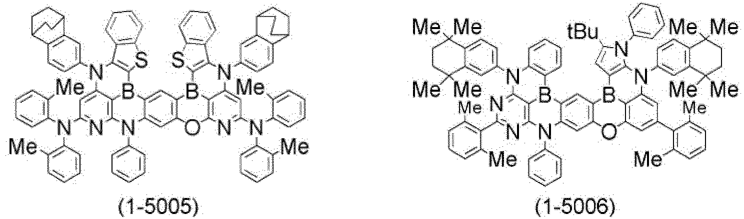

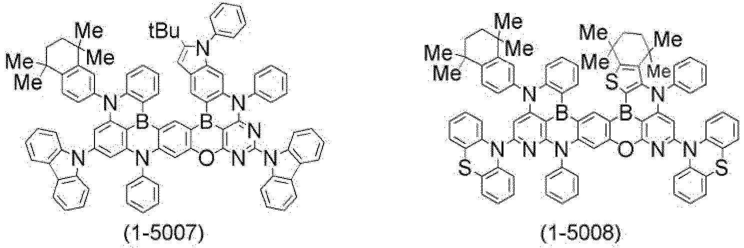

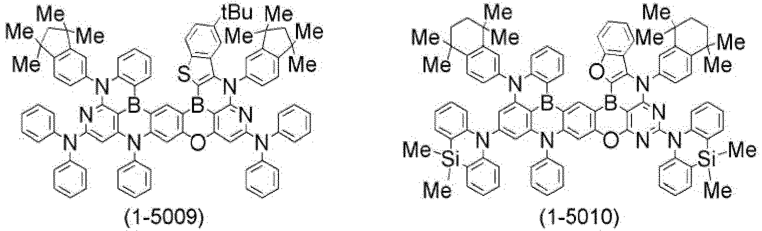

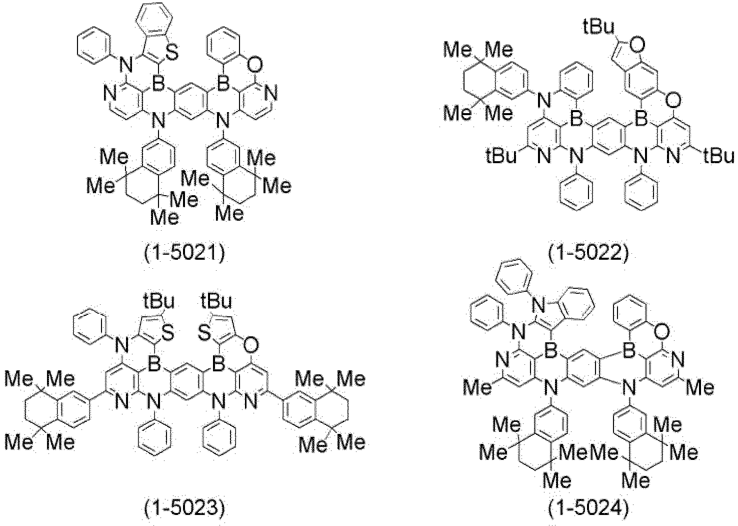

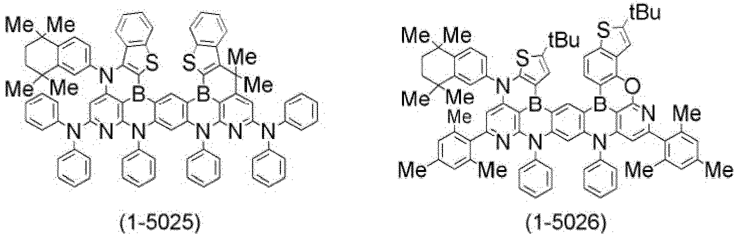

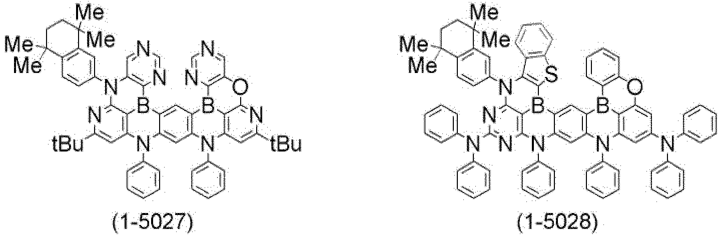

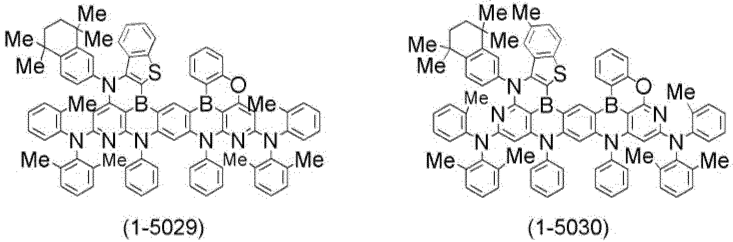

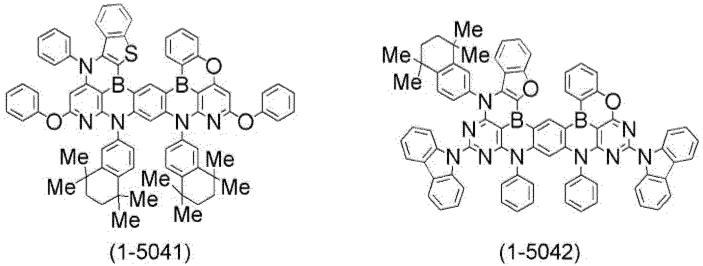

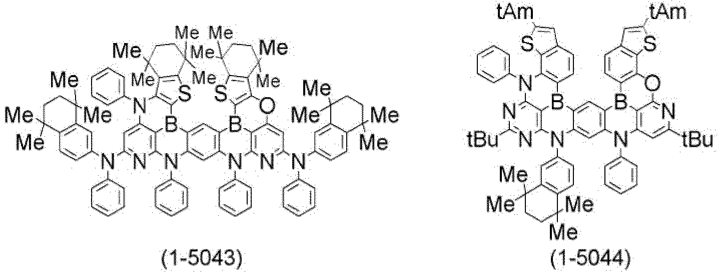

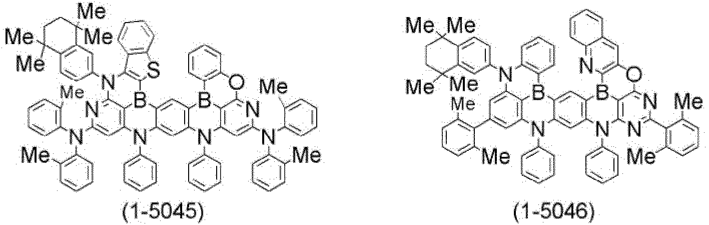

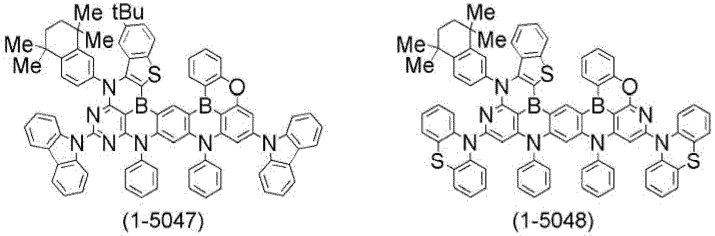

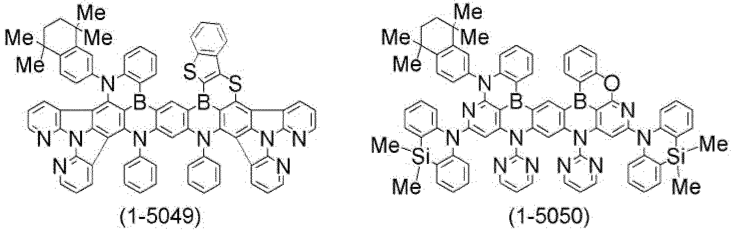

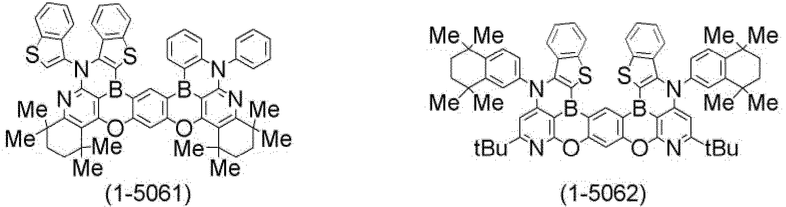

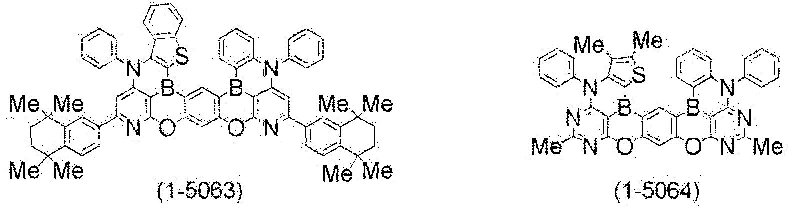

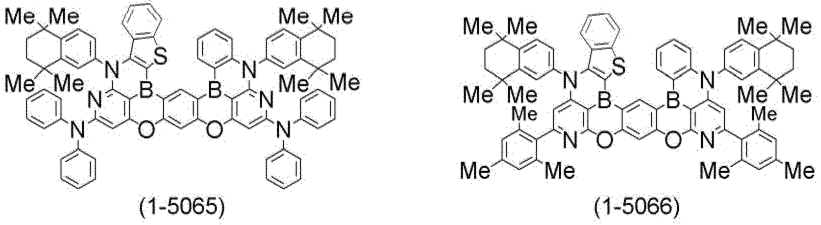

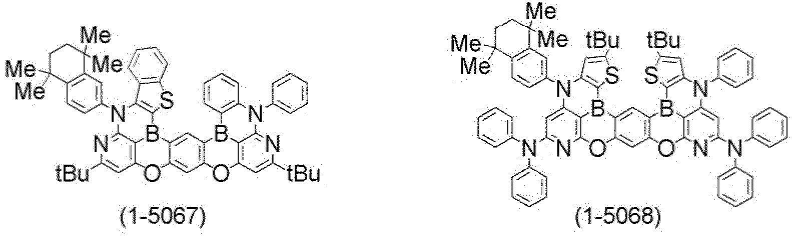

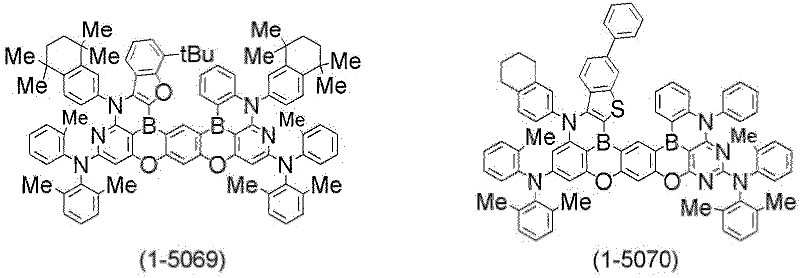

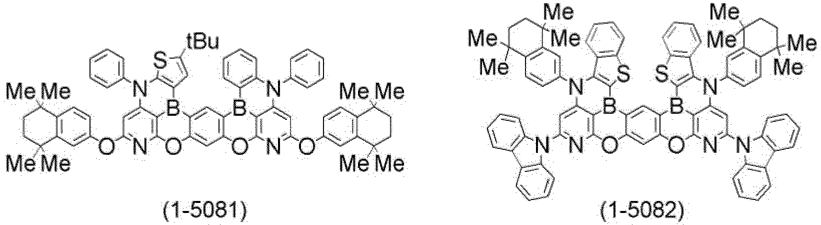

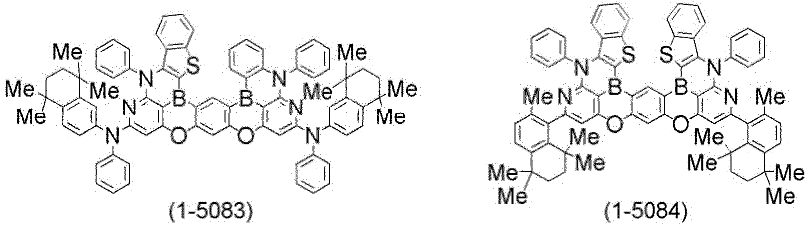

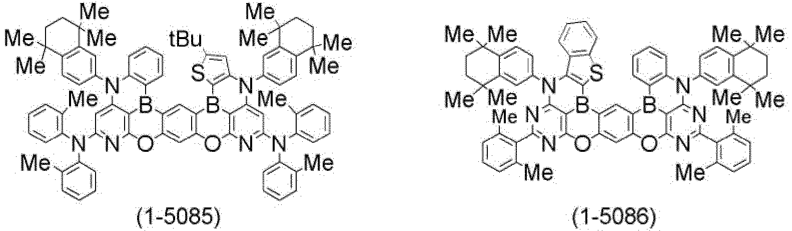

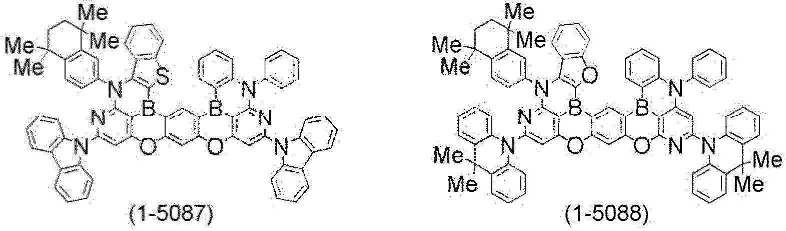

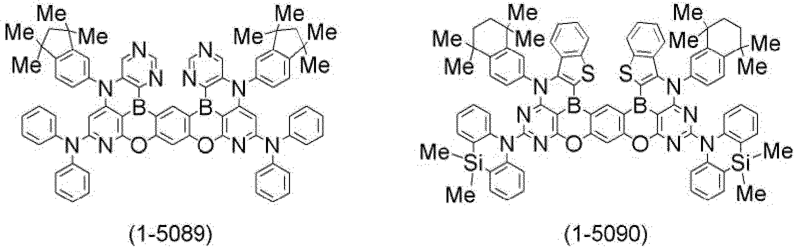

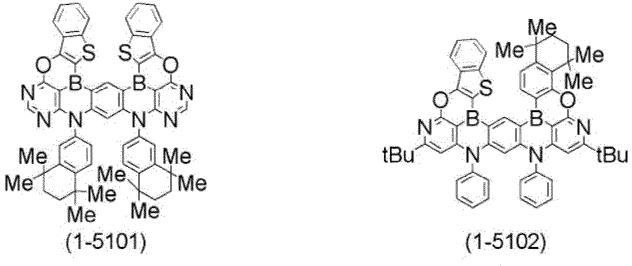

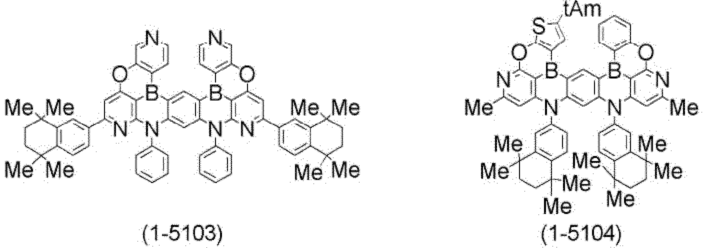

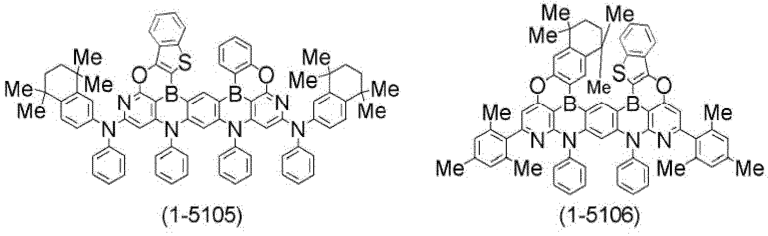

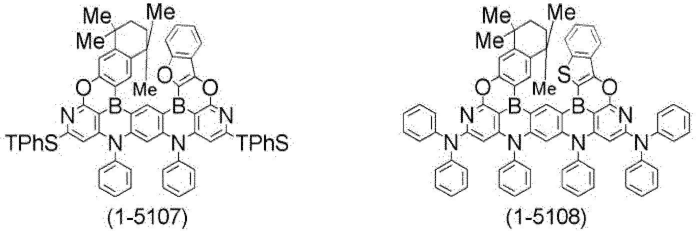

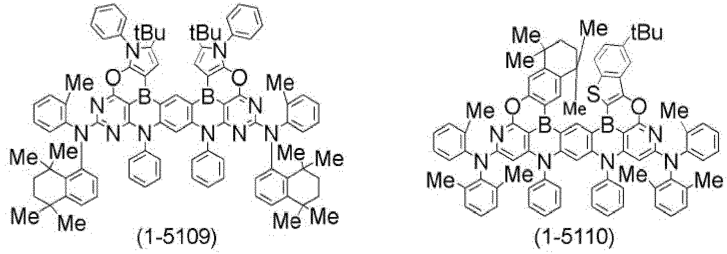

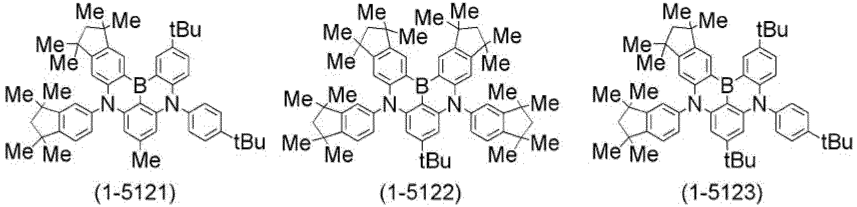

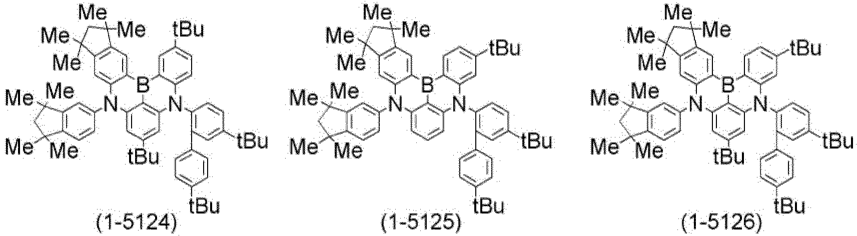

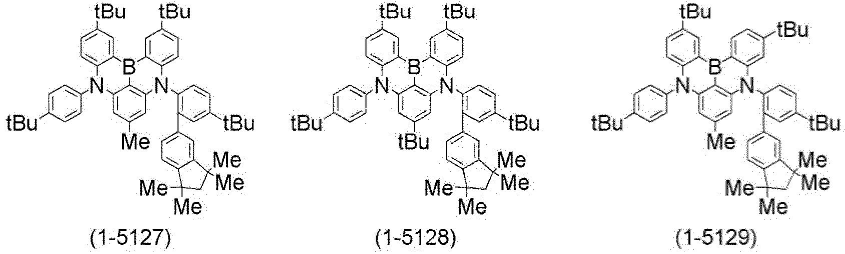

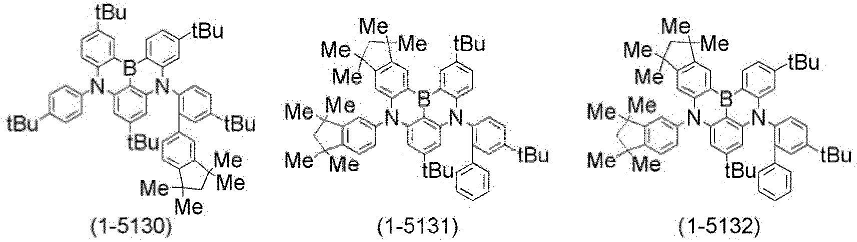

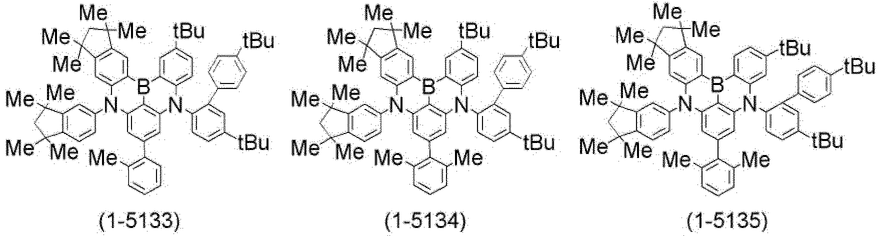

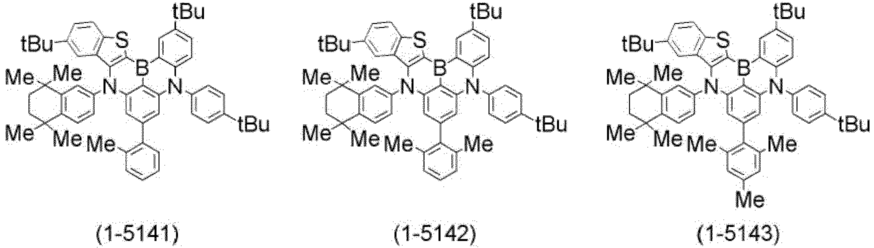

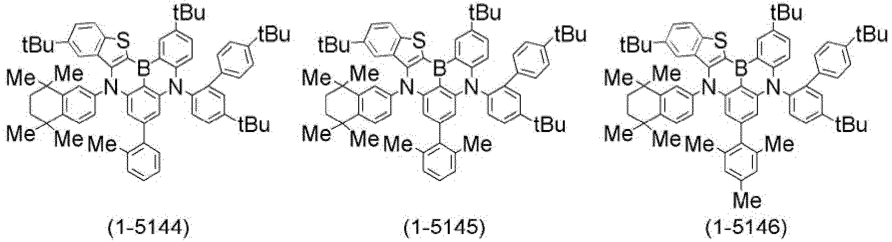

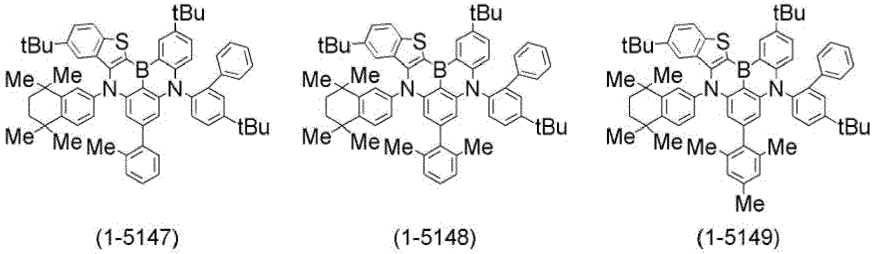

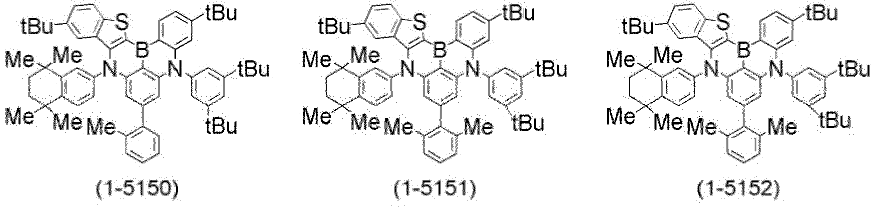

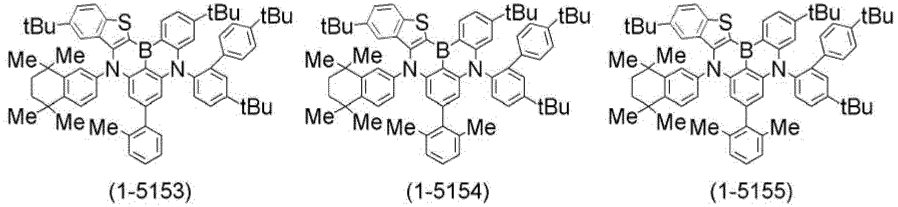

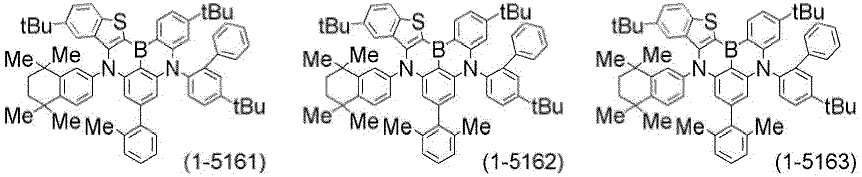

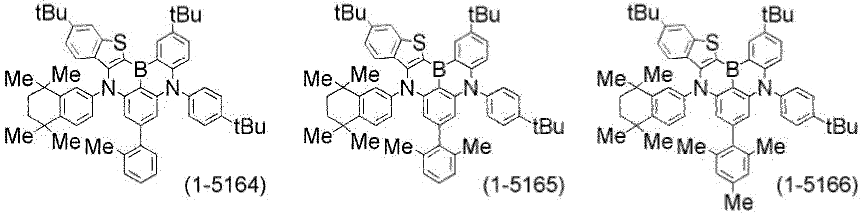

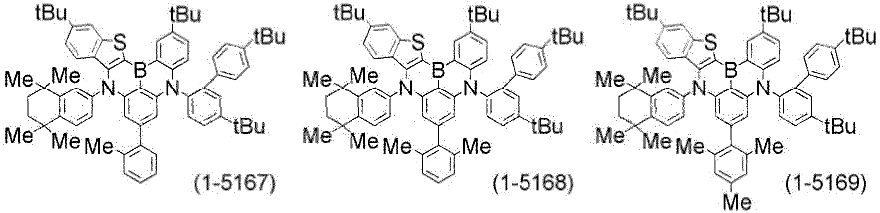

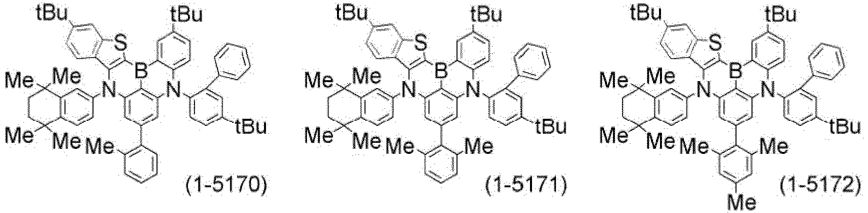

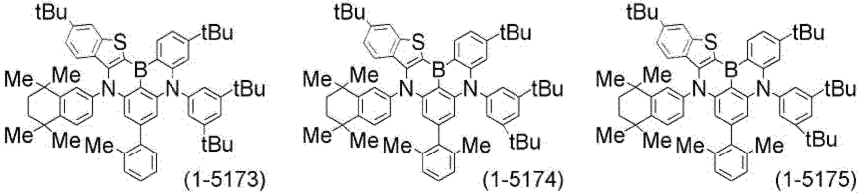

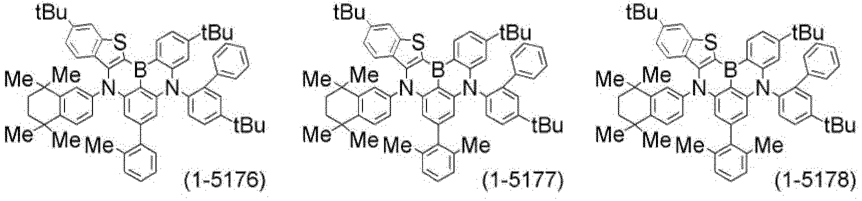

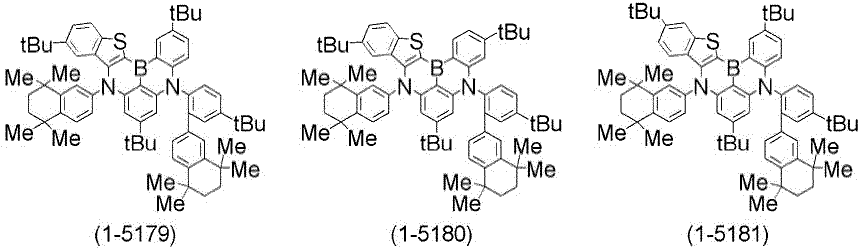

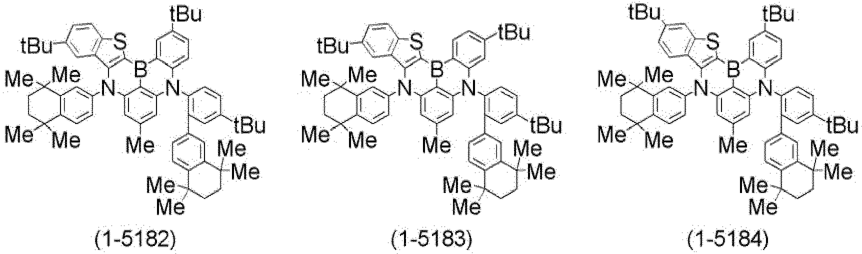

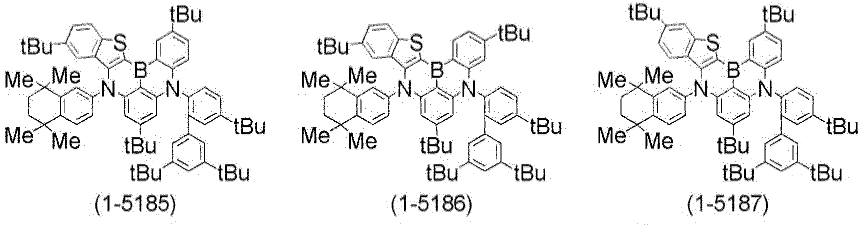

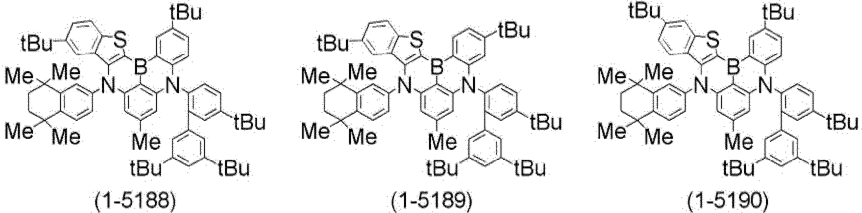

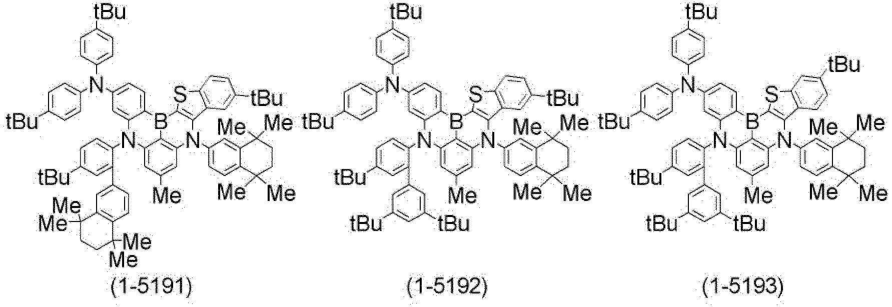

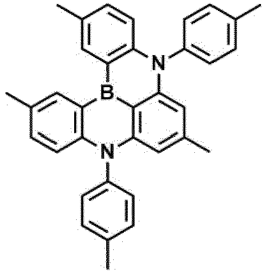

According to an exemplary embodiment of the present specification, the ink composition may further include Chemical Formula B as a dopant (an additional compound).

According to an exemplary embodiment of the present specification, Cy¹ is a substituted or unsubstituted divalent hexacyclic to octacyclic fused aromatic ring group; or a substituted or unsubstituted divalent hexacyclic to octacyclic fused aromatic heterocyclic group.

According to another exemplary embodiment, Cy¹ is a divalent hexacyclic to octacyclic fused aromatic ring group unsubstituted or substituted with an alkyl group; or a divalent hexacyclic to octacyclic fused aromatic heterocyclic group unsubstituted or substituted with an aryl group. In this case, the fused aromatic ring group has 24 to 60 carbon atoms, and the fused aromatic heterocyclic group has 22 to 60 carbon atoms.

In another exemplary embodiment, Cy² and Cy³ are the same as or different from each other, and are each independently a substituted or unsubstituted arylene group having 6 to 60 carbon atoms; or a substituted or unsubstituted heteroarylene group having 2 to 60 carbon atoms.

According to still another exemplary embodiment, Cy² and Cy³ are the same as or different from each other, and are each independently a substituted or unsubstituted phenylene group; or a substituted or unsubstituted naphthylene group.

In still another exemplary embodiment, Cy⁴ to Cy⁷ are the same as or different from each other, and are each independently a substituted or unsubstituted aryl group having 6 to 60 carbon atoms; or a substituted or unsubstituted heteroaryl group having 2 to 60 carbon atoms, or Cy⁴ and Cy⁵ are bonded to each other to form a substituted or unsubstituted carbazole, and Cy⁶ and Cy⁷ are bonded to each other to form a substituted or unsubstituted carbazole.

In yet another exemplary embodiment, Cy⁴ to Cy⁷ are the same as or different from each other, and are each independently a substituted or unsubstituted aryl group having 6 to 60 carbon atoms; or a substituted or unsubstituted heteroaryl group having 2 to 60 carbon atoms, or Cy⁴ and Cy⁵ are bonded to each other to form a substituted or unsubstituted carbazole, and Cy⁶ and Cy⁷ are bonded to each other to form a substituted or unsubstituted carbazole. In this case, the "substituted or unsubstituted" means being unsubstituted or substituted with one or more substituents selected from the group consisting of a cyano group, a halogen group, an alkyl group, a haloalkyl group, an alkoxy group, a silyl group and a heteroaryl group.

In still yet another exemplary embodiment, Cy⁴ to Cy⁷ are the same as or different from each other, and are each independently a substituted or unsubstituted phenyl group; a substituted or unsubstituted biphenyl group; a substituted or unsubstituted terphenyl group; a substituted or unsubstituted tetraphenyl group; a substituted or unsubstituted naphthyl group; a substituted or unsubstituted fluorenyl group; a substituted or unsubstituted pyrene group; or a substituted or unsubstituted benzofuranyl group. In this case, the "substituted or unsubstituted" means being unsubstituted or substituted with one or more substituents selected from the group consisting of a cyano group, a halogen group, an alkyl group, a haloalkyl group, an alkoxy group, a silyl group and a heteroaryl group.

According to an exemplary embodiment of the present specification, Chemical Formula B may be any one of the following structures, but is not limited thereto.

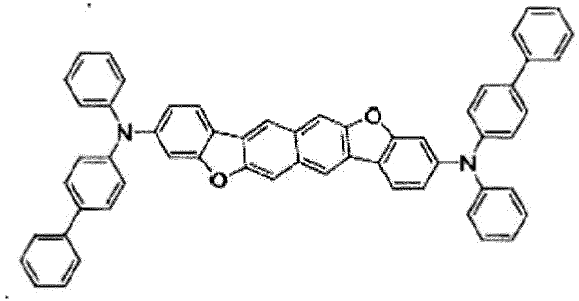

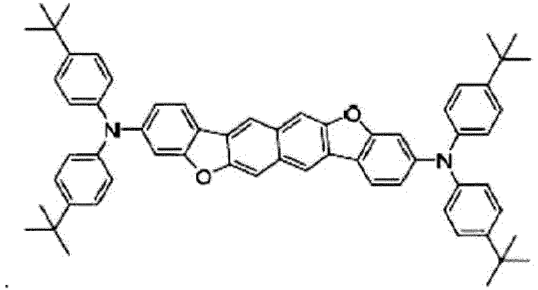

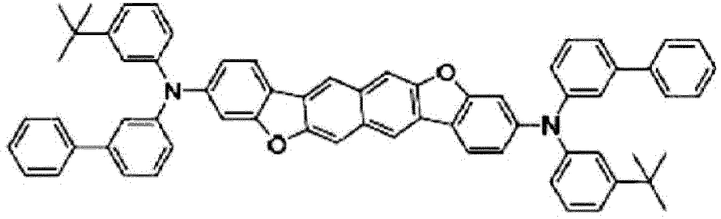

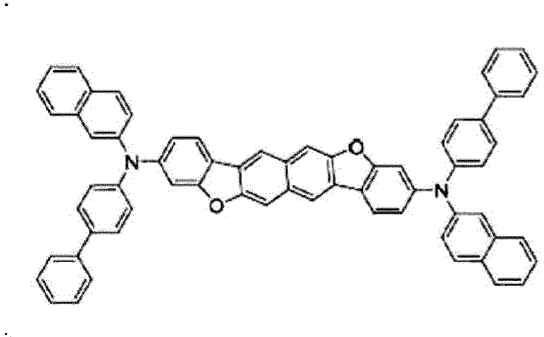

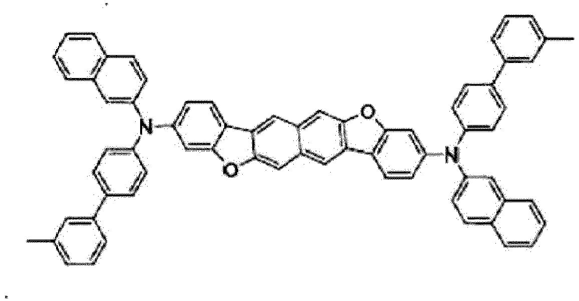

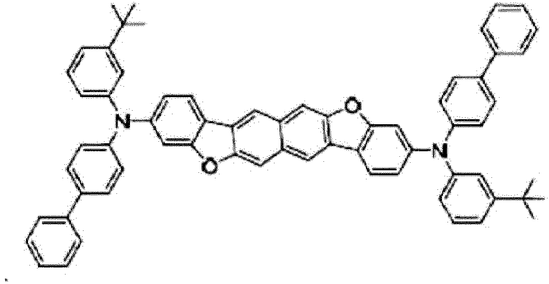

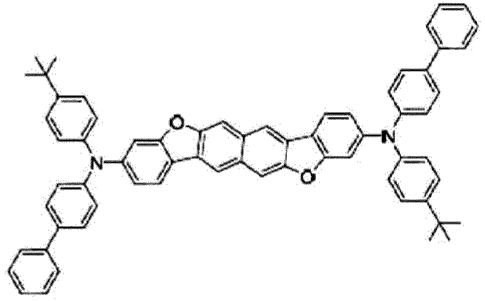

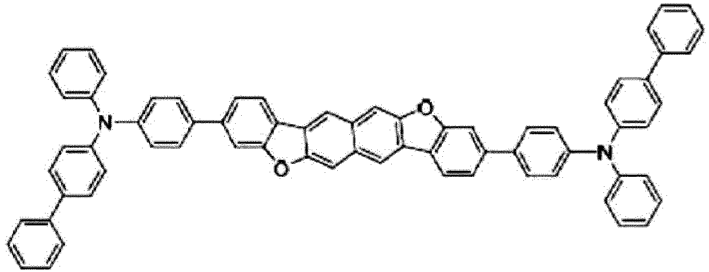

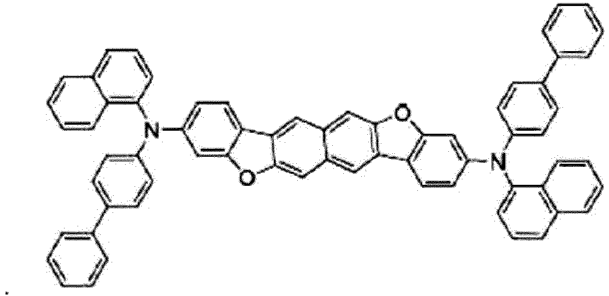

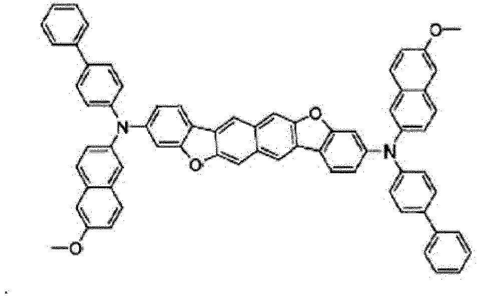

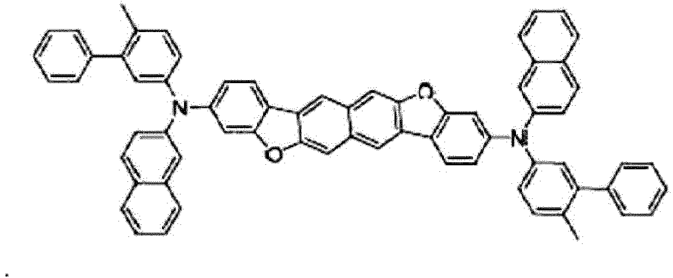

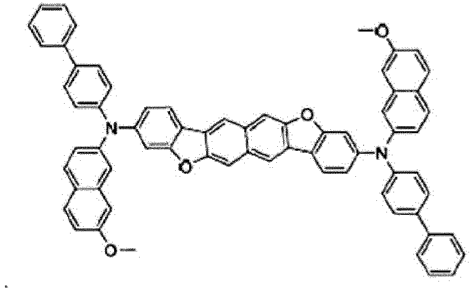

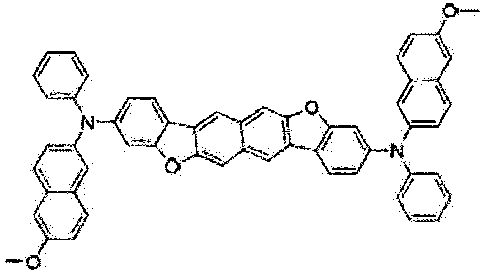

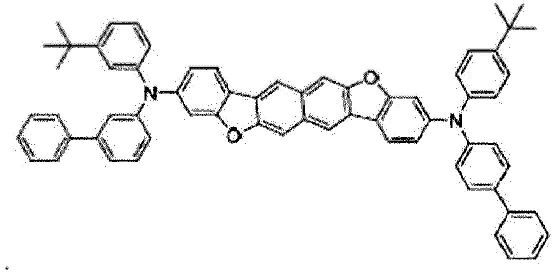

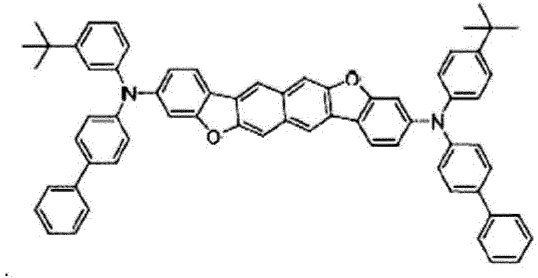

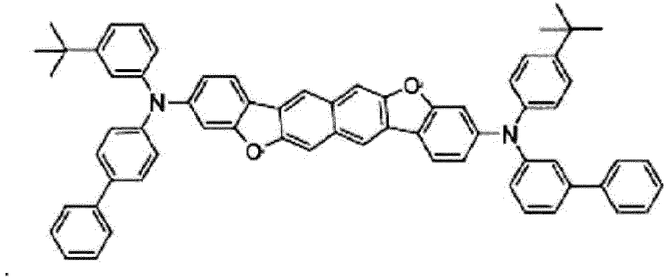

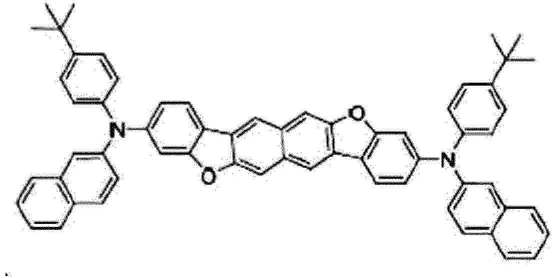

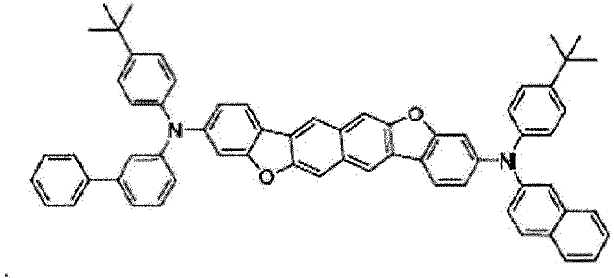

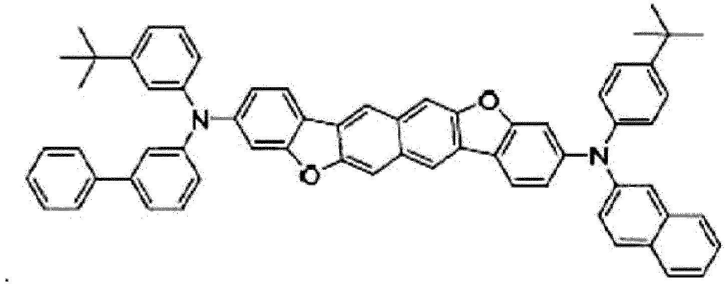

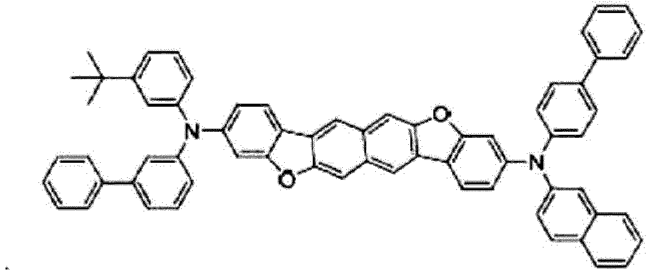

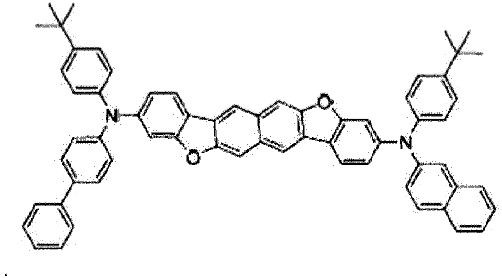

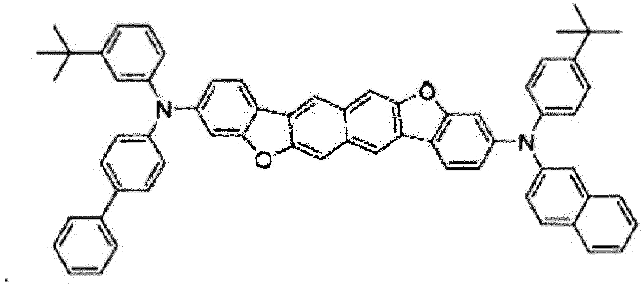

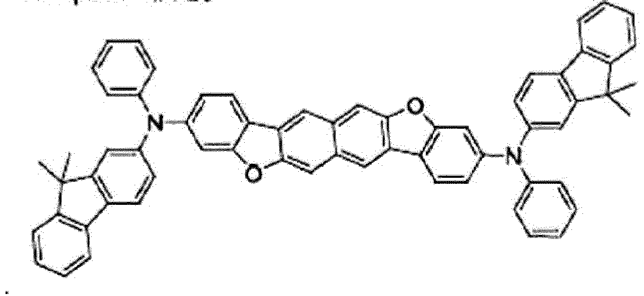

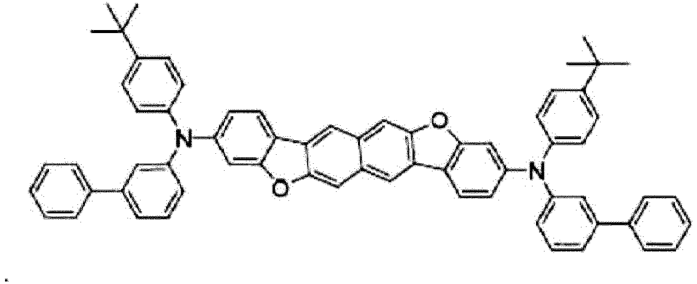

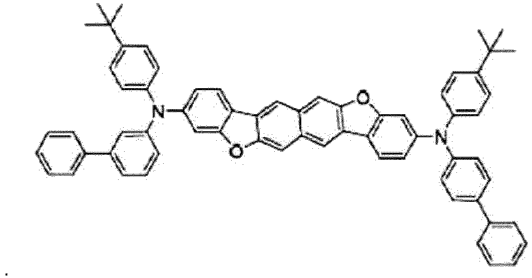

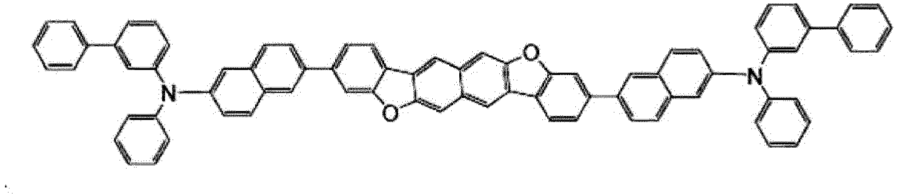

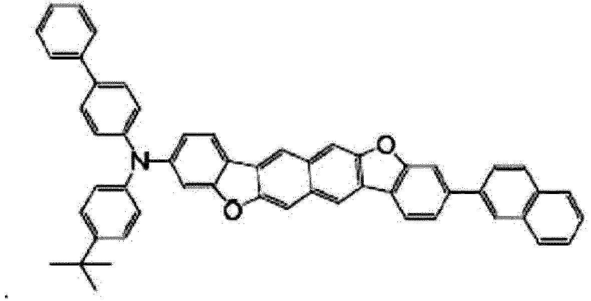

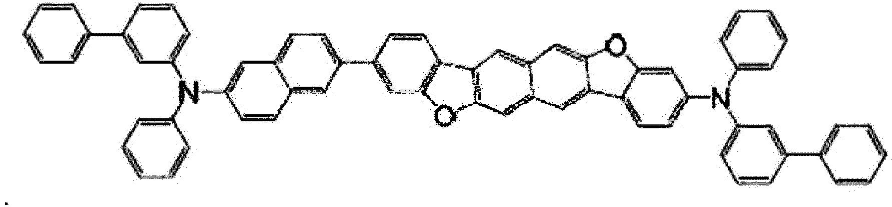

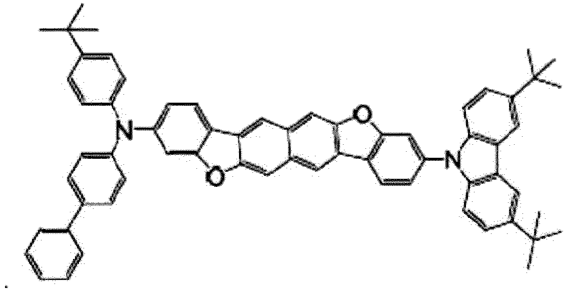

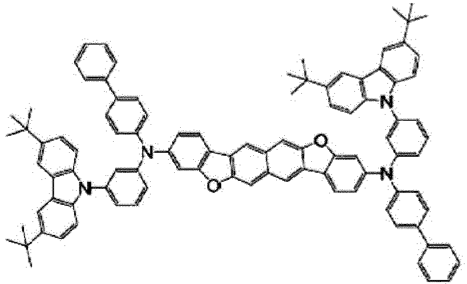

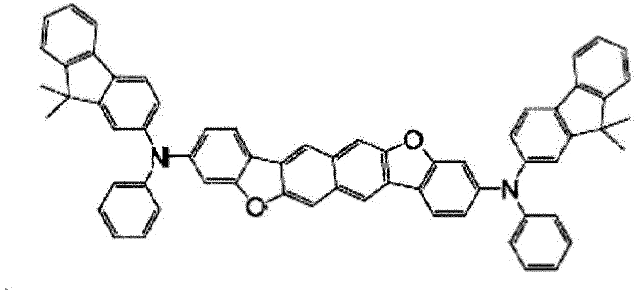

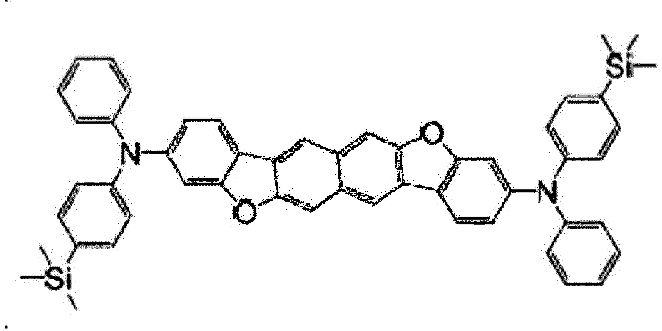

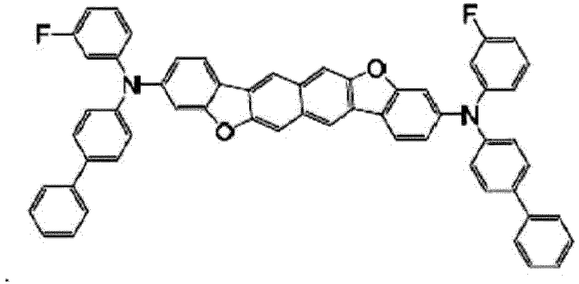

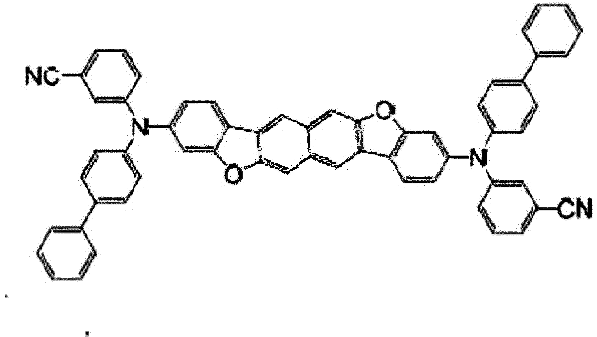

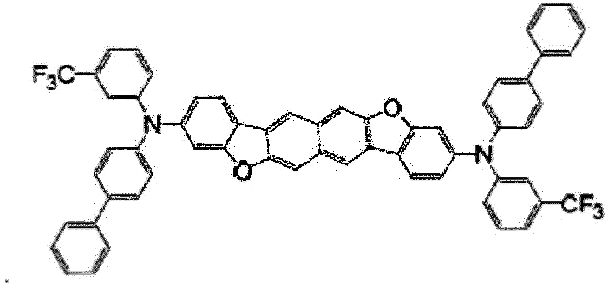

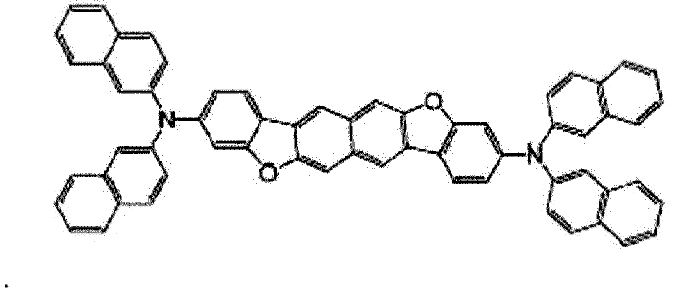

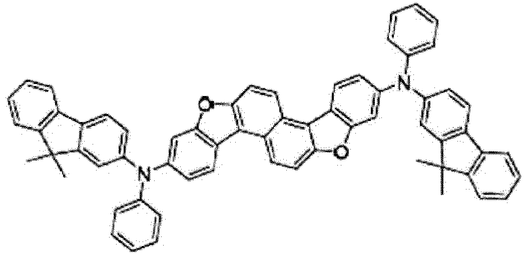

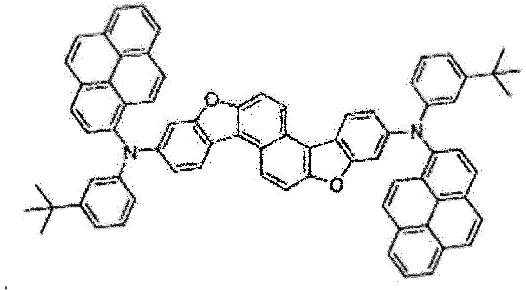

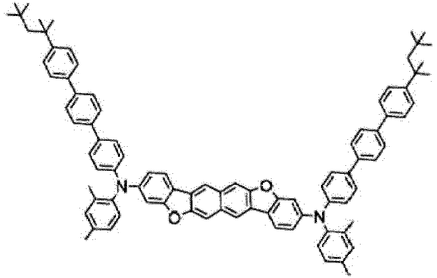

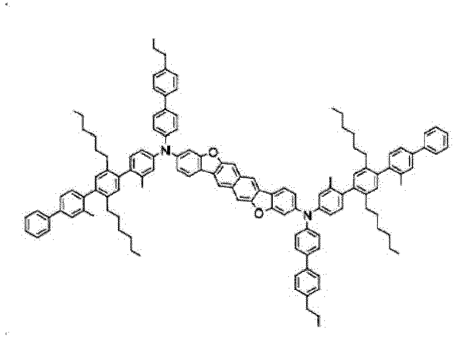

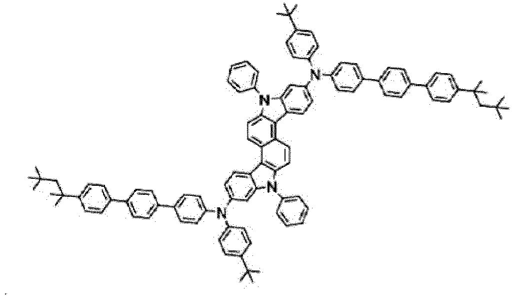

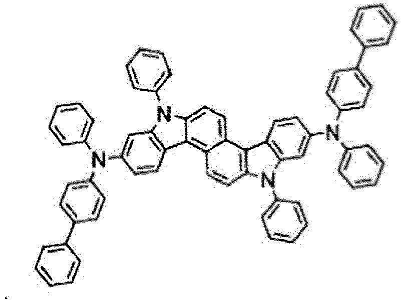

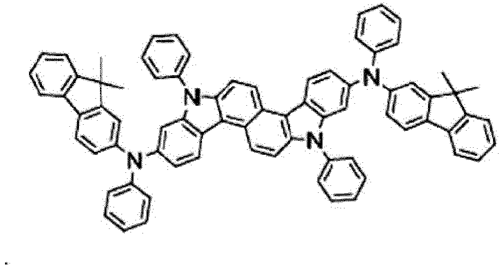

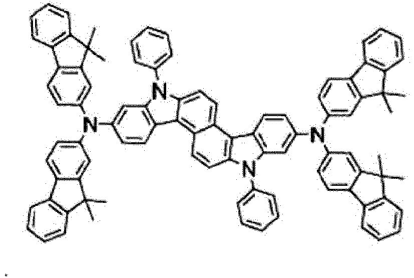

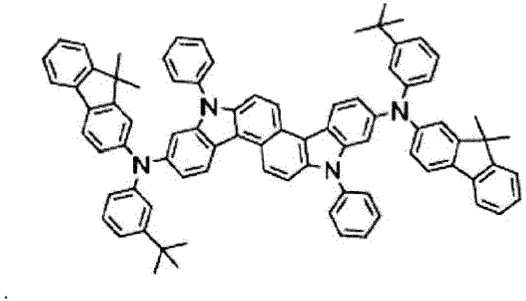

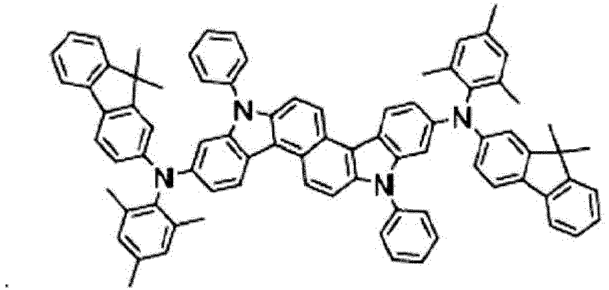

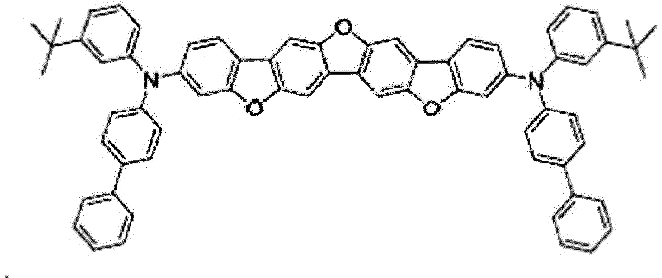

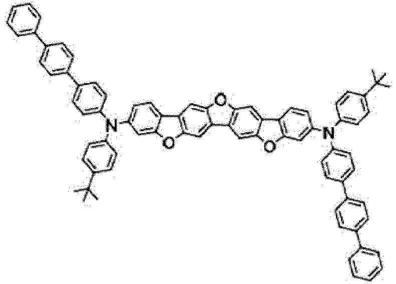

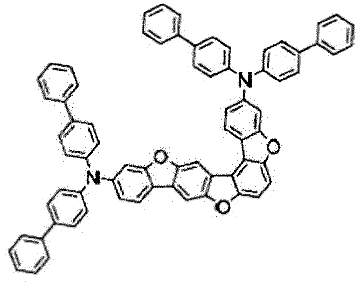

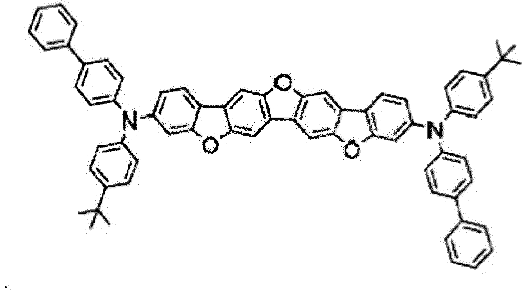

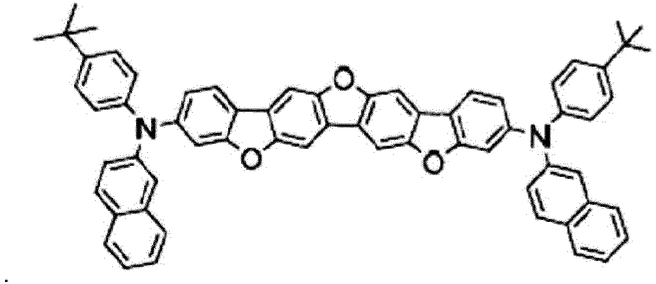

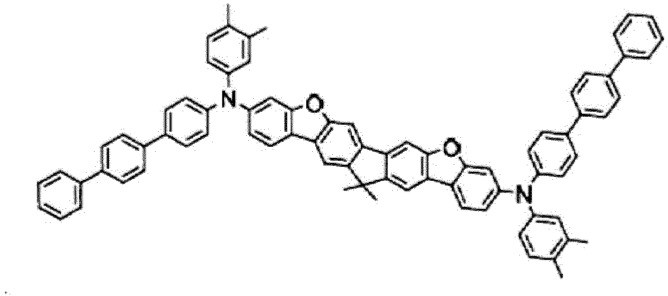

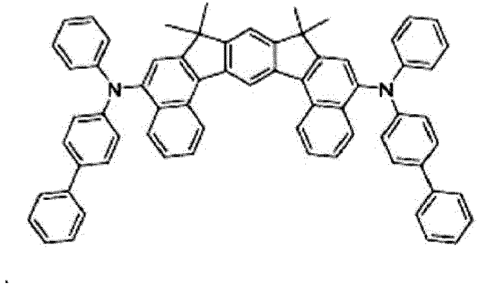

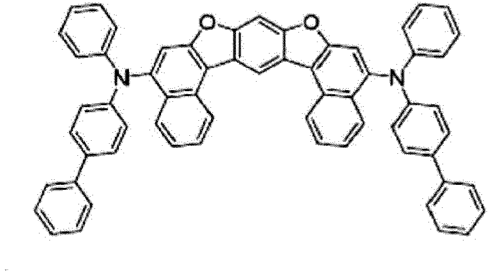

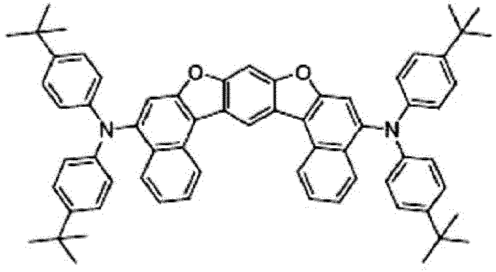

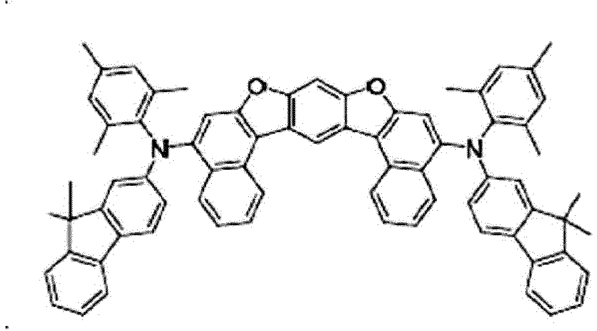

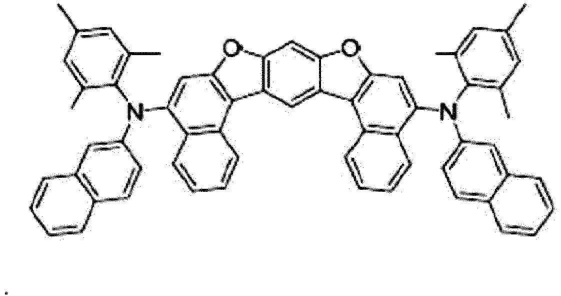

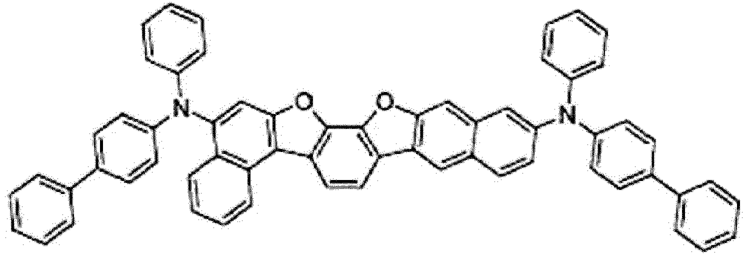

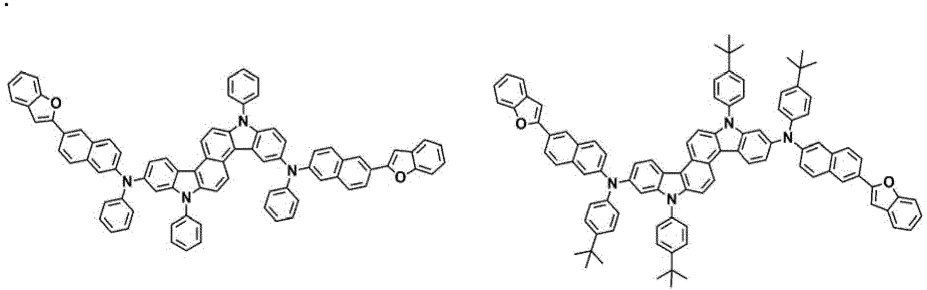

The organic light emitting device according to an exemplary embodiment of the present invention includes: a first electrode; a second electrode; and an organic material layer having one or more layers provided between the first electrode and the second electrode, and one or more layers of the organic material layer having one or more layers include the above-described ink composition or a cured product thereof.

The organic material layer including the above-described ink composition or a cured product thereof may be a hole injection layer, a hole transport layer, a light emitting layer, an electron injection layer or an electron transport layer.

Among the organic material layers having one or more layers provided between the first electrode and the second electrode, the organic material layer except for the organic material layer including the above-described ink composition or a cured product thereof may be one layer or two or more layers selected from the group consisting of a hole injection layer, a hole transport layer, a hole injection and transport layer, an electron blocking layer, a light emitting layer, an electron injection layer, an electron transport layer, an electron injection and transport layer, and a hole blocking layer.

The film flatness (%) of the organic material layer including the ink composition of the present specification or a cured product thereof is calculated using the pixel length and the longest length of the lengths between two points where the thickness deviation with the thickness of the thin film center is within 5% as shown below, and may be measured using an optical profiler manufactured by Bruker. Film flatness (%) = (the longest length of the lengths between two points where the thickness deviation with the thickness of the thin film center is within 5% / the pixel length) X 100

The thin film formed using the ink composition is formed to be thicker from the center to the edge that is brought into contact with the partition wall of the pixel. When the film flatness measurement value is 80% or more, the thin film may be considered flat.

The structure of the organic light emitting device according to an exemplary embodiment of the present specification is exemplified in FIG. 1.

FIG. 1 exemplifies a structure of an organic light emitting device in which a positive electrode 201, a hole injection layer 301, a hole transport layer 401, a light emitting layer 501, an electron transport layer 601, an electron injection layer 701, and a negative electrode 801 are sequentially stacked on a substrate 101. The light emitting layer 501, electron transport layer 601 or electron injection layer 701 may be an organic material layer formed using the above-described ink composition, but FIG. 1 exemplifies an organic light emitting device, and is not limited thereto.

When the organic light emitting device includes a plurality of organic material layers, the organic material layers may be formed of the same material or different materials.

As the positive electrode material, materials having a high work function are usually preferred so as to facilitate the injection of holes into an organic material layer. Specific examples of the positive electrode material which may be used in the present invention include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO . Al or SnO₂ : Sb; a conductive polymer such as poly(3-methylthiophene), poly[3,4-(ethylene-1,2-dioxy)thiophene] (PEDOT), polypyrrole, and polyaniline; and the like, but are not limited thereto.

As the negative electrode material, materials having a low work function are usually preferred so as to facilitate the injection of electrons into an organic material layer. Specific examples of the negative electrode material include a metal such as barium, magnesium, calcium, sodium, potassium, titanium, indium, yttrium, lithium, gadolinium, aluminum, silver, tin, and lead, or an alloy thereof, or a multi-layer structured material, such as LiF/Al or LiO₂/Al, and the like, but are not limited thereto.

The hole injection layer is a layer which injects holes from an electrode, and a hole injection material is preferably a compound which has a capability of transporting holes and thus has an effect of injecting holes at a positive electrode and an excellent effect of injecting holes into a light emitting layer or a light emitting material, prevents excitons produced from the light emitting layer from moving to an electron injection layer or an electron injection material, and is also excellent in the ability to form a thin film. The highest occupied molecular orbital (HOMO) of the hole injection material is preferably a value between the work function of the positive electrode material and the HOMO of the neighboring organic material layer. Specific examples of the hole injection material include metal porphyrins, oligothiophene, arylamine-based organic materials, hexanitrile hexaazatriphenylene-based organic materials, quinacridone-based organic materials, perylene-based organic materials, anthraquinone, and polyaniline- and polythiophene-based conductive polymers, and the like, but are not limited thereto.

The hole transport layer is a layer which accepts holes from a hole injection layer and transports the holes to a light emitting layer, and a hole transport material is suitably a material having high hole mobility which may accept holes from a positive electrode or a hole injection layer and transfer the holes to a light emitting layer. Specific examples thereof include arylamine-based organic materials, conductive polymers, block copolymers having conjugated parts and non-conjugated parts together, and the like, but are not limited thereto.

The hole injection and transport layer may include materials for the above-described hole injection layer and/or hole transport layer.

The light emitting material is a material which may accept holes and electrons from a hole transport layer and an electron transport layer, respectively, and combine the holes and the electrons to emit light in a visible ray region, and is preferably a material having high quantum efficiency to fluorescence or phosphorescence. Specific examples thereof include: 8-hydroxy-quinoline aluminum complexes (Alq₃); carbazole-based compounds; dimerized styryl compounds; BAlq; 10-hydroxybenzoquinoline-metal compounds; benzoxazole-based, benzthiazole-based and benzimidazole-based compounds; poly(p-phenylenevinylene) (PPV)-based polymers; spiro compounds; polyfluorene, rubrene, and the like, but are not limited thereto.

The light emitting layer may include a host material and a dopant material. Examples of the host material include fused aromatic ring derivatives, or hetero ring-containing compounds, and the like. Specifically, examples of the fused aromatic ring derivatives include anthracene derivatives, pyrene derivatives, naphthalene derivatives, pentacene derivatives, phenanthrene compounds, fluoranthene compounds, and the like, and examples of the hetero ring-containing compounds include carbazole derivatives, dibenzofuran derivatives, ladder-type furan compounds, pyrimidine derivatives, and the like, but the examples thereof are not limited thereto.

Examples of the dopant material include aromatic amine derivatives, styrylamine compounds, boron complexes, fluoranthene compounds, metal complexes, and the like. Specifically, the aromatic amine derivative is a substituted or unsubstituted fused aromatic ring derivative having a arylamino group, and examples thereof include a pyrene, an anthracene, a chrysene, a periflanthene, and the like, which have an arylamino group, and the styrylamine compound is a compound in which a substituted or unsubstituted arylamine is substituted with at least one arylvinyl group, and one or two or more substituents selected from the group consisting of an aryl group, a silyl group, an alkyl group, a cycloalkyl group, and an arylamino group is or are substituted or unsubstituted. Specific examples thereof include styrylamine, styryldiamine, styryltriamine, styryltetramine, and the like, but are not limited thereto. Further, examples of the metal complexes include an iridium complex, a platinum complex, and the like, but are not limited thereto.

The electron transport layer is a layer which accepts electrons from an electron injection layer and transports the electrons to a light emitting layer, and an electron transport material is suitably a material having high electron mobility which may proficiently accept electrons from a negative electrode and transfer the electrons to a light emitting layer. Specific examples thereof include Al complexes of 8-hydroxyquinoline; complexes including Alq₃; organic radical compounds; hydroxyflavon-metal complexes, and the like, but are not limited thereto. An electron transport layer may be used with any desired negative electrode material, as used according to the related art. In particular, examples of an appropriate negative electrode material include a typical material which has a low work function, followed by an aluminum layer or a silver layer. Specific examples thereof include cesium, barium, calcium, ytterbium, and samarium, in each case followed by an aluminum layer or a silver layer.

The electron injection layer is a layer which injects electrons from an electrode, and an electron injection material is preferably a compound which has a capability of transporting electrons, has an effect of injecting electrons from a negative electrode and an excellent effect of injecting electrons into a light emitting layer or a light emitting material, prevents excitons produced from the light emitting layer from moving to a hole injection layer, and is also excellent in the ability to form a thin film. Specific examples thereof include fluorenone, anthraquinodimethane, diphenoquinone, thiopyran dioxide, oxazole, oxadiazole, triazole, imidazole, perylene tetracarboxylic acid, fluorenylidene methane, anthrone or the like, and derivatives thereof, metal complex compounds, nitrogen-containing 5-membered ring derivatives, and the like, but are not limited thereto.

The electron injection and transport layer may include materials for the above-described electron transport layer and/or electron injection layer.

The metal complex compound includes 8-hydroxyquinolinato lithium, bis(8-hydroxyquinolinato)zinc, bis(8-hydroxyquinolinato)copper, bis(8-hydroxyquinolinato) manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)berylium, bis(10-hydroxybenzo[h]quinalinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium and the like, but is not limited thereto.

The hole blocking layer is a layer which blocks holes from reaching a negative electrode, and may be generally formed under the same conditions as those of the hole injection layer. Specific examples thereof include oxadiazole derivatives, triazole derivatives, phenanthroline derivatives, BCP, aluminum complexes and the like, but are not limited thereto.

The electron blocking layer is a layer which blocks electrons from reaching a positive electrode, and materials known in the art may be used.

The organic light emitting device according to the present specification may be a top-emission type, a bottom-emission type or a dual-emission type depending on the materials used.

According to an exemplary embodiment of the present specification, in order to manufacture the organic light emitting device, preparing a first electrode; forming an organic material layer having one or more layers on the first electrode; and forming a second electrode on the organic material layer having one or more layers are included, and the forming of the organic material layer having one or more layers includes forming the organic material layer using the above-described ink composition.

The organic light emitting device of the present specification may be manufactured by a method such as a solution process and a deposition process using materials known in the art.

Examples of the deposition process include a physical vapor deposition (PVD) method such as sputtering or e-beam evaporation, and the like, but are not limited thereto.

Examples of the solution process include a spin coating method, a printing method, and the like, but are not limited thereto.

In an exemplary embodiment of the present specification, examples of the printing method include inkjet printing, nozzle printing, offset printing, transfer printing or screen printing, and the like, but are not limited thereto. When layers are formed using a solution process as described above, there is an economic effect in terms of time and cost when a device is manufactured.

In an exemplary embodiment of the present specification, when an organic material layer is formed using the solution process, coating an ink composition including materials for the organic material layer and a solvent; and heat-treating or light-treating the coated ink composition are included.

In an exemplary embodiment of the present specification, the heat-treating of the coated ink composition may be performed through a heat treatment, and the heat treatment temperature in the heat-treating of the coated ink composition may be 60°C to 250°C, may be 100°C to 250°C according to an exemplary embodiment, and may be 150°C to 250°C in another exemplary embodiment.

In another exemplary embodiment, the heat treatment time in the heat-treating of the coated ink composition may be 1 minute to 2 hours, may be 1 minute to 1 hour according to an exemplary embodiment, and may be 30 minutes to 1 hour in another exemplary embodiment.

In still another exemplary embodiment, the ink composition has a viscosity of 1 cP to 20 cP at room temperature. When the above viscosity is satisfied, a device is easily manufactured.

When the forming of the organic material layer using the solution process includes the heat-treating or light-treating of the ink composition, the plurality of compounds included in the ink composition may form a cross-linkage, thereby providing an organic material layer including a thin-filmed structure.

Therefore, when the organic material layer formed using the solution process is formed by a method including the heat-treating or light-treating of the coated ink composition, resistance to a solvent is increased, so that a plurality of layers may be formed by repeatedly performing solution deposition and cross-linking methods, and stability is increased, so that the service life characteristic of the device may be increased.

Hereinafter, the present specification will be described in detail with reference to Examples for specifically describing the present specification. However, the Examples according to the present specification may be modified in various forms, and it is not interpreted that the scope of the present specification is limited to the Examples described below. The Examples of the present specification are provided to more completely explain the present specification to a person with ordinary skill in the art.

### [Mode for Invention]

### <Preparation of Ink Composition>

Ink Composition Preparation Example 1.

The following Blue Host 1 and Blue Dopant 1 were mixed at a weight ratio of 98 . 2, and the resulting mixture was introduced into the solvent shown in the following Table 1 at a concentration of 1 part by weight. Thereafter, the mixed solution was stirred for 24 hours and dissolved to prepare an ink composition.

### Ink Composition Preparation Examples 2 to 61.

Ink Compositions 2 to 61 were prepared in the same manner as in Ink Composition Preparation Example 1, except that the types of host and dopant and the composition of the solvent were changed as shown in the following Table 1.

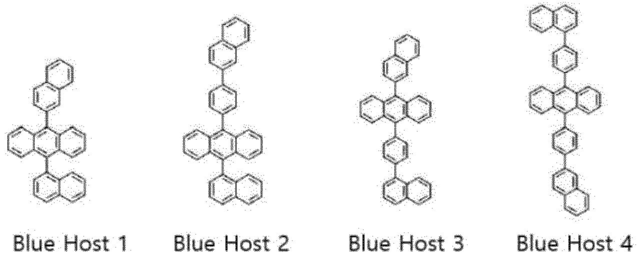

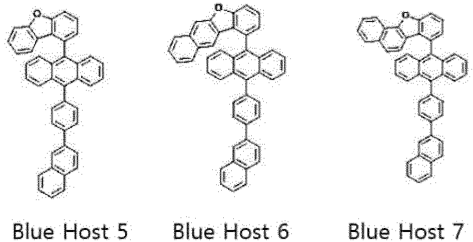

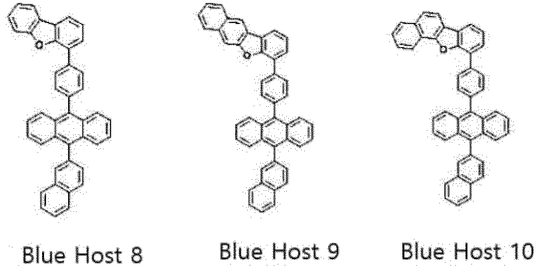

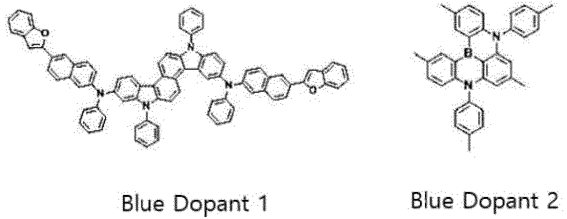

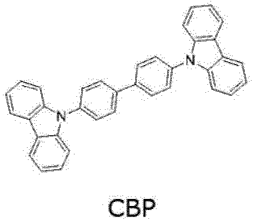

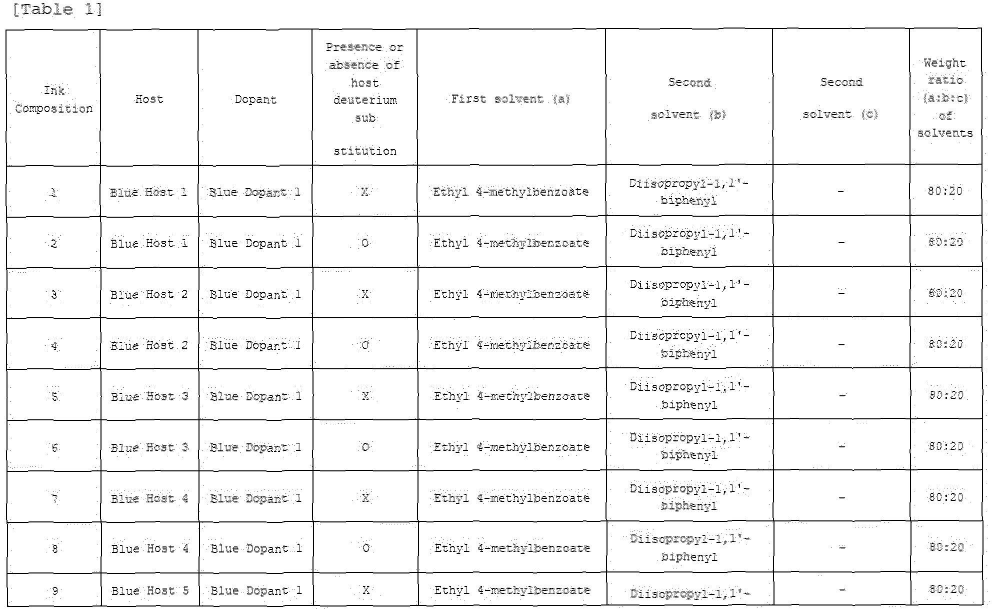

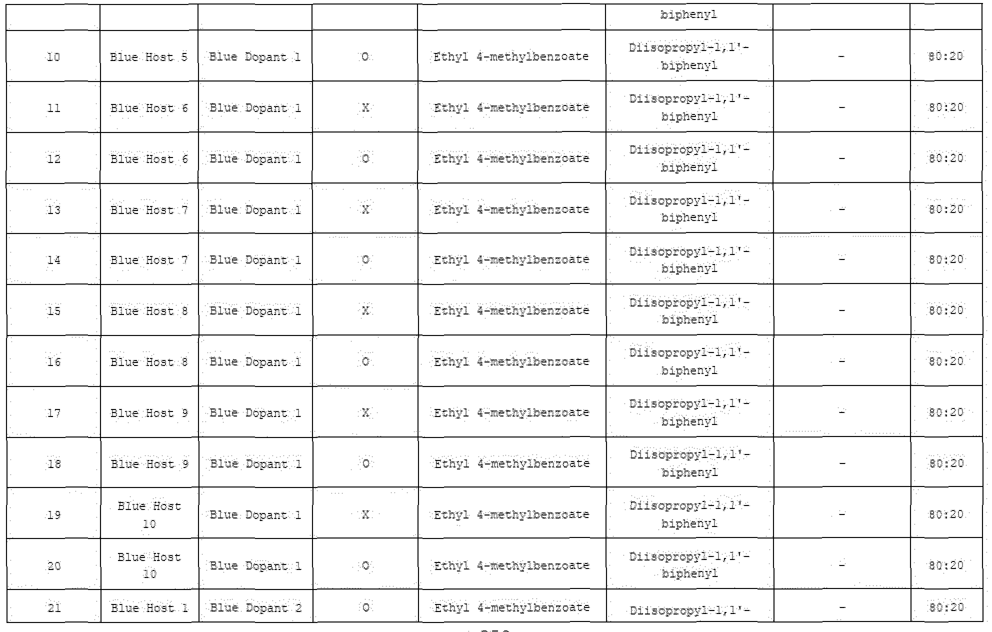

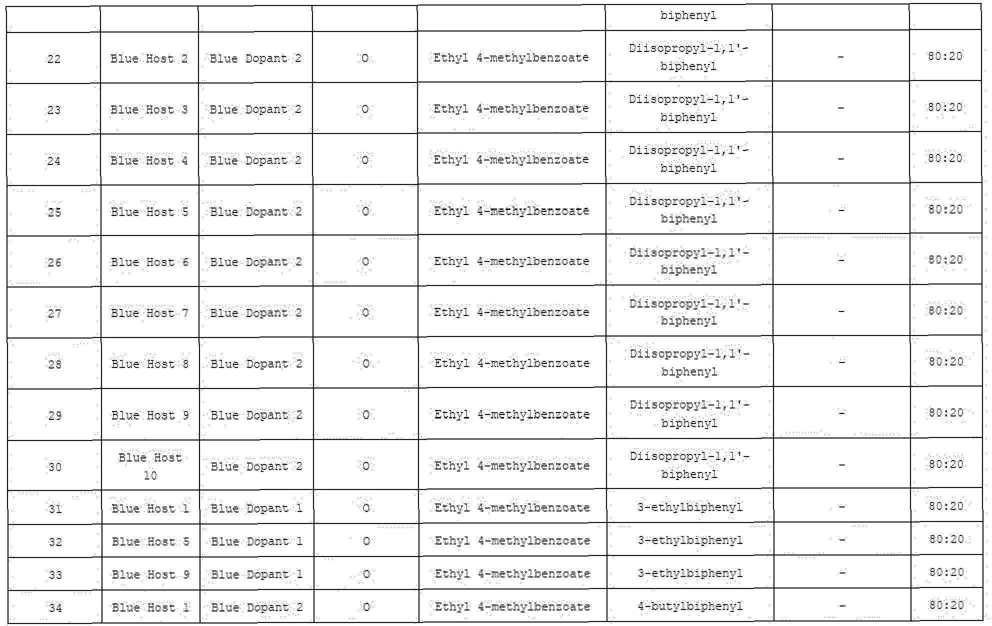

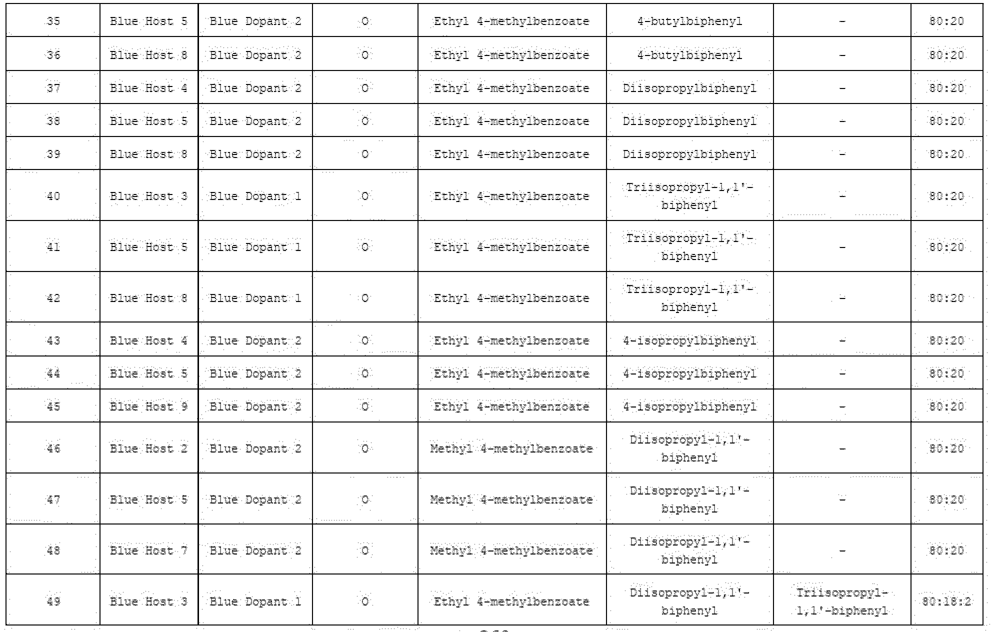

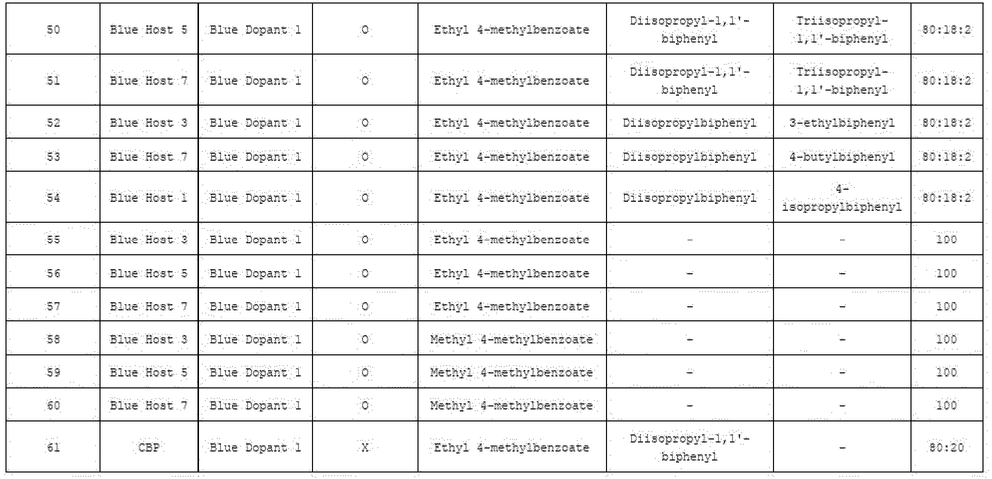

### <Experimental Example A. Thin film preparation and flatness evaluation>

### Example 1.

Ink Composition 1 prepared above was applied to a base material on which banks are formed using an inkjet apparatus, and the base material coated with the ink was put into a vacuum drying apparatus and dried in a high vacuum (1 × 10⁻⁶ Torr). Thereafter, the dried base material was heat-treated at 140°C for 20 minutes in a glove box under a nitrogen atmosphere to form a thin film. The thickness of the pixel included in the cured thin film was measured using an optical profiler (model name: ContourGT-I) manufactured by Bruker, which is an optical thickness measurement device, and based on the measured thicknesses of the pixels, the film flatness (%) of the organic material layer is calculated using the pixel length and the longest length of the lengths between two points where the thickness deviation with the thickness of the thin film center is within 5% as in the following equation,Film flatness (%) = (the longest length of the lengths between two points where the thickness deviation with the thickness of the thin film center is within 5% / the pixel length) X 100

In Table 2, a film flatness of 80% or more is described as passed (O).

### Examples 2 to 54 and Comparative Examples 1 to 7.

Except that the ink compositions shown in the following Table 2 were used instead of Ink Composition 1, thin films were prepared in the same manner as in Example 1, and the film flatness was derived and shown in the following Table 2.

**[Table 2]**

| Experimental Example | Ink composition | Film flatness |
|---|---|---|
| Example 1 | 1 | ○ |
| Example 2 | 2 | ○ |
| Example 3 | 3 | ○ |
| Example 4 | 4 | ○ |
| Example 5 | 5 | ○ |
| Example 6 | 6 | ○ |
| Example 7 | 7 | ○ |
| Example 8 | 8 | ○ |
| Example 9 | 9 | ○ |
| Example 10 | 10 | ○ |
| Example 11 | 11 | ○ |
| Example 12 | 12 | ○ |
| Example 13 | 13 | ○ |
| Example 14 | 14 | ○ |
| Example 15 | 15 | ○ |
| Example 16 | 16 | ○ |
| Example 17 | 17 | ○ |
| Example 18 | 18 | ○ |
| Example 19 | 19 | ○ |
| Example 20 | 20 | ○ |
| Example 21 | 21 | ○ |
| Example 22 | 22 | ○ |
| Example 23 | 23 | ○ |
| Example 24 | 24 | ○ |
| Example 25 | 25 | ○ |
| Example 26 | 26 | ○ |
| Example 27 | 27 | ○ |
| Example 28 | 28 | ○ |
| Example 29 | 29 | ○ |
| Example 30 | 30 | ○ |
| Example 31 | 31 | ○ |
| Example 32 | 32 | ○ |
| Example 33 | 33 | ○ |
| Example 34 | 34 | ○ |
| Example 35 | 35 | ○ |
| Example 36 | 36 | ○ |
| Example 37 | 37 | ○ |
| Example 38 | 38 | ○ |
| Example 39 | 39 | ○ |
| Example 40 | 40 | ○ |
| Example 41 | 41 | ○ |
| Example 42 | 42 | ○ |
| Example 43 | 43 | ○ |
| Example 44 | 44 | ○ |
| Example 45 | 45 | ○ |
| Example 46 | 46 | ○ |
| Example 47 | 47 | ○ |
| Example 48 | 48 | ○ |
| Example 49 | 49 | ○ |
| Example 50 | 50 | ○ |
| Example 51 | 51 | ○ |
| Example 52 | 52 | ○ |
| Example 53 | 53 | ○ |
| Example 54 | 54 | ○ |
| Comparative Example 1 | 55 | X |
| Comparative Example 2 | 56 | X |
| Comparative Example 3 | 57 | X |
| Comparative Example 4 | 58 | X |
| Comparative Example 5 | 59 | X |
| Comparative Example 6 | 60 | X |
| Comparative Example 7 | 61 | X |

From the results in Table 2, it can be confirmed that the thin film formed using the ink composition including the compound of Chemical Formula 1 of the present application, the first solvent, and the second solvent has better film flatness than a thin film formed using an ink composition which does not include the second solvent and a thin film formed using an ink composition which includes another compound instead of the compound of Chemical Formula 1 of the present application.

### <Experimental Example B. Device manufacturing and evaluation>

### Example B-1.

A glass substrate which was thin-film coated to have a thickness of 700 Å of indium tin oxide (ITO) and patterned with hydrophobic banks was washed with distilled water for 30 minutes and then dried on a hot plate at 230°C for 10 minutes. The following hole injection host and hole injection dopant were added to amyl benzoate in an amount of 2.0 wt% at a weight ratio of 8 : 2. The mixed solution was stirred for 24 hours and completely dissolved, and then inkjet-printed on a bank patterned, washed substrate. Thereafter, the base material coated with the ink was put into a vacuum drying apparatus, dried under high vacuum (1 × 10⁻⁶ Torr or less), and then heat-treated at 200°C for 10 minutes to form a hole injection layer with a thickness of 30 nm. An ink, in which the following hole transport material (Mn: 27,900; Mw: 35,600; measured by GPC using the PC Standard using Agilent 1200 series) was dissolved in cyclohexylbenzene at a concentration of 2 wt%, was inkjet-printed on the hole injection layer and dried under high vacuum (1×10⁻⁶ Torr or less), and then heat treatment was performed at 230°C for 30 minutes to form a hole transport layer with a thickness of 40 nm. Ink Composition 1 of Table 1 was inkjet-printed on the hole transport layer and dried under high vacuum (1 × 10⁻⁶ Torr or less), and then heat treatment was performed at 130°C for 20 minutes to form a light emitting layer with a thickness of 40 nm. The following BCP compound was vacuum-deposited to have a thickness of 35 nm on the light emitting layer, thereby forming an electron transport layer. An organic light emitting device was manufactured by forming a LiF electron injection layer with a thickness of 1 nm and an aluminum cathode with a thickness of 100 nm on the electron transport layer. The service life of the organic light emitting device was evaluated using a Lifetime Measurement Incubator (model name: YM-TC240) manufactured by Y.M.RTC, which is a service life measurement apparatus.

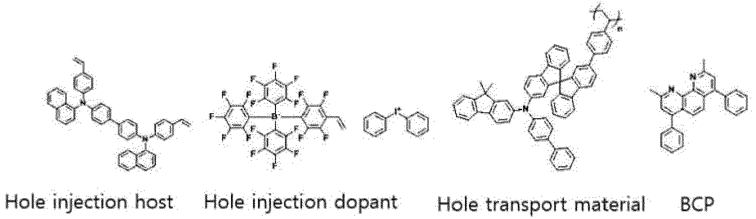

### Examples B-2 to B-22 and Comparative Examples B-1 to B-3.

Organic light emitting devices were manufactured in the same manner as in Example B-1, except that the ink compositions in the following Table 3 were used instead of Ink Composition 1 in Example B-1, and the service lives of the organic light emitting devices were evaluated as in Table 3.

**[Table 3]**

| | Ink Composition | Organic light emitting device Service life (hour) |
|---|---|---|
| Example B-1 | 1 | 83 |
| Example B-2 | 2 | 128 |
| Example B-3 | 3 | 76 |
| Example B-4 | 4 | 117 |
| Example B-5 | 5 | 79 |
| Example B-6 | 6 | 123 |
| Example B-7 | 7 | 58 |
| Example B-8 | 8 | 95 |
| Example B-9 | 9 | 78 |
| Example B-10 | 10 | 125 |
| Example B-11 | 11 | 67 |
| Example B-12 | 12 | 105 |
| Example B-13 | 13 | 72 |
| Example B-14 | 14 | 108 |
| Example B-15 | 15 | 78 |
| Example B-16 | 16 | 122 |
| Example B-17 | 17 | 63 |
| Example B-18 | 18 | 107 |
| Example B-19 | 19 | 69 |
| Example B-20 | 20 | 102 |
| Example B-21 | 49 | 83 |
| Example B-22 | 52 | 81 |
| Comparative Example B-1 | 56 | 37 |
| Comparative Example B-2 | 59 | 42 |
| Comparative Example B-3 | 61 | 18 |

From the results in Table 3, it can be confirmed that in the case of a device in which a light emitting layer was formed using the ink composition including the compound of Chemical Formula 1 of the present application, the first solvent, and the second solvent, the service life of the device was significantly improved compared to devices in which a light emitting layer was formed using an ink composition which does not include the second solvent or an ink composition which includes another compound instead of the compound of Chemical Formula 1 of the present application. Furthermore, when comparison is made between Examples B-1 and B-2, Examples B-3 and B-4, Examples B-5 and B-6, Examples B-7 and B-8, Examples B-9 and B-10, Examples B-11 and B-12, Examples B-13 and B-14, Examples B-15 and B-16, Examples B-17 and B-18, and Examples B-19 and B-20, respectively, it can be confirmed that when a compound having the same core structure is used as a host, the service life of a device including a compound in which deuterium is substituted is excellent compared to that of a device including a compound in which deuterium is not substituted.

## Claims

1. An ink composition comprising:
a compound represented by the following Chemical Formula 1;
a first solvent represented by the following Chemical Formula 2; and
a second solvent represented by the following Chemical Formula 3: 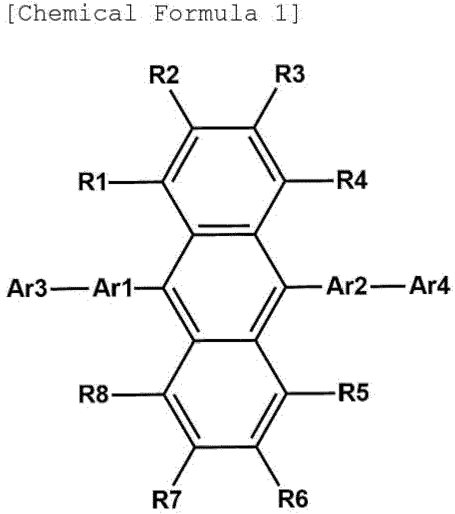
wherein, in Chemical Formula 1,
R1 to R8 are the same as or different from each other, and are each independently hydrogen; deuterium; a substituted or unsubstituted alkyl group; a substituted or unsubstituted alkoxy group; a substituted or unsubstituted aryl group; a substituted or unsubstituted aryloxy group; a substituted or unsubstituted diarylamino group; a substituted or unsubstituted siloxane group; or a substituted or unsubstituted silyl group,
Ar1 and Ar2 are the same as or different from each other, and are each independently a direct bond; or a substituted or unsubstituted arylene group,
Ar3 and Ar4 are the same as or different from each other, and are each independently a substituted or unsubstituted aryl group; or a substituted or unsubstituted heteroaryl group, 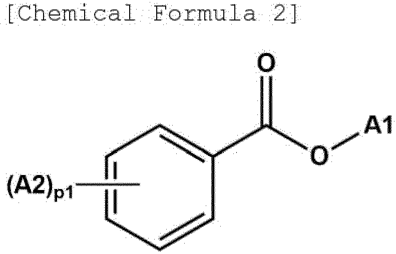 in Chemical Formula 2,
A1 and A2 are the same as or different from each other, and each independently a substituted or unsubstituted alkyl group; a substituted or unsubstituted alkoxy group; a substituted or unsubstituted cycloalkyl group; or a substituted or unsubstituted aryl group,
p1 is an integer from 0 to 5, and when p1 is 2 or higher, two or more A2's are the same as or different from each other, 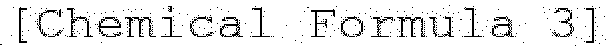 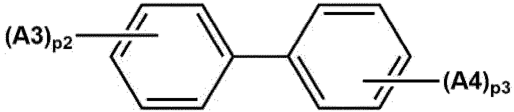 in Chemical Formula 3,
A3 and A4 are the same as or different from each other, and each independently a substituted or unsubstituted alkyl group; a substituted or unsubstituted alkoxy group; a substituted or unsubstituted cycloalkyl group; or a substituted or unsubstituted aryl group, and
p2 and p3 are each an integer from 0 to 5, and when p2 and p3 are 2 or higher, two or more substituents in the parenthesis are the same as or different from each other.

2. The ink composition of claim 1, wherein Chemical Formula 1 is substituted with at least one deuterium.

3. The ink composition of 1, wherein the first solvent has a boiling point of 180°C to 270°C.

4. The ink composition of 1, wherein the second solvent has a boiling point of 240°C to 350°C.

5. The ink composition of 1, wherein A1 and A2 are the same as or different from each other, and are each independently a substituted or unsubstituted alkyl group having 1 to 20 carbon atoms; or a substituted or unsubstituted alkoxy group having 1 to 20 carbon atoms.

6. The ink composition of 1, wherein A3 and A4 are the same as or different from each other, and are each independently a substituted or unsubstituted alkyl group having 1 to 20 carbon atoms; or a substituted or unsubstituted alkoxy group having 1 to 20 carbon atoms.

7. The ink composition of 1, comprising two or more second solvents.

8. The ink composition of 1, wherein the first solvent and the second solvent are comprised at a weight ratio of 95 : 5 to 50 : 50.

9. The ink composition of 1, further comprising an additional compound.

10. The ink composition of 9, wherein the compound represented by Chemical Formula 1 and the additional compound are comprised at amount of 0.1 parts by weight to 10 parts by weight based on 100 parts by weight of the ink composition.

11. An organic light emitting device comprising: a first electrode; a second electrode; and an organic material layer having one or more layers provided between the first electrode and the second electrode,
wherein one or more layers of the organic material layer comprise the ink composition of any one of claims 1 to 10 or a cured product thereof.

12. A method for manufacturing an organic light emitting device, the method comprising:
preparing a first electrode;
forming an organic material layer having one or more layers on the first electrode; and
forming a second electrode on the organic material layer having one or more layers,
wherein the forming of the organic material layer having one or more layers comprises forming an organic material layer using the ink composition of any one of claims 1 to 10.
